# EUROPEAN PATENT APPLICATION

(11) **EP 4 481 495 A1**
(43) Date of publication of application: **25.12.2024**
(21) Application number: 24182276.6
(22) Date of filing: 14.06.2024
(51) Int. Cl.: G03F 7/004, G03F 7/039

(54) **CHEMICALLY AMPLIFIED POSITIVE RESIST COMPOSITION AND RESIST PATTERN FORMING PROCESS**

(30) Priority: 19.06.2023 JP 2023099916
(71) Applicant: Shin-Etsu Chemical Co., Ltd., Tokyo 100-0005 (JP)
(72) Inventor: Fukushima, Masahiro, NIIGATA-KEN (JP); Watanabe, Satoshi, NIIGATA-KEN (JP); Funatsu, Kenji, NIIGATA-KEN (JP); Masunaga, Keiichi, NIIGATA-KEN (JP); Kotake, Masaaki, NIIGATA-KEN (JP); Matsuzawa, Yuta, NIIGATA-KEN (JP)
(74) Representative: Ter Meer Steinmeister & Partner

(57) **Abstract**

A chemically amplified positive resist composition is provided comprising a polymer comprising repeat units having a phenolic hydroxy group protected with a tertiary ether type acid labile group and an acid generator capable of generating a fluorinated aromatic sulfonic acid. A resist pattern with a high resolution, reduced LER, rectangularity, minimized influence of develop loading, and few development residue defects can be formed.

## Description

### TECHNICAL FIELD

This invention relates to a chemically amplified positive resist composition and a resist pattern forming process using the same.

### BACKGROUND ART

To meet the recent demand for higher integration in integrated circuits, pattern formation to a smaller feature size is required. Acid-catalyzed chemically amplified resist compositions are most often used in forming resist patterns with a feature size of 0.2 µm or less. High-energy radiation such as UV, deep-UV, EUV or EB is used as the energy source for exposure of these resist compositions. In particular, the EB lithography, which is utilized as the ultra-fine microfabrication technique, is also indispensable in processing a photomask blank into a photomask for use in the fabrication of semiconductor devices.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB having a minute area. The operation of successively scanning all finely divided regions on the work surface takes a long time as compared with one-shot exposure through a photomask. To avoid any throughput decline, a resist film having a high sensitivity is required. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. A small line edge roughness (LER) is another important performance factor. In recent years, the multibeam mask writing (MBMW) process is used in the processing of mask blanks to achieve further miniaturization. The resist used in the MBMW process is a low-sensitivity resist (or high-dose region) which is advantageous in roughness while a spotlight is brought to the optimization of the resist composition in the high-dose region.

The control of resist sensitivity and pattern profile has been improved by a proper selection and combination of resist material components and processing conditions. One improvement pertains to the diffusion of acid that largely affects the resolution of a resist film. In the processing of photomasks, it is required that the profile of a resist pattern formed do not change with the lapse of time from the end of exposure to bake. The major cause of such a resist pattern profile change with time is diffusion of an acid generated upon exposure. The problem of acid diffusion has been widely studied not only in terms of photomask processing, but also in terms of general resist compositions because the acid diffusion has a significant impact on sensitivity and resolution.

Patent Documents 1 and 2 describe acid generators capable of generating bulky acids for controlling acid diffusion and reducing LER. Since these acid generators are still insufficient to control acid diffusion, it is desired to have an acid generator with more controlled acid diffusion.

Patent Document 3 discloses a resist composition comprising a base polymer having introduced therein repeat units having a sulfonium structure capable of generating a sulfonic acid upon light exposure. This approach of controlling acid diffusion by introducing repeat units capable of generating acid upon exposure into a base polymer is effective in forming a pattern with small LER. However, the base polymer having introduced therein repeat units capable of generating acid upon exposure sometimes encounters a problem with respect to its solubility in organic solvent, depending on the structure and proportion of the repeat units.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption to radiation of wavelength around 200 nm. These polymers, however, are expected to form useful resist materials for the EB and EUV lithography for forming patterns of smaller size than the processing limit of ArF excimer laser because they offer high etching resistance.

Often used as the base polymer in positive resist compositions for EB and EUV lithography is a polymer having an acidic functional group on phenol side chain masked with an acid labile group. Upon exposure to high-energy radiation, a photoacid generator generates an acid and the acid labile group is deprotected by the catalysis of the generated acid whereby the polymer turns soluble in alkaline developer. Typical of the acid labile group are tertiary alkyl, tert-butoxycarbonyl, and acetal groups. The use of acid labile groups (e.g., acetal groups) requiring a relatively low level of activation energy for deprotection offers the advantage that a resist film having a high sensitivity is obtainable. However, if the diffusion of generated acid is not fully controlled, deprotection reaction can occur even in the unexposed region of the resist film, giving rise to problems like degradations of resolution and LER.

It is known that a develop loading phenomenon arises in the development step of the photomask fabrication process. That is, the finish size of pattern features differs between a grouped region and an isolated region on a photomask. Due to the develop loading, the distribution of pattern finish size becomes non-uniform depending on the surrounding pattern feature distribution. This is caused by a difference in elimination reaction during acid generation due to an energy difference of EB and a difference of dissolution rate in alkaline developer between grouped and isolated images. As one solution, Patent Document 4 discloses a beam dose computing method of an EB writing apparatus comprising the steps of adjusting an input dose in the EB writing apparatus so as to correct develop loading effects, and irradiating EB in the adjusted dose for thereby writing a pattern on a photomask. However, since the prior art correcting method has not fully taken into account the develop loading phenomenon for correction, the accuracy of correcting develop loading effects is not so high. To solve such problems, Patent Document 5 discloses an imaging method and Patent Document 6 discloses a method of improving a development mode after patterning. These methods are insufficient for establishing a uniform distribution of grouped and isolated features in the advanced generation of lithography. An improvement in resist compositions is desired.

### Citation List

Patent Document 1: JP-A 2009-053518
Patent Document 2: JP-A 2010-100604
Patent Document 3: JP-A 2011-022564
Patent Document 4: JP-A 2007-150243 (USP 7740991)
Patent Document 5: JP 5443548
Patent Document 6: JP 6281244

### SUMMARY OF INVENTION

An object of the invention is to provide a chemically amplified positive resist composition which is lithographically processed into a resist pattern with a very high resolution, reduced LER, improved rectangularity, minimized influence of develop loading, and few development residue defects, and a resist pattern forming process using the same.

The inventors have found that when a base polymer comprising repeat units containing a phenolic hydroxy group protected with a tertiary ether type acid labile group and an acid generator capable of generating a fluorinated aromatic sulfonic acid are blended in a resist composition, a resist pattern with a satisfactory resolution, profile and LER can be formed from the resist composition while controlling the influence of develop loading and minimizing development residue defects.

In one aspect, the invention provides a chemically amplified positive resist composition comprising
(A) a photoacid generator capable of generating an acid upon receipt of high-energy radiation, having the formula (A), and
(B) a base polymer containing a polymer adapted to increase its solubility in an alkaline aqueous solution under the action of acid, the polymer comprising repeat units having the formula (B 1).

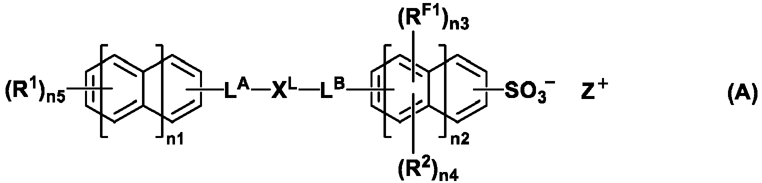

Herein n1 and n2 are each independently an integer of 0 to 2, n3 is an integer of 1 to 4 in case of n2=0, an integer of 1 to 6 in case of n2=1, and an integer of 1 to 8 in case of n2=2, n4 is an integer of 0 to 3 in case of n2=0, an integer of 0 to 5 in case of n2=1, and an integer of 0 to 7 in case of n2=2, n3+n4 is an integer of 1 to 4 in case of n2=0, an integer of 1 to 6 in case of n2=1, and an integer of 1 to 8 in case of n2=2, n5 is an integer of 1 to 5 in case of n1=0, an integer of 1 to 7 in case of n1=1, and an integer of 1 to 9 in case of n1=2,
R¹ is iodine or a C₃-C₂₀ branched or cyclic hydrocarbyl group which may contain a heteroatom, at least one R¹ is attached to the carbon atom adjoining the carbon atom to which L^{A} is attached, a plurality of R¹ may bond together to form a ring with the carbon atoms to which they are attached when n5 is 2 or more,
R² is a C₁-C₂₀ hydrocarbyl group which may contain a heteroatom, a plurality of R² may bond together to form a ring with the carbon atoms to which they are attached when n4 is 2 or more,
R^{F1} is fluorine, a C₁-C₆ fluorinated alkyl group, C₁-C₆ fluorinated alkoxy group, or C₁-C₆ fluorinated thioalkoxy group,
L^{A} and L^{B} are each independently a single bond, ether bond, ester bond, amide bond, sulfonate ester bond, carbonate bond or carbamate bond,
X^{L} is a single bond or a C₁-C₄₀ hydrocarbylene group which may contain a heteroatom, and
Z⁺ is an onium cation.

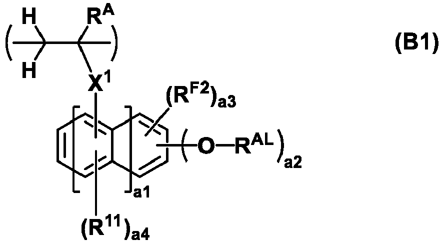

Herein a1 is an integer of 0 to 2, a2 is an integer of 1 or 2, a3 is an integer of 1 or 2, a4 is an integer of 0 to 4,
R^{A} is hydrogen, fluorine, methyl or trifluoromethyl,
X¹ is a single bond or *-C(=O)-O-, * designates a point of attachment to the carbon atom in the backbone,
R^{AL} is an acid labile group,
R^{F2} is fluorine, a C₁-C₆ fluorinated saturated hydrocarbyl group, C₁-C₆ fluorinated saturated hydrocarbyloxy group, or C₁-C₆ fluorinated saturated hydrocarbylthio group,
R¹¹ is halogen exclusive of fluorine or a C₁-C₂₀ hydrocarbyl group which may contain a heteroatom,
in case of a2=1, -O-R^{AL} and -R^{F2} are attached to the adjoining carbon atoms on the aromatic ring, and in case of a2=2, one of two -O-R^{AL} is attached to the carbon atom adjoining the carbon atom on the aromatic ring to which -R^{F2} is attached.

Preferably, the photoacid generator has the formula (A1): 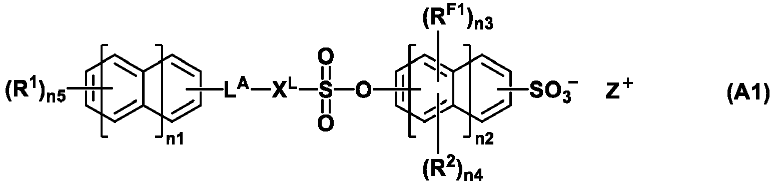 wherein n1 to n5, R¹, R², R^{F1}, L^{A}, X^{L} and Z⁺ are as defined above.

In a preferred embodiment, Z⁺ is a sulfonium cation having the formula (cation-1) or iodonium cation having the formula (cation-2):

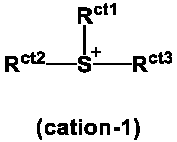

**R^{ct4}-I⁺-R^{ct5}** **(cation-2)**

wherein R^{ct1} to R^{ct5} are each independently halogen or a C₁-C₃₀ hydrocarbyl group which may contain a heteroatom, R^{ct1} and R^{ct2} may bond together to form a ring with the sulfur atom to which they are attached.

In a preferred embodiment, R^{AL} is a group having the formula (AL-1) or (AL-2).

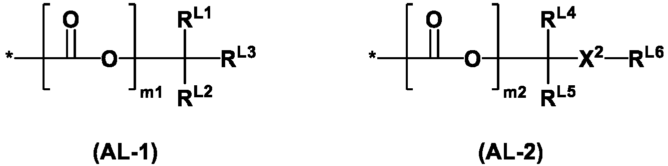

Herein R^{L1}, R^{L2} and R^{L3} are each independently a C₁-C₁₂ hydrocarbyl group in which some -CH₂- may be replaced by -O- or -S-, when the hydrocarbyl group contains an aromatic ring, some or all of the hydrogen atoms in the aromatic ring may be substituted by halogen, cyano moiety, nitro moiety, optionally halogenated C₁-C₄ alkyl moiety or optionally halogenated C₁-C₄ alkoxy moiety, R^{L1} and R^{L2} may bond together to form a ring with the carbon atom to which they are attached,
R^{L4} and R^{L5} are each independently hydrogen or a C₁-C₁₀ hydrocarbyl group, R^{L6} is a C₁-C₂₀ hydrocarbyl group in which some -CH₂- may be replaced by -O- or -S-, R^{L5} and R^{L6} may bond together to form a C₃-C₂₀ heterocyclic group with the carbon atom and X² to which they are attached, some -CH₂- in the heterocyclic group may be replaced by -O- or -S-,
X² is -O- or -S-,
m1 and m2 are each independently 0 or 1,
* designates a point of attachment to the adjoining -O-.

In a preferred embodiment, the polymer further comprises repeat units of at least one type selected from repeat units having the formula (B2) and repeat units having the formula (B3).

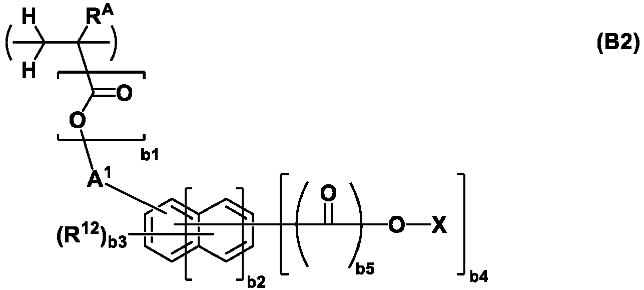

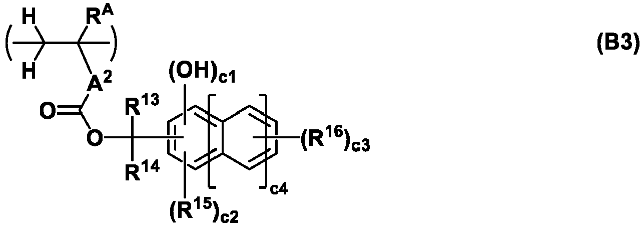

Herein b1 is 0 or 1, b2 is an integer of 0 to 2, b3 is an integer satisfying 0 ≤ b3 ≤ 5+2(b2)-b4, b4 is an integer of 1 to 3, b5 is 0 or 1,
c1 is an integer of 0 to 2, c2 is an integer of 0 to 2, c3 is an integer of 0 to 5, c4 is an integer of 0 to 2,
R^{A} is each independently hydrogen, fluorine, methyl or trifluoromethyl,
A¹ is a single bond or a C₁-C₁₀ saturated hydrocarbylene group in which some -CH₂-may be replaced by -O-,
A² is a single bond, phenylene group, naphthylene group or *-C(=O)-O-A²¹-, A²¹ is a C₁-C₂₀ aliphatic hydrocarbylene group which may contain hydroxy, ether bond, ester bond or lactone ring, or phenylene group or naphthylene group, * designates a point of attachment to the carbon atom in the backbone,
R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R¹³ and R¹⁴ are each independently a C₁-C₁₀ hydrocarbyl group which may contain a heteroatom, R¹³ and R¹⁴ may bond together to form a ring with the carbon atom to which they are attached,
R¹⁵ is each independently fluorine, C₁-C₅ fluorinated alkyl group, or C₁-C₅ fluorinated alkoxy group, and
R¹⁶ is each independently a C₁-C₁₀ hydrocarbyl group which may contain a heteroatom,
X is an acid labile group in case of b4=1, X is hydrogen or an acid labile group, at least one being an acid labile group, in case of b4=2 or 3.

In a preferred embodiment, the polymer further comprises repeat units having the formula (B4).

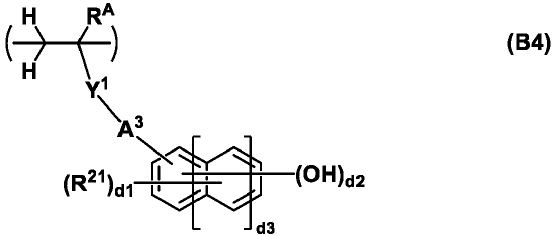

Herein d1 is an integer satisfying 0 ≤ d1 ≤ 5+2(d3)-d2, d2 is an integer of 1 to 3, d3 is an integer of 0 to 2,
R^{A} is hydrogen, fluorine, methyl or trifluoromethyl,
Y¹ is a single bond, *-C(=O)-O- or *-C(=O)-NH-, * designates a point of attachment to the carbon atom in the backbone,
A³ is a single bond or a C₁-C₁₀ saturated hydrocarbylene group in which some -CH₂-may be replaced by -O-, and
R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group.

In a preferred embodiment, the polymer further comprises repeat units of at least one type selected from repeat units having the formula (B5), repeat units having the formula (B6), and repeat units having the formula (B7).

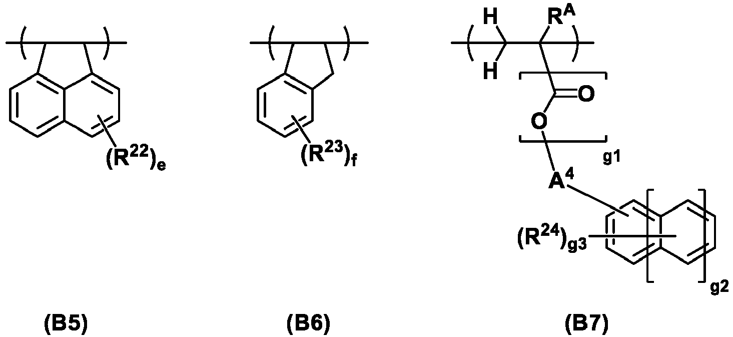

Herein e is an integer of 0 to 6, f is an integer of 0 to 4, g1 is 0 or 1, g2 is an integer of 0 to 2, g3 is an integer of 0 to 5,
R^{A} is hydrogen, fluorine, methyl or trifluoromethyl,
R²² and R²³ are each independently hydroxy, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group,
R²⁴ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group or cyano group, R²⁴ may also be hydroxy in case of g2=1 or 2,
A⁴ is a single bond or a C₁-C₁₀ saturated hydrocarbylene group in which some -CH₂-may be replaced by -O-.

In a preferred embodiment, the polymer further comprises repeat units of at least one type selected from repeat units having the formula (B8), repeat units having the formula (B9), repeat units having the formula (B10), and repeat units having the formula (B11).

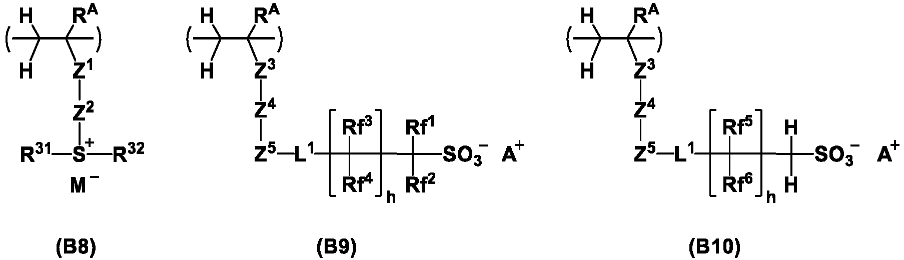

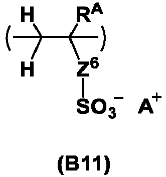

Herein R^{A} is each independently hydrogen, fluorine, methyl or trifluoromethyl,
Z¹ is a single bond or phenylene group,
Z² is *¹-C(=O)-O-Z²¹-, *¹-C(=O)-NH-Z²¹- or *¹-O-Z²¹-, Z²¹ is a C₁-C₆ aliphatic hydrocarbylene group, phenylene group, or divalent group obtained by combining the foregoing, which may contain a carbonyl moiety, ester bond, ether bond or hydroxy moiety, *¹ designates a point of attachment to Z¹,
Z³ is each independently a single bond, phenylene group, naphthylene group, or *²-C(=O)-O-Z³¹-, Z³¹ is a C₁-C₁₀ aliphatic hydrocarbylene group, phenylene group, or naphthylene group, the aliphatic hydrocarbylene group may contain a hydroxy moiety, ether bond, ester bond or lactone ring, *² designates a point of attachment to the carbon atom in the backbone,
Z⁴ is each independently a single bond, *³-Z⁴¹-C(=O)-O-, *³-C(=O)-NH-Z⁴¹- or *³-O-Z⁴¹-, Z⁴¹ is a C₁-C₂₀ hydrocarbylene group which may contain a heteroatom, *³ designates a point of attachment to Z³,
Z⁵ is each independently a single bond, *⁴-Z⁵¹-C(=O)-O-, *⁴-C(=O)-NH-Z⁵¹- or *⁴-O-Z⁵¹-, Z⁵¹ is a C₁-C₂₀ hydrocarbylene group which may contain a heteroatom, *⁴ designates a point of attachment to Z⁴,
Z⁶ is a single bond, methylene, ethylene, phenylene, fluorinated phenylene, trifluoromethyl-substituted phenylene, *²-C(=O)-O-Z⁶¹-, *²-C(=O)-N(H)-Z⁶¹-, or *²-O-Z⁶¹-, Z⁶¹ is a C₁-C₆ aliphatic hydrocarbylene group, phenylene group, fluorinated phenylene group, or trifluoromethyl-substituted phenylene group, which may contain a carbonyl moiety, ester bond, ether bond or hydroxy moiety, *² designates a point of attachment to the carbon atom in the backbone,
R³¹ and R³² are each independently a C₁-C₂₀ hydrocarbyl group which may contain a heteroatom, R³¹ and R³² may bond together to form a ring with the sulfur atom to which they are attached,
L¹ is a single bond, ether bond, ester bond, carbonyl group, sulfonate ester bond, carbonate bond or carbamate bond,
Rf¹ and Rf² are each independently fluorine or a C₁-C₆ fluorinated saturated hydrocarbyl group,
Rf³ and Rf⁴ are each independently hydrogen, fluorine, or a C₁-C₆ fluorinated saturated hydrocarbyl group,
Rf⁵ and Rf⁶ are each independently hydrogen, fluorine, or a C₁-C₆ fluorinated saturated hydrocarbyl group, excluding that all Rf⁵ and Rf⁶ are hydrogen at the same time,
M⁻ is a non-nucleophilic counter ion,
A⁺ is an onium cation, and
h is an integer of 0 to 3.

The resist composition may further comprise an organic solvent.

In a preferred embodiment, the resist composition further comprises a fluorinated polymer comprising repeat units of at least one type selected from repeat units having the formula (D1), repeat units having the formula (D2), repeat units having the formula (D3), and repeat units having the formula (D4) and optionally repeat units of at least one type selected from repeat units having the formula (D5) and repeat units having the formula (D6).

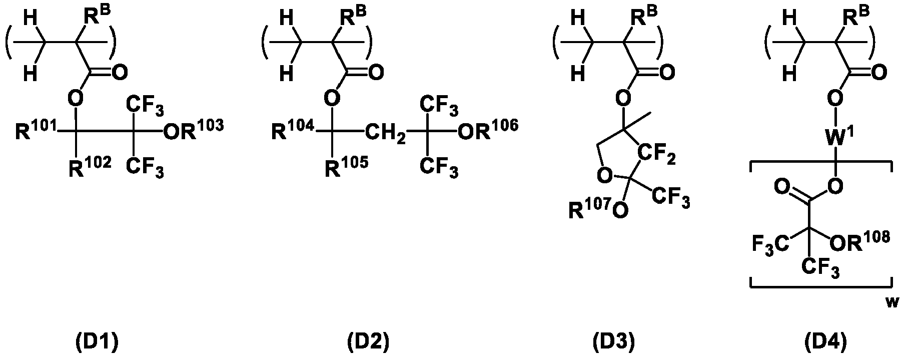

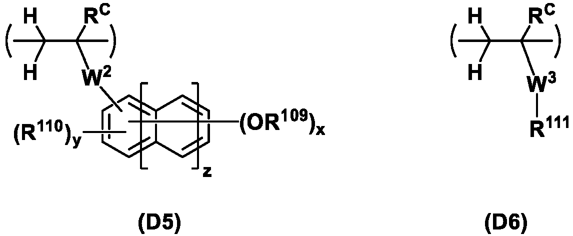

Herein x is an integer of 1 to 3, y is an integer satisfying 0 ≤ y ≤ 5+2z-x, z is 0 or 1, w is an integer of 1 to 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³ , R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen atom is substituted by fluorine and in which some -CH₂- may be replaced by an ester bond or ether bond,
W¹ is a C₁-C₂₀ (w+1)-valent hydrocarbon group or C₁-C₂₀ (w+1)-valent fluorinated hydrocarbon group,
W² is a single bond, *-C(=O)-O- or *-C(=O)-NH-,
W³ is a single bond, -O-, *-C(=O)-O-W³¹-W³²- or *-C(=O)-NH-W³¹-W³²-, W³¹ is a single bond or a C₁-C₁₀ saturated hydrocarbylene group, W³² is a single bond, ester bond, ether bond or sulfonamide bond,
* designates a point of attachment to the carbon atom in the backbone.

The resist composition may further comprise a quencher and/or a photoacid generator other than the photoacid generator having formula (A).

In another aspect, the invention provides a resist pattern forming process comprising the steps of:
applying the chemically amplified positive resist composition defined herein onto a substrate to form a resist film thereon,
exposing the resist film to high-energy radiation, and
developing the exposed resist film in an alkaline developer.

Typically, the high-energy radiation is EUV or EB.

In a preferred embodiment, the substrate has the outermost surface of a material containing at least one element selected from chromium, silicon, tantalum, molybdenum, cobalt, nickel, tungsten, and tin.

The substrate is often a mask blank of transmission or reflection type.

Also contemplated herein is a mask blank of transmission or reflection type which is coated with the chemically amplified positive resist composition defined above.

### ADVANTAGEOUS EFFECTS OF INVENTION

The chemically amplified positive resist composition can be processed to form a resist pattern of good profile with a high resolution, reduced LER, and improved rectangularity while controlling the influence of develop loading. It is thus suited as a resist composition for forming a resist film which is sensitive to high-energy radiation such as UV, deep UV, EB, EUV, X-ray, γ-ray or synchrotron radiation and useful in the processing of semiconductor substrates and photomask blanks. The pattern forming process using the positive resist composition can form a resist pattern with a high resolution, reduced LER, etch resistance, controlled influence of develop loading and few development residue defects and is thus best suited in the micropatterning technology, typically EUV or EB lithography.

### BRIED DESCRIPTION OF DRAWINGS

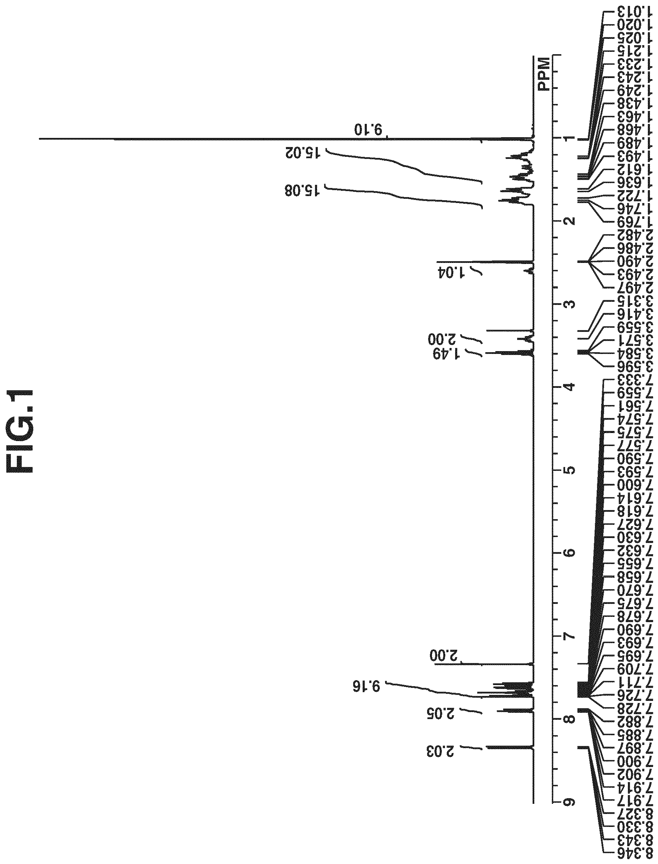

The only figure, FIG. 1 is a diagram showing the ¹H-NMR spectrum of photoacid generator PAG-1 in Synthesis Example 1.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. The terms "group" and "moiety" are interchangeable. In chemical formulae, Me stands for methyl, Ac stands for acetyl, and the broken line (---) and asterisk (*) designate a point of attachment or valence bond.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness

It is understood that for some structures represented by chemical formulae, there can exist enantiomers and diastereomers because of the presence of asymmetric carbon atoms. In such a case, a single formula collectively represents all such isomers. The isomers may be used alone or in admixture.

The high-energy radiation encompasses UV, deep UV, EB, EUV, X-ray, γ-ray and synchrotron radiation.

### Positive resist composition

One embodiment of the invention is a chemically amplified positive resist composition comprising (A) a photoacid generator and (B) a base polymer.

### (A) Photoacid generator

Component (A) is a photoacid generator capable of generating an acid upon receipt of high-energy radiation, having the formula (A).

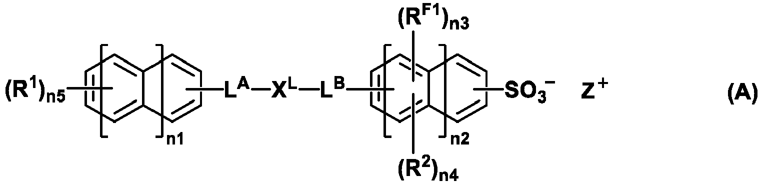

In formula (A), n1 and n2 are each independently an integer of 0 to 2, n3 is an integer of 1 to 4 (1 ≤ n3 ≤ 4) in case of n2=0, an integer of 1 to 6 (1 ≤ n3 ≤ 6) in case of n2=1, and an integer of 1 to 8 (1 ≤ n3 ≤ 8) in case of n2=2.

In formula (A), n4 is an integer of 0 to 3 in case of n2=0, an integer of 0 to 5 in case of n2=1, and an integer of 0 to 7 in case of n2=2. Notably, n3+n4 is an integer of 1 to 4 in case of n2=0, an integer of 1 to 6 in case of n2=1, and an integer of 1 to 8 in case of n2=2.

In formula (A), n5 is an integer of 1 to 5 in case of n1=0, an integer of 1 to 7 in case of n1=1, and an integer of 1 to 9 in case of n1=2.

In formula (A), R¹ is iodine, or a C₃-C₂₀ branched or cyclic hydrocarbyl group which may contain a heteroatom, at least one R¹ is attached to the carbon atom adjoining the carbon atom to which L^{A} is attached. Examples of the hydrocarbyl group include, but are not limited to, branched alkyl groups such as isopropyl, sec-butyl, tert-butyl, tert-pentyl, and 2-ethylhexyl; C₃-C₂₀ aliphatic cyclic hydrocarbon groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, oxanorbornyl, tricyclo[5.2.1.0^{2,6}]decyl, and adamantyl; aryl groups such as phenyl, naphthyl and anthracenyl; and groups obtained by combining the foregoing. In the hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy, cyano, halogen, carbonyl, ether bond, ester bond, sulfonate ester bond, carbonate bond, lactone ring, sultone ring, carboxylic anhydride (-C(=O)-O-C(=O)-) or haloalkyl moiety. Suitable halogen atoms include fluorine, chlorine, bromine and iodine, with fluorine and iodine being preferred. A plurality of R¹ may be identical or different when n5 is 2 or more.

Also, a plurality of R¹ may bond together to form a ring with the carbon atoms to which they are attached when n5 is 2 or more. The ring is preferably a 5- to 8-membered ring.

Examples of the structure in formula (A) that R¹ forms with the aromatic ring are shown below, but not limited thereto. The broken line designates a point of attachment to L^{A}.

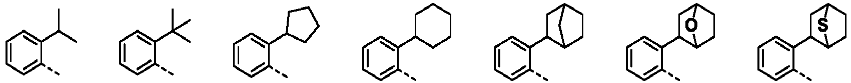

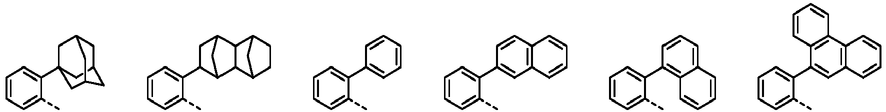

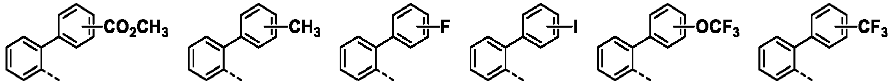

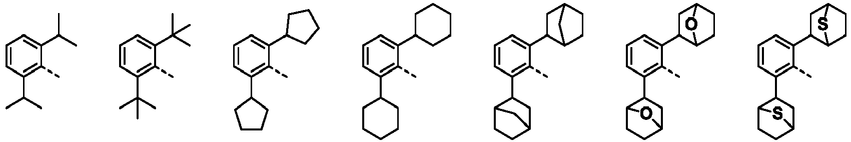

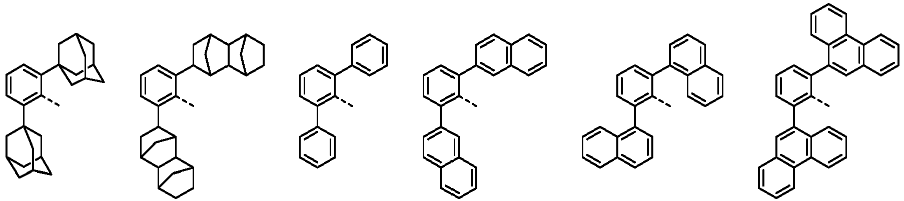

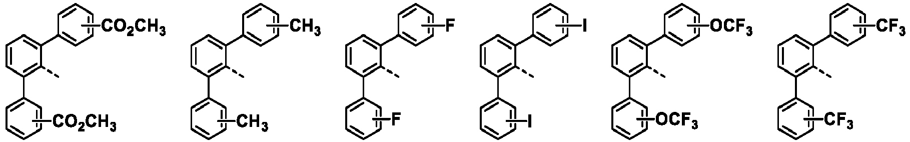

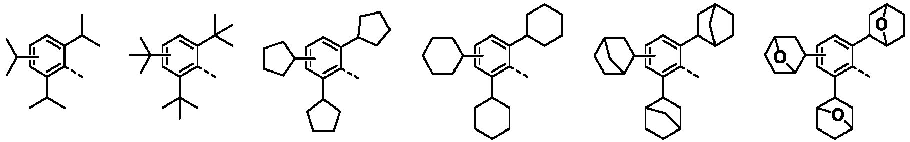

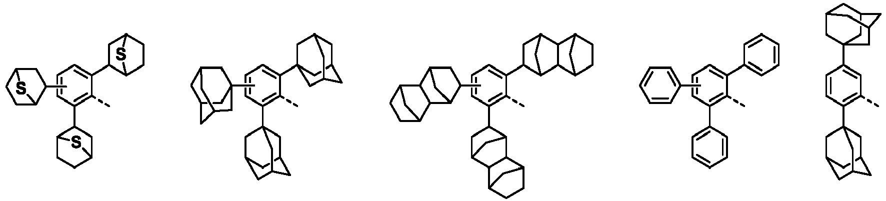

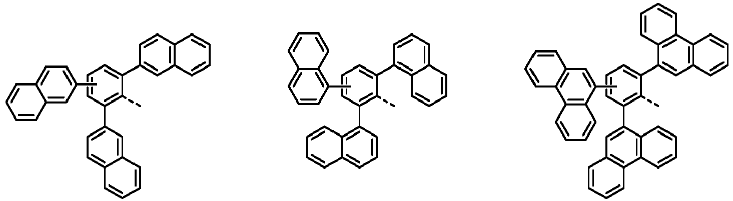

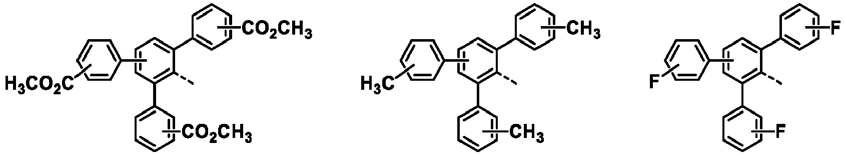

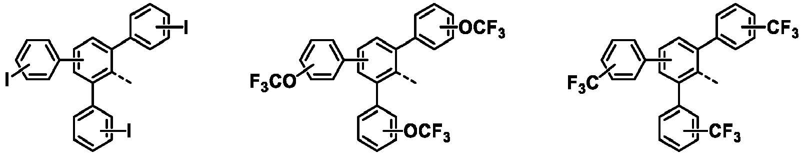

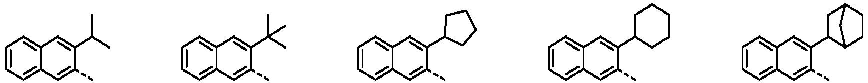

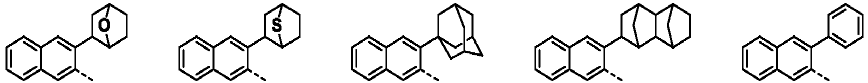

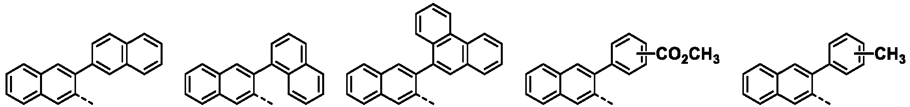

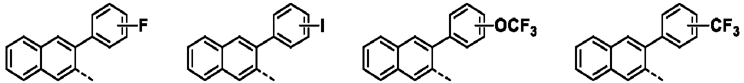

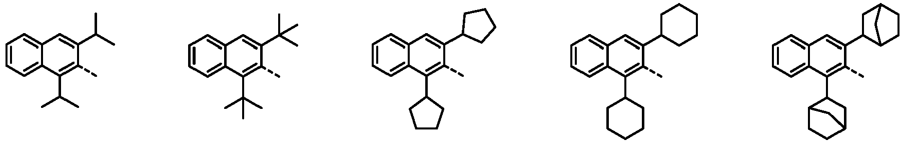

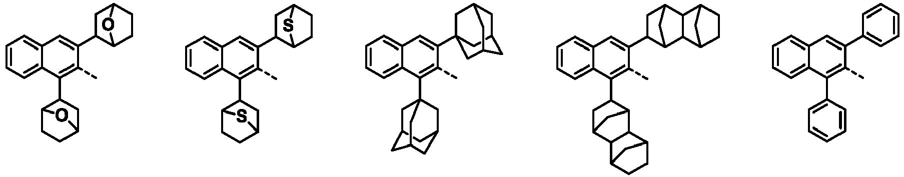

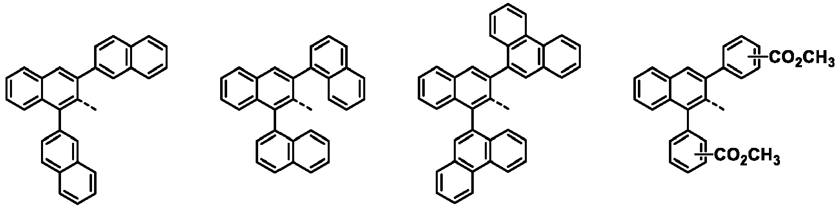

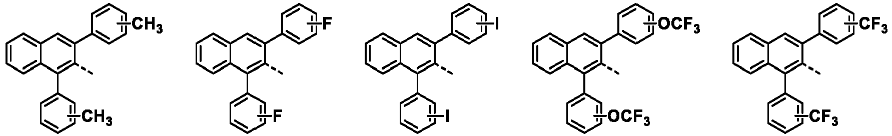

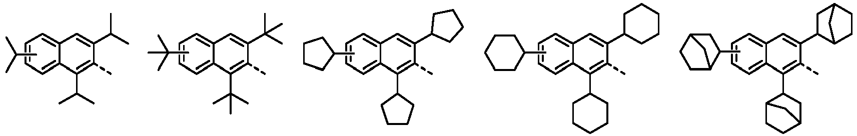

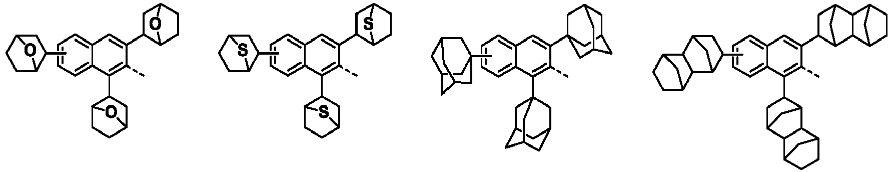

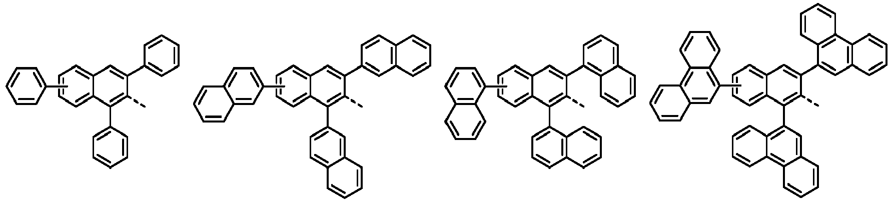

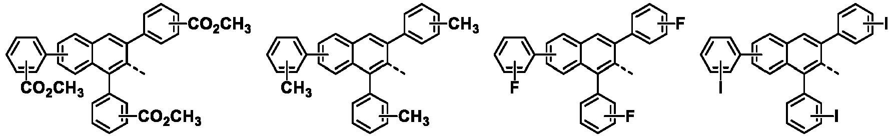

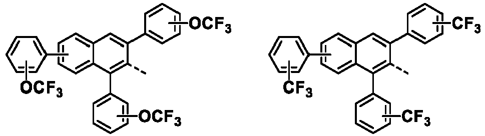

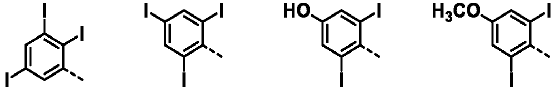

In formula (A), R² is each independently a C₁-C₂₀ hydrocarbyl group which may contain a heteroatom. The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, tert-pentyl, n-hexyl, n-octyl, 2-ethylhexyl, n-nonyl and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; and C₆-C₂₀ aryl groups such as phenyl, naphthyl and anthracenyl. In the hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy, cyano, halogen, carbonyl, ether bond, ester bond, sulfonate ester bond, carbonate bond, lactone ring, sultone ring, carboxylic anhydride (-C(=O)-O-C(=O)-) or haloalkyl moiety. Suitable halogen atoms include fluorine, chlorine, bromine and iodine, with fluorine and iodine being preferred. A plurality of R² may be identical or different when n4 is 2 or more.

Also, a plurality of R² may bond together to form a ring with the carbon atoms to which they are attached when n4 is 2 or more. The ring is preferably a 5- to 8-membered ring.

In formula (A), R^{F1} is fluorine, a C₁-C₆ fluorinated alkyl group, C₁-C₆ fluorinated alkoxy group, or C₁-C₆ fluorinated thioalkoxy group. R^{F1} is preferably fluorine, trifluoromethyl, difluoromethyl, trifluoromethoxy, difluoromethoxy, trifluoromethylthio or difluoromethylthio, more preferably fluorine, trifluoromethyl or trifluoromethoxy. The inclusion of fluorine enhances the strength of the generated acid, allowing for smooth progress of deprotection reaction. A plurality of R^{F1} may be identical or different when n3 is 2 or more.

In formula (A), L^{A} and L^{B} are each independently a single bond, ether bond, ester bond, amide bond, sulfonate ester bond, carbonate bond or carbamate bond. Inter alia, an ether bond, ester bond, and sulfonate ester bond are preferred, with an ether bond and sulfonate ester bond being more preferred.

In formula (A), X^{L} is a single bond or C₁-C₄₀ hydrocarbylene group which may contain a heteroatom. The hydrocarbylene group may be straight, branched or cyclic and examples thereof include alkanediyl groups and cyclic saturated hydrocarbylene groups. Suitable heteroatoms include oxygen, nitrogen and sulfur.

Examples of the optionally heteroatom-containing C₁-C₄₀ hydrocarbylene group X^{L} are shown below, but not limited thereto. Herein, * designates a point of attachment to L^{A} or L^{B}.

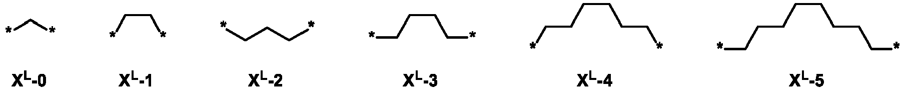

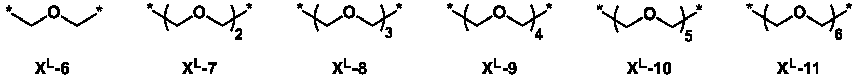

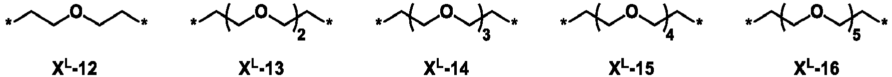

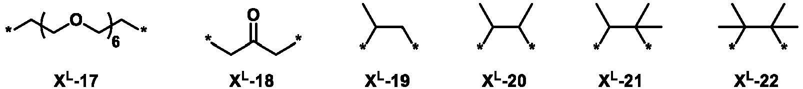

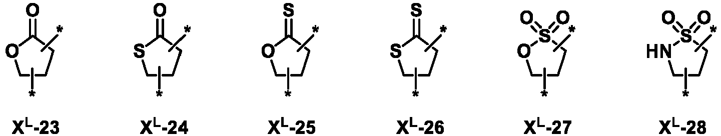

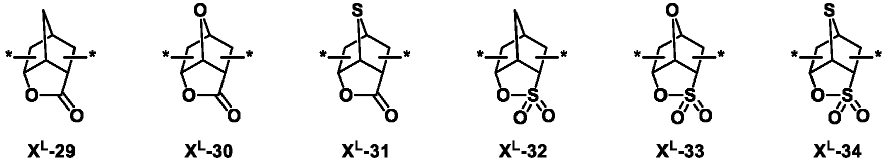

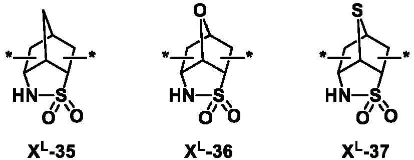

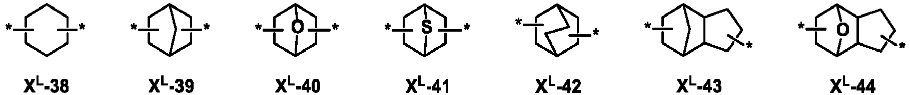

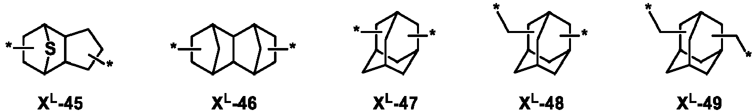

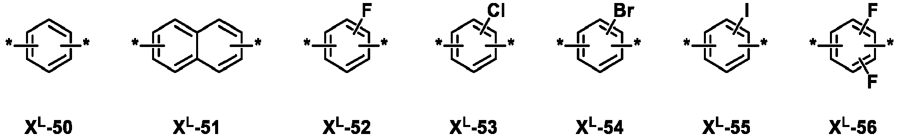

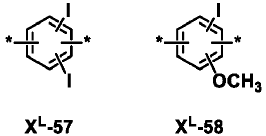

Of these, X^{L}-0 to X^{L}-22 and X^{L}-47 to X^{L}-58 are preferred.

Of the photoacid generators having formula (A), those having the formula (A1) are preferred. 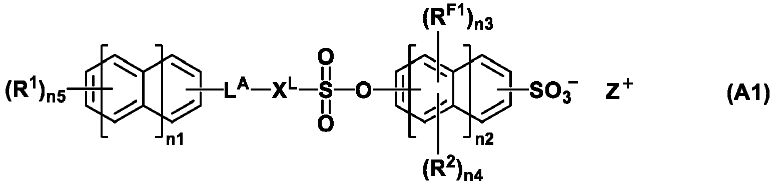 Herein n1 to n5, R¹, R², R^{F1}, L^{A}, X^{L} and Z⁺ are as defined above.

Examples of the anion in the photoacid generators having formula (A) are shown below, but not limited thereto.

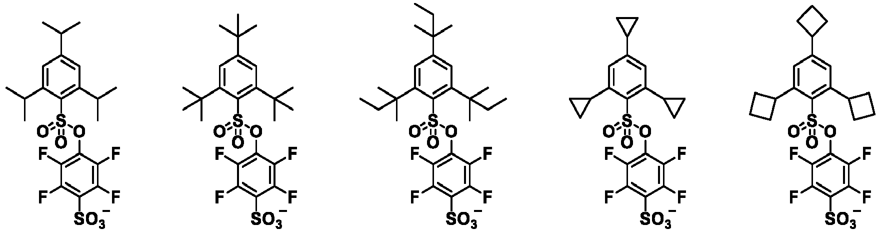

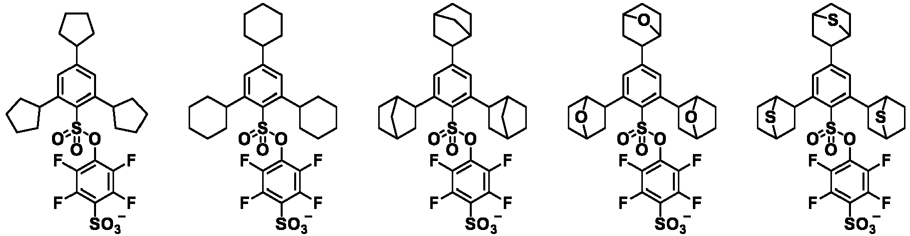

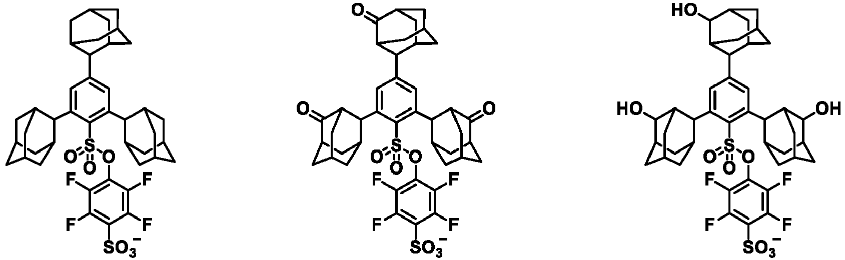

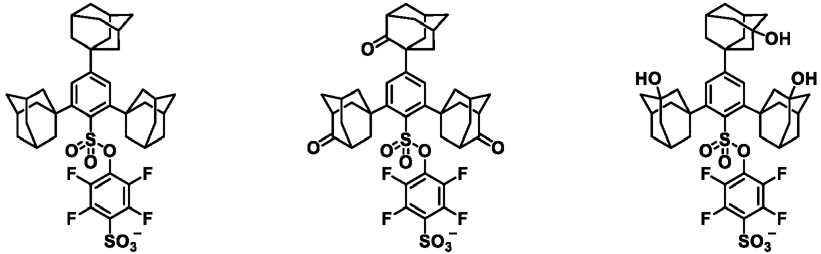

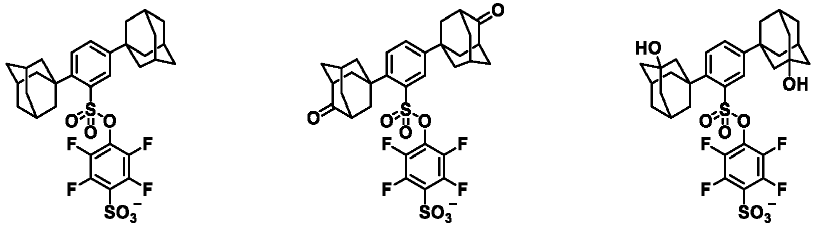

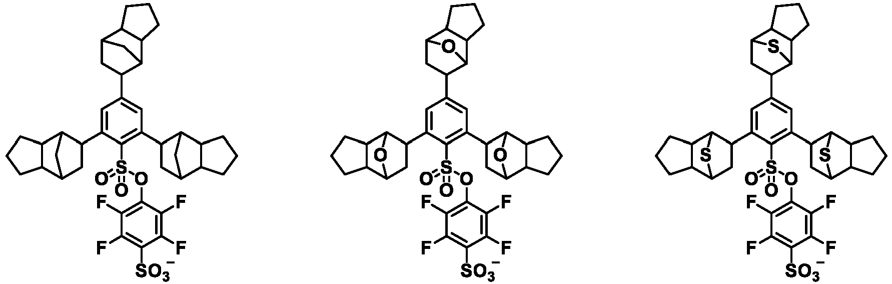

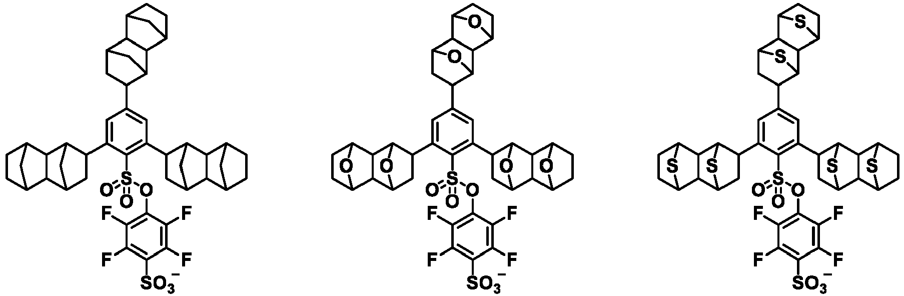

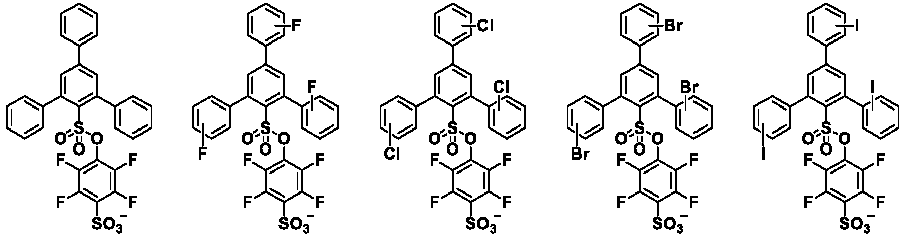

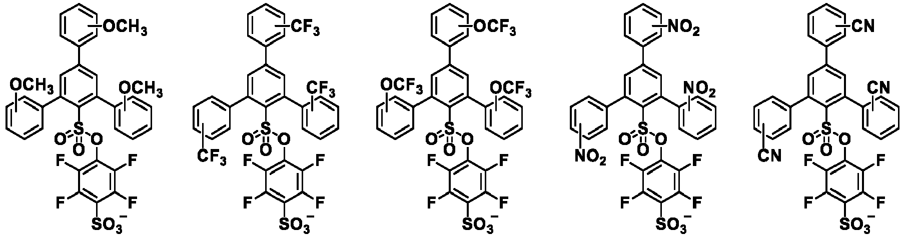

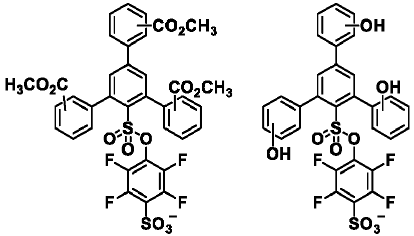

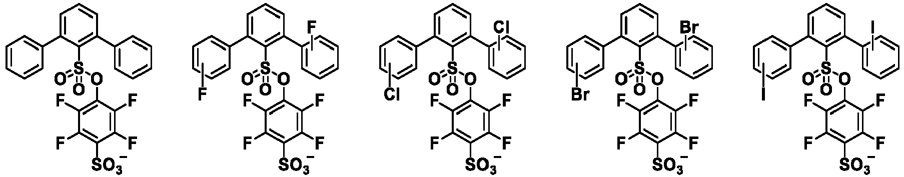

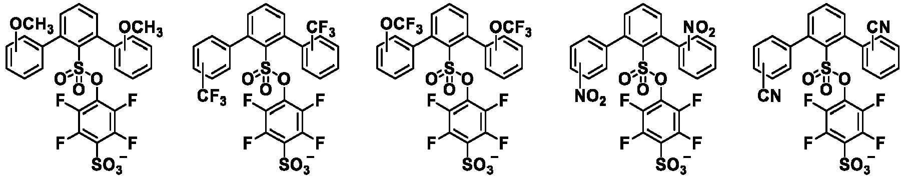

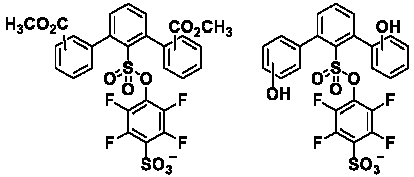

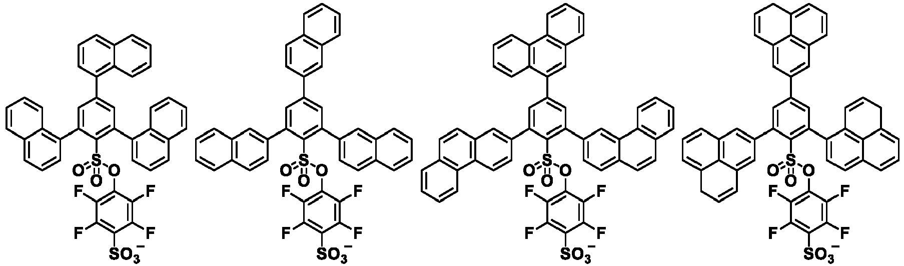

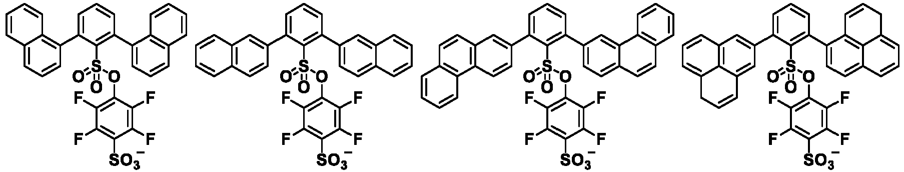

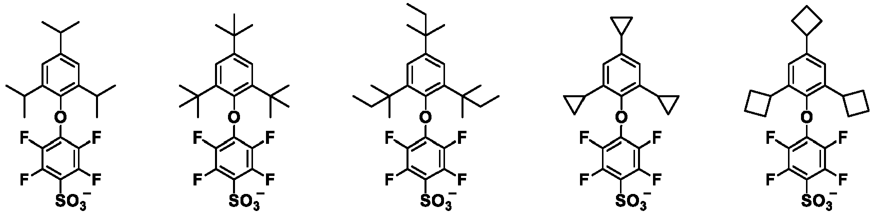

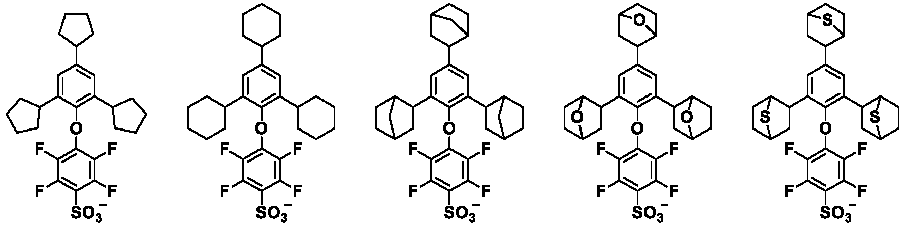

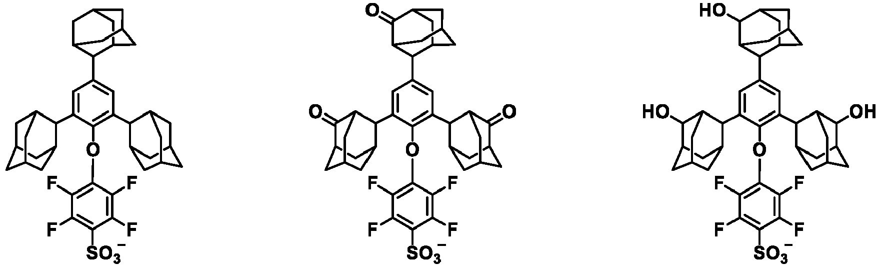

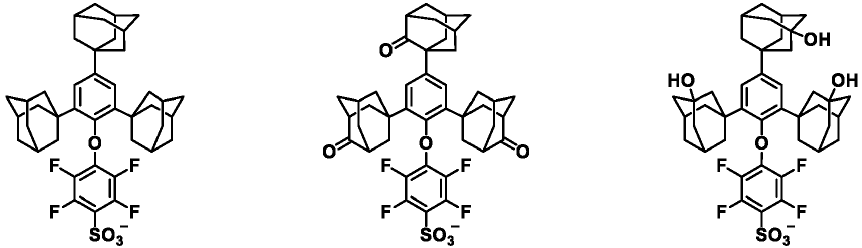

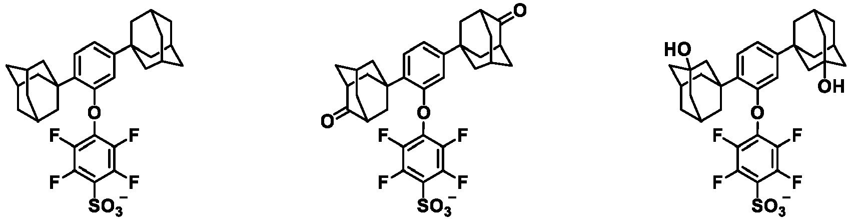

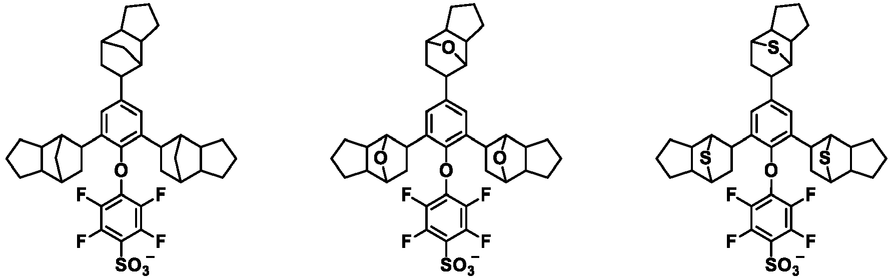

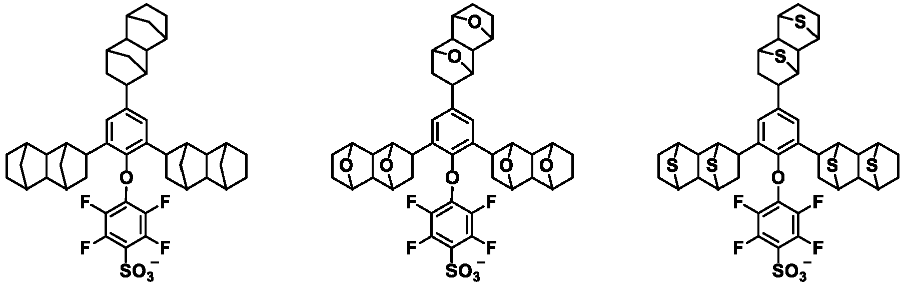

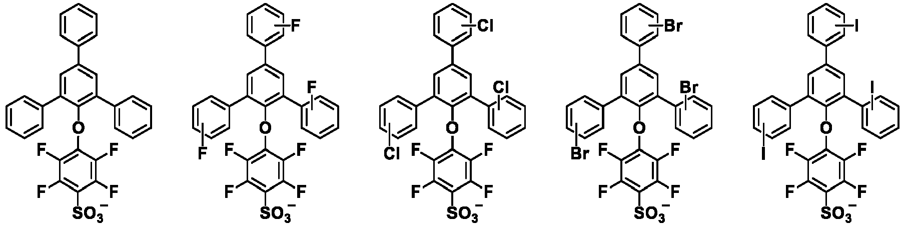

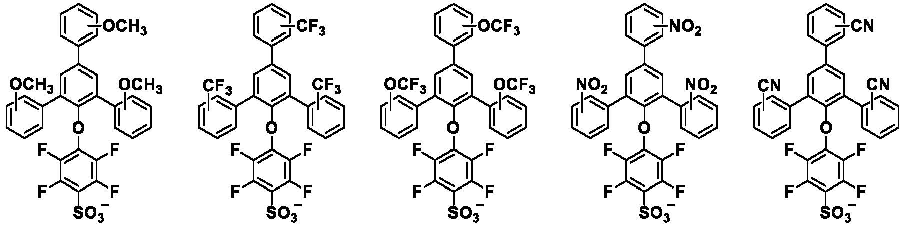

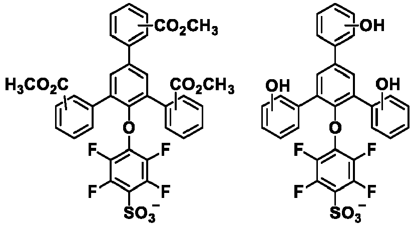

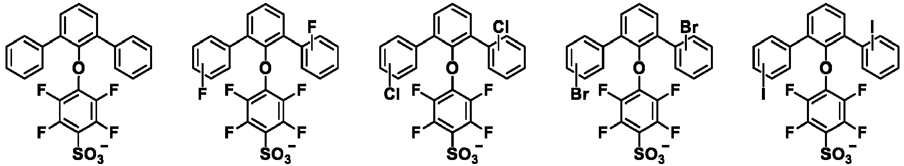

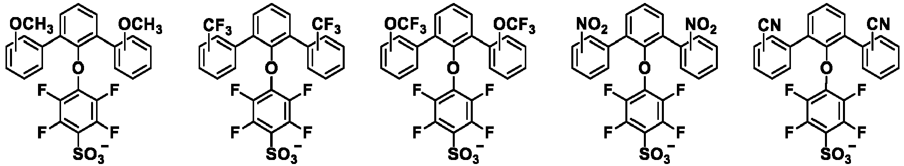

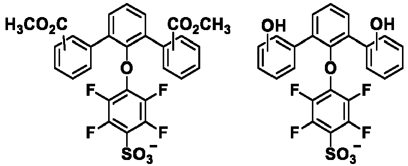

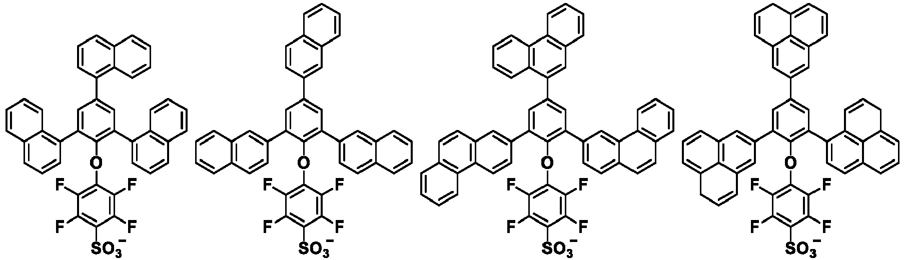

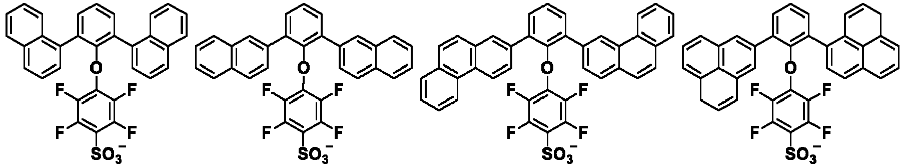

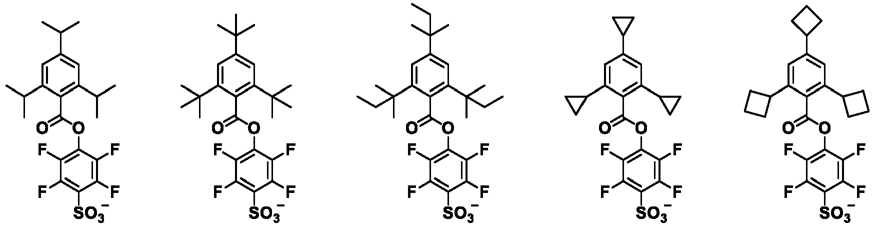

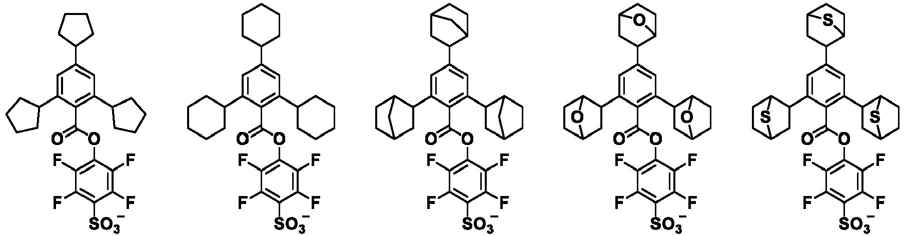

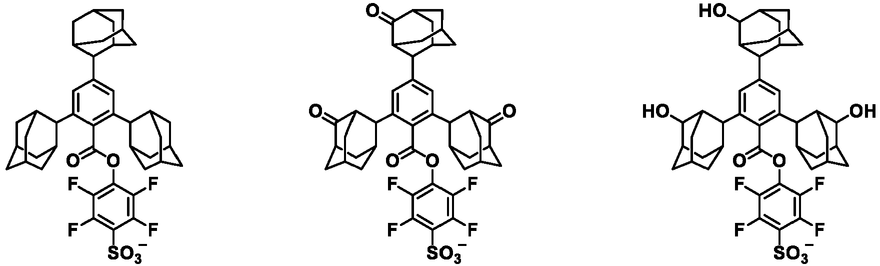

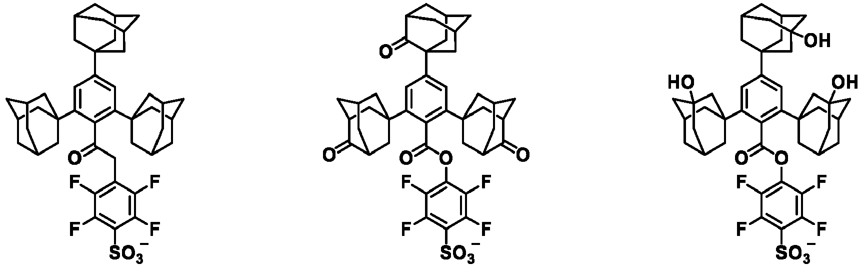

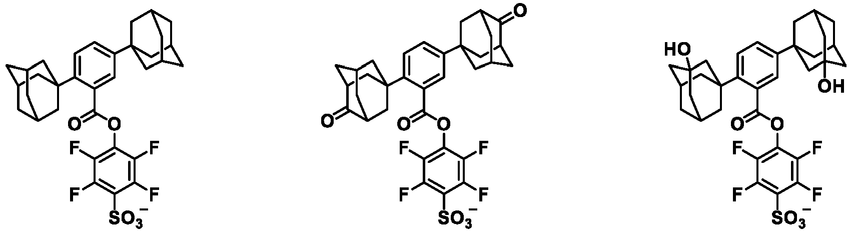

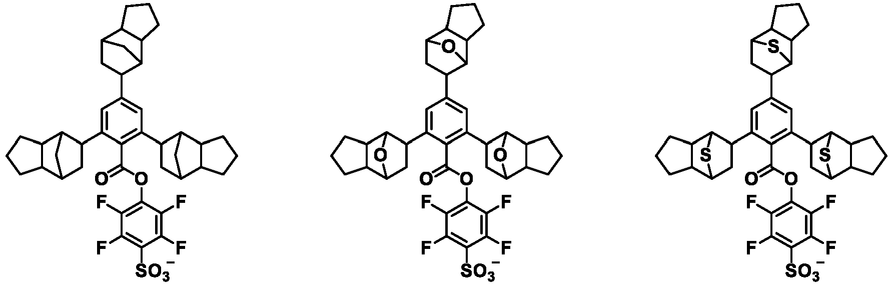

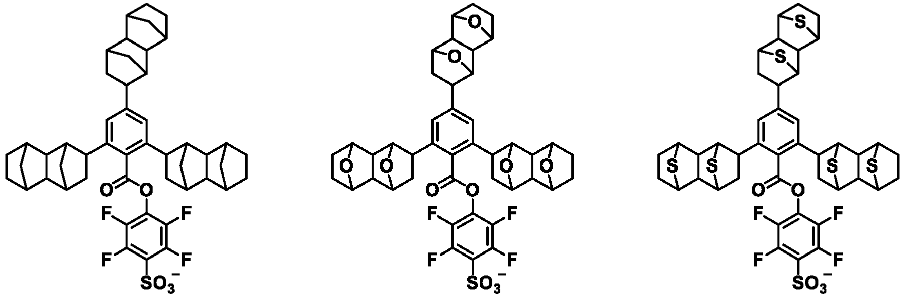

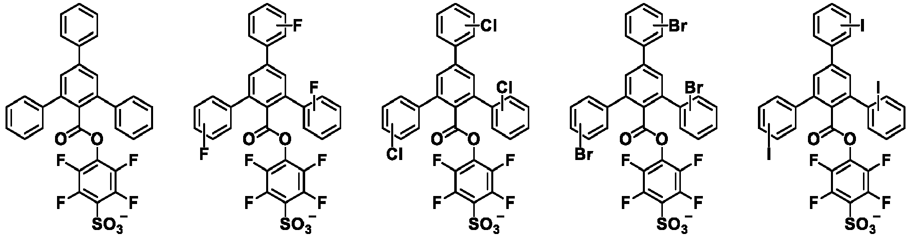

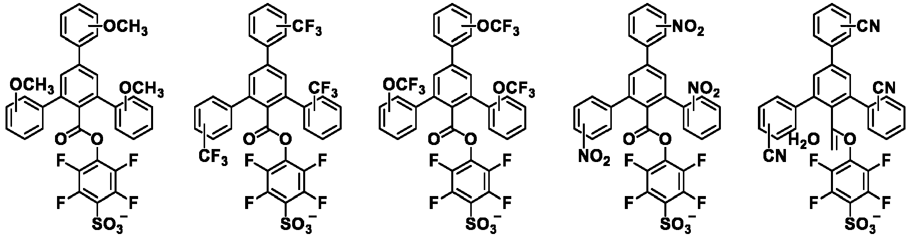

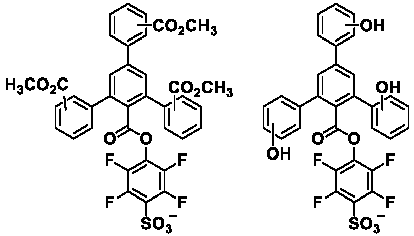

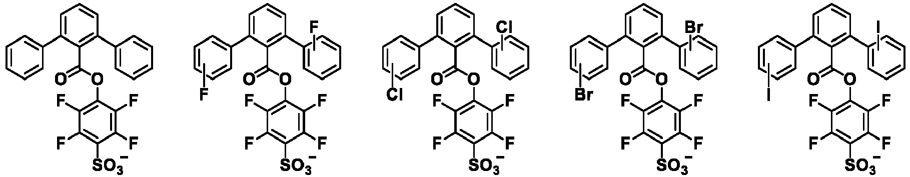

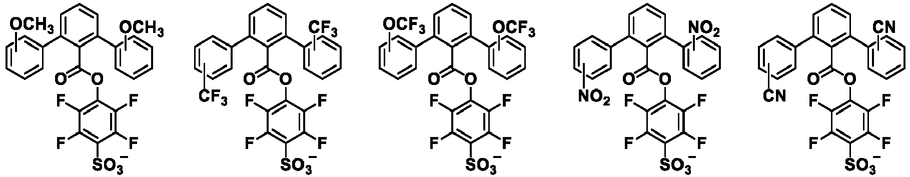

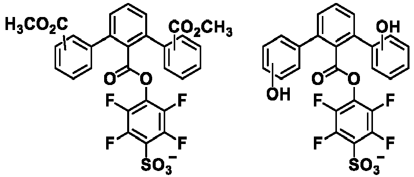

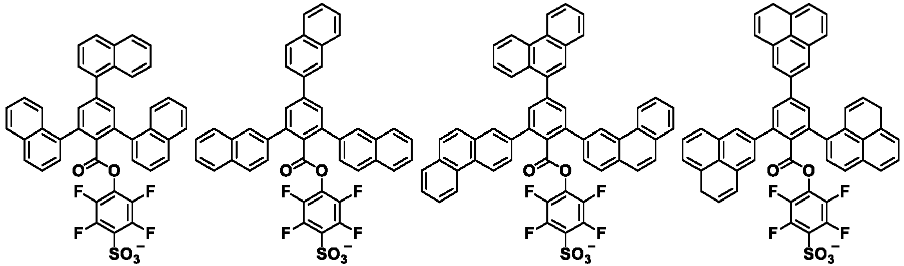

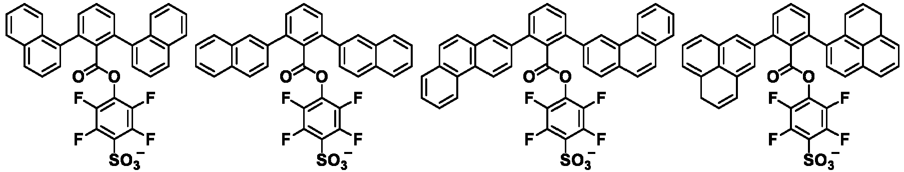

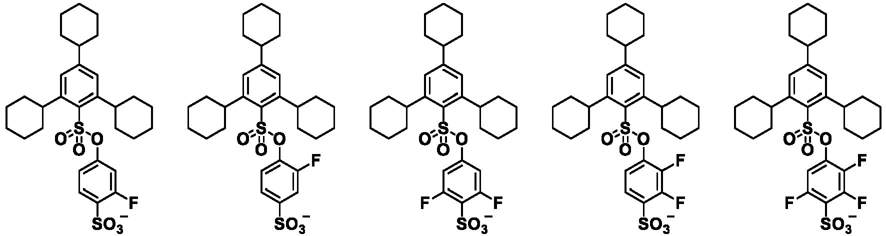

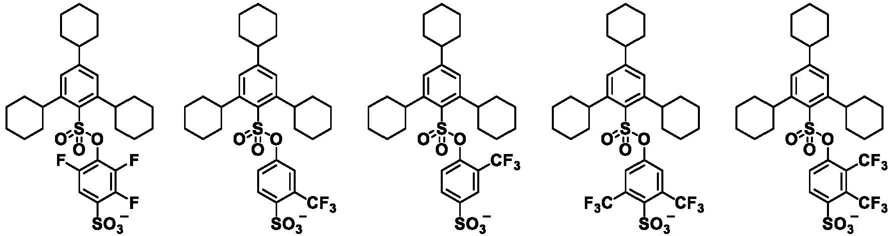

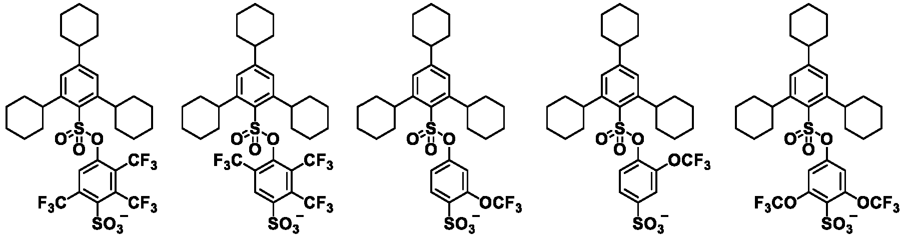

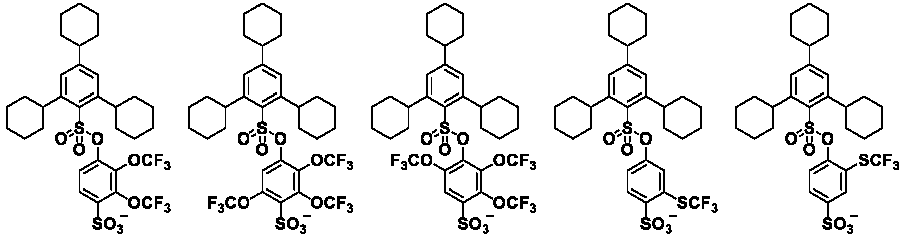

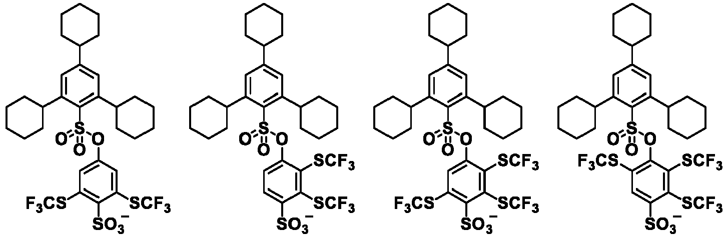

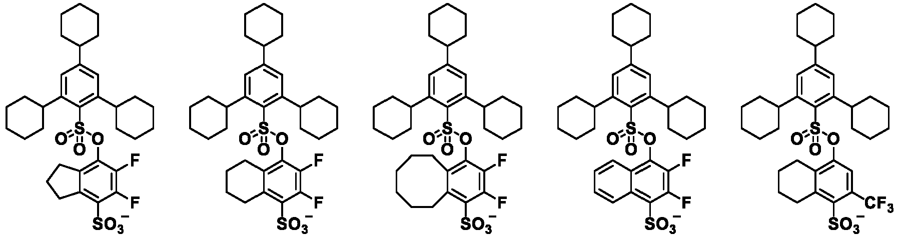

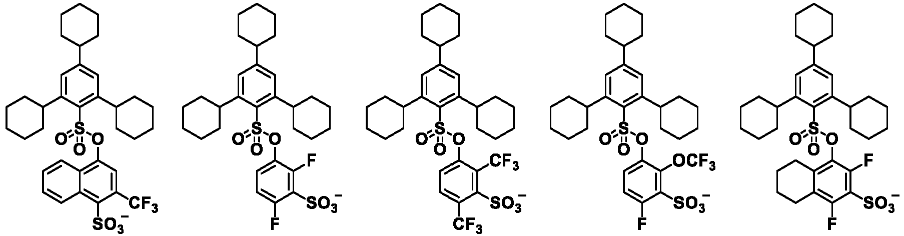

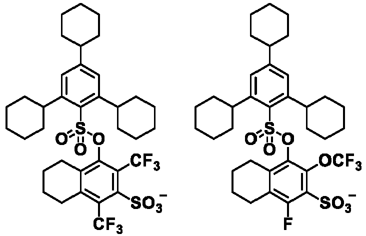

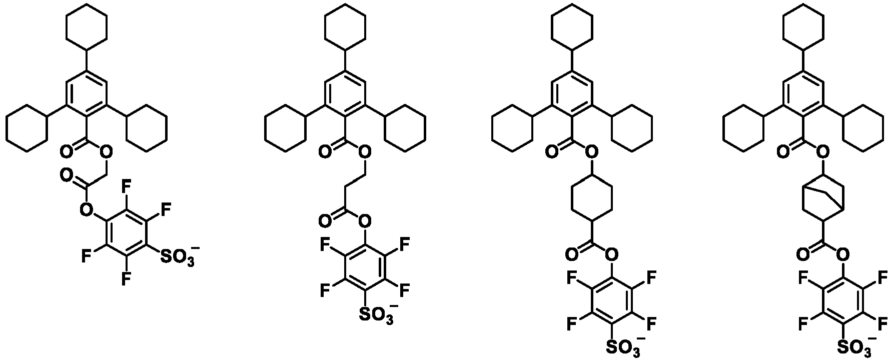

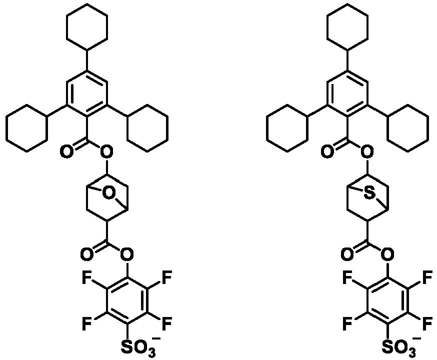

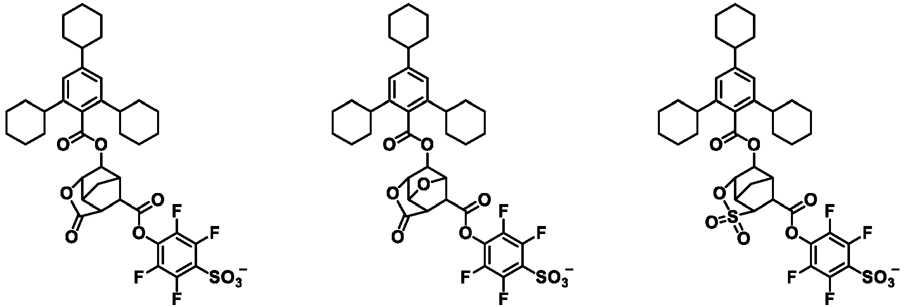

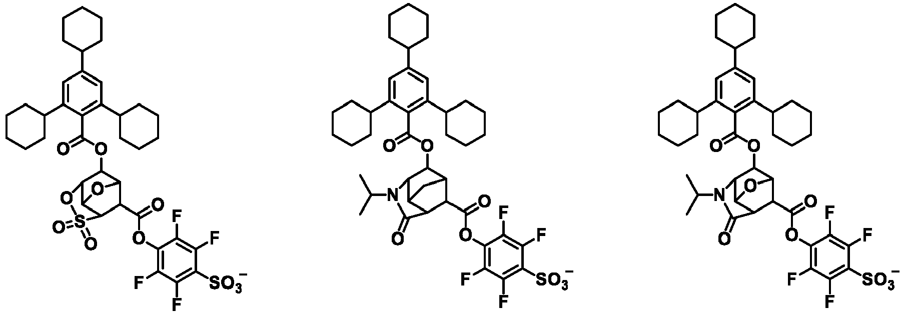

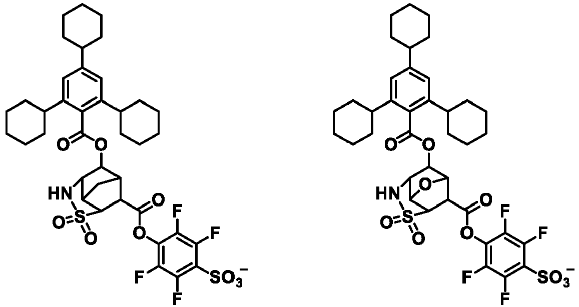

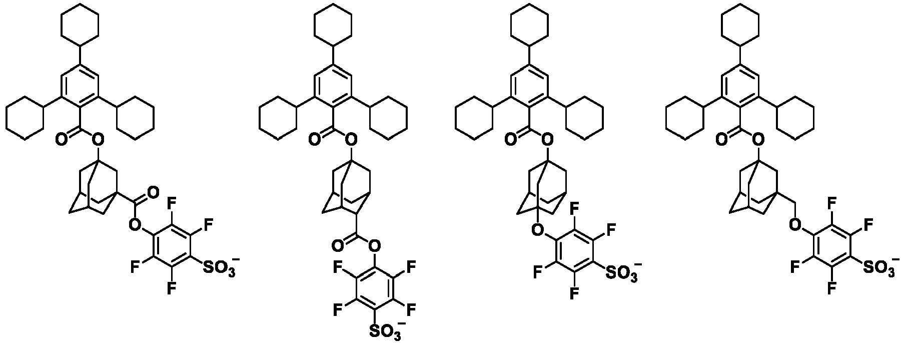

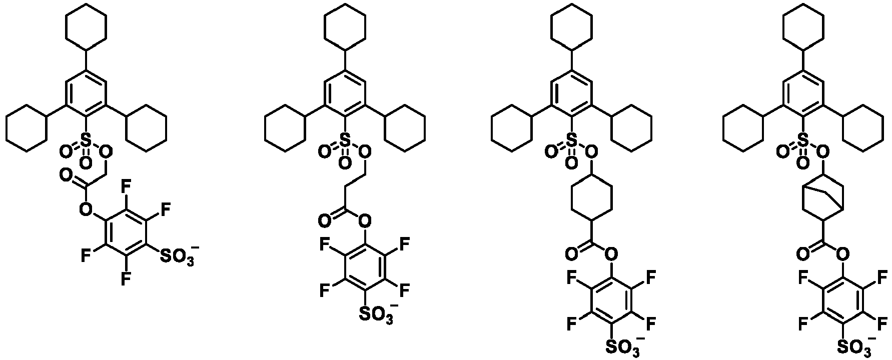

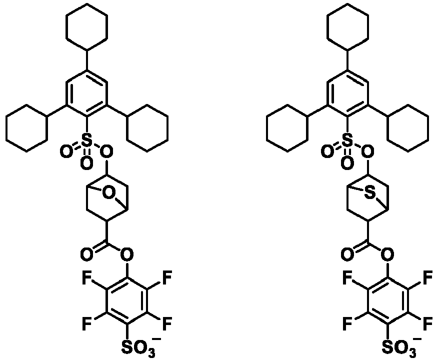

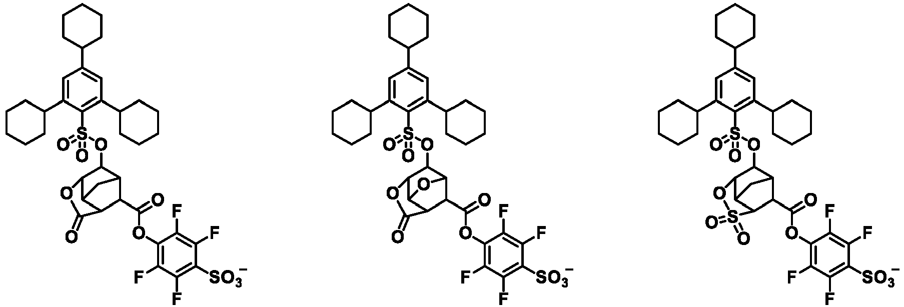

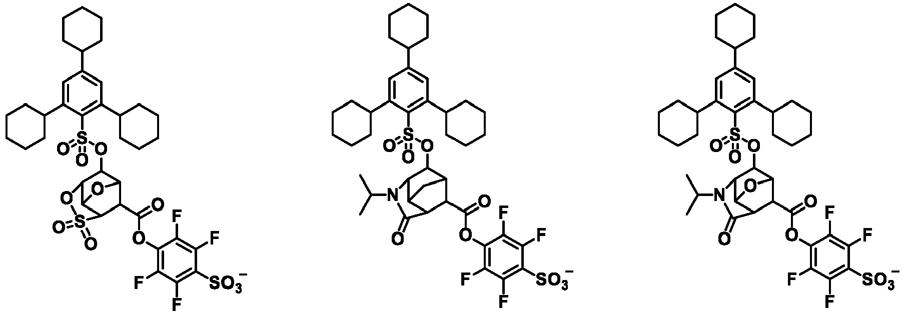

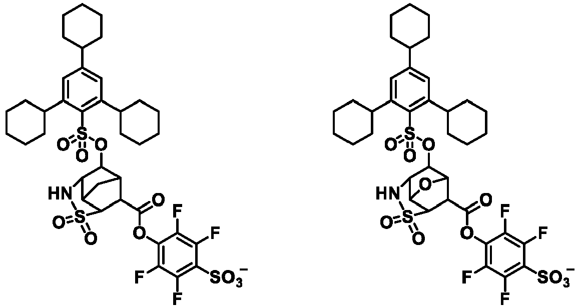

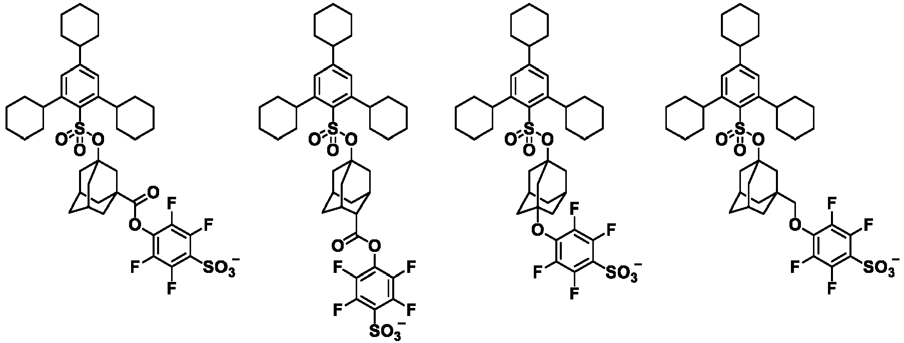

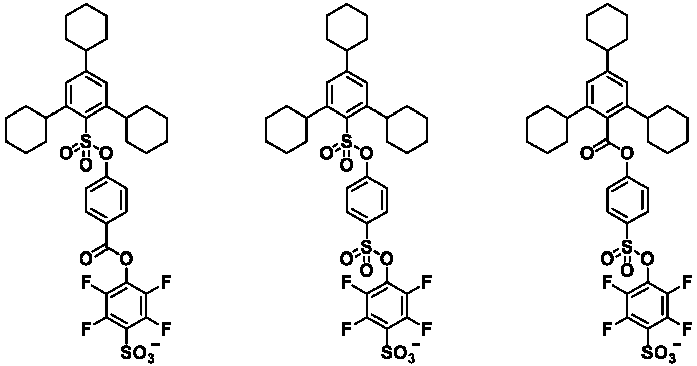

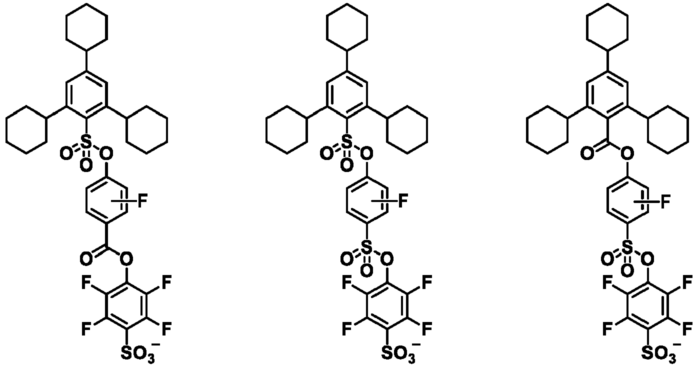

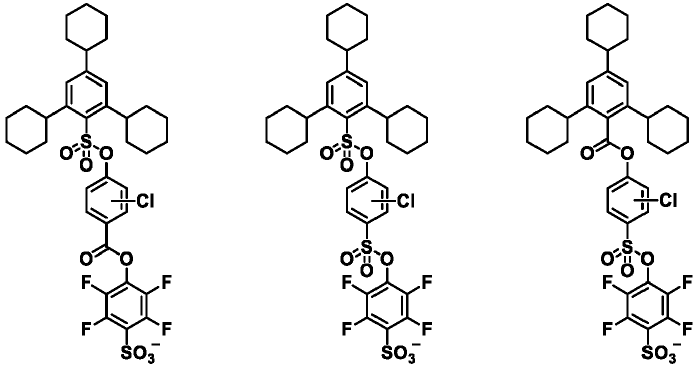

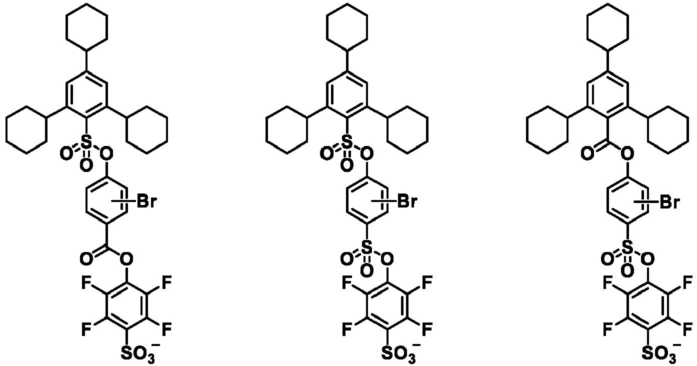

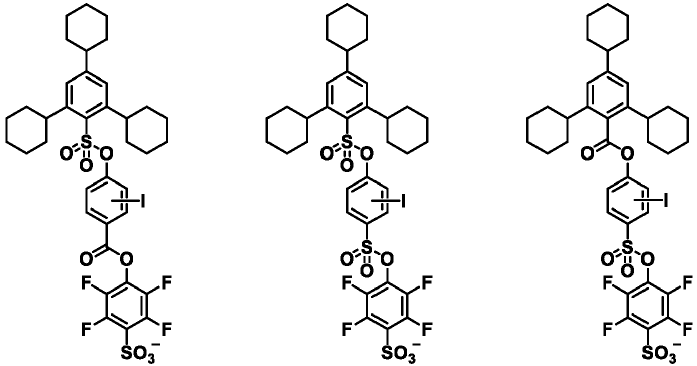

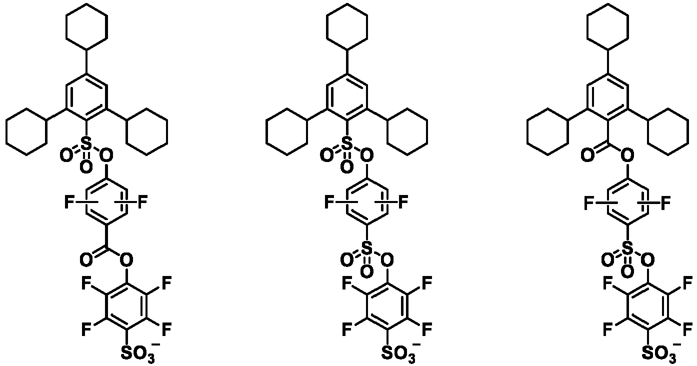

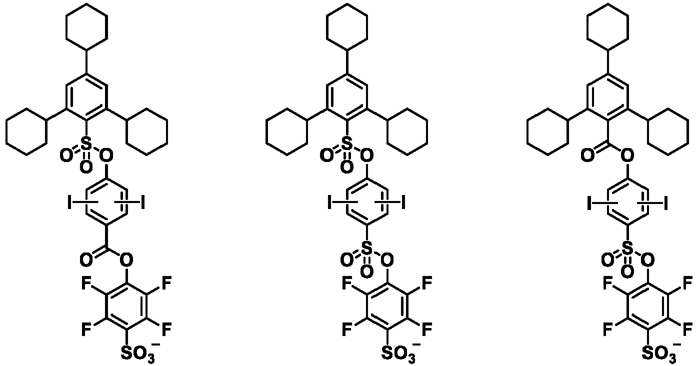

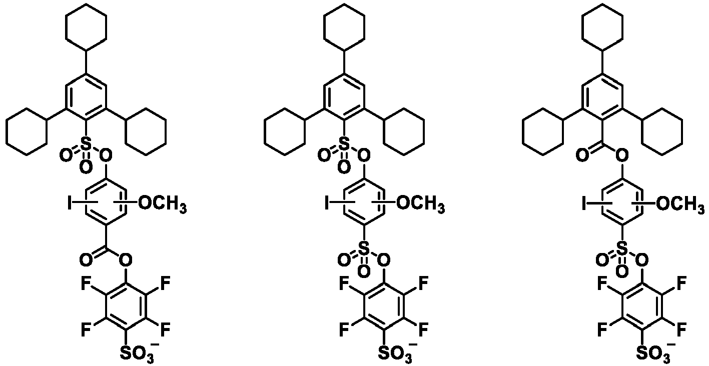

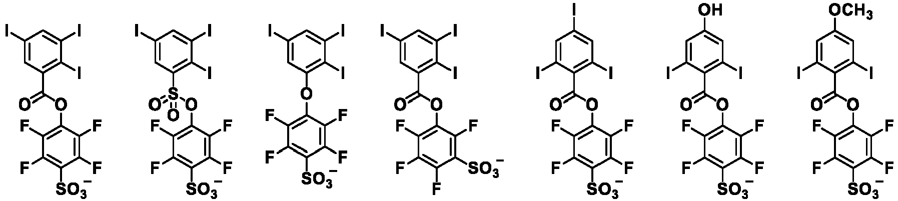

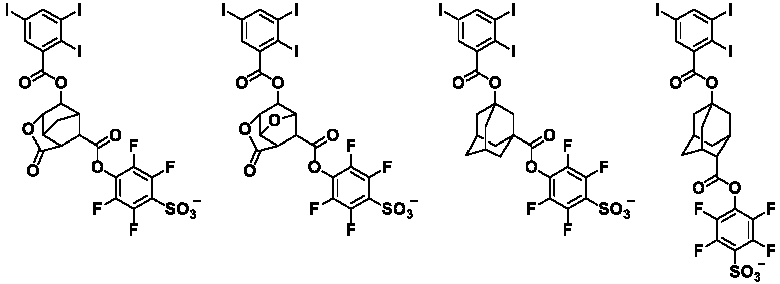

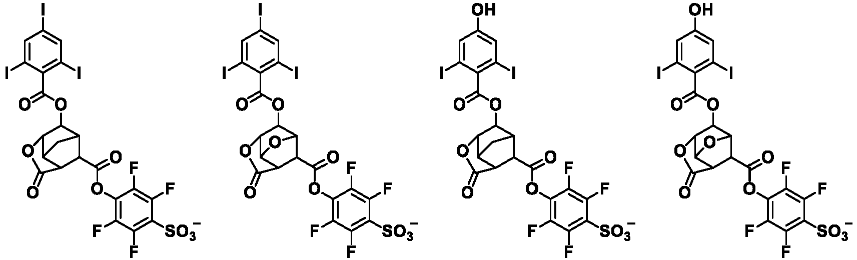

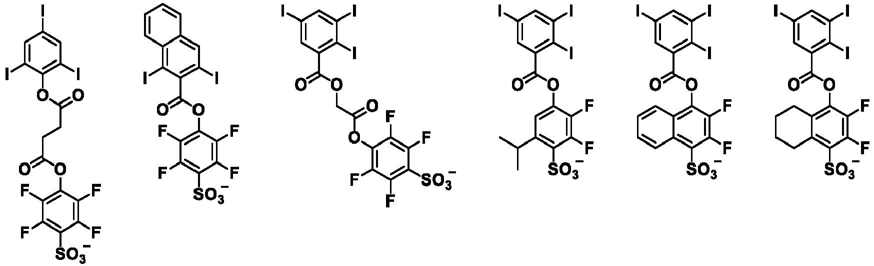

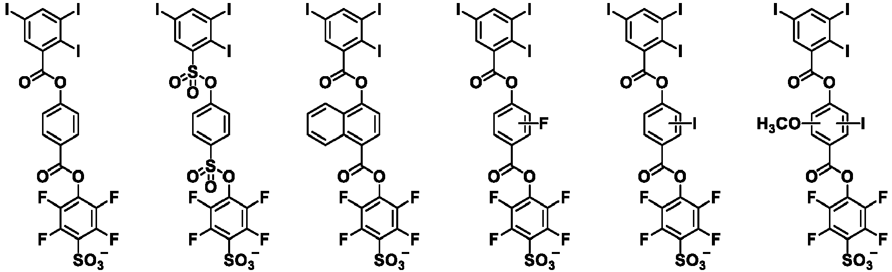

In formula (A), Z⁺ is an onium cation, preferably a sulfonium cation having the formula (cation-1) or iodonium cation having the formula (cation-2).

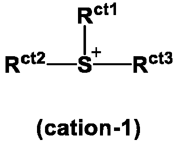

**R^{ct4}-I⁺-R^{ct5}** **(cation-2)**

In formulae (cation-1) and (cation-2), R^{ct1} to R^{ct5} are each independently halogen or a C₁-C₃₀ hydrocarbyl group which may contain a heteroatom. Suitable halogen atoms include fluorine, chlorine, bromine and iodine. The hydrocarbyl group may be saturated or unsaturated and straight, branched or cyclic. Examples thereof include C₁-C₃₀ alkyl groups such as methyl, ethyl, n-propyl, isopropyl, n-butyl, isobutyl, sec-butyl, and tert-butyl; C₃-C₃₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₃₀ alkenyl groups such as vinyl, allyl, propenyl, butenyl, and hexenyl; C₃-C₃₀ cyclic unsaturated hydrocarbyl groups such as cyclohexenyl; C₆-C₃₀ aryl groups such as phenyl, naphthyl, and thienyl; C₇-C₃₀ aralkyl groups such as benzyl, 1-phenylethyl, and 2-phenylethyl, and combinations thereof. Inter alia, the aryl groups are preferred. In the hydrocarbyl groups, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonate ester bond, carbonate bond, lactone ring, sultone ring, carboxylic anhydride (-C(=O)-O-C(=O)-) or haloalkyl moiety.

Also, R^{ct1} and R^{ct2} may bond together to form a ring with the sulfur atom to which they are attached. Examples of the ring are shown below.

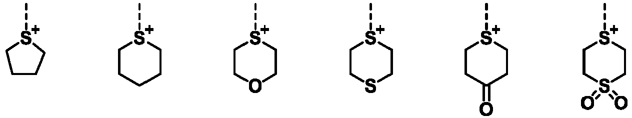

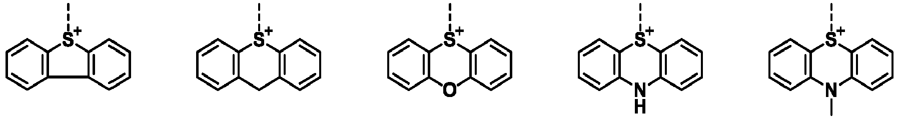

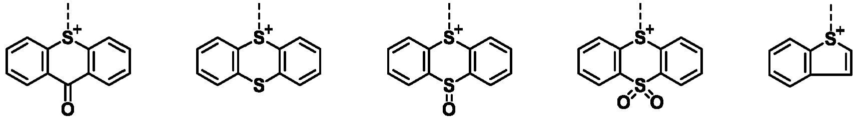

Herein the broken line designates a point of attachment to R^{ct3}.

Examples of the sulfonium cation having formula (cation-1) are shown below, but not limited thereto.

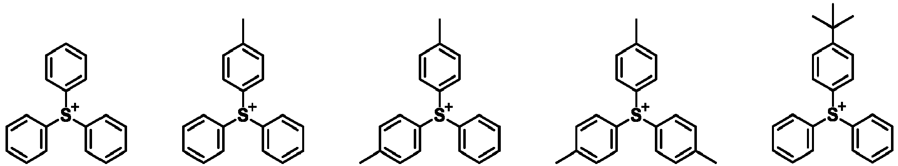

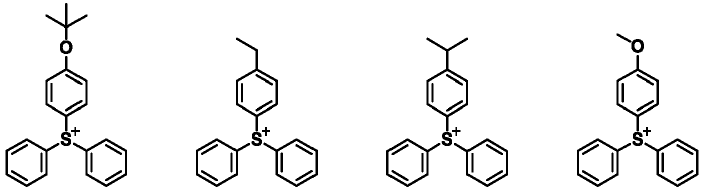

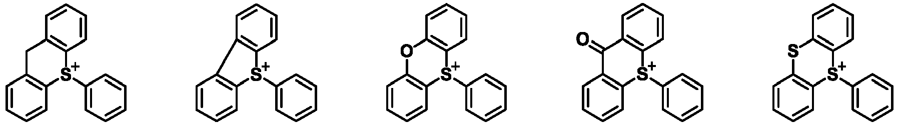

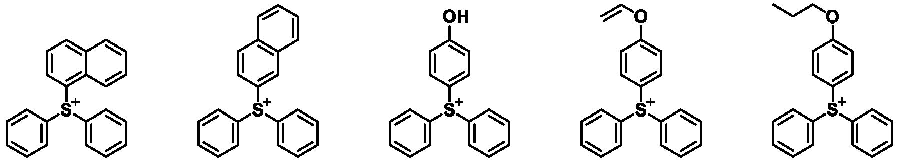

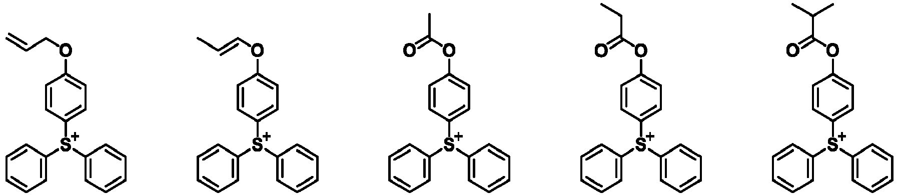

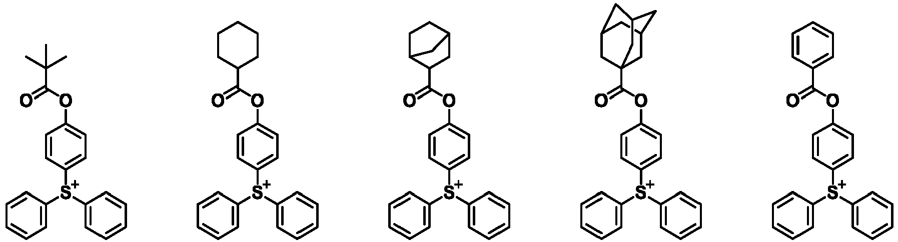

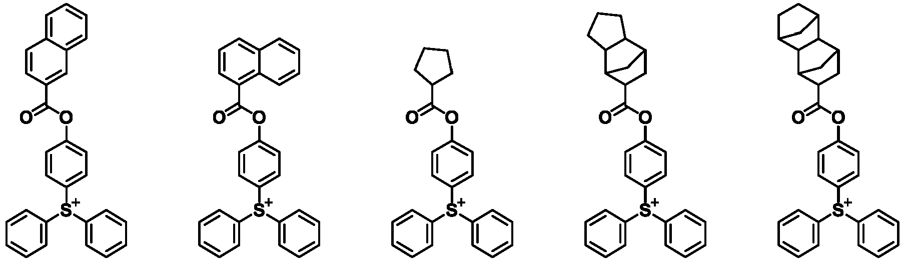

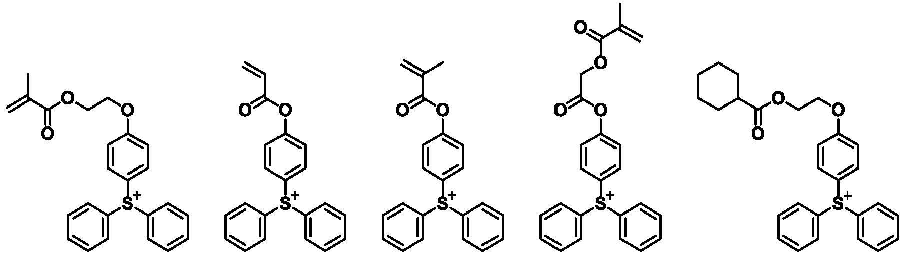

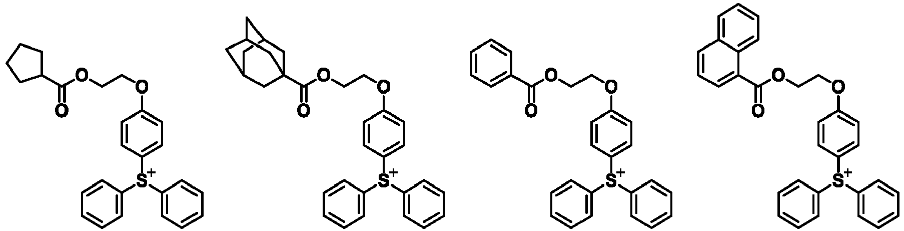

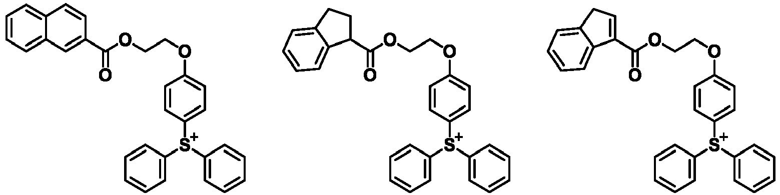

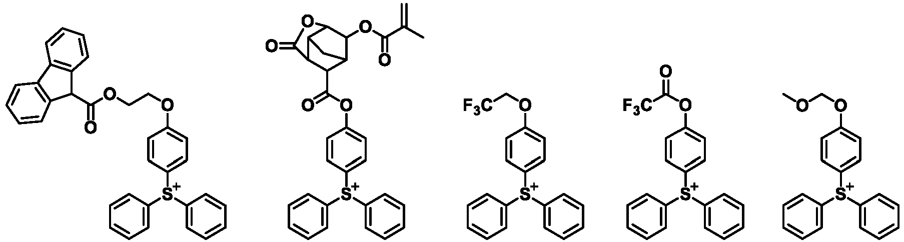

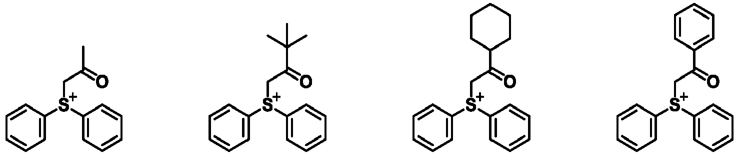

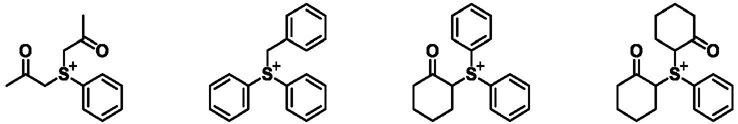

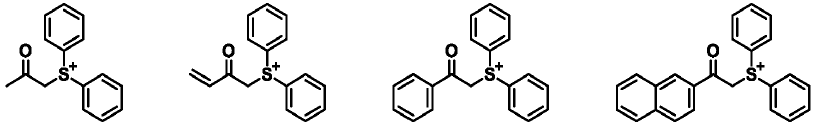

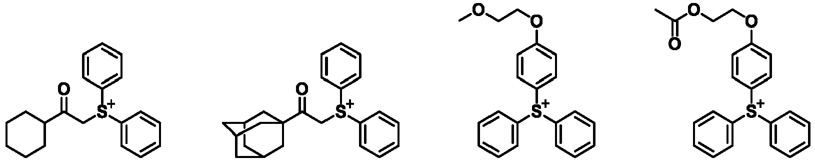

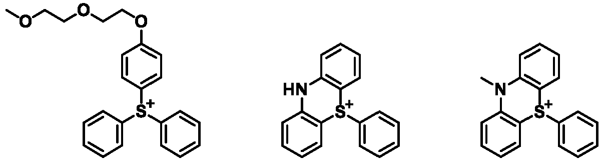

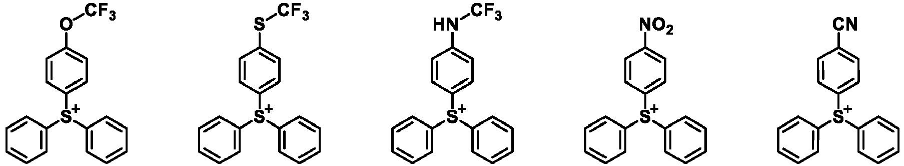

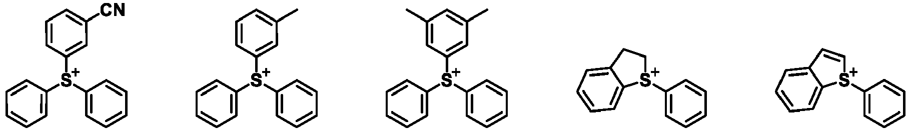

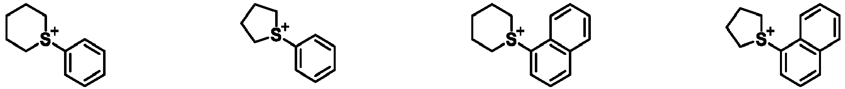

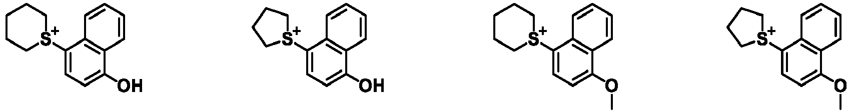

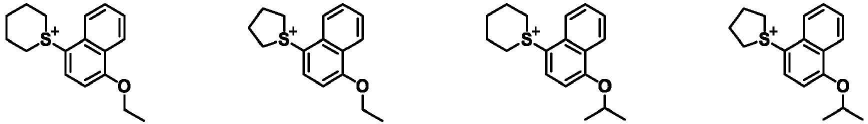

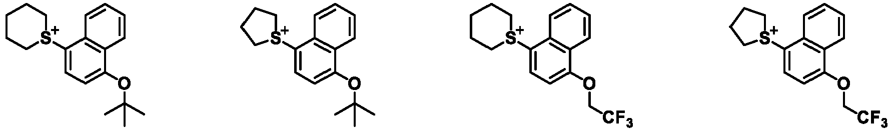

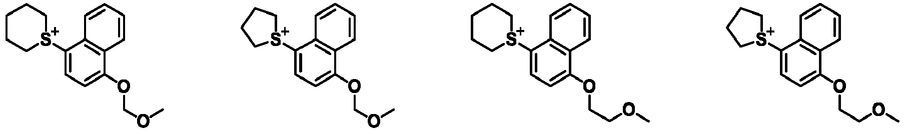

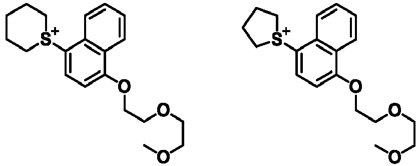

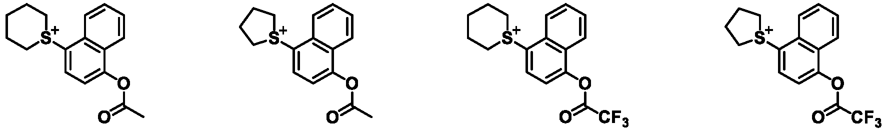

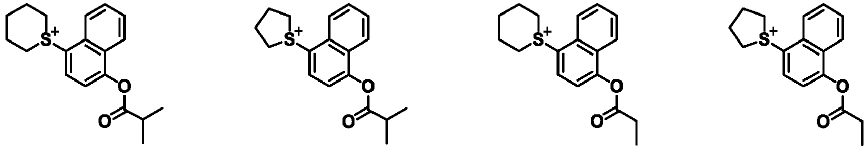

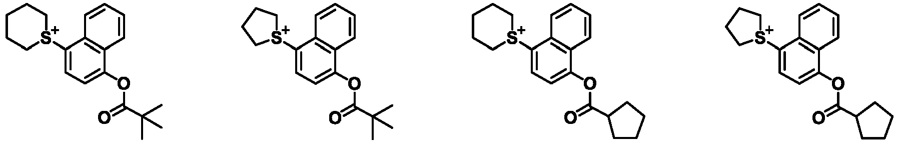

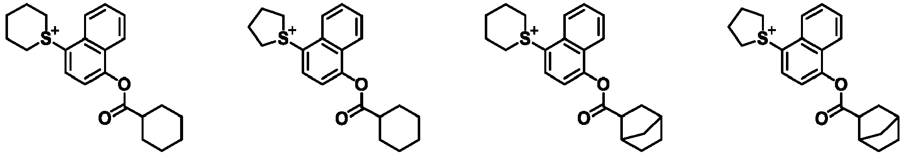

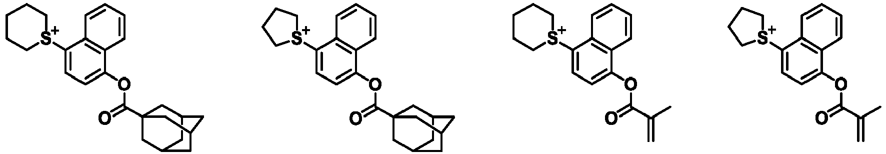

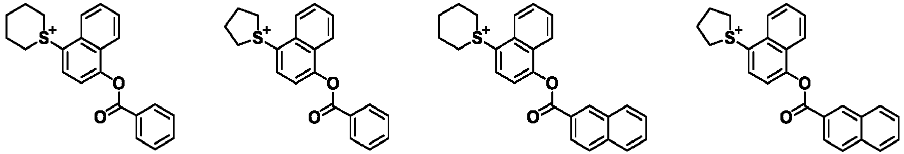

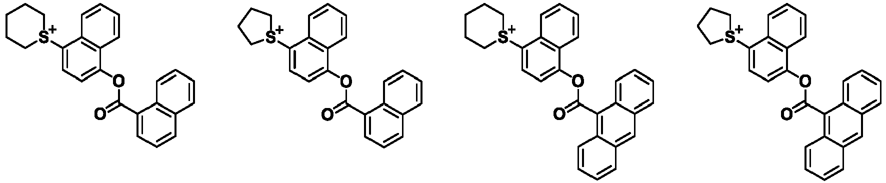

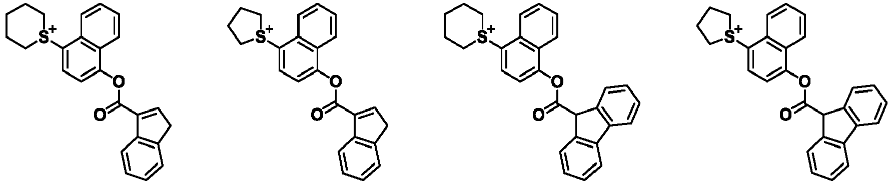

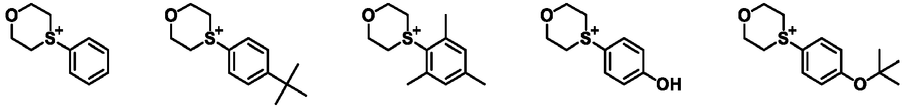

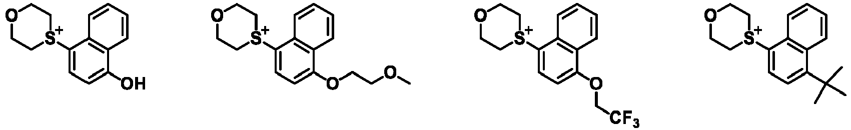

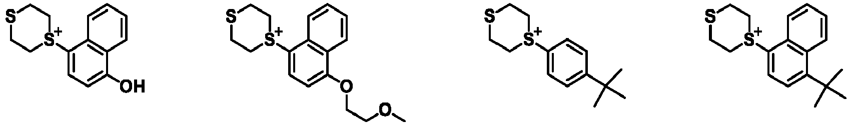

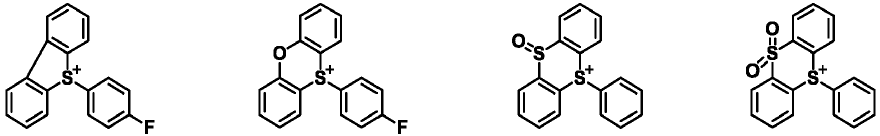

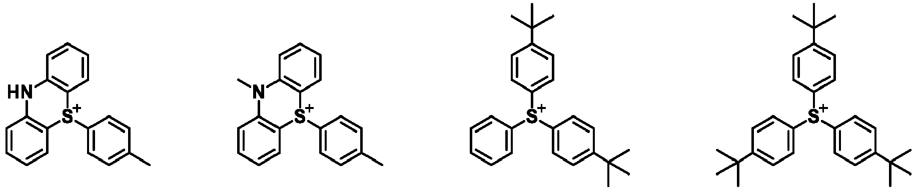

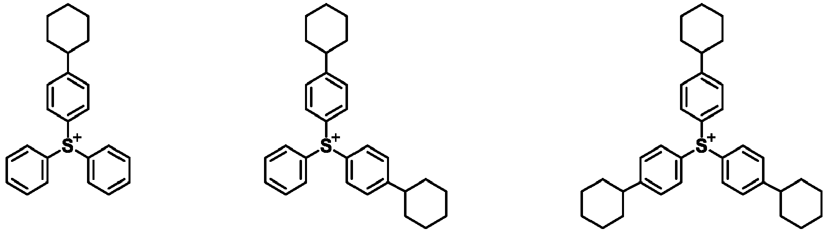

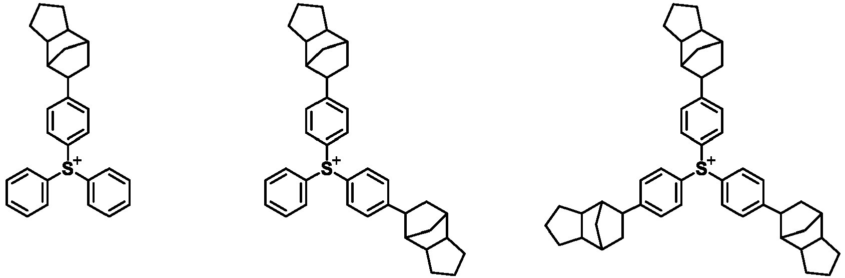

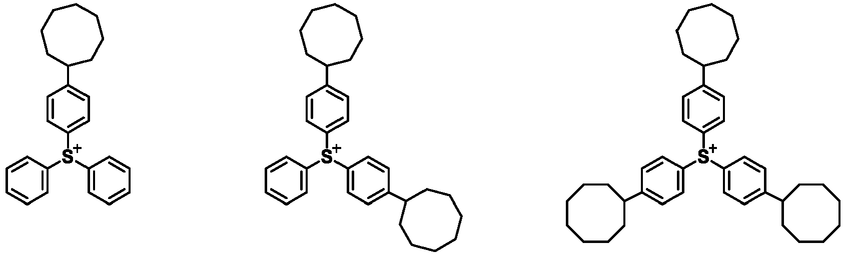

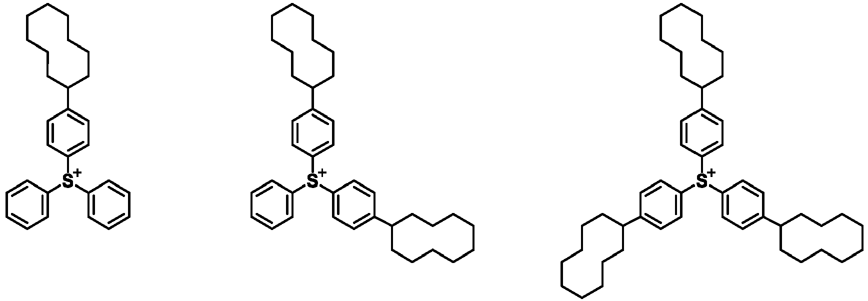

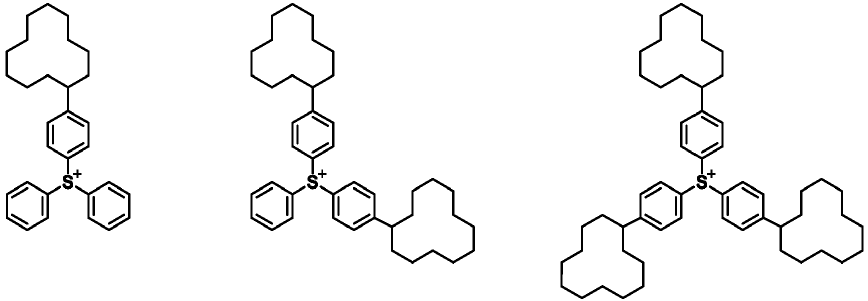

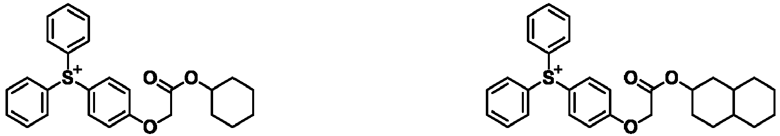

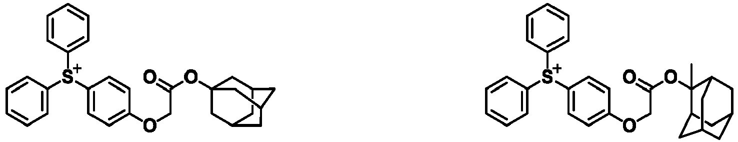

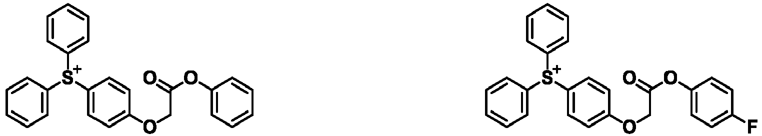

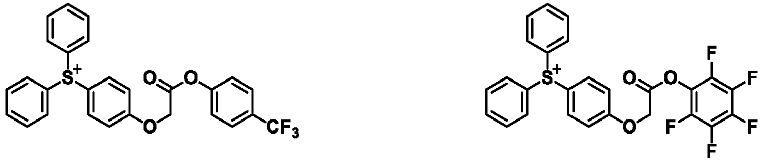

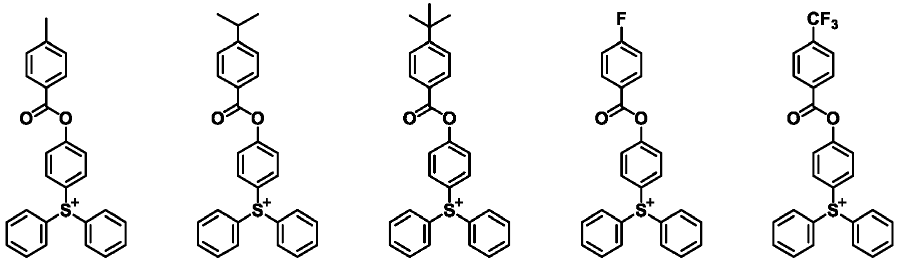

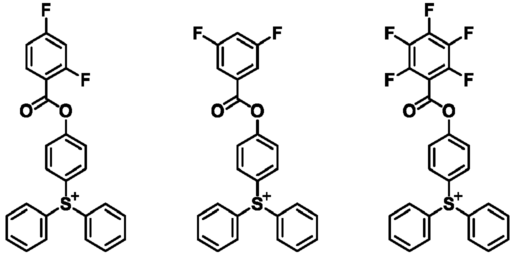

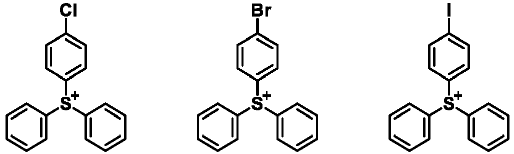

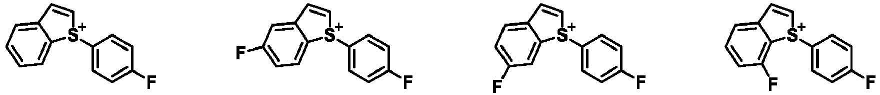

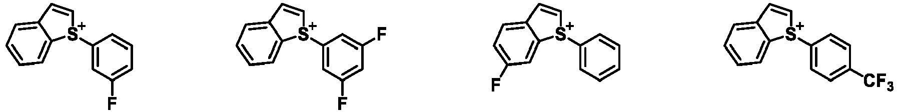

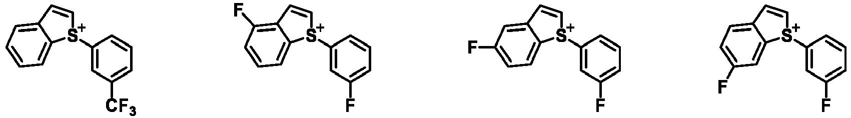

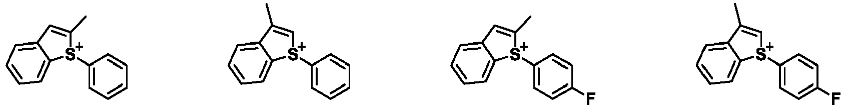

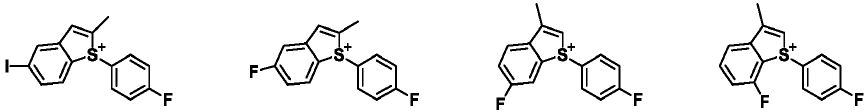

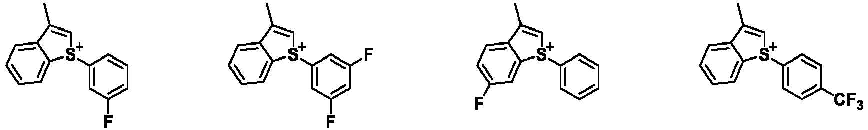

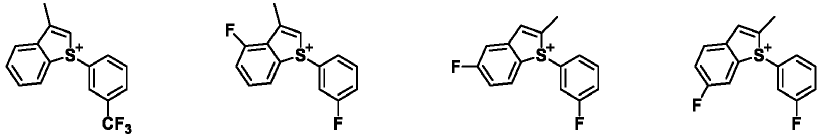

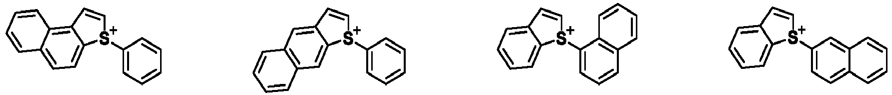

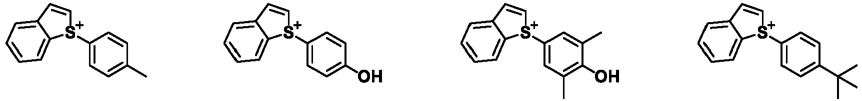

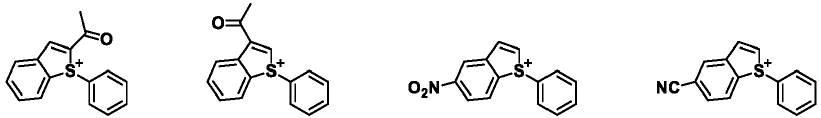

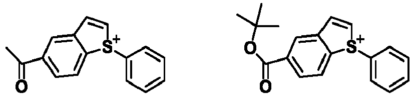

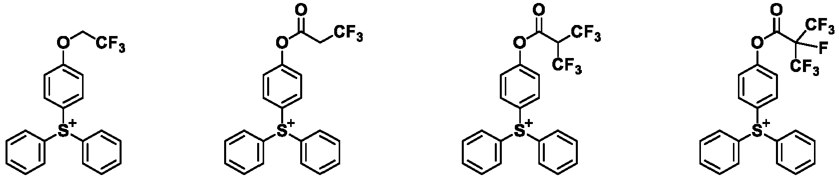

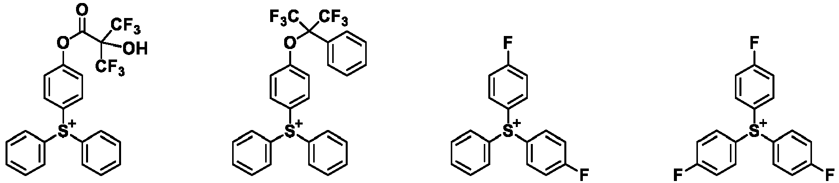

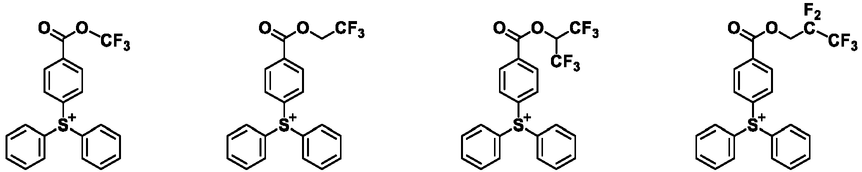

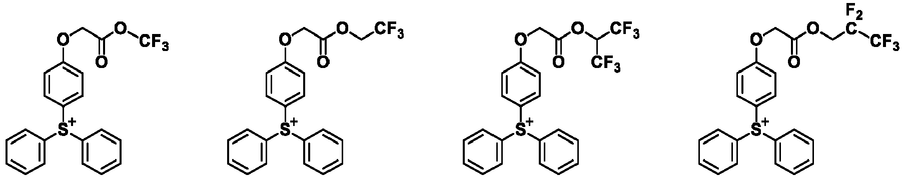

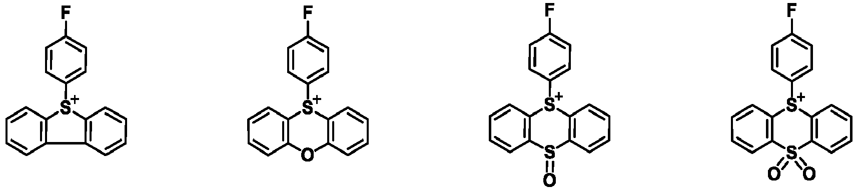

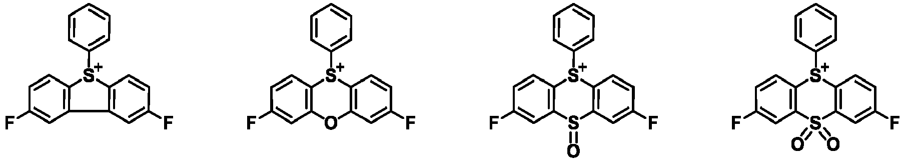

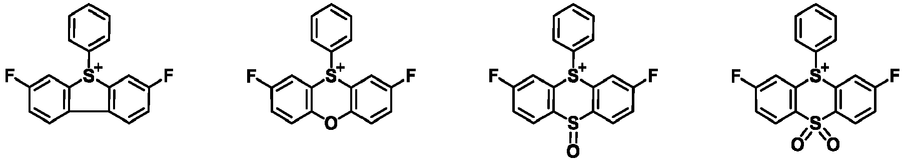

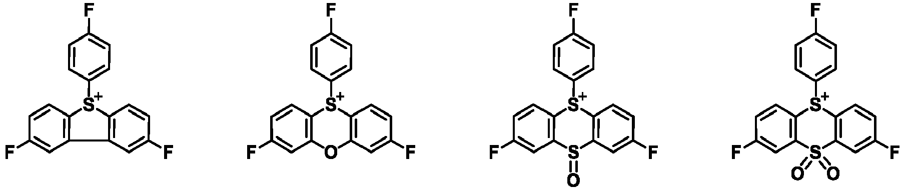

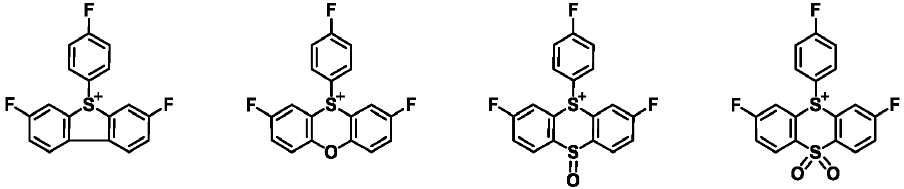

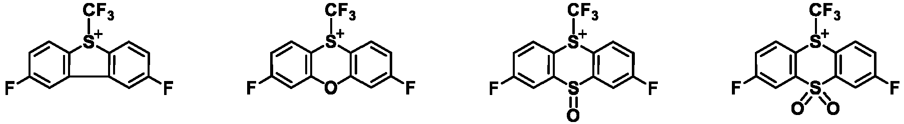

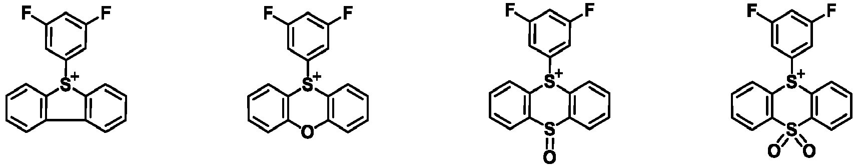

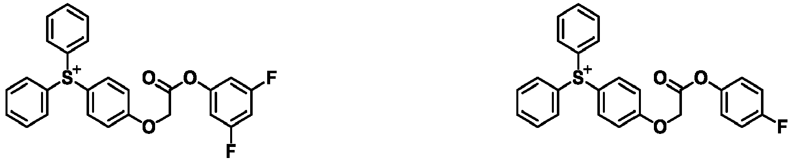

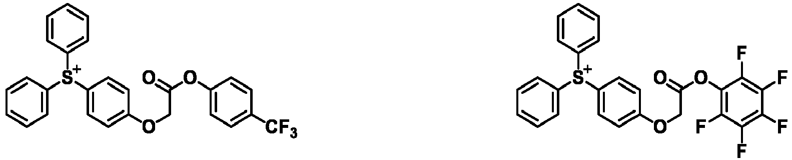

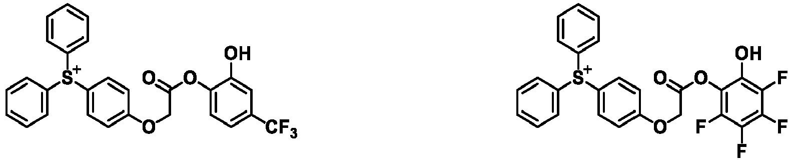

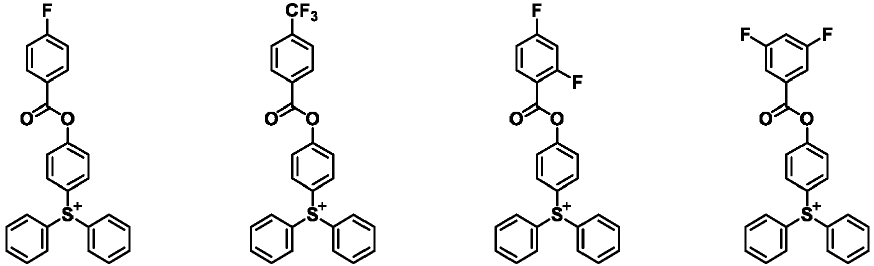

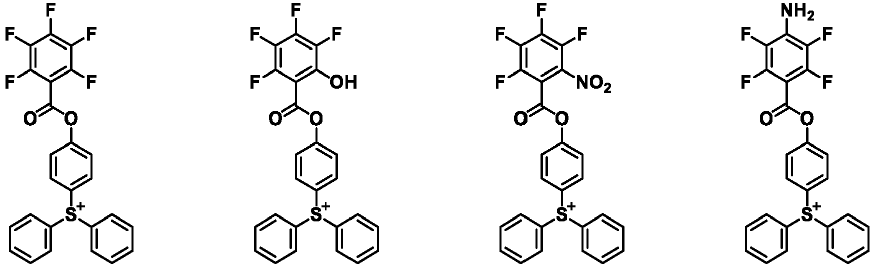

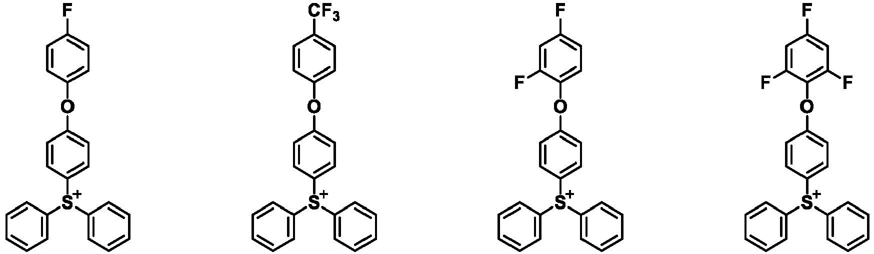

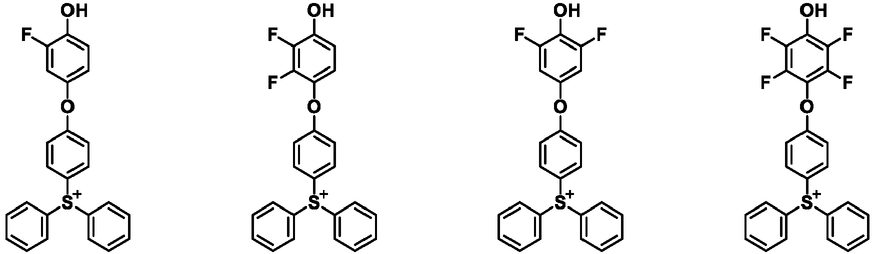

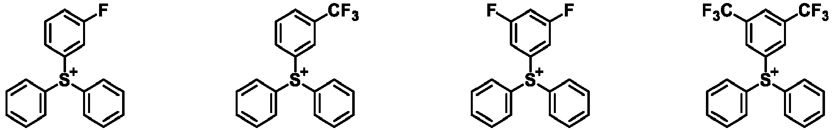

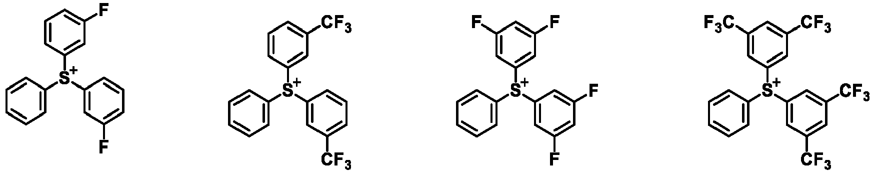

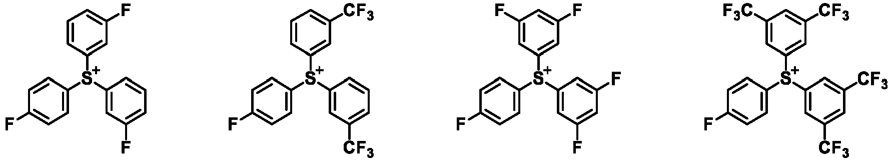

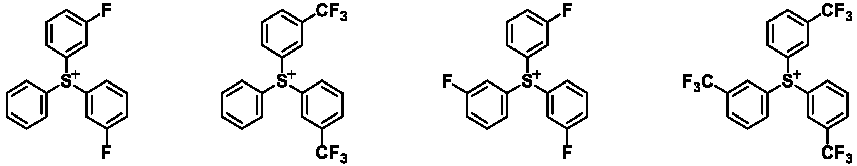

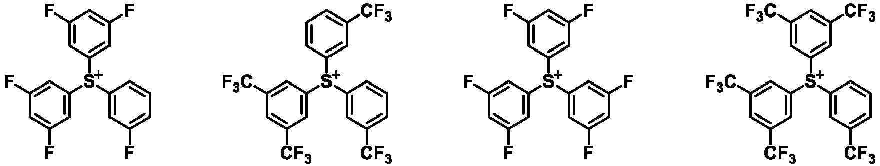

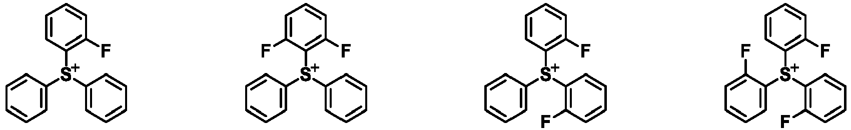

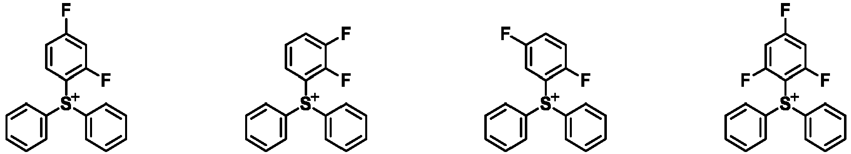

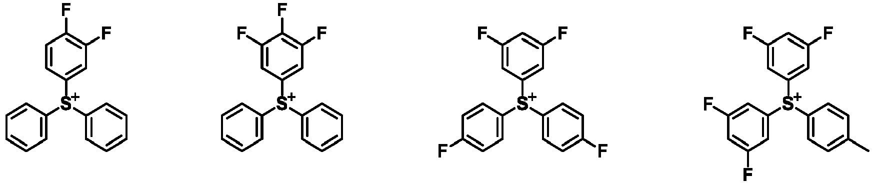

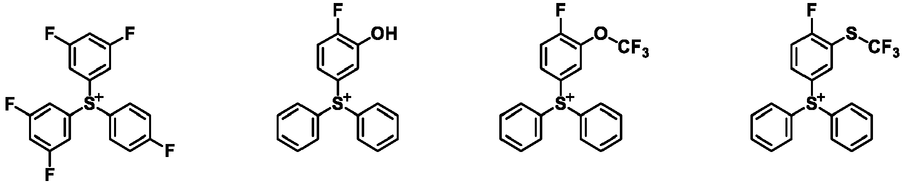

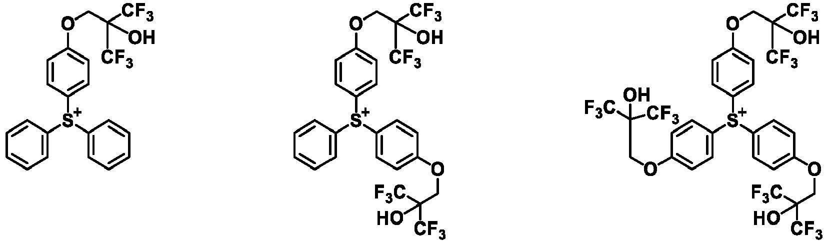

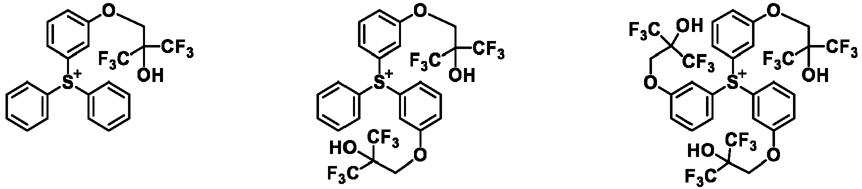

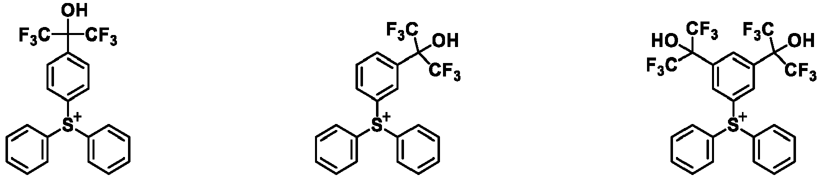

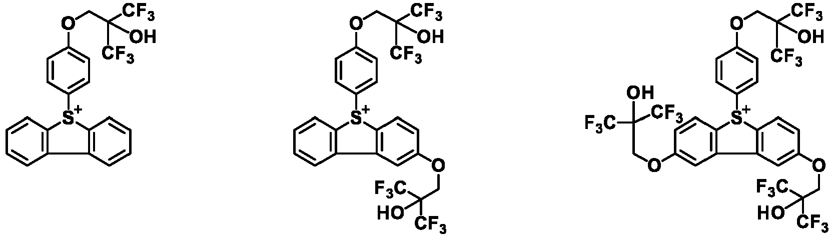

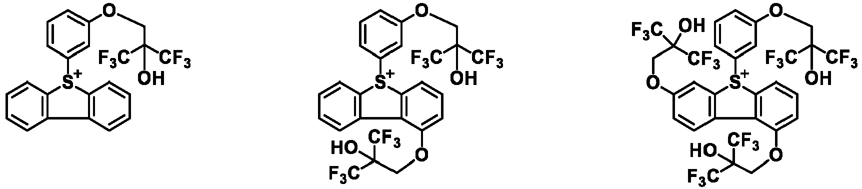

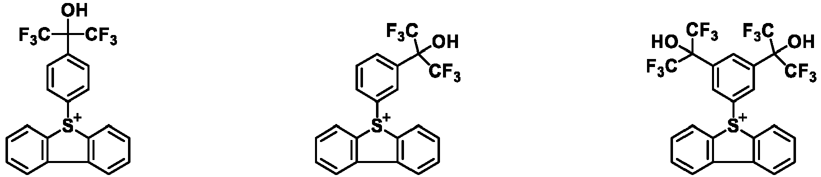

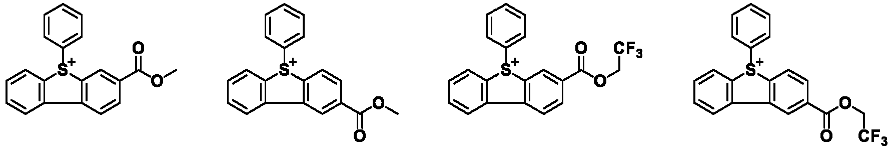

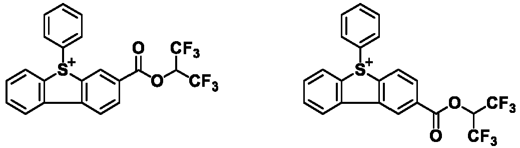

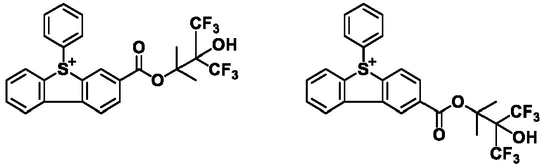

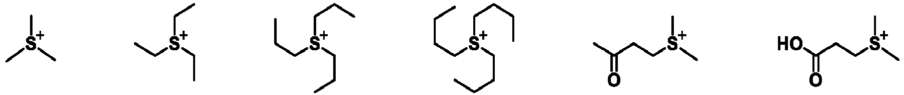

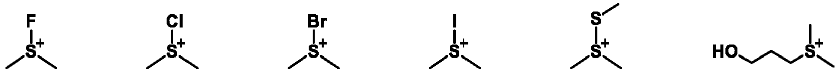

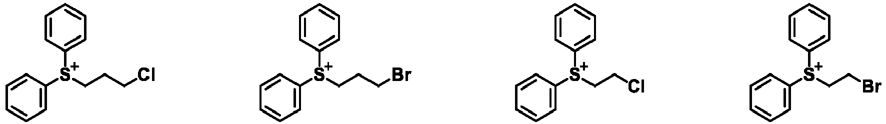

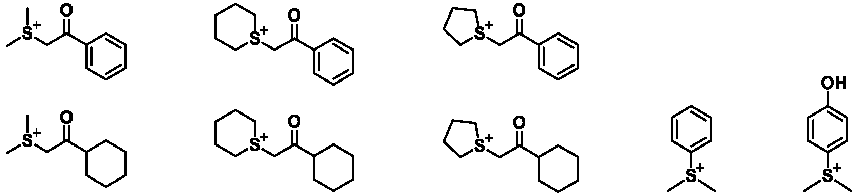

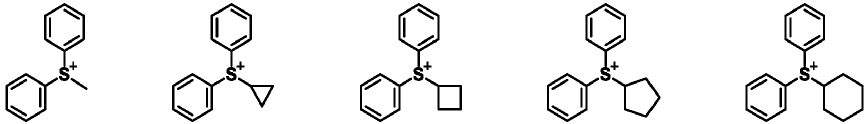

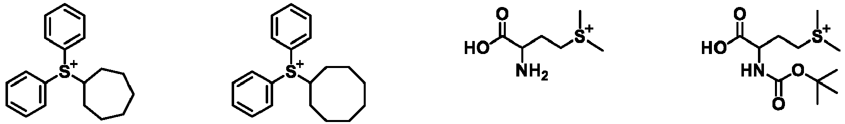

Examples of the iodonium cation having formula (cation-2) are shown below, but not limited thereto.

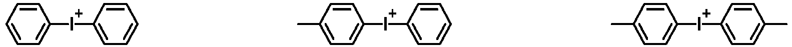

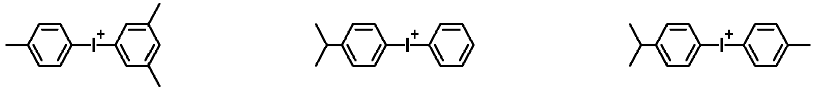

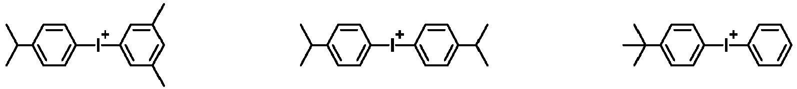

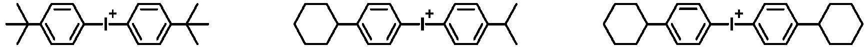

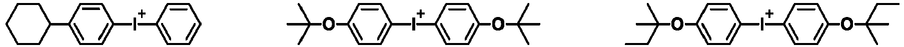

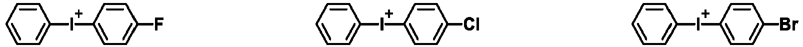

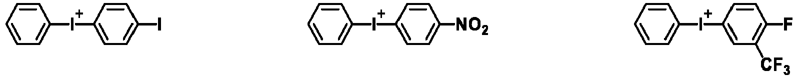

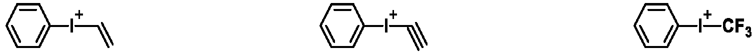

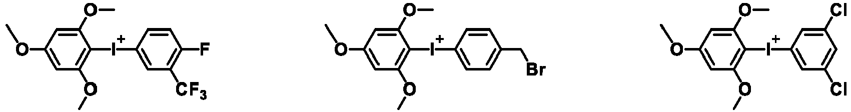

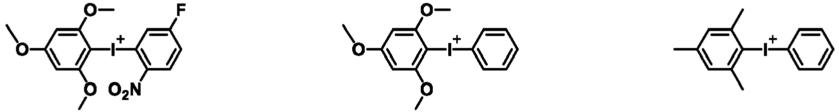

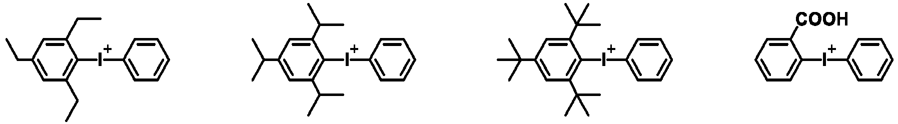

Examples of the photoacid generator having formula (A) include arbitrary combinations of anions with cations, both as exemplified above.

In the chemically amplified resist composition, the amount of the PAG (A) is preferably 0.1 to 40 parts by weight, more preferably 1 to 20 parts by weight per 80 parts by weight of the base polymer (B). An amount of PAG (A) in the range is sufficient to generate a necessary amount of acid for deprotection of an acid labile group and ensures shelf stability. The PAG (A) may be used alone or in admixture.

### (B) Base polymer

Component (B) is a base polymer containing a polymer comprising repeat units having a phenolic hydroxy group protected with an acid labile group and adapted to turn alkali soluble under the action of acid. The repeat units having a phenolic hydroxy group protected with an acid labile group are represented by the formula (B 1). The units are also referred to as repeat units B 1, hereinafter.

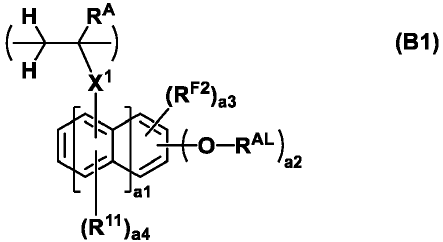

In formula (B 1), a1 is an integer of 0 to 2. The structure represents a benzene ring when a1=0, a naphthalene ring when a1=1, and an anthracene ring when a1=2. Inter alia, the benzene ring corresponding to a1=0 is preferred from the aspect of solvent solubility. The subscript a2 is an integer of 1 or 2. It is preferred for the availability of reactants that a2 be 1. The subscript a3 is an integer of 1 or 2. It is preferred for the availability of reactants that a3 be 1. The subscript a4 is an integer of 0 to 4. It is preferred for the availability of reactants that a4 be 0 or 1.

In formula (B 1), R^{A} is hydrogen, fluorine, methyl or trifluoromethyl.

In formula (B1), X¹ is a single bond or *-C(=O)-O-, wherein * designates a point of attachment to the carbon atom in the backbone. X¹ is preferably a single bond.

In formula (B 1), R^{AL} is an acid labile group. A plurality of R^{AL} may be identical or different in case of a2=2. The acid labile group R^{AL} is preferably a group having the formula (AL-1) or (AL-2).

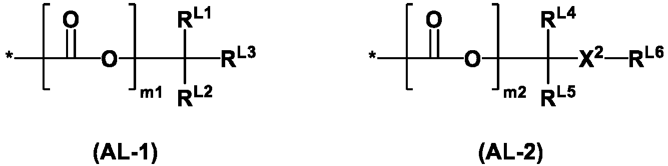

The asterisk (*) designates a point of attachment to the adjoining oxygen atom.

In formula (AL-1), R^{L1}, R^{L2} and R^{L3} are each independently a C₁-C₁₂ hydrocarbyl group in which some constituent -CH₂- may be replaced by -O- or -S-. When the hydrocarbyl group contains an aromatic ring, some or all of the hydrogen atoms in the aromatic ring may be substituted by halogen, cyano, nitro, optionally halogenated C₁-C₄ alkyl moiety, or optionally halogenated C₁-C₄ alkoxy moiety.

The C₁-C₁₂ hydrocarbyl group represented by R^{L1}, R^{L2} and R^{L3} may be saturated or unsaturated and straight, branched or cyclic. Examples thereof include C₁-C₁₂ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl, n-undecyl and n-dodecyl; C₃-C₁₂ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, norbornylmethyl, adamantyl, adamantylmethyl, tricyclo[5.2.1.0^{2,6}]decyl, and tetracyclo[6.2.1.1^{3,6}.0^{2,7}]dodecyl; C₂-C₁₂ alkenyl groups such as vinyl, allyl, propenyl, butenyl, pentenyl, and hexenyl; C₂-C₁₂ alkynyl groups such as ethynyl, propynyl, butynyl, pentynyl and hexynyl; C₃-C₁₂ cyclic unsaturated aliphatic hydrocarbyl groups such as cyclopentenyl and cyclohexenyl; C₆-C₁₂ aryl groups such as phenyl, naphthyl and indanyl; C₇-C₁₂ aralkyl groups such as benzyl, 1-phenylethyl and 2-phenylethyl, and combinations thereof.

Also, R^{L1} and R^{L2} may bond together to form a ring with the carbon atom to which they are attached. Suitable rings include cyclopropane, cyclobutane, cyclopentane, cyclohexane, cycloheptane, cyclooctane, norbornane, adamantane, tricyclo[5.2.1.0^{2,6}]decane, and tetracyclo[6.2.1.1^{3,6}.0^{2,7}]dodecane rings. Some constituent -CH₂- in the ring may be replaced by -O- or -S-.

In formula (AL-2), R^{L4} and R^{L5} are each independently hydrogen or a C₁-C₁₀ hydrocarbyl group. The C₁-C₁₀ hydrocarbyl group may be saturated or unsaturated and straight, branched or cyclic. Examples thereof are as exemplified above for the C₁-C₁₂ hydrocarbyl groups R^{L1}, R^{L2} and R^{L3}, but of 1 to 10 carbon atoms.

In formula (AL-2), R^{L6} is a C₁-C₂₀ hydrocarbyl group in which some constituent -CH₂- may be replaced by -O- or -S-. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl and icosyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, norbornylmethyl, adamantyl, adamantylmethyl, tricyclo[5.2.1.0^{2,6}]decyl, and tetracyclo[6.2.1.1^{3,6}.0^{2,7}]dodecyl; C₂-C₂₀ alkenyl groups such as vinyl, propenyl, butenyl, pentenyl, and hexenyl; C₂-C₂₀ alkynyl groups such as ethynyl, propynyl, butynyl, pentynyl and hexynyl; C₃-C₂₀ cyclic unsaturated aliphatic hydrocarbyl groups such as cyclopentenyl, cyclohexenyl and norbornenyl; C₆-C₂₀ aryl groups such as phenyl, methylphenyl, ethylphenyl, n-propylphenyl, isopropylphenyl, n-butylphenyl, isobutylphenyl, sec-butylphenyl, tert-butylphenyl, naphthyl, methylnaphthyl, ethylnaphthyl, n-propylnaphthyl, isopropylnaphthyl, n-butylnaphthyl, isobutylnaphthyl, sec-butylnaphthyl, and tert-butylnaphthyl; C₇-C₂₀ aralkyl groups such as benzyl and phenethyl, and combinations thereof.

Also, R^{L5} and R^{L6} may bond together to form a C₃-C₂₀ heterocyclic group with the carbon atom and X² to which they are attached, in which some constituent -CH₂- may be replaced by -O- or -S-.

In formula (AL-2), X² is -O- or -S-.

In formulae (AL-1) and (AL-2), m1 and m2 are each independently 0 or 1.

Examples of the acid labile group having formula (AL-1) are shown below, but not limited thereto. Herein * designates a point of attachment to the adjoining -O-.

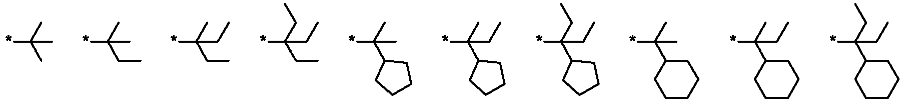

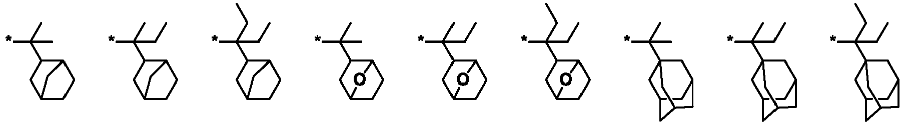

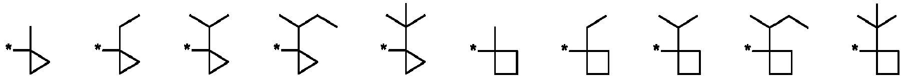

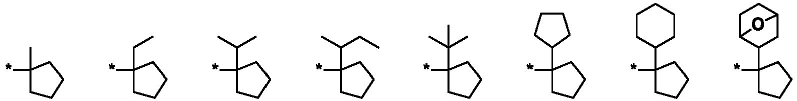

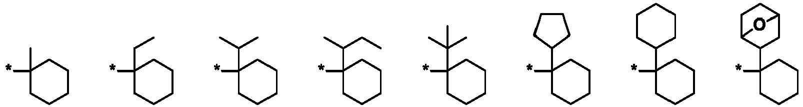

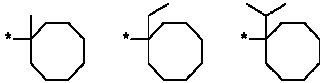

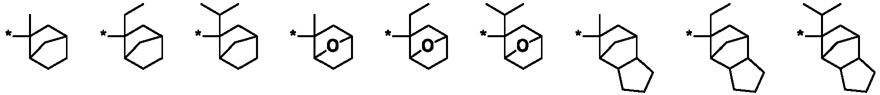

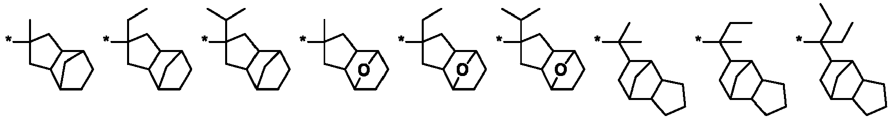

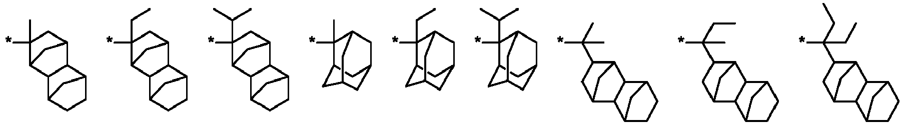

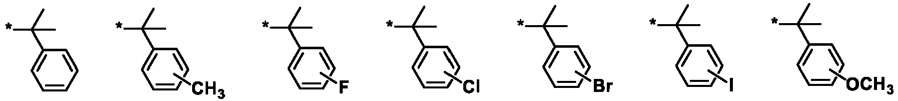

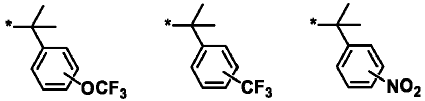

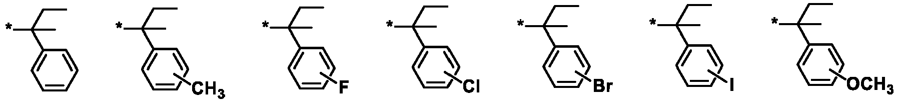

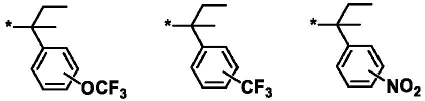

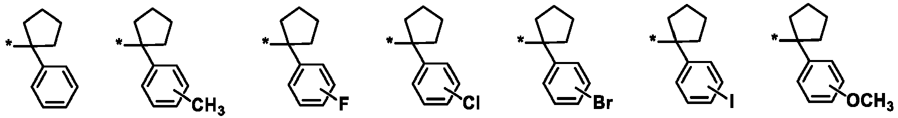

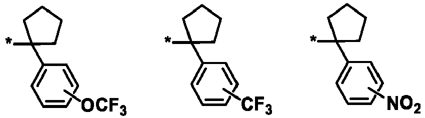

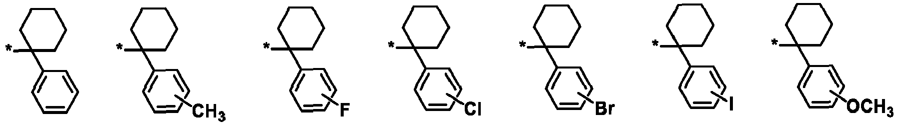

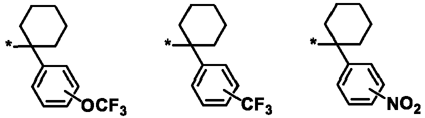

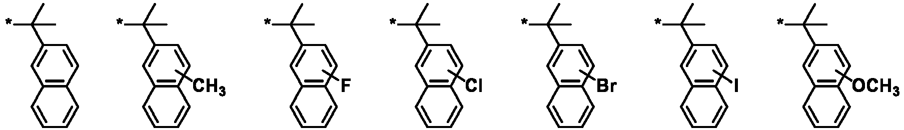

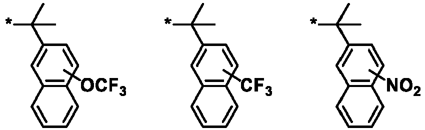

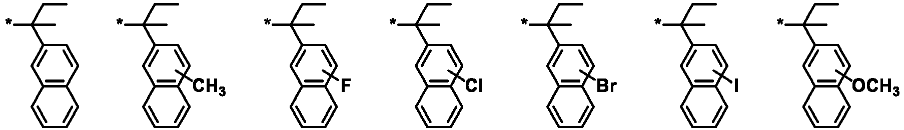

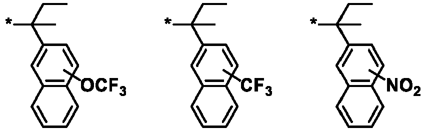

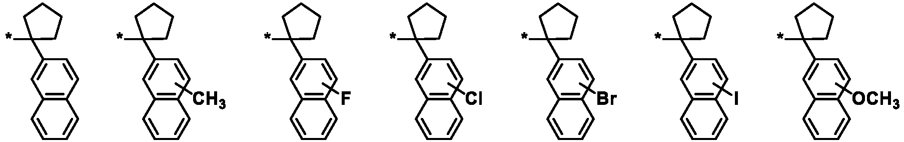

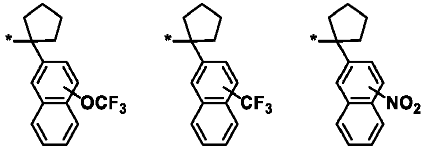

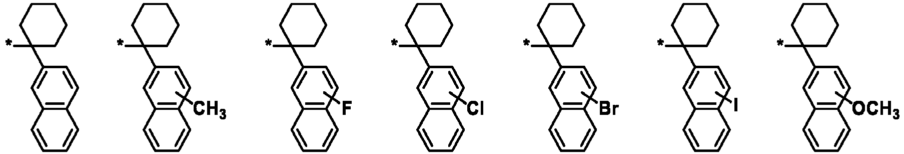

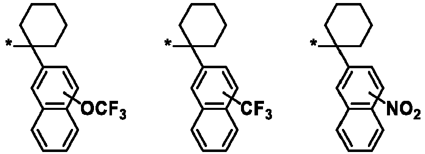

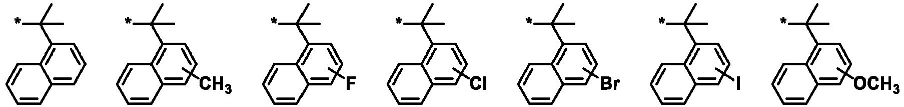

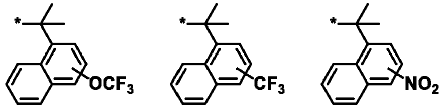

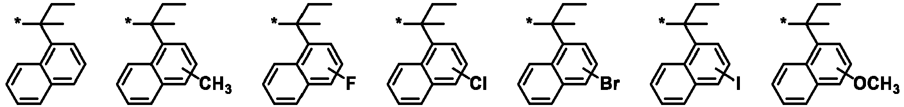

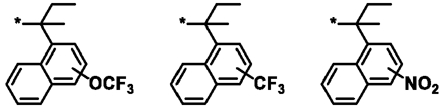

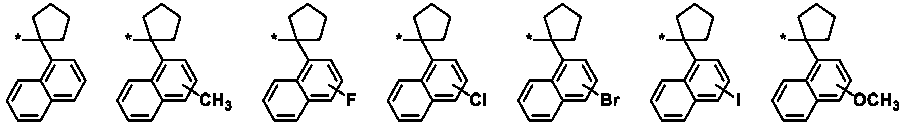

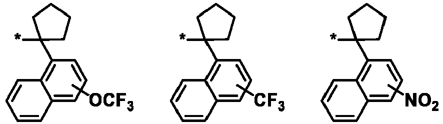

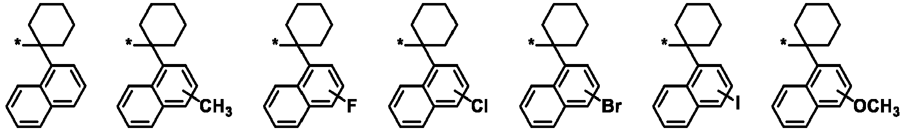

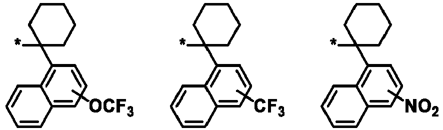

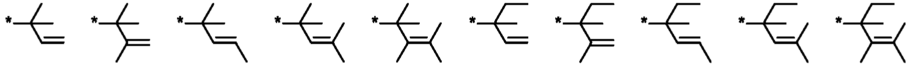

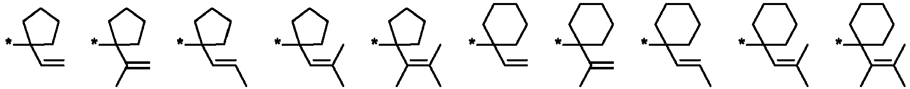

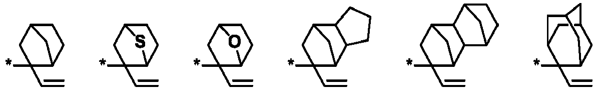

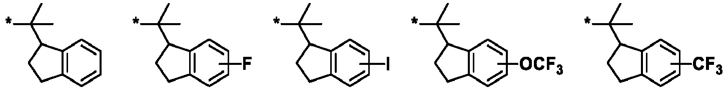

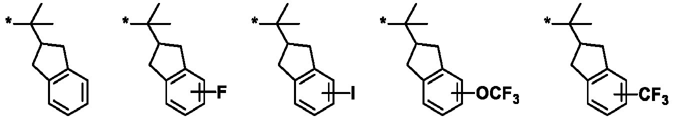

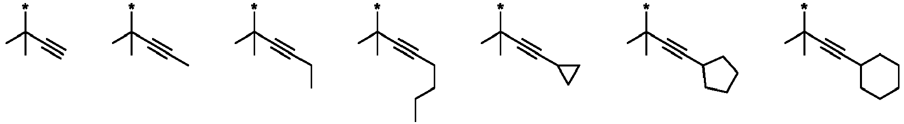

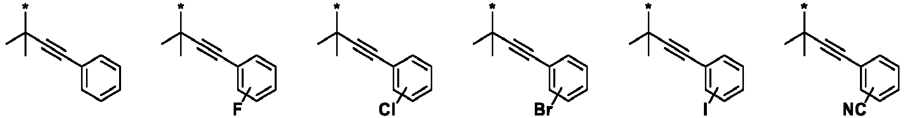

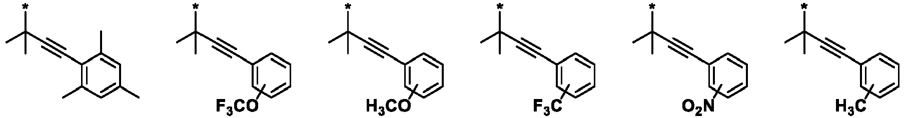

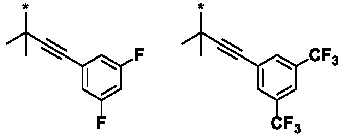

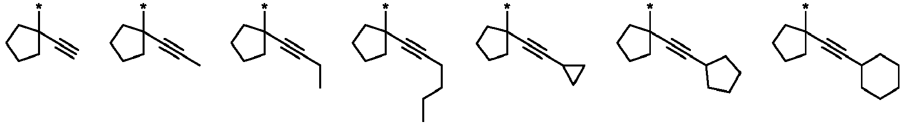

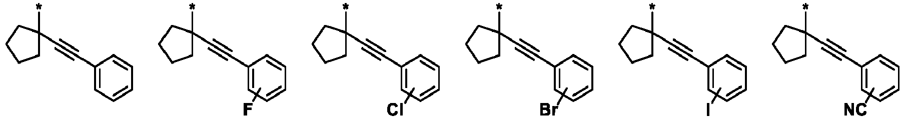

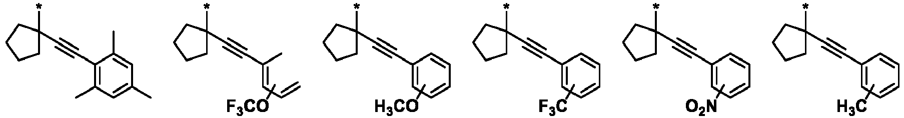

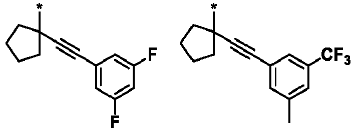

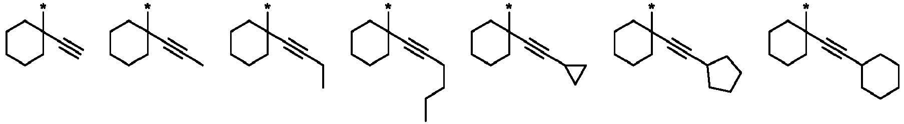

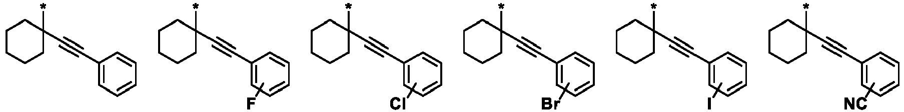

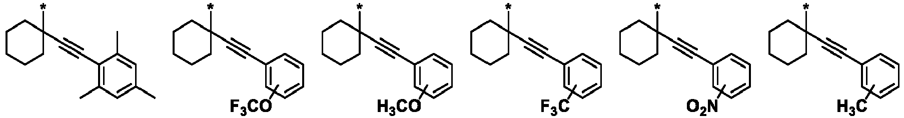

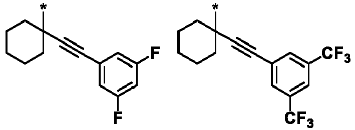

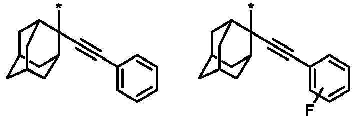

Examples of the acid labile group having formula (AL-2) are shown below, but not limited thereto. Herein, * designates a point of attachment to the adjoining oxygen atom.

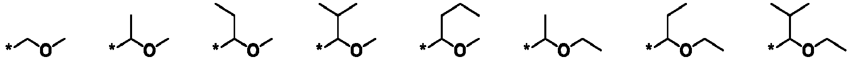

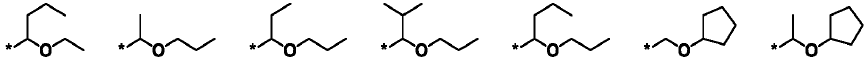

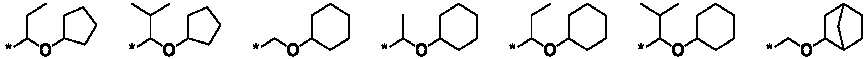

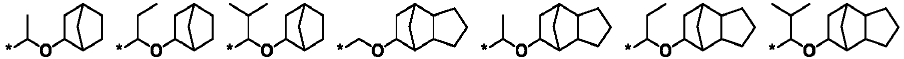

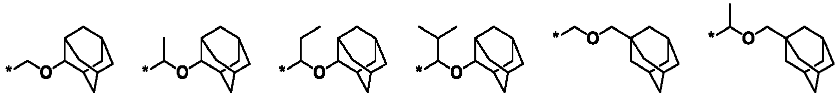

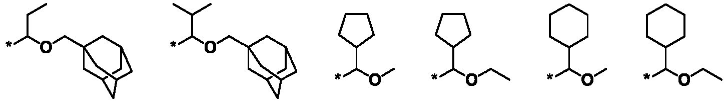

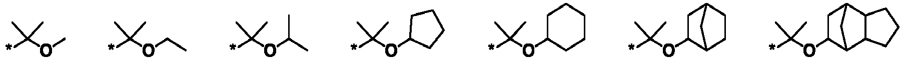

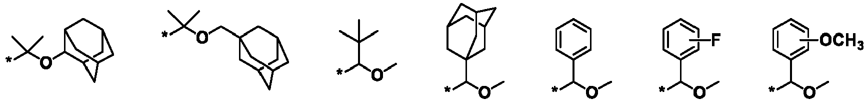

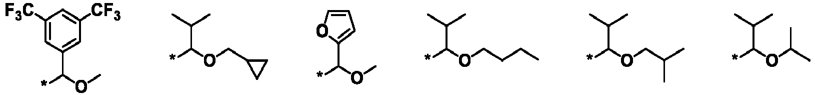

In formula (B 1), R^{F2} is fluorine, a C₁-C₆ fluorinated saturated hydrocarbyl group, C₁-C₆ fluorinated saturated hydrocarbyloxy group, or C₁-C₆ fluorinated saturated hydrocarbylthio group. R^{F2} is preferably fluorine, trifluoromethyl, difluoromethyl, trifluoromethoxy, difluoromethoxy, trifluoromethylthio or difluoromethylthio, more preferably fluorine, trifluoromethyl or trifluoromethoxy. The inclusion of fluorine enables to form a collapse-resistant pattern due to a swell-suppressing effect. A plurality of R^{F2} may be identical or different when a3 is 2 or more.

In formula (B 1), there must be included at least one set of -O-R^{AL} and -R^{F2} which are attached to the adjoining carbon atoms on the aromatic ring. That is, in case of a2=1, -O-R^{AL} and -R^{F2} are attached to the adjoining carbon atoms on the aromatic ring. In case of a2=2, at least one of two -O-R^{AL} is attached to the carbon atom adjoining the carbon atom on the aromatic ring to which -R^{F2} is attached. The neighboring of -O-R^{AL} and -R^{F2} ensures that the aromatic alcohol created after deprotection of R^{AL} has a higher acidity.

In formula (B 1), R¹¹ is halogen exclusive of fluorine or a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl and icosyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₂₀ alkenyl groups such as vinyl, allyl, propenyl, butenyl, and hexenyl; C₃-C₂₀ cyclic unsaturated hydrocarbyl groups such as cyclohexenyl; C₆-C₂₀ aryl groups such as phenyl and naphthyl; C₇-C₂₀ aralkyl groups such as benzyl, 1-phenylethyl and 2-phenylethyl, and combinations thereof. In the hydrocarbyl group, some or all of the hydrogen atoms may be substituted by a moiety containing a heteroatom such as oxygen, sulfur, nitrogen or halogen and some constituent -CH₂- may be replaced by a moiety containing a heteroatom such as oxygen, sulfur or nitrogen, so that the group may contain a hydroxy moiety, cyano moiety, chlorine, bromine, iodine, carbonyl moiety, ether bond, ester bond, sulfonate ester bond, carbonate bond, lactone ring, sultone ring, carboxylic anhydride (-C(=O)-O-C(=O)-), or haloalkyl moiety. A plurality of R¹¹ may bae identical or different when a4 is 2 or more.

Examples of the monomer from which repeat units B 1 are derived are shown below, but not limited thereto. The positions of substituents on the aromatic ring are not limited to the illustrated ones as long as -O-R^{AL} and -R^{F2} are positioned as adjoining one another. Herein, R^{A} is as defined above.

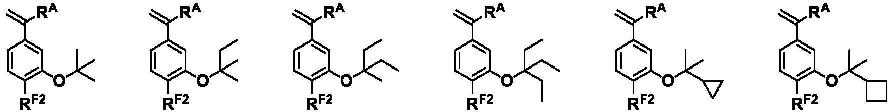

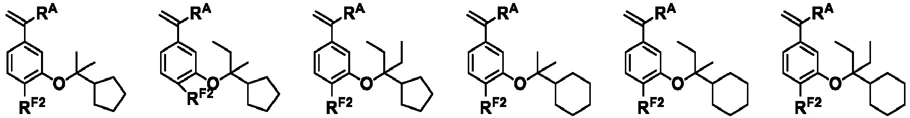

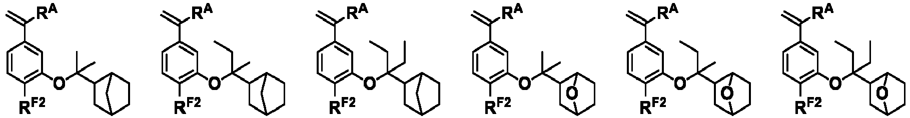

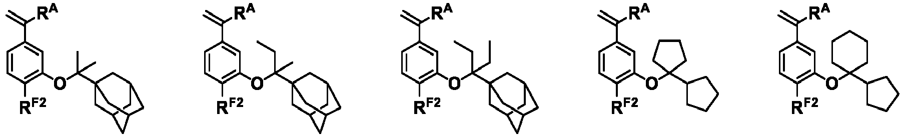

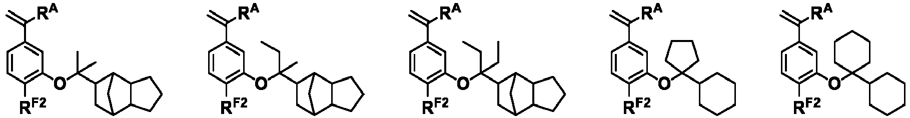

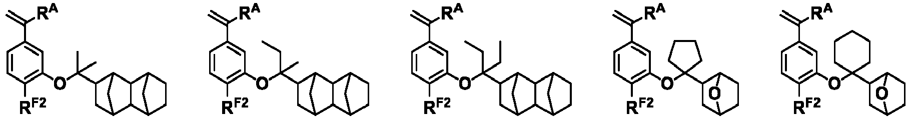

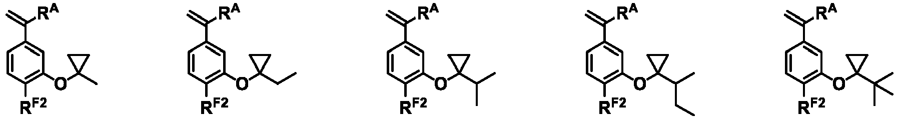

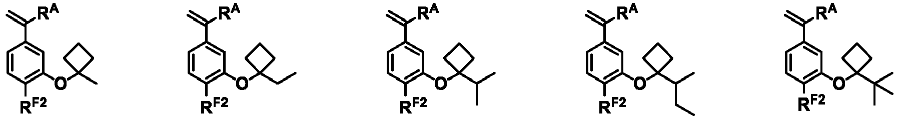

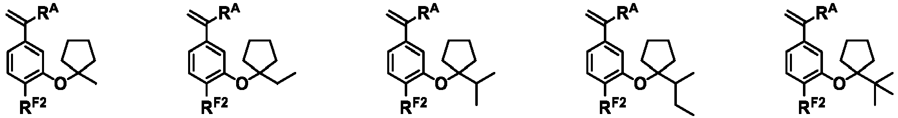

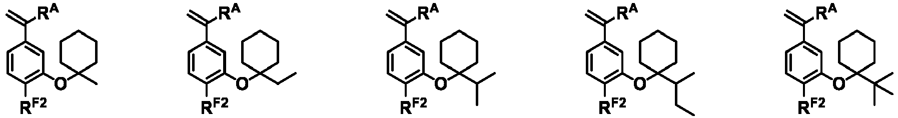

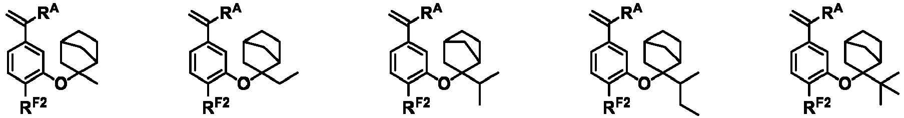

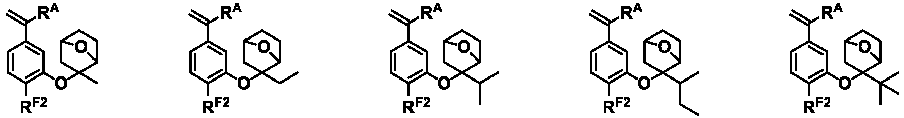

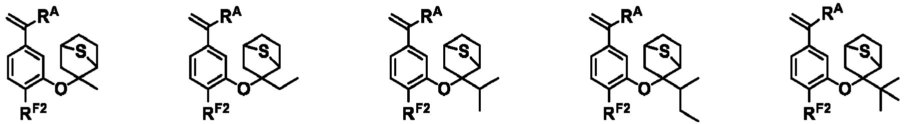

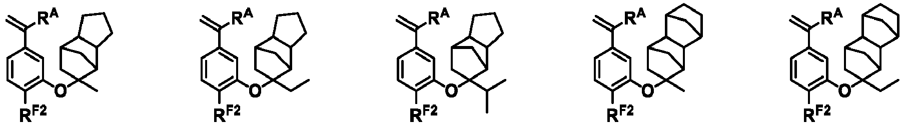

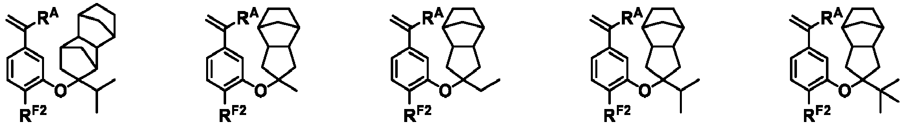

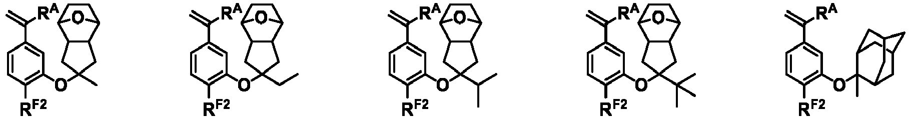

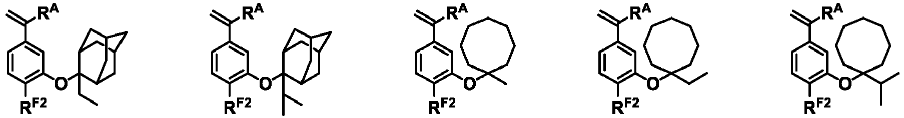

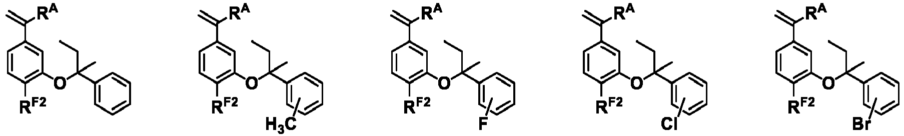

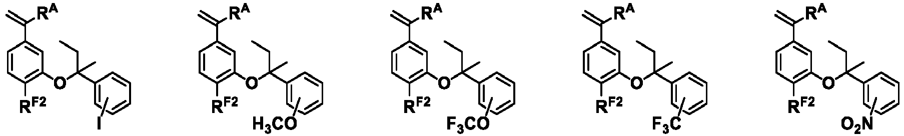

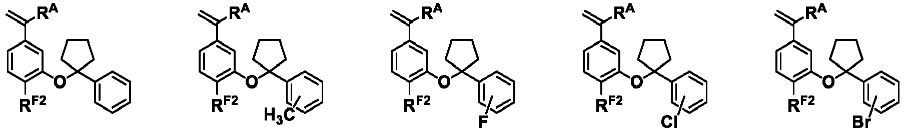

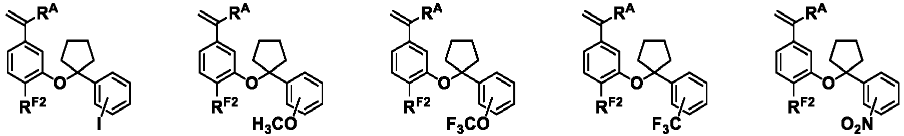

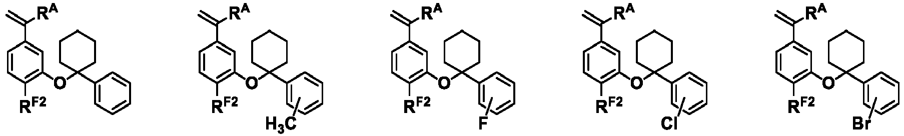

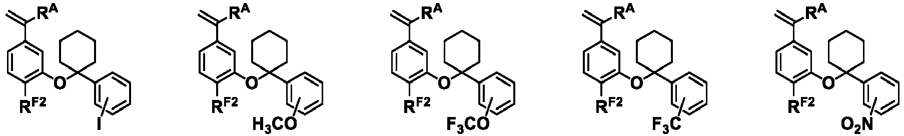

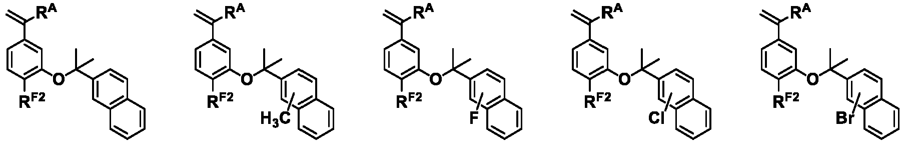

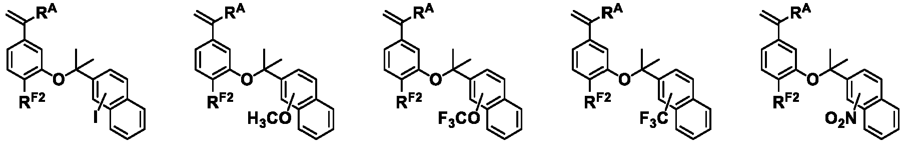

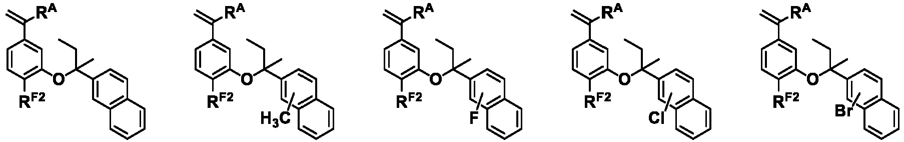

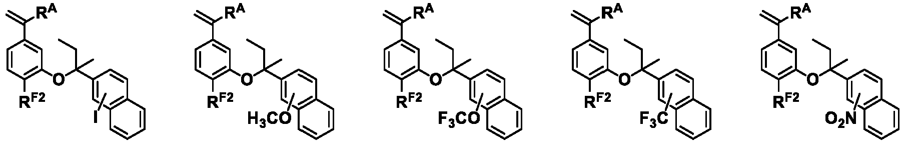

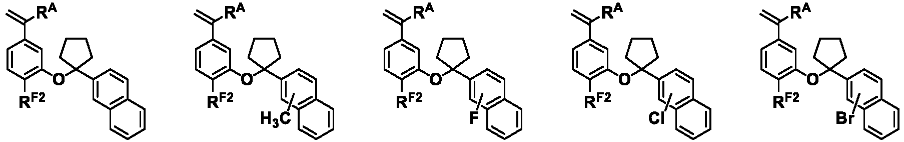

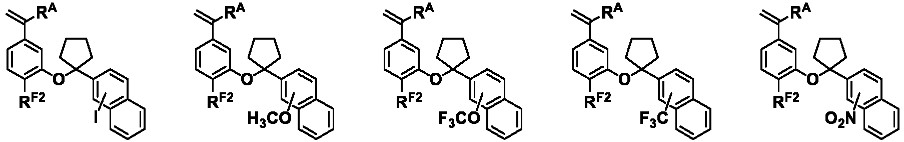

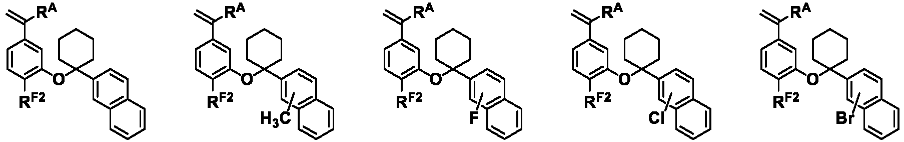

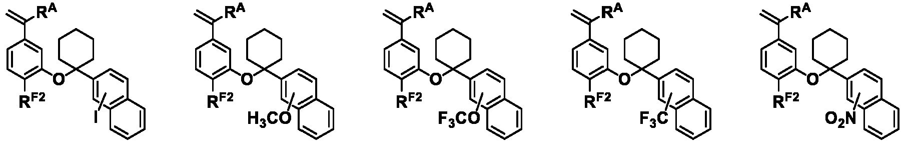

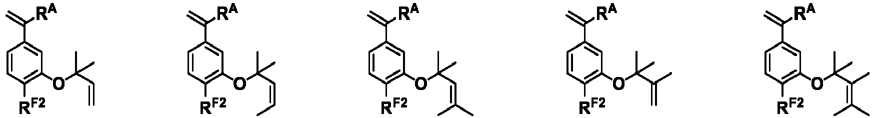

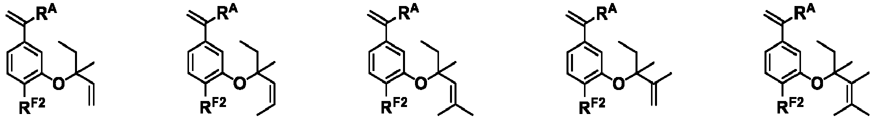

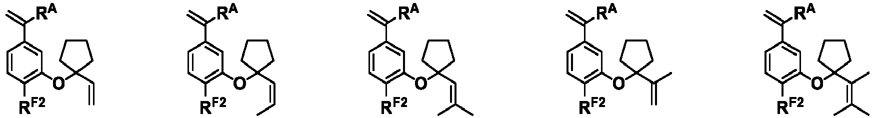

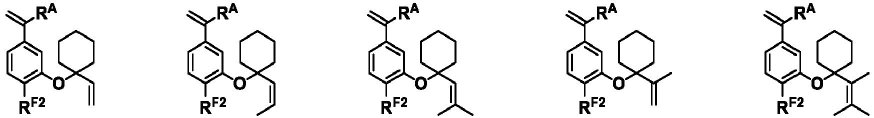

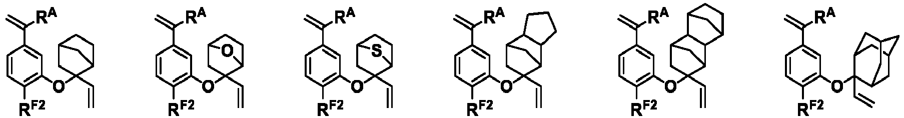

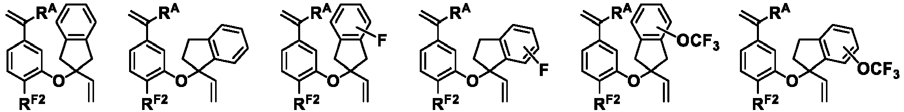

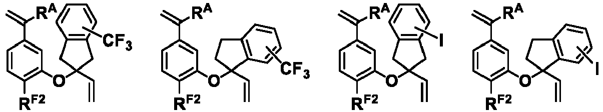

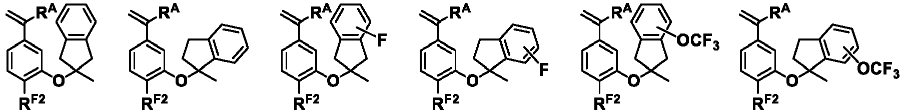

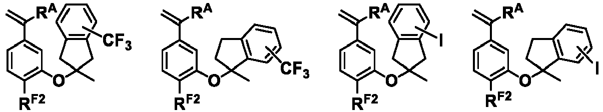

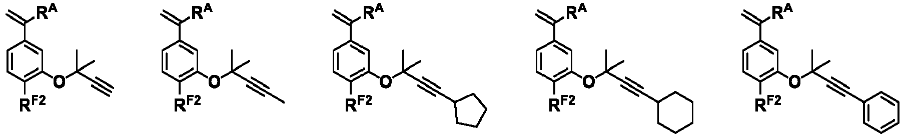

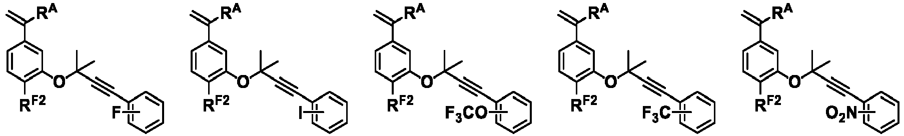

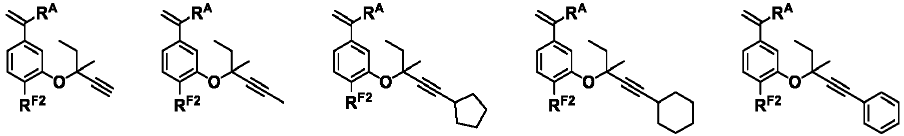

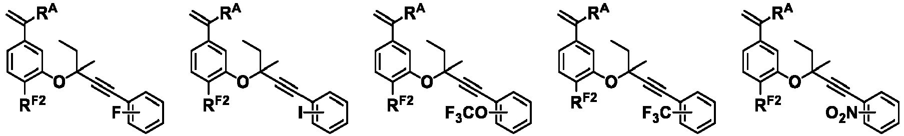

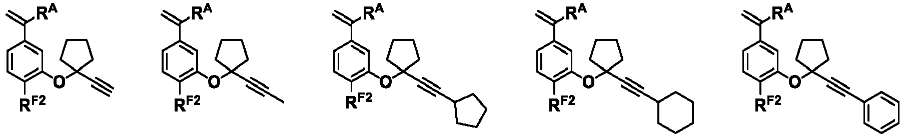

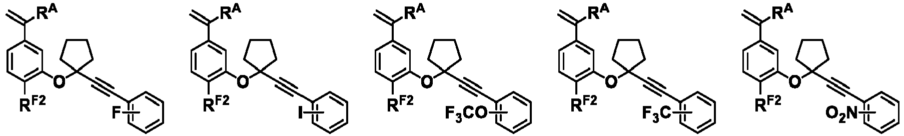

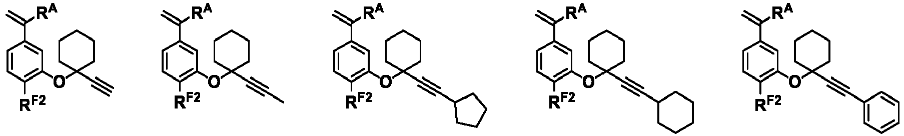

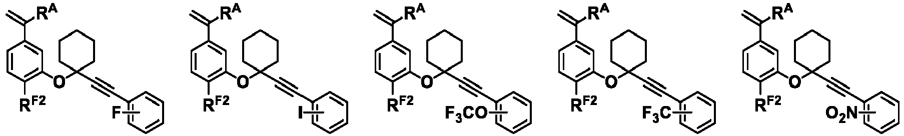

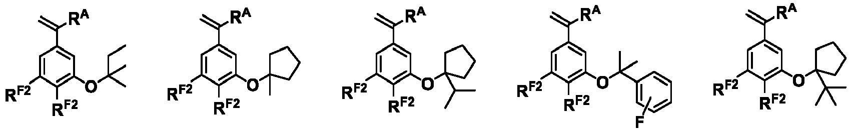

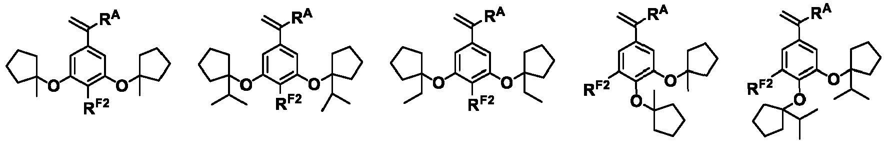

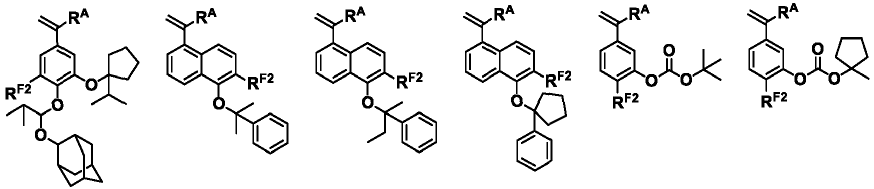

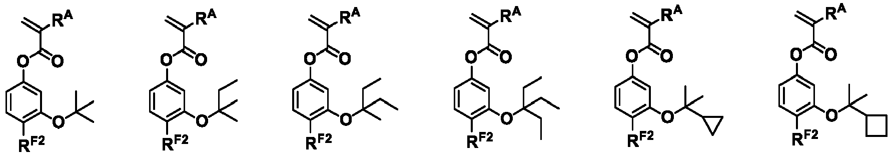

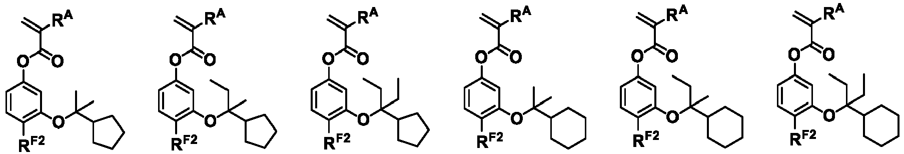

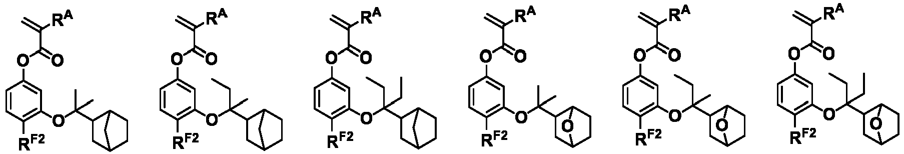

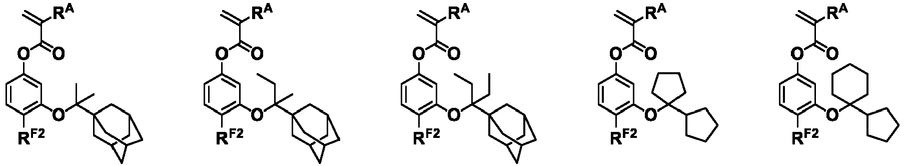

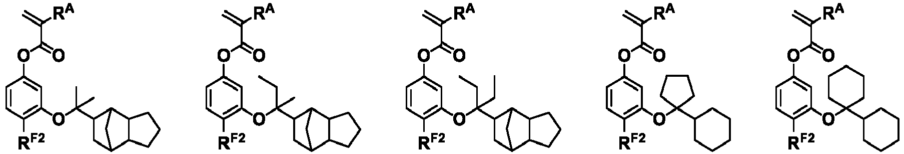

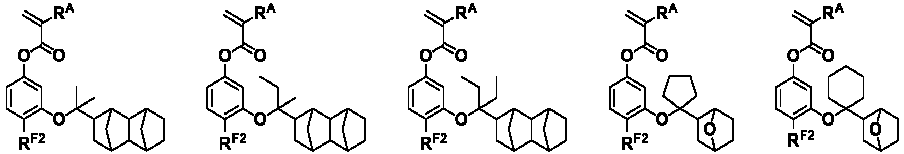

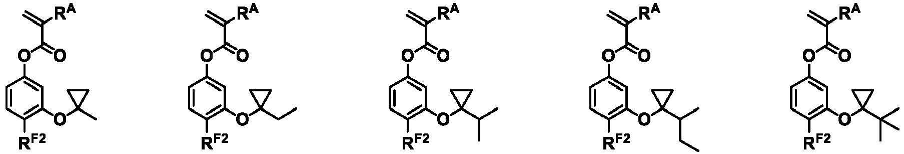

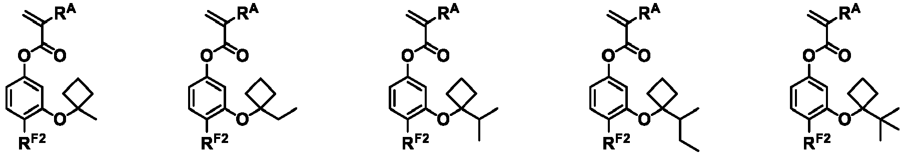

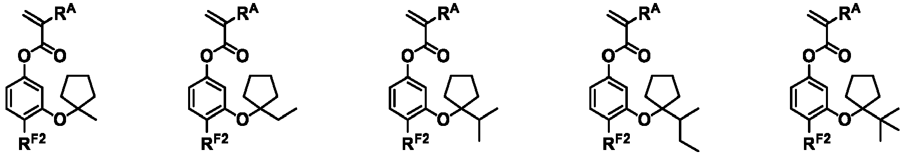

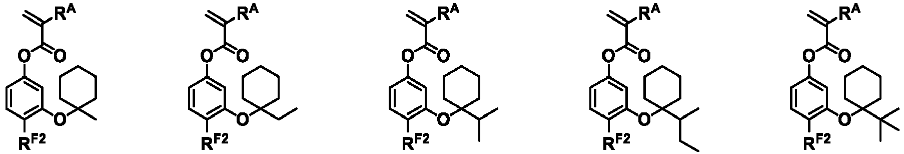

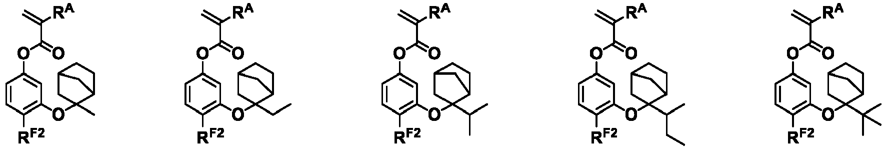

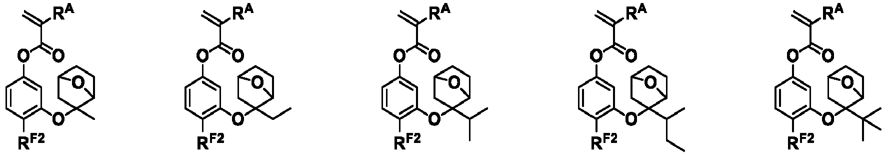

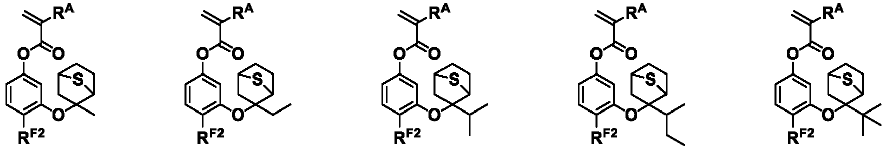

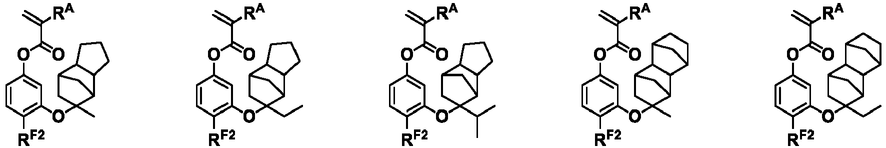

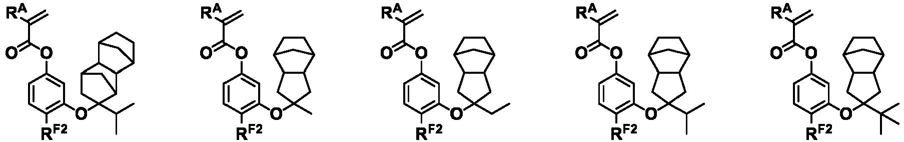

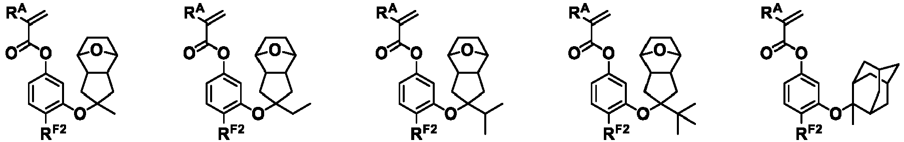

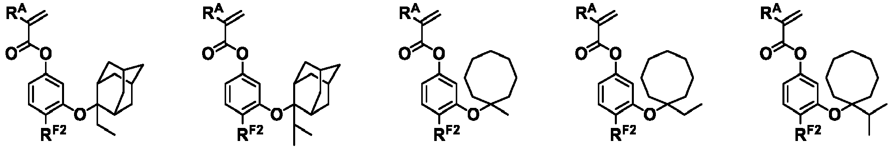

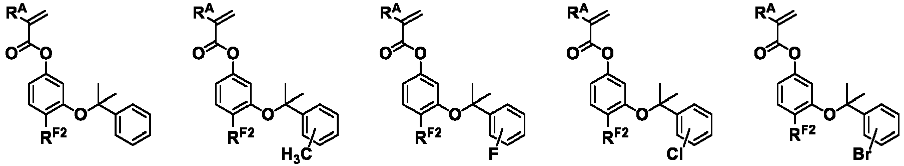

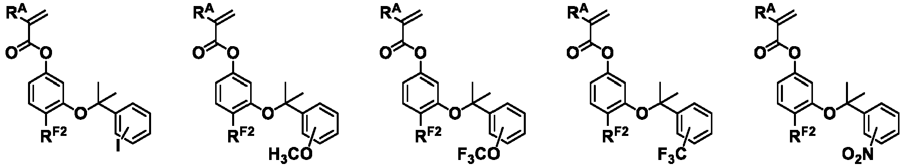

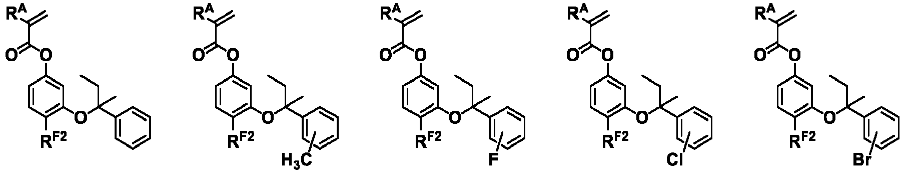

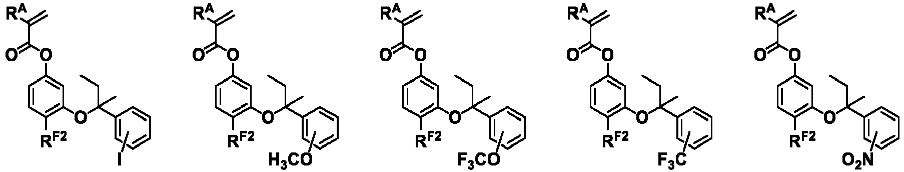

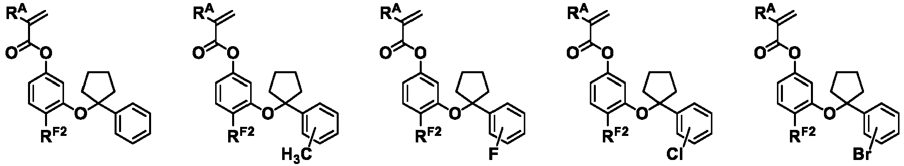

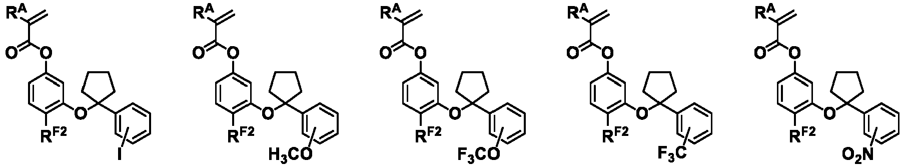

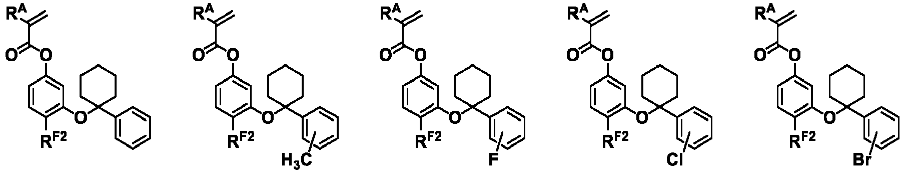

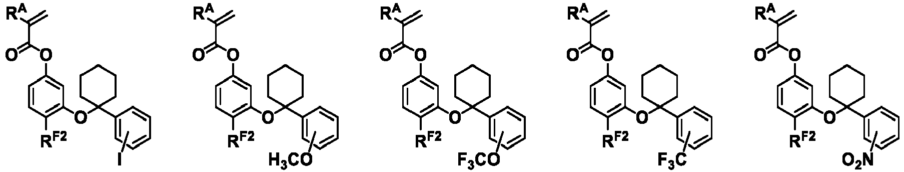

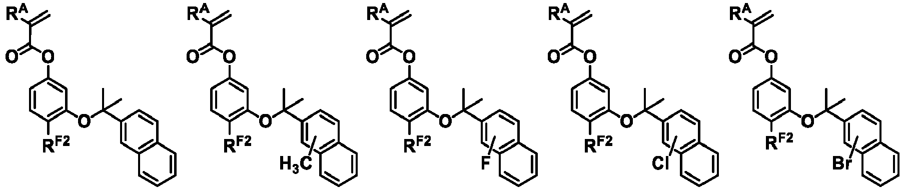

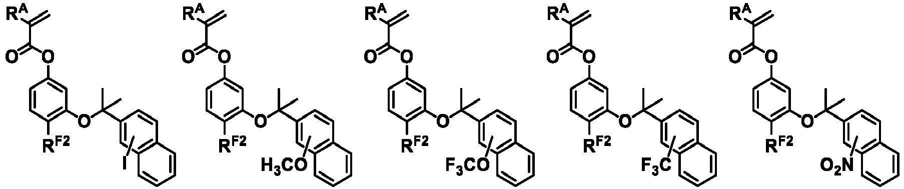

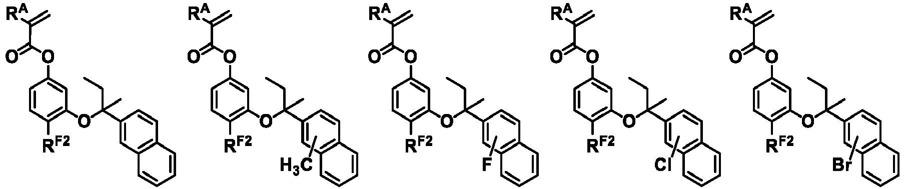

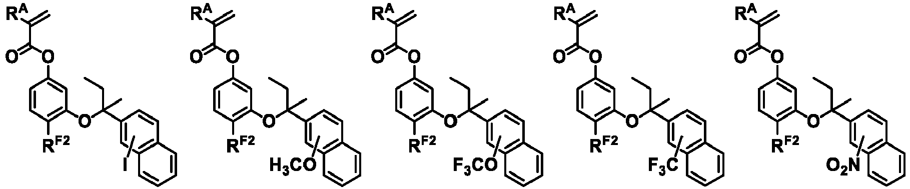

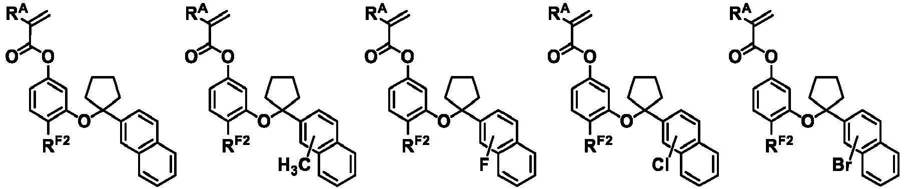

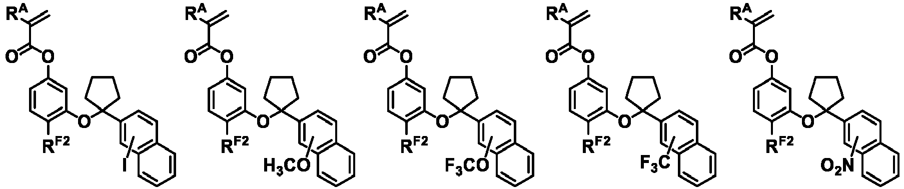

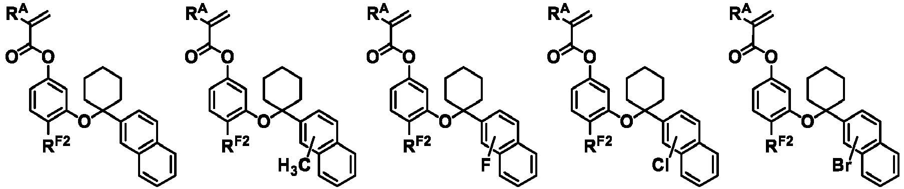

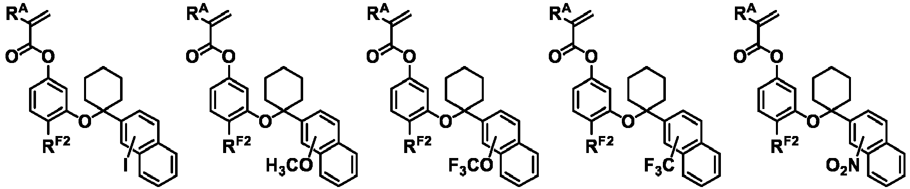

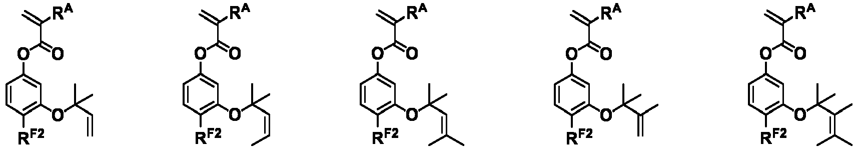

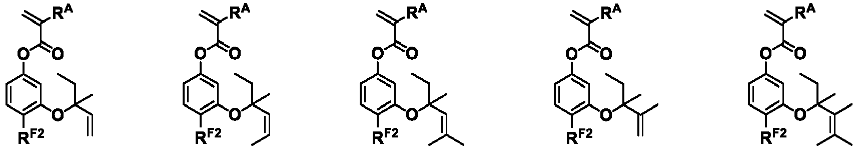

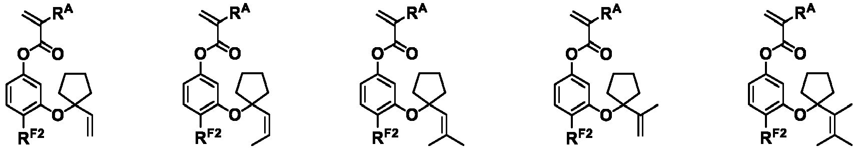

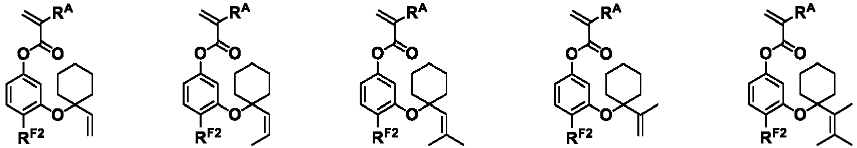

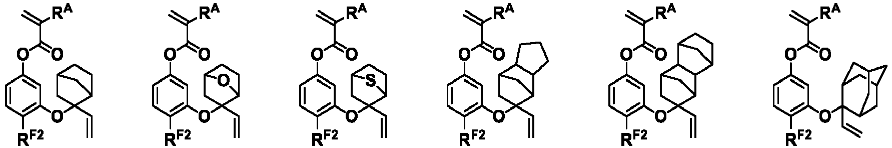

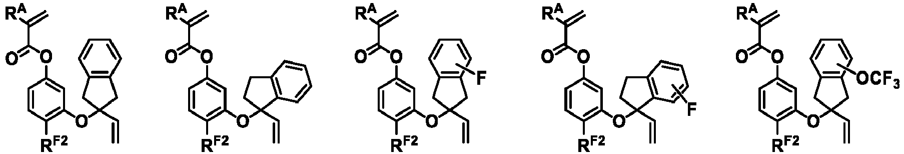

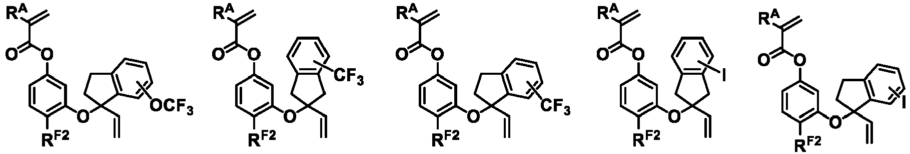

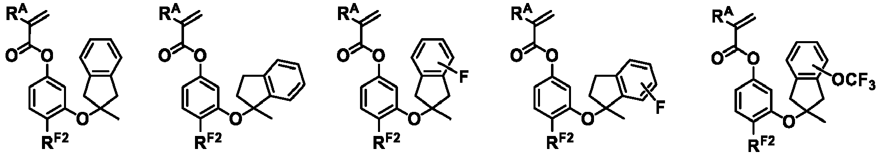

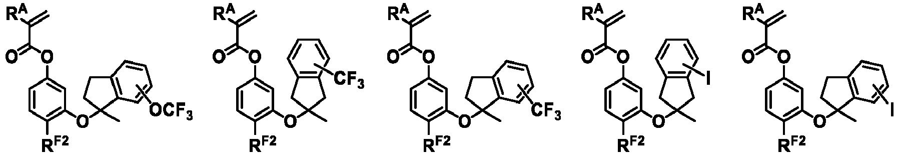

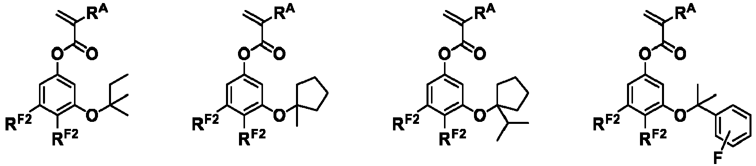

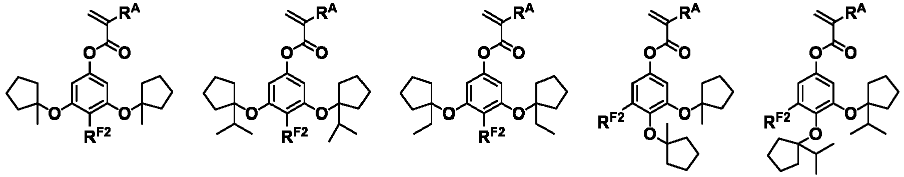

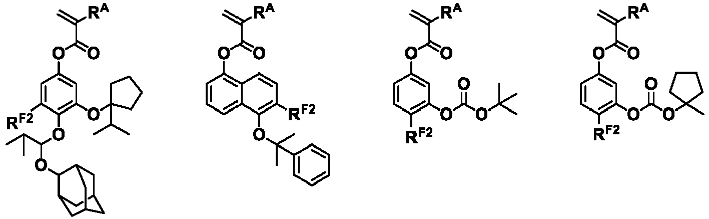

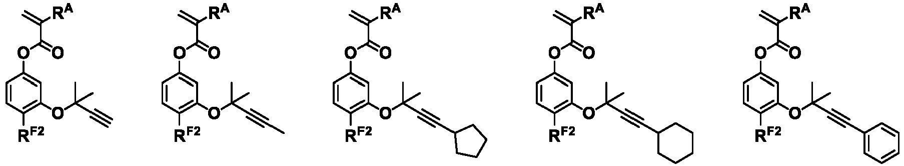

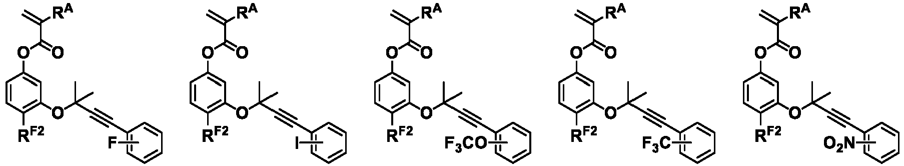

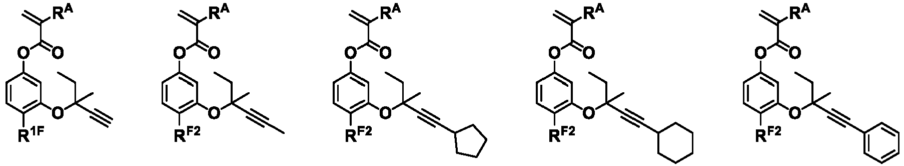

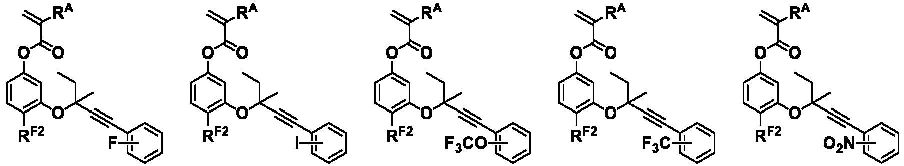

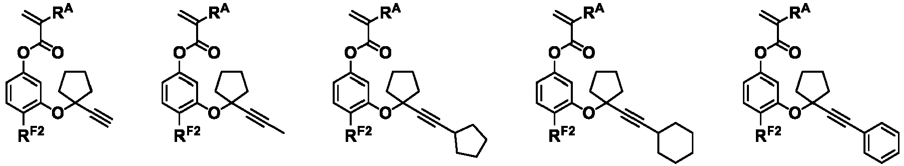

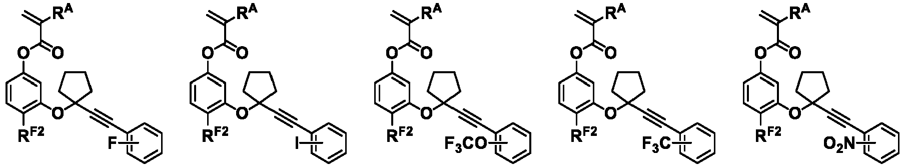

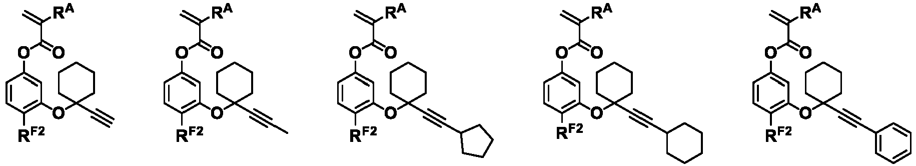

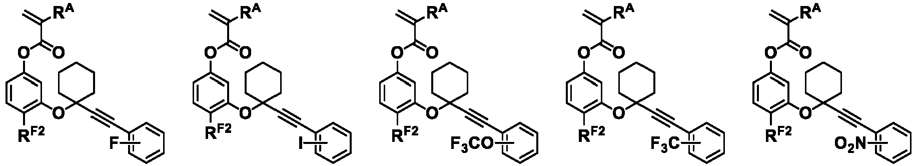

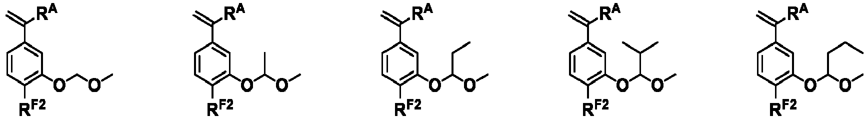

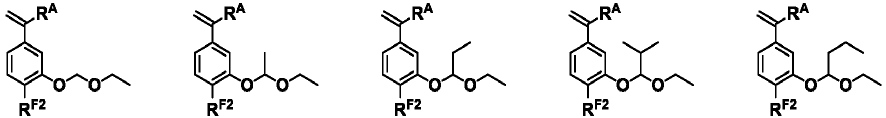

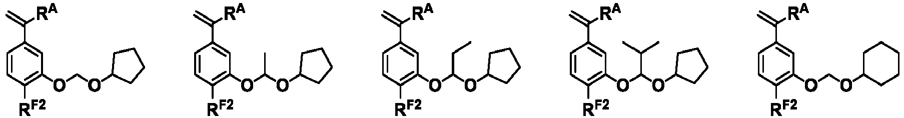

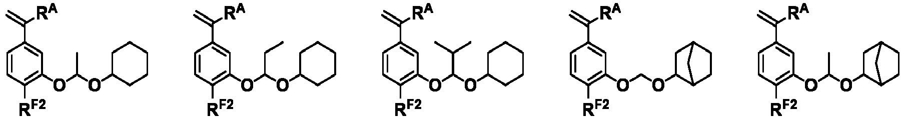

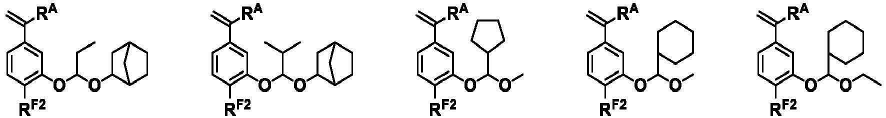

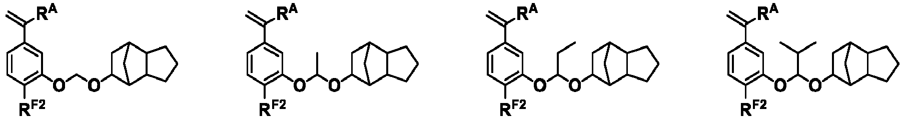

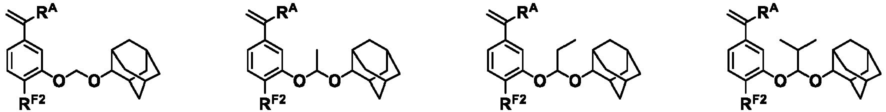

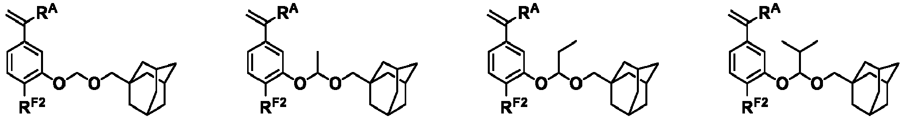

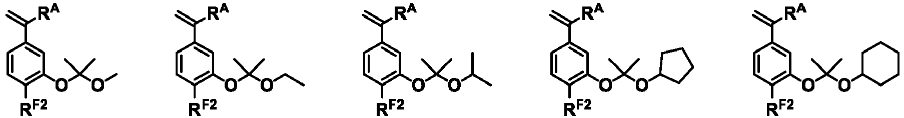

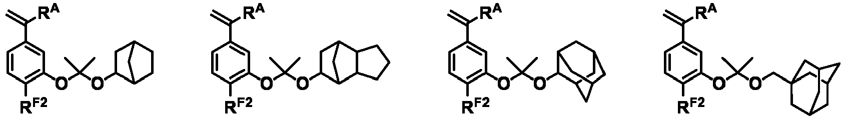

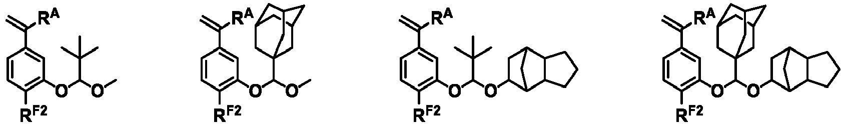

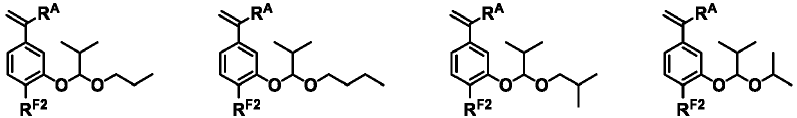

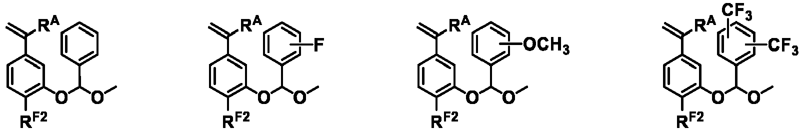

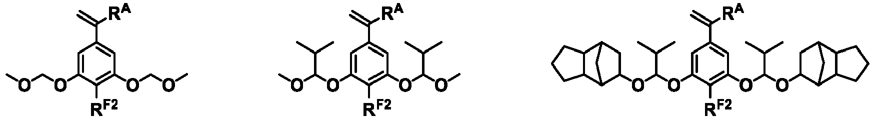

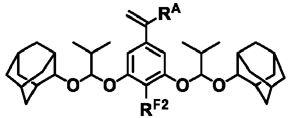

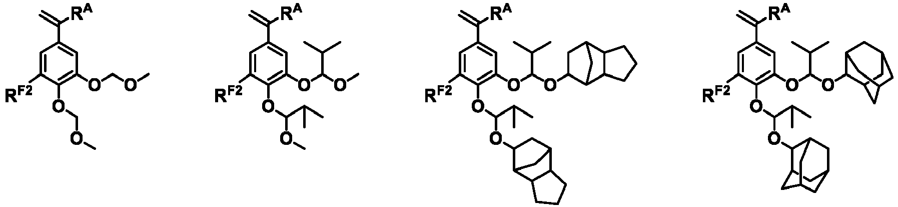

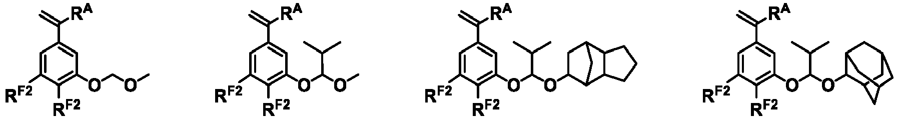

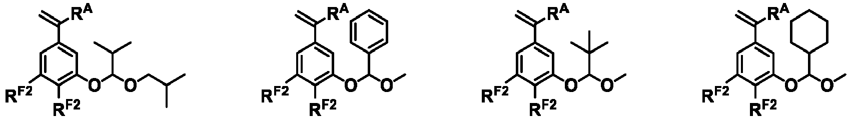

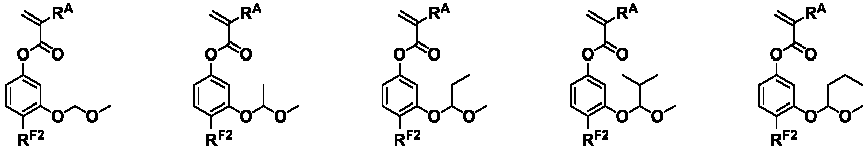

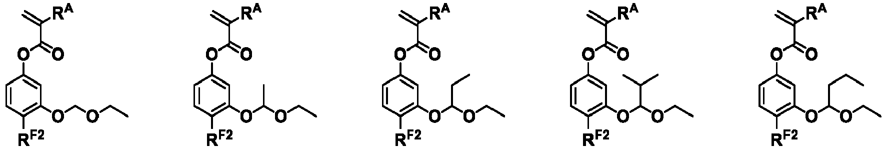

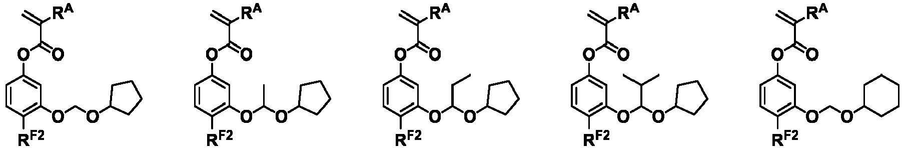

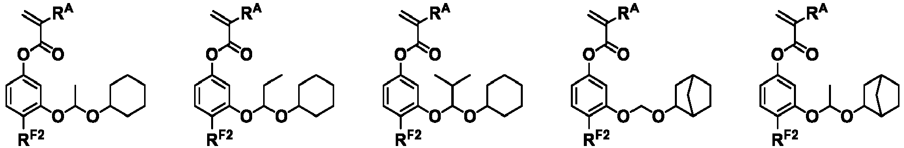

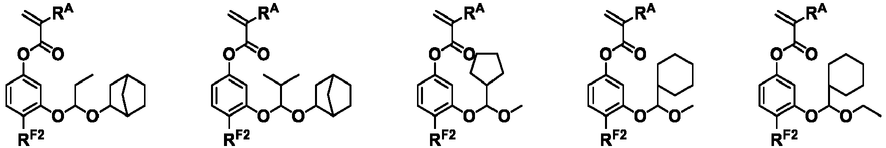

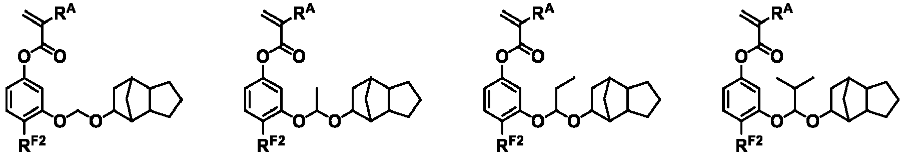

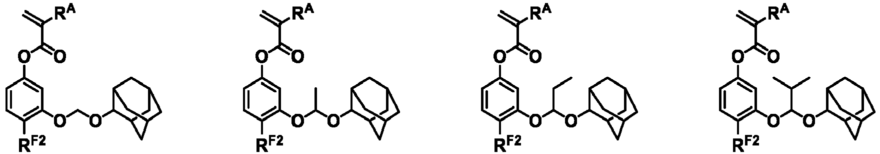

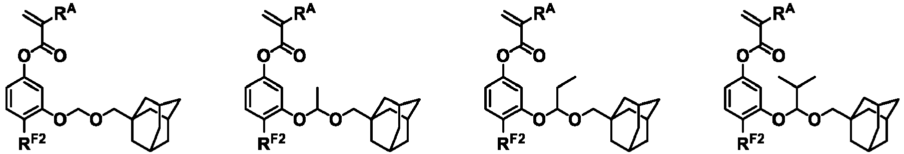

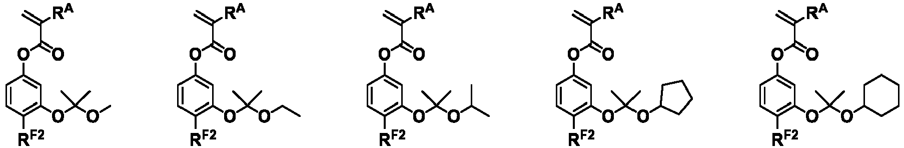

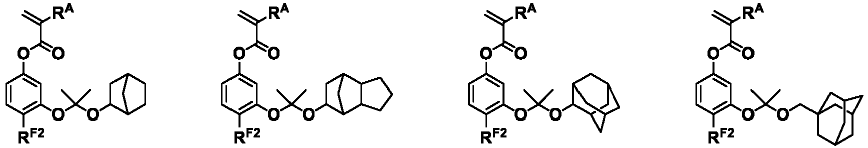

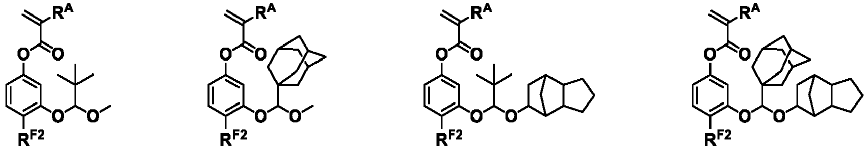

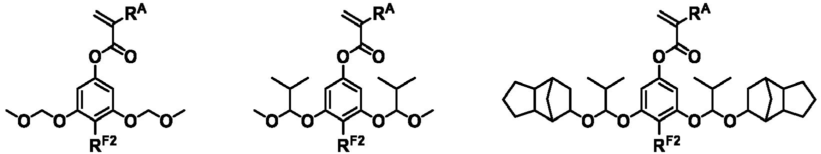

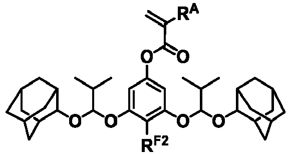

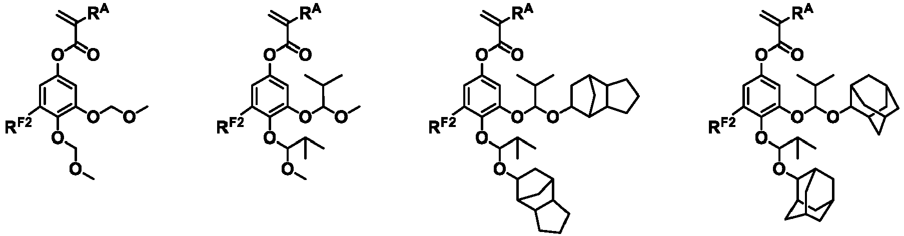

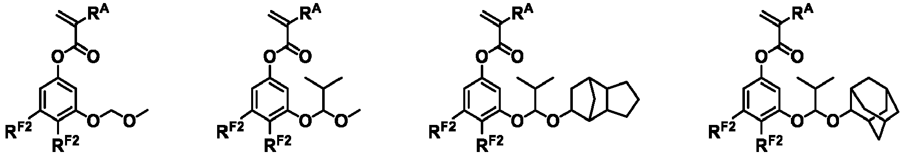

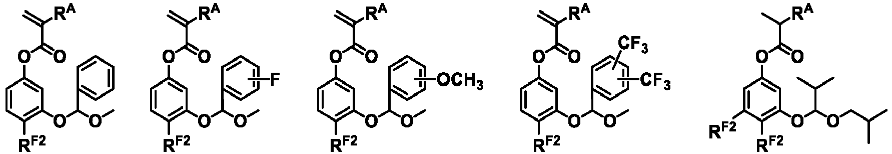

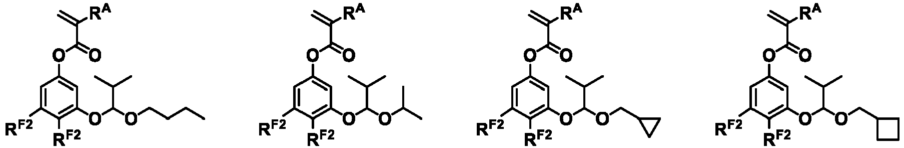

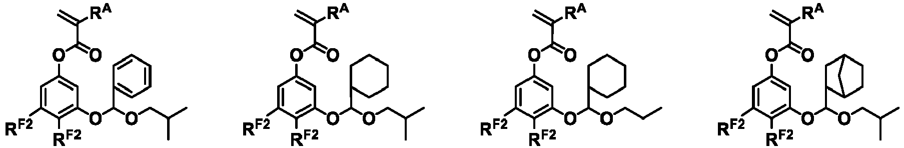

The polymer may further comprise repeat units of at least one type selected from repeat units having the formula (B2) and repeat units having the formula (B3), which are also referred to as repeat units B2 and B3, respectively.

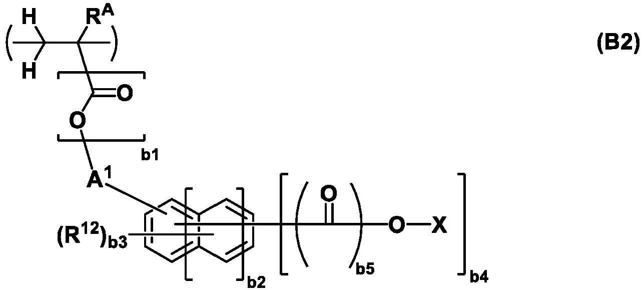

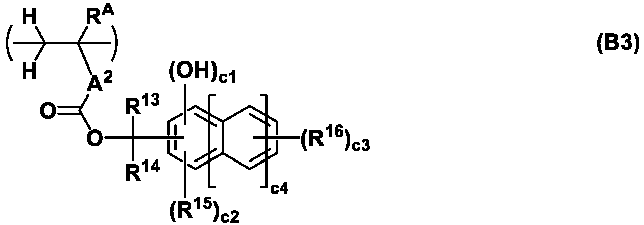

In formula (B2), b1 is 0 or 1, and b2 is an integer of 0 to 2. The structure represents a benzene skeleton in case of b2=0, a naphthalene skeleton in case of b2=1, and an anthracene skeleton in case of b2=2. The subscript b3 is an integer meeting 0 ≤ b3 ≤ 5+2(b2)-b4; b4 is an integer of 1 to 3, and b5 is 0 or 1. In case of b2=0, preferably b3 is an integer of 0 to 3, and b4 is an integer of 1 to 3. In case of b2=1 or 2, preferably b3 is an integer of 0 to 4, and b4 is an integer of 1 to 3.

In formula (B3), c1 is an integer of 0 to 2, c2 is an integer of 0 to 2, c3 is an integer of 0 to 5, and c4 is an integer of 0 to 2.

In formulae (B2) and (B3), R^{A} is each independently hydrogen, fluorine, methyl or trifluoromethyl.

In formula (B2), A¹ is a single bond or a C₁-C₁₀ saturated hydrocarbylene group in which some constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of b 1 = 1 in formula (B2), the ether bond may be incorporated at any position excluding the position between the α- and β-carbons relative to the ester oxygen. In case of b 1=0, the atom in A¹ that bonds with the backbone becomes an ethereal oxygen atom, and a second ether bond may be incorporated at any position excluding the position between the α- and β-carbons relative to that ether oxygen. Saturated hydrocarbylene groups having no more than 10 carbon atoms are desirable because of a sufficient solubility in alkaline developer.

In formula (B3), A² is a single bond, phenylene group, naphthylene group or *-C(=O)-O-A²¹-. A²¹ is a C₁-C₂₀ aliphatic hydrocarbylene group which may contain hydroxy, ether bond, ester bond or lactone ring, or phenylene group or naphthylene group, and * designates a point of attachment to the carbon atom in the backbone.

In formula (B2), R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy and saturated hydrocarbylcarbonyloxy groups may be straight, branched or cyclic. Examples thereof include C₁-C₆ alkyl groups such as methyl, ethyl, propyl, isopropyl, butyl, pentyl, and hexyl; C₃-C₆ cycloalkyl groups such as cyclopropyl, cyclobutyl, cyclopentyl, and cyclohexyl; and combinations thereof. A carbon count within the upper limit ensures good solubility in alkaline developer. A plurality of R¹² may be identical or different when b3 is 2 or more.

In formula (B3), R¹³ and R¹⁴ are each independently a C₁-C₁₀ hydrocarbyl group which may contain a heteroatom. R¹³ and R¹⁴ may bond together to form a ring with the carbon atom to which they are attached.

In formula (B3), R¹⁵ is each independently fluorine, C₁-C₅ fluorinated alkyl group, or C₁-C₅ fluorinated alkoxy group. A plurality of R¹⁵ may be identical or different when c2 is 2 or more.

In formula (B3), R¹⁶ is each independently a C₁-C₁₀ hydrocarbyl group which may contain a heteroatom. A plurality of R¹⁶ may be identical or different when c3 is 2 or more.

In formula (B2), X is an acid labile group in case of b4=1, and X is hydrogen or an acid labile group, at least one being an acid labile group, in case of b4=2 or 3. That is, repeat unit B2 is such that at least one phenolic hydroxy group bonded to the aromatic ring is protected with an acid labile group, or the carboxy group bonded to the aromatic ring is protected with an acid labile group. The acid labile group is not particularly limited and may be selected from many acid labile groups which are eliminatable to give an acidic group under the action of acid and commonly used in well-known chemically amplified resist compositions.

A choice of a tertiary saturated hydrocarbyl group as the acid labile group is preferred for the reason that even when a resist film is formed to a thickness of 10 to 100 nm and processed to form a fine pattern having a line width of up to 45 nm, the pattern has reduced LER. Of the tertiary saturated hydrocarbyl groups, tertiary alkyl groups of 4 to 18 carbon atoms are preferred because the corresponding monomer for use in polymerization is available through distillation. The group attached to the tertiary carbon atom in the tertiary saturated hydrocarbyl group is typically a C₁-C₁₅ saturated hydrocarbyl group which may contain an oxygen-containing functional group such as ether bond or carbonyl group. The groups attached to the tertiary carbon atom may bond together to form a ring.

Examples of the group bonded to the tertiary carbon atom include methyl, ethyl, propyl, adamantyl, norbornyl, tetrahydrofuran-2-yl, 7-oxanorbornan-2-yl, cyclopentyl, 2-tetrahydrofuryl, tricyclo[5.2.1.0^{2,6}]decyl, tetracyclo[4.4.0.1^{2,5}.1^{7,10}]dodecyl, and 3-oxo-1-cyclohexyl.

Examples of the tertiary saturated hydrocarbyl group having such a substituent include, but are not limited to, tert-butyl, tert-pentyl, 1-ethyl-1-methylpropyl, 1,1-diethylpropyl, 1,1,2-trimethylpropyl, 1-adamantyl-1-methylethyl, 1-methyl-1-(2-norbornyl)ethyl, 1-methyl-1-(tetrahydrofuran-2-yl)ethyl, 1-methyl-1-(7-oxanorbornan-2-yl)ethyl, 1-methylcyclopentyl, 1-ethylcyclopentyl, 1-propylcyclopentyl, 1-isopropylcyclopentyl, 1-cyclopentylcyclopentyl, 1-cyclohexylcyclopentyl, 1-(2-tetrahydrofuryl)cyclopentyl, 1-(7-oxanorbornan-2-yl)cyclopentyl, 1-methylcyclohexyl, 1-ethylcyclohexyl, 1-cyclopentylcyclohexyl, 1-cyclohexylcyclohexyl, 2-methyl-2-norbornyl, 2-ethyl-2-norbornyl, 8-methyl-8-tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl,3-ethyl-3-tetracyclo[4.4.0.1^{2,5}.1^{7,10}]dodecyl, 2-methyl-2-adamantyl, 2-ethyl-2-adamantyl, 1-methyl-3-oxo-1-cyclohexyl, 1-methyl-1-(tetrahydrofuran-2-yl)ethyl, 5-hydroxy-2-methyl-2-adamantyl, and 5-hydroxy-2-ethyl-2-adamantyl.

A group having the following formula (B2-1) is also suitable as the acid labile group. The group having formula (B2-1) is often used as the acid labile group. It is a good choice of the acid labile group that ensures to form a pattern having a relatively rectangular pattern-substrate interface in a consistent manner. An acetal structure is formed when X is a group having formula (B2-1).

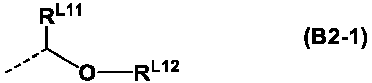

In formula (B2-1), R^{L11} is hydrogen or a C₁-C₁₀ saturated hydrocarbyl group. R^{L12} is a C₁-C₃₀ saturated hydrocarbyl group. The saturated hydrocarbyl group may be straight, branched or cyclic.

A choice of R^{L11} may depend on the designed sensitivity of labile group to acid. For example, hydrogen is selected when the acid labile group is designed to ensure relatively high stability and to be decomposed with strong acid. A straight alkyl group is selected when the acid labile group is designed to have relatively high reactivity and high sensitivity to pH changes. Although the choice varies with a particular combination of acid generator and basic compound in the resist composition, R^{L11} is preferably a group in which the carbon in bond with acetal carbon is secondary, when R^{L12} is a relatively large alkyl group substituted at the end and the acid labile group is designed to undergo a substantial change of solubility by decomposition. Examples of R^{L11} bonded to acetal carbon via secondary carbon include isopropyl, sec-butyl, cyclopentyl, and cyclohexyl.

In the acetal group, R^{L12} is preferably a C₇-C₃₀ polycyclic alkyl group for acquiring a higher resolution. When R^{L12} is a polycyclic alkyl group, a bond is preferably formed between secondary carbon on the polycyclic structure and acetal oxygen. The acetal oxygen bonded to secondary carbon on the cyclic structure, as compared with the acetal oxygen bonded to tertiary carbon on the cyclic structure, ensures that a corresponding polymer becomes a stable compound, suggesting that the resist composition has better shelf stability and is not degraded in resolution. Said acetal oxygen, as compared with R^{L2} bonded to primary carbon via a straight alkyl group of at least one carbon atom, ensures that a corresponding polymer has a higher glass transition temperature (Tg), suggesting that a resist pattern after development is not deformed by bake.

Preferred examples of the group having formula (B2-1) are given below, but not limited thereto. Herein R^{L11} is as defined above.

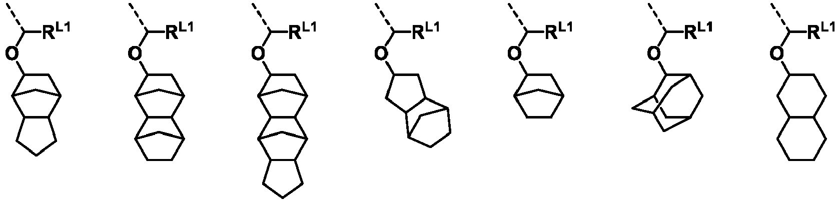

Preferred examples of repeat unit B3 are given below, but not limited thereto. Herein R^{A} is as defined above.

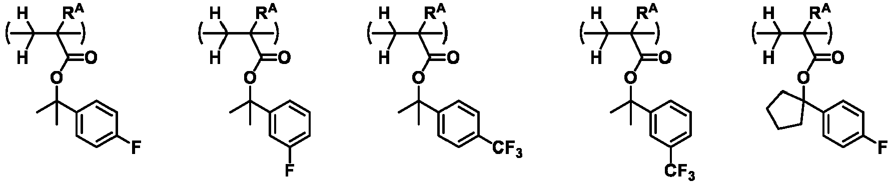

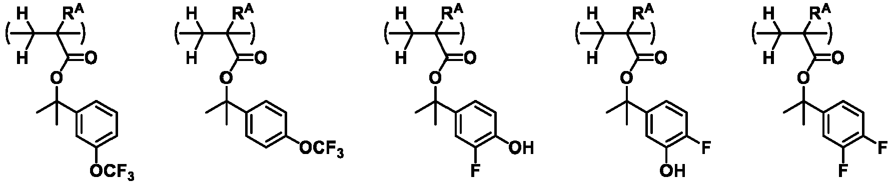

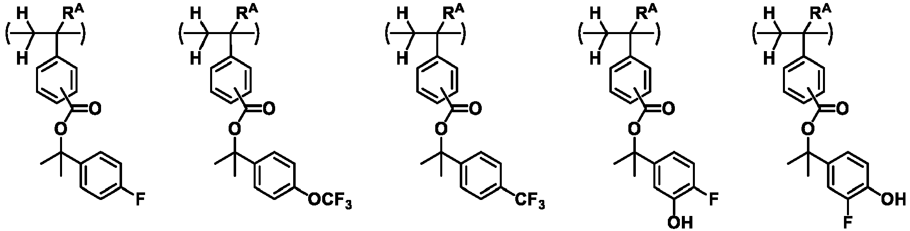

Another choice of acid labile group which can be used herein is a phenolic hydroxy group whose hydrogen is substituted by a tertiary saturated hydrocarbyl moiety: -CH₂COO-. Examples of the tertiary saturated hydrocarbyl moiety are as exemplified above for the tertiary saturated hydrocarbyl group used for the protection of phenolic hydroxy group.

The repeat units B 1 are preferably incorporated in a range of 4 to 40 mol% of the overall repeat units of the polymer in the base polymer. Repeat units of at least one type selected from repeat units B2 and B3 are preferably incorporated in a range of 2 to 40 mol% of the overall repeat units of the polymer in the base polymer. The sum of repeat units B1, B2 and B3 is preferably incorporated in a range of 8 to 60 mol%, more preferably 10 to 50 mol%, even more preferably 10 to 40 mol% of the overall repeat units of the polymer in the base polymer.

The polymer may further comprise repeat units having the formula (B4), which are also referred to as repeat units B4.

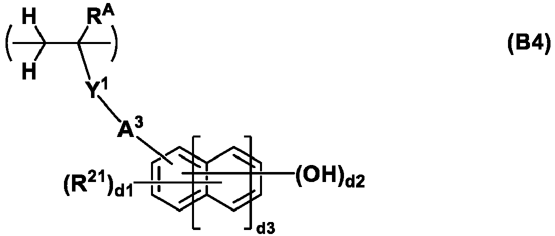

In formula (B4), d1 is an integer satisfying 0 ≤ d1 ≤ 5+2(d3)-d2, d2 is an integer of 1 to 3, and d3 is an integer of 0 to 2.

In formula (B4), R^{A} is hydrogen, fluorine, methyl or trifluoromethyl.

In formula (B4), Y¹ is a single bond, *-C(=O)-O- or *-C(=O)-NH-, wherein * designates a point of attachment to the carbon atom in the backbone.

In formula (B4), A³ is a single bond or a C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl and cyclohexanediyl; and combinations thereof.

In formula (B4), R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy and saturated hydrocarbyloxy groups may be straight, branched or cyclic and examples thereof include alkyl groups such as methyl, ethyl, n-propyl, isopropyl, butyl, pentyl, and hexyl; cycloalkyl groups such as cyclopropyl, cyclobutyl, cyclopentyl, and cyclohexyl; and combinations thereof. A carbon count within the upper limit ensures a good solubility in alkaline developer. A plurality of R²¹ may be identical or different when d1 is 2 or more.

Preferred examples of repeat units B4 wherein both Y¹ and A³ are a single bond include units derived from 3-hydroxystyrene, 4-hydroxystyrene, 5-hydroxy-2-vinylnaphthalene, and 6-hydroxy-2-vinylnaphthalene. Of these, repeat units having the formula (B4-1) are more preferred. Herein R^{A} and d2 are as defined above.

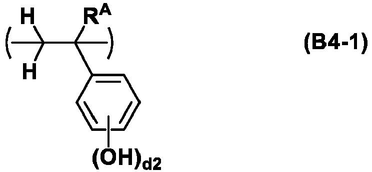

Preferred examples of repeat units B4 wherein Y¹ is other than a single bond are shown below, but not limited thereto. Herein R^{A} is as defined above.

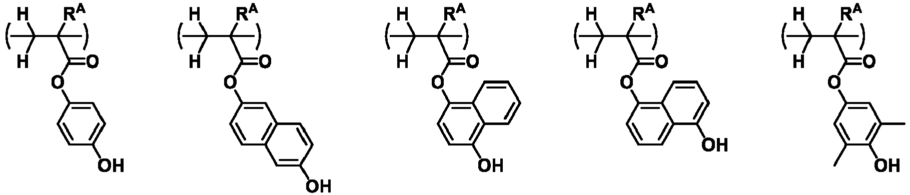

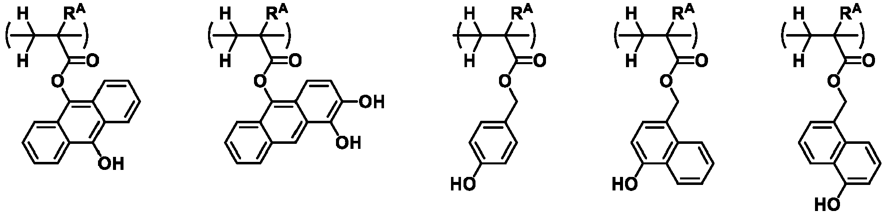

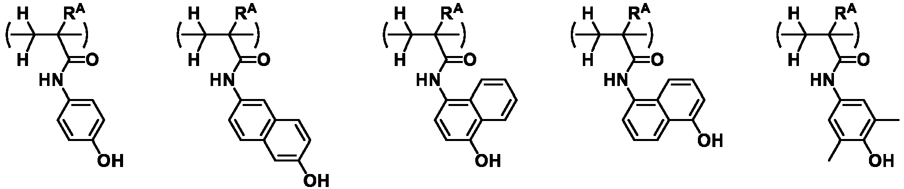

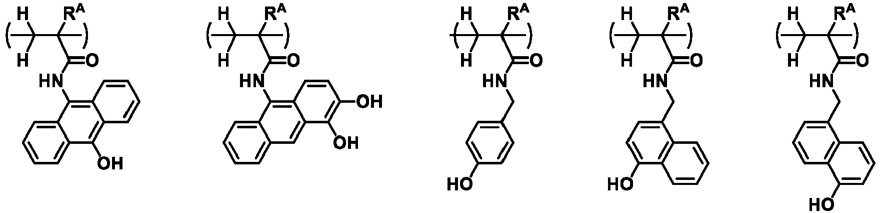

The repeat units B4 are preferably incorporated in an amount of 10 to 95 mol%, more preferably 30 to 85 mol% based on the overall repeat units of the polymer in the base polymer. It is noted that when the polymer contains additional repeat units of at least one type selected from repeat units having formulae (B5) and (B6) contributing to high etching resistance, the additional repeat units having a phenolic hydroxy group as a substituent group, the sum of repeat units B4 and additional repeat units preferably falls in the above range. The repeat units B4 used herein may be of one type or a mixture of two or more types.

In a preferred embodiment, the polymer in the base polymer further comprises repeat units of at least one type selected from repeat units having the formula (B5), repeat units having the formula (B6), and repeat units having the formula (B7), which are also referred to as repeat units B5, B6 and B7, respectively.

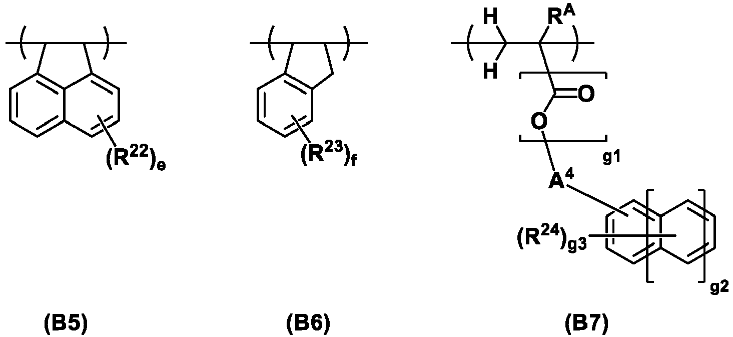

In formulae (B5) and (B6), e is an integer of 0 to 6, and f is an integer of 0 to 4.

In formulae (B5) and (B6), R²² and R²³ are each independently a hydroxy group, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group. The saturated hydrocarbyl group, saturated hydrocarbyloxy group and saturated hydrocarbylcarbonyloxy group may be straight, branched or cyclic. A plurality of R²² may be identical or different when e is 2 or more. A plurality of R²³ may be identical or different when f is 2 or more.

In formula (B7), R^{A} is as defined above, g1 is an integer of 0 to 5, g2 is an integer of 0 to 2, and g3 is an integer of 0 to 5.

In formula (B7), R²⁴ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group. R²⁴ may also be hydroxy when g2 is 1 or 2. The saturated hydrocarbyl group, saturated hydrocarbyloxy group, saturated hydrocarbylcarbonyloxy group, saturated hydrocarbyloxyhydrocarbyl group and saturated hydrocarbylthiohydrocarbyl group may be straight, branched or cyclic. A plurality of R²⁴ may be identical or different when g3 is 2 or more.

In formula (B7), A⁴ is a single bond or a C₁-C₁₀ saturated hydrocarbylene group in which some constituent -CH₂- may be replaced by -O-. The saturated hydrocarbylene group may be straight, branched or cyclic and examples thereof are as exemplified for A¹ in formula (B2).

When repeat units of at least one type selected from repeat units B5 to B7 are incorporated, better performance is obtained because not only the aromatic ring possesses etch resistance, but the cyclic structure incorporated into the main chain also exerts the effect of improving resistance to etching and EB irradiation during pattern inspection step.

The repeat units B5 to B7 are preferably incorporated in a range of at least 5 mol% based on the overall repeat units of the polymer in the base polymer for obtaining the effect of improving etch resistance. Also, the repeat units B5 to B7 are preferably incorporated in a range of up to 30 mol%, more preferably up to 25 mol% based on the overall repeat units of the polymer in the base polymer. When the relevant units are free of functional groups or have a functional group other than hydroxy, their content of up to 30 mol% is preferred because the risk of forming development defects is eliminated. Each of the repeat units B5 to B7 may be of one type or a combination of plural types.

The total content of repeat units B4 and repeat units of at least one type selected from repeat units B5 to B7 is preferably at least 50 mol%, more preferably at least 60 mol%, even more preferably at least 65 mol% based on the overall repeat units of the polymer in the base polymer because of etch resistance during mask processing.

In a preferred embodiment, the polymer in the base polymer further comprises repeat units of at least one type selected from repeat units having the formula (B8), repeat units having the formula (B9), repeat units having the formula (B10), and repeat units having the formula (B11), which are also referred to as repeat units B8, B9, B10, and B11, respectively.

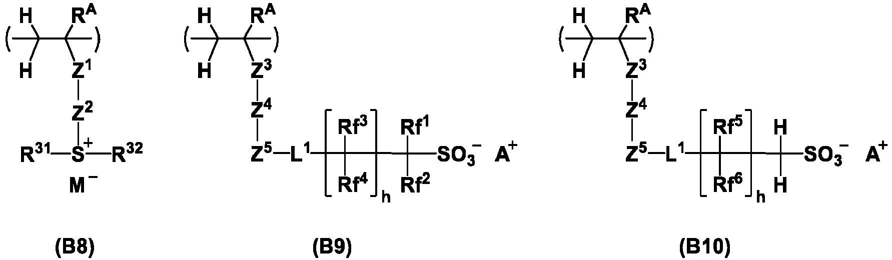

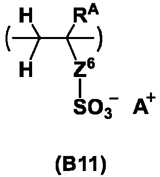

In formulae (B8) to (B11), R^{A} is each independently hydrogen, fluorine, methyl or trifluoromethyl. Z¹ is a single bond or phenylene group. Z² is *¹-C(=O)-O-Z²¹-, *¹-C(=O)-NH-Z²¹- or *¹-O-Z²¹-, wherein Z²¹ is a C₁-C₆ aliphatic hydrocarbylene group, phenylene group, or divalent group obtained by combining the foregoing, which may contain a carbonyl moiety, ester bond, ether bond or hydroxy moiety, *¹ designates a point of attachment to Z¹. Z³ is each independently a single bond, phenylene group, naphthylene group, or *²-C(=O)-O-Z³¹-, wherein Z³¹ is a C₁-C₁₀ aliphatic hydrocarbylene group, phenylene group, or naphthylene group, the aliphatic hydrocarbylene group may contain a hydroxy moiety, ether bond, ester bond or lactone ring, *² designates a point of attachment to the carbon atom in the backbone. Z⁴ is each independently a single bond, *³-Z⁴¹-C(=O)-O-, *³-C(=O)-NH-Z⁴¹- or *³-O-Z⁴¹-, wherein Z⁴¹ is a C₁-C₂₀ hydrocarbylene group which may contain a heteroatom, *³ designates a point of attachment to Z³. Z⁵ is each independently a single bond, *⁴-Z⁵¹-C(=O)-O-, *⁴-C(=O)-NH-Z⁵¹- or *⁴-O-Z⁵¹-, Z⁵¹ is a C₁-C₂₀ hydrocarbylene group which may contain a heteroatom, *⁴ designates a point of attachment to Z⁴. Z⁶ is a single bond, methylene, ethylene, phenylene, fluorinated phenylene, trifluoromethyl-substituted phenylene, *²-C(=O)-O-Z⁶¹-, *²-C(=O)-N(H)-Z⁶¹-, or *²-O-Z⁶¹-, wherein Z⁶¹ is a C₁-C₆ aliphatic hydrocarbylene group, phenylene group, fluorinated phenylene group, or trifluoromethyl-substituted phenylene group, which may contain a carbonyl moiety, ester bond, ether bond or hydroxy moiety, *² designates a point of attachment to the carbon atom in the backbone.

The aliphatic hydrocarbylene group represented by Z²¹, Z³¹ and Z⁶¹ may be straight, branched or cyclic. Examples thereof include alkanediyl groups such as methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, 1,1-dimethylethane-1,2-diyl, pentane-1,5-diyl, 2-methylbutane-1,2-diyl, and hexane-1,6-diyl; cycloalkanediyl groups such as cyclopropanediyl, cyclobutanediyl, cyclopentanediyl and cyclohexanediyl; and combinations thereof.

The hydrocarbylene group represented by Z⁴¹ and Z⁵¹ may be saturated or unsaturated and straight, branched or cyclic. Examples thereof are shown below, but not limited thereto.

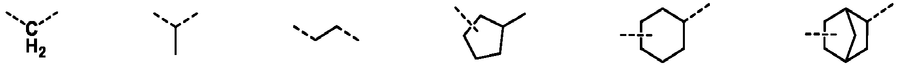

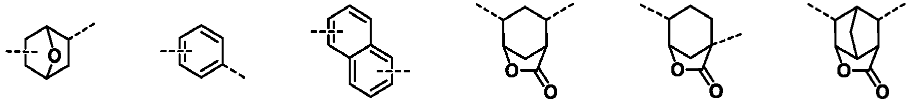

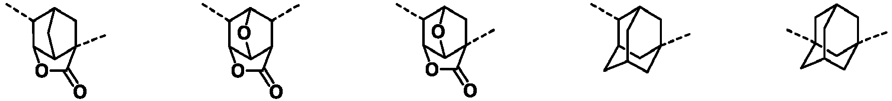

In formula (B8), R³¹ and R³² are each independently a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, n-propyl, isopropyl, n-butyl, and tert-butyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl; C₂-C₂₀ alkenyl groups such as vinyl, allyl, propenyl, butenyl, and hexenyl; C₃-C₂₀ cyclic unsaturated hydrocarbyl groups such as cyclohexenyl; C₆-C₂₀ aryl groups such as phenyl, naphthyl, and thienyl; C₇-C₂₀ aralkyl groups such as benzyl, 1-phenethyl and 2-phenethyl; and combinations thereof. Of these, aryl groups are preferred. In the hydrocarbyl group, some or all of the hydrogen atoms may be substituted by a moiety containing a heteroatom such as oxygen, sulfur, nitrogen or halogen and some constituent -CH₂- may be replaced by a moiety containing a heteroatom such as oxygen, sulfur or nitrogen, so that the group may contain a hydroxy moiety, fluorine, chlorine, bromine, iodine, cyano moiety, carbonyl moiety, ether bond, ester bond, sulfonate ester bond, carbonate bond, lactone ring, sultone ring, carboxylic anhydride (-C(=O)-O-C(=O)-), or haloalkyl moiety.

Also, R³¹ and R³² may bond together to form a ring with the sulfur atom to which they are attached. Examples of the ring are as exemplified above for the ring that R^{ct1} and R^{ct2} in formula (cation-1), taken together, form with the sulfur atom to which they are attached.

Examples of the cation in repeat units B8 are shown below, but not limited thereto. Herein R^{A} is as defined above.

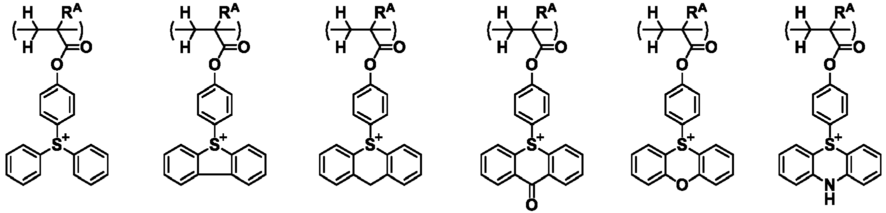

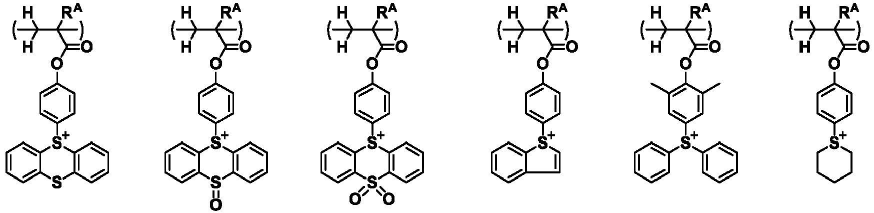

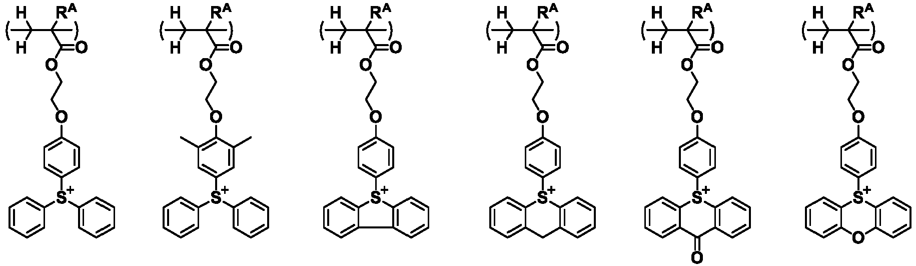

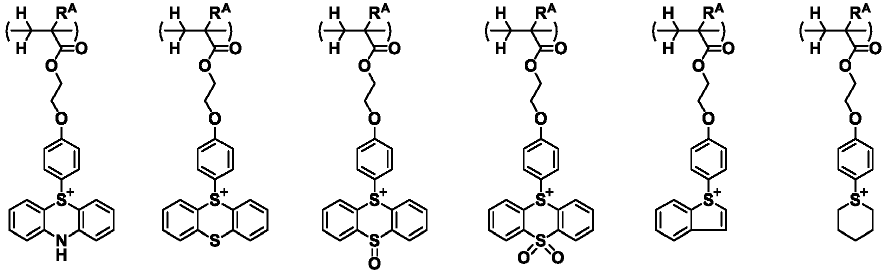

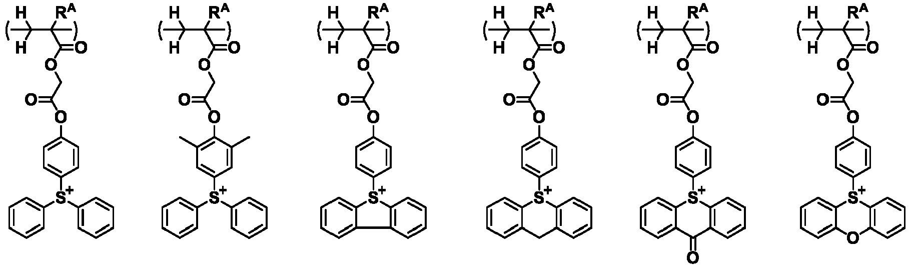

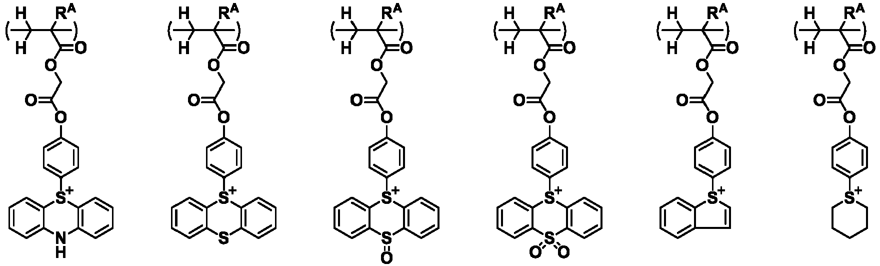

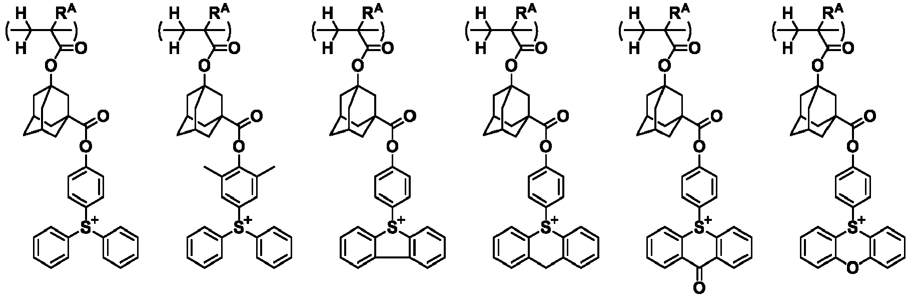

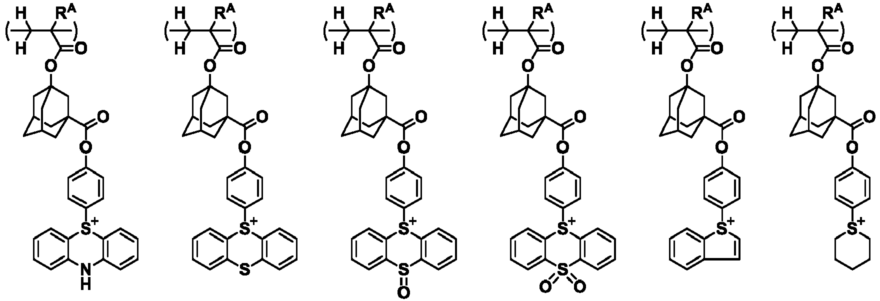

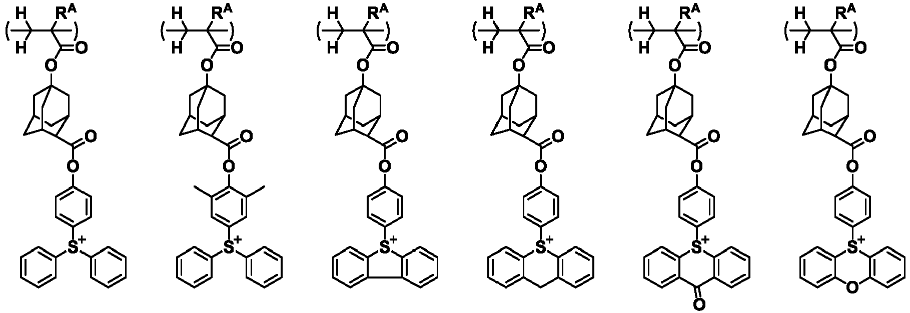

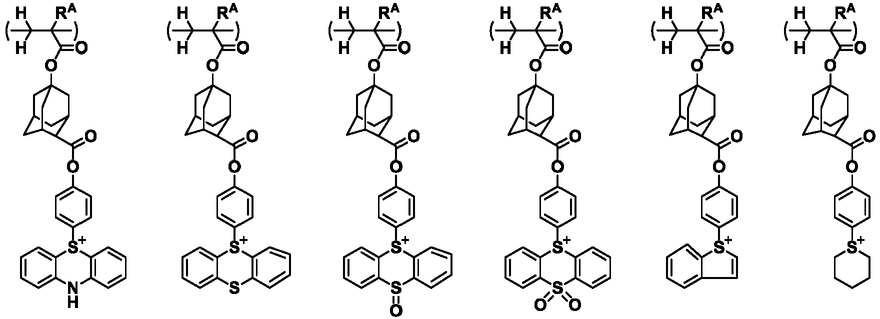

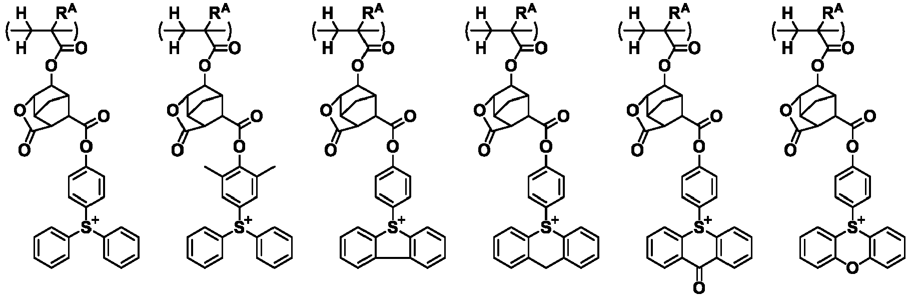

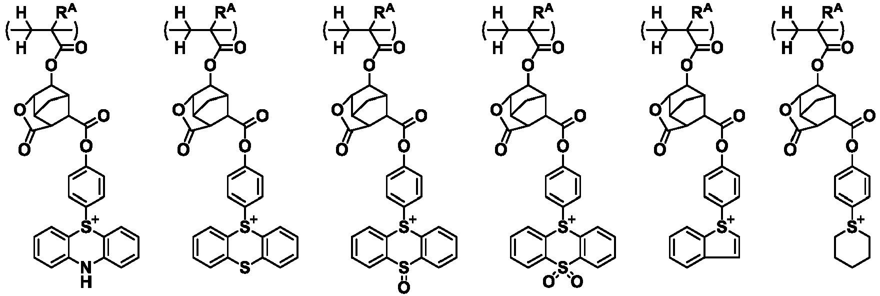

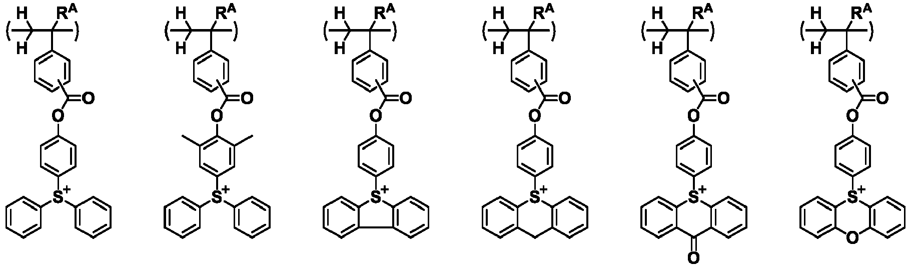

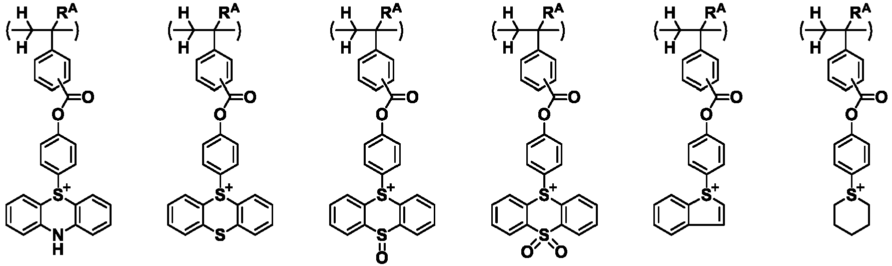

In formula (B8), M⁻ is a non-nucleophilic counter ion. Examples of the non-nucleophilic counter ion include halide ions such as chloride and bromide ions; sulfonate anions, specifically fluoroalkylsulfonate ions such as triflate, 1,1,1-trifluoroethanesulfonate, and nonafluorobutanesulfonate, arylsulfonate ions such as tosylate, benzenesulfonate, 4-fluorobenzenesulfonate, and 1,2,3,4,5-pentafluorobenzenesulfonate, alkylsulfonate ions such as mesylate and butanesulfonate; imide ions such as bis(trifluoromethylsulfonyl)imide, bis(perfluoroethylsulfonyl)imide and bis(perfluorobutylsulfonyl)imide; and methide ions such as tris(trifluoromethylsulfonyl)methide and tris(perfluoroethylsulfonyl)methide.

Also included are sulfonate anions having fluorine substituted at α-position as represented by the formula (B8-1) and sulfonate anions having fluorine substituted at α-position and trifluoromethyl at β-position as represented by the formula (B8-2).

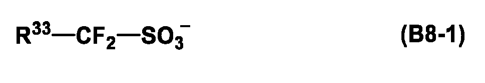

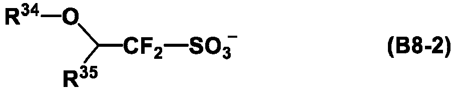

In formula (B8-1), R³³ is hydrogen, a C₁-C₃₀ hydrocarbyl group, C₂-C₃₀ hydrocarbylcarbonyloxy group, or C₂-C₃₀ hydrocarbyloxycarbonyl group. The hydrocarbyl group may contain halogen, an ether bond, ester bond, carbonyl moiety or lactone ring. The hydrocarbyl group and hydrocarbyl moiety in the hydrocarbylcarbonyloxy group and hydrocarbyloxycarbonyl group may be saturated or unsaturated and straight, branched or cyclic. Examples of the hydrocarbyl group include C₁-C₃₀ alkyl groups such as methyl, ethyl, propyl, isopropyl, butyl, isobutyl, sec-butyl, tert-butyl, pentyl, neopentyl, hexyl, heptyl, octyl, 2-ethylhexyl, nonyl, decyl, undecyl, dodecyl, tridecyl, pentadecyl, heptadecyl, and icosyl; C₃-C₃₀ cyclic saturated hydrocarbyl groups such as cyclopentyl, cyclohexyl, 1-adamantyl, 2-adamantyl, 1-adamantylmethyl, norbornyl, norbornylmethyl, tricyclodecanyl, tetracyclododecanyl, tetracyclododecanylmethyl, and dicyclohexylmethyl; C₂-C₃₀ unsaturated aliphatic hydrocarbyl groups such as allyl and 3-cyclohexenyl; C₆-C₃₀ aryl groups such as phenyl, 1-naphthyl, 2-naphthyl; C₇-C₃₀ aralkyl groups such as benzyl and diphenylmethyl; and combinations thereof.

In formula (B8-2), R³⁴ is hydrogen, or a C₁-C₃₀ hydrocarbyl group or C₂-C₃₀ hydrocarbylcarbonyl group. The hydrocarbyl group and hydrocarbylcarbonyl group may contain halogen, an ether bond, ester bond, carbonyl moiety or lactone ring. R³⁵ is hydrogen, fluorine, or a C₁-C₆ fluorinated alkyl group. The hydrocarbyl group and hydrocarbyl moiety in the hydrocarbylcarbonyl group may be saturated or unsaturated and straight, branched or cyclic. Examples thereof are as exemplified above for the hydrocarbyl group R³³. R³⁵ is preferably trifluoromethyl.

Examples of the sulfonate anion having formula (B8-1) or (B8-2) are shown below, but not limited thereto. Herein R³⁵ is as defined above.

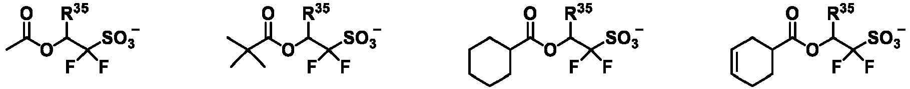

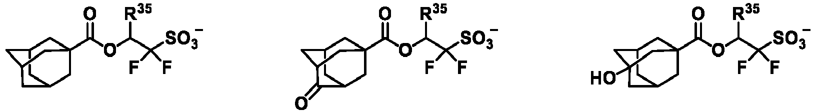

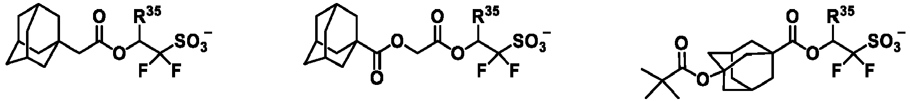

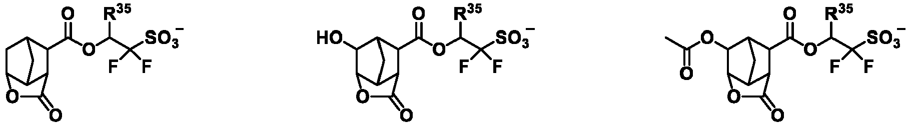

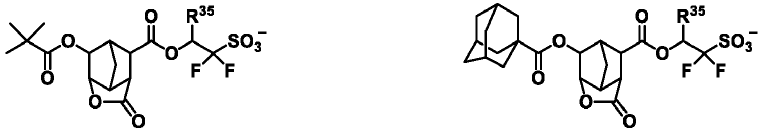

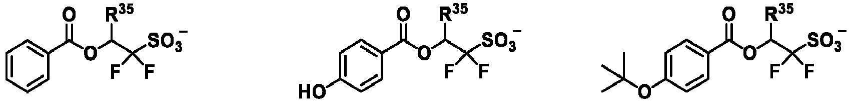

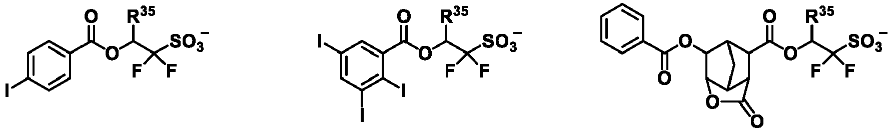

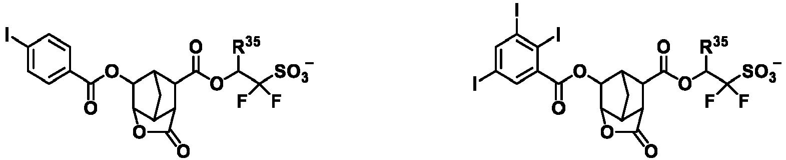

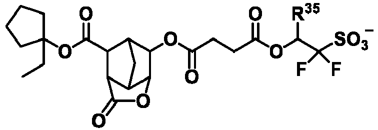

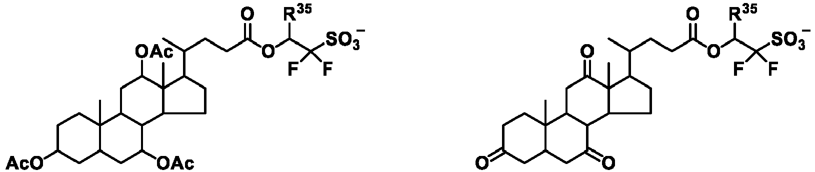

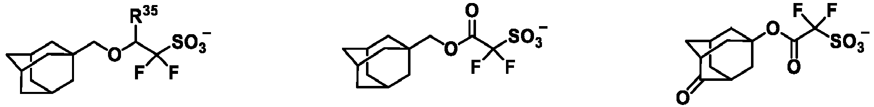

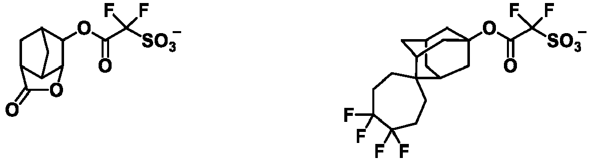

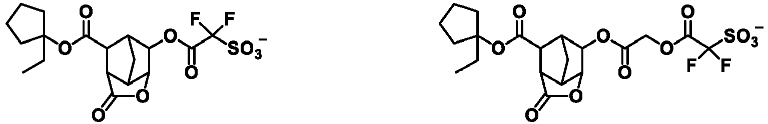

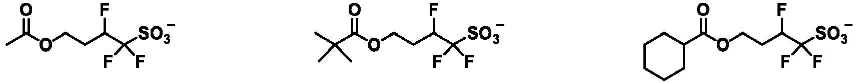

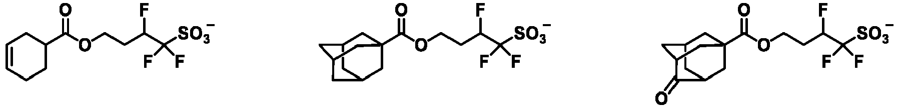

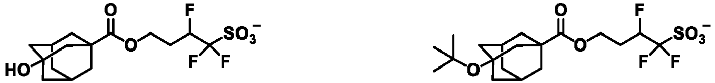

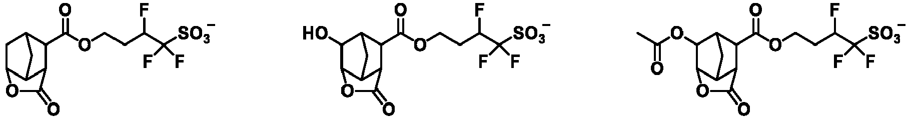

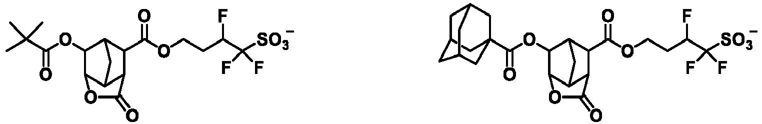

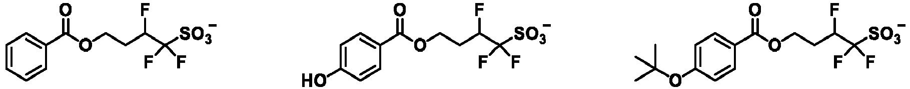

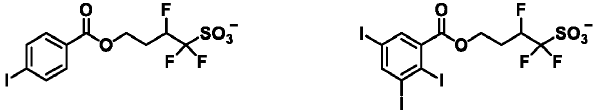

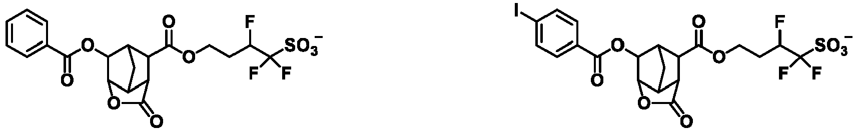

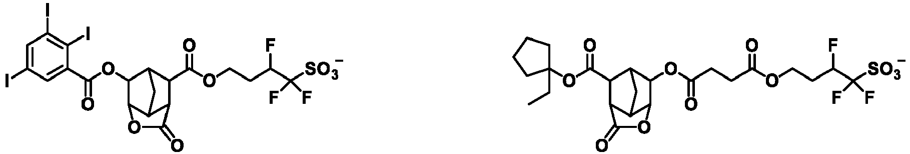

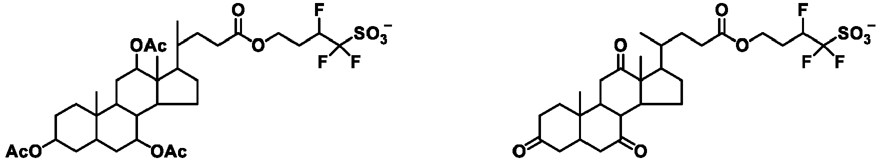

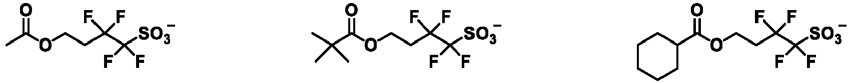

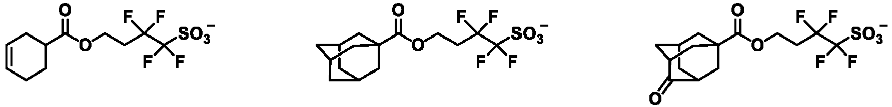

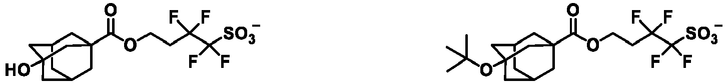

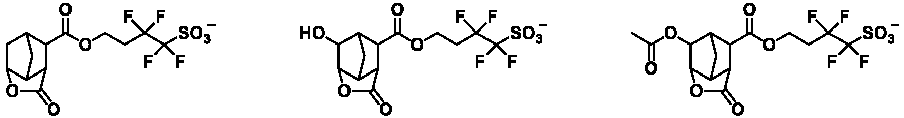

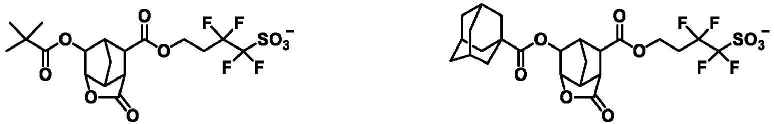

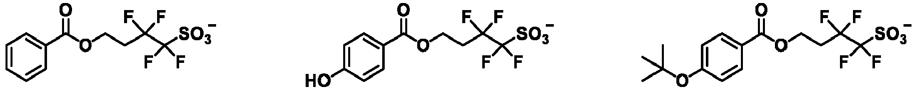

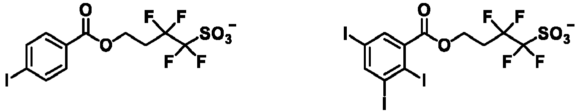

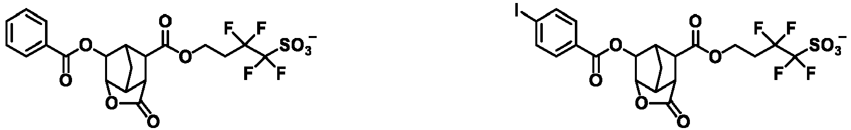

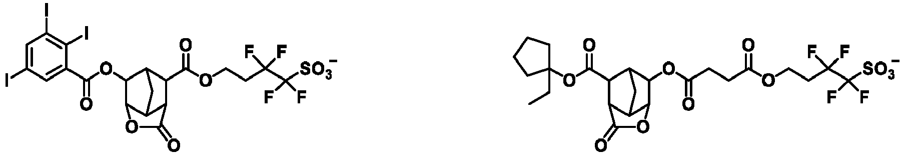

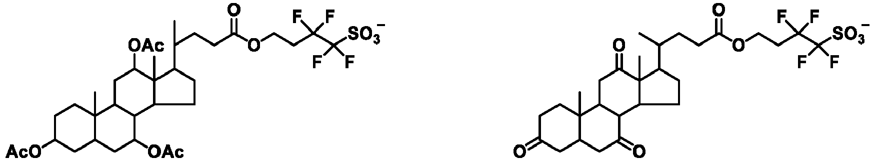

Non-fluorinated sulfonate anions are also exemplary of the non-nucleophilic counter ion. Their examples are shown below, but not limited thereto.

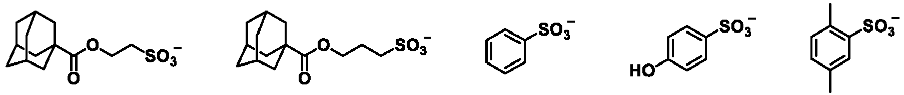

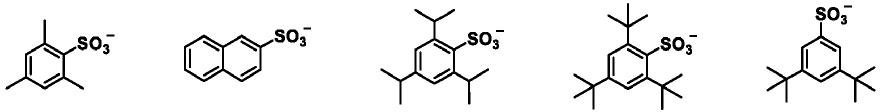

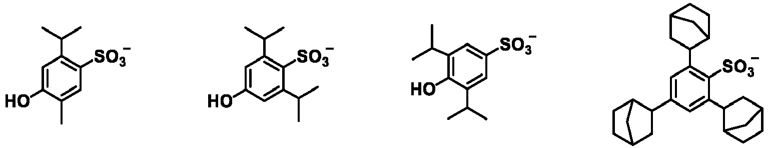

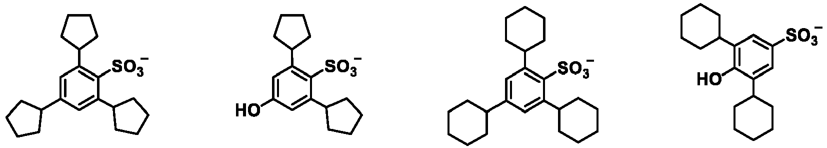

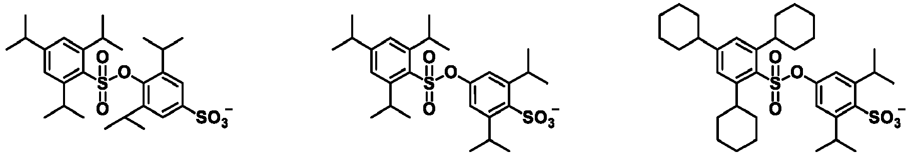

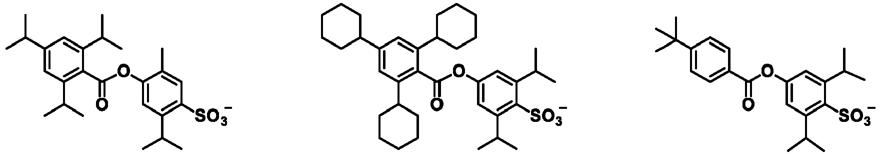

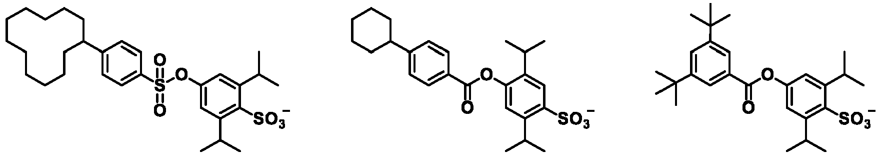

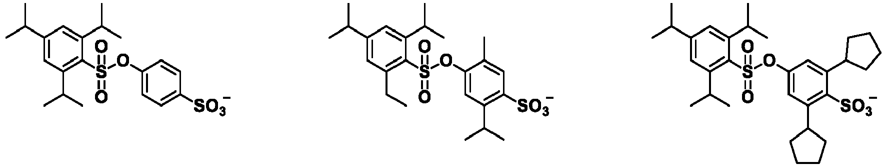

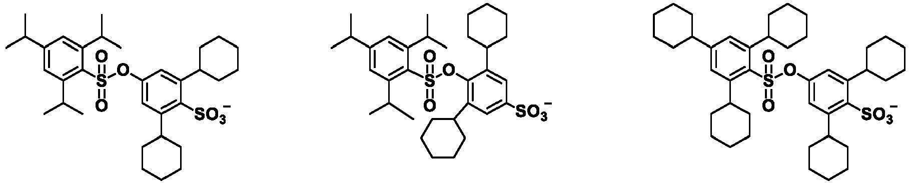

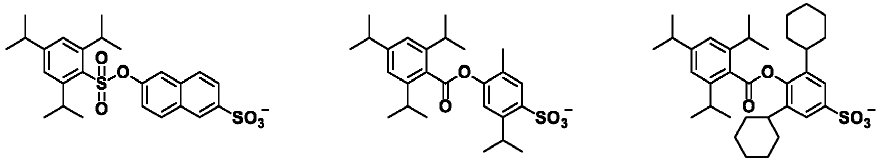

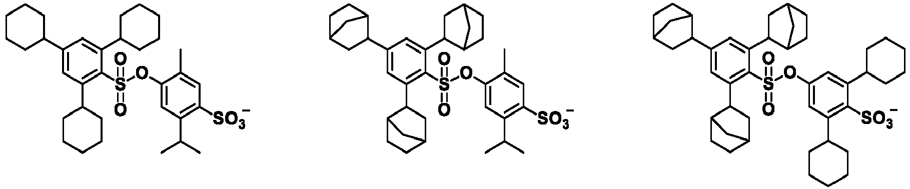

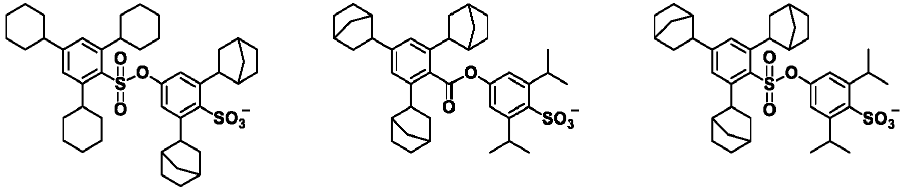

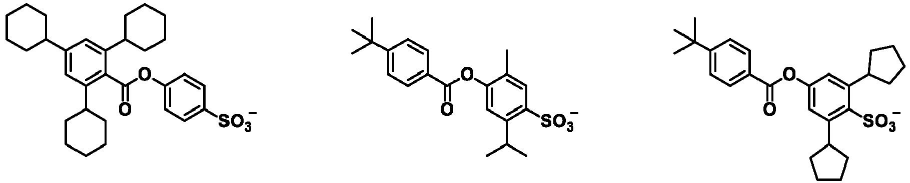

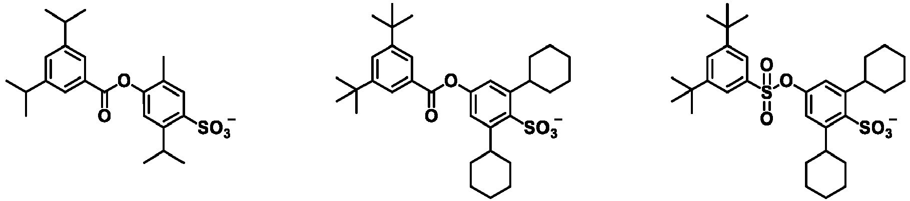

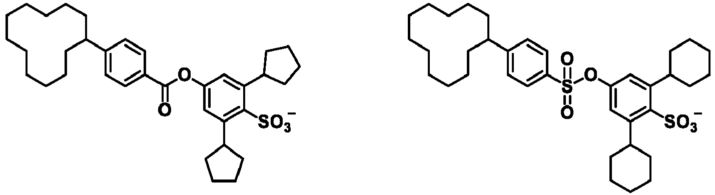

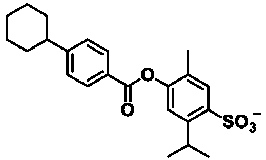

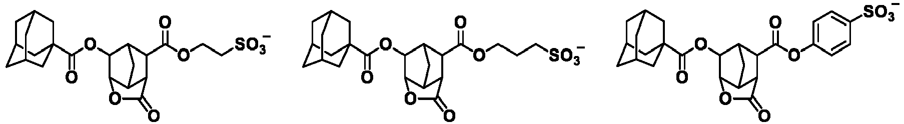

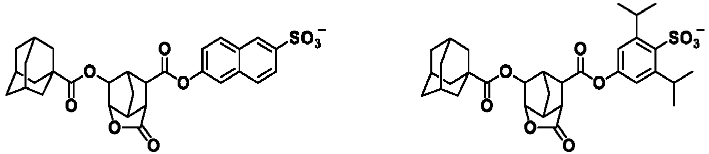

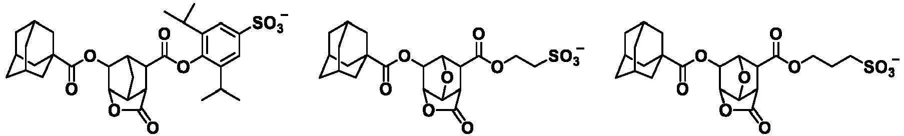

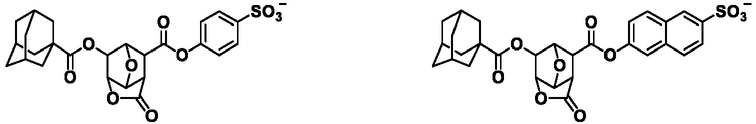

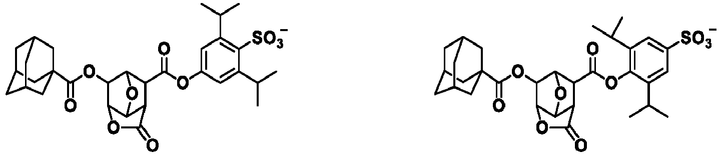

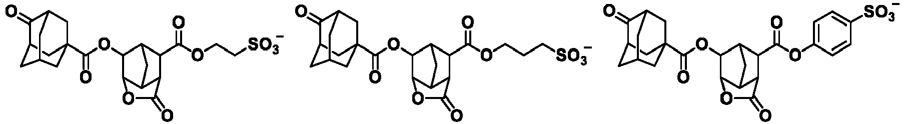

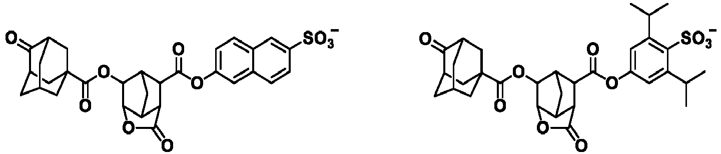

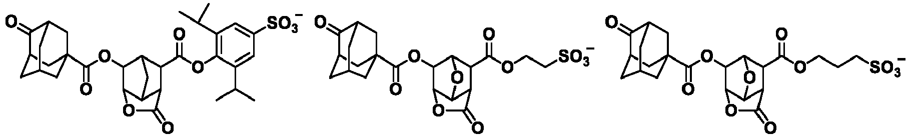

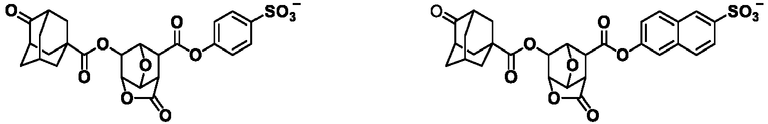

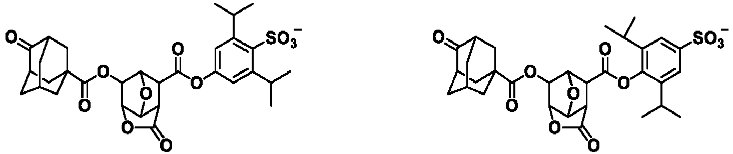

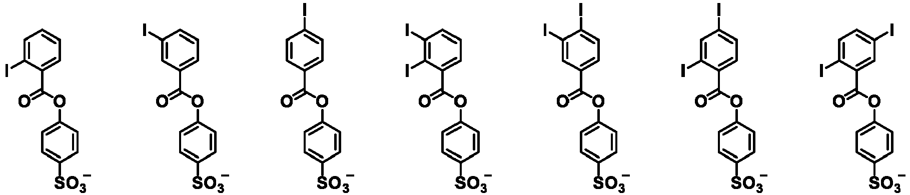

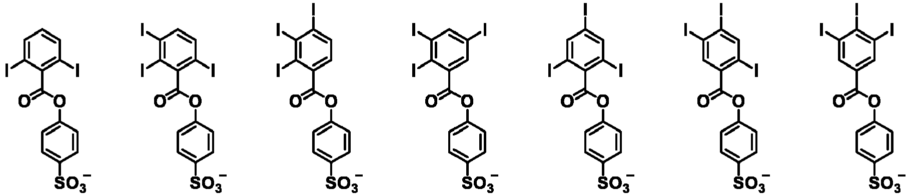

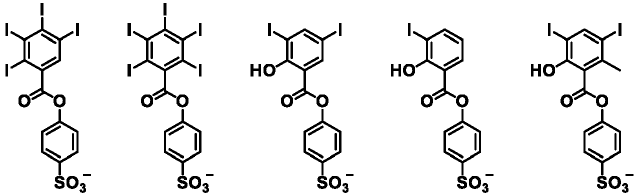

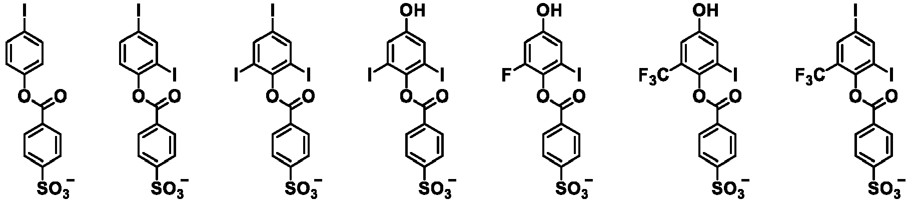

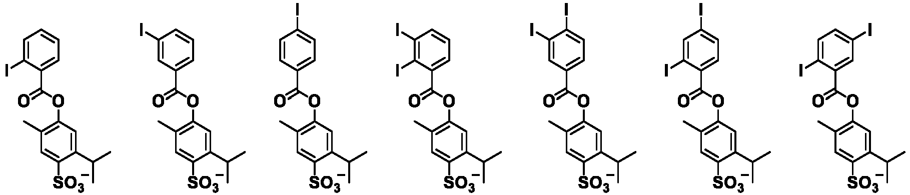

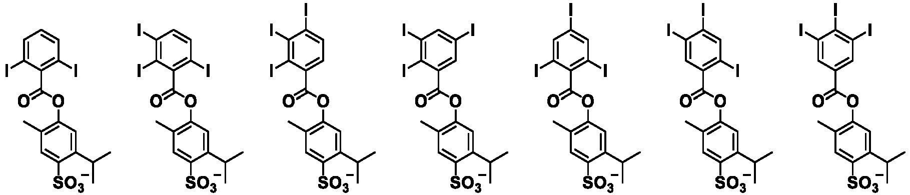

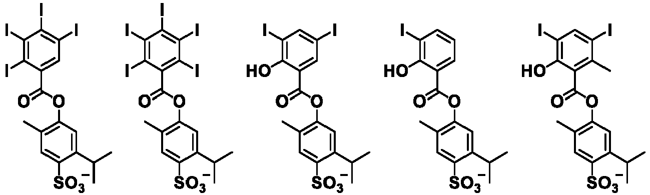

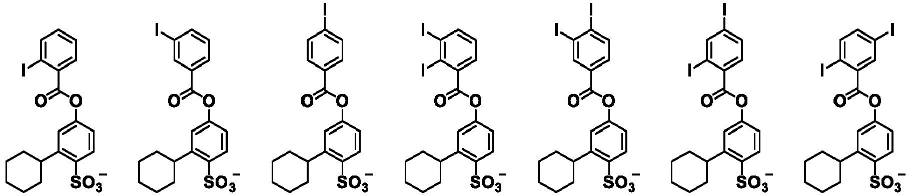

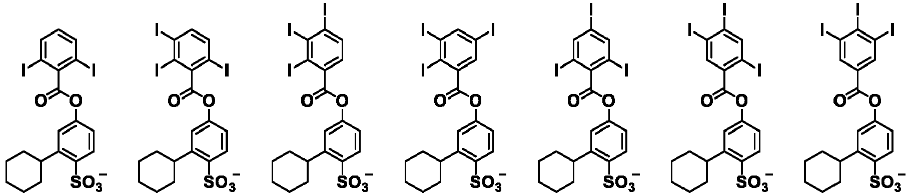

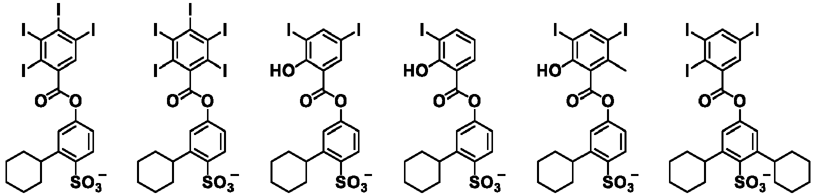

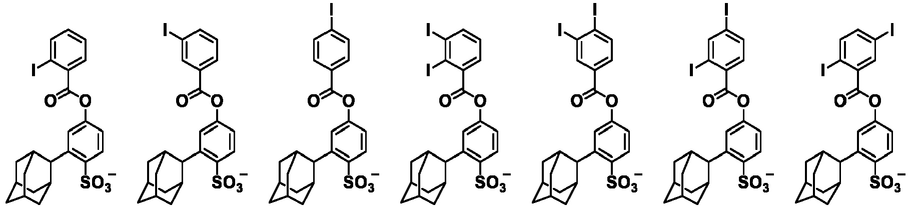

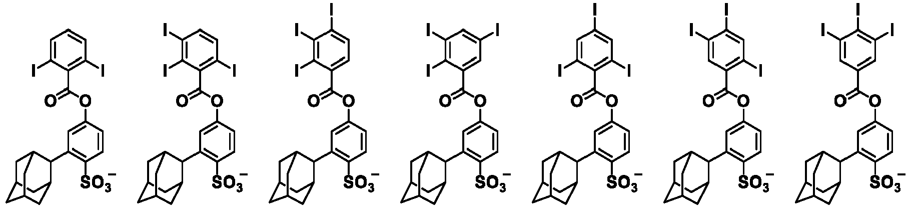

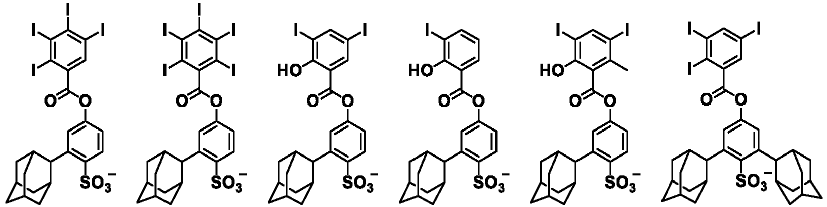

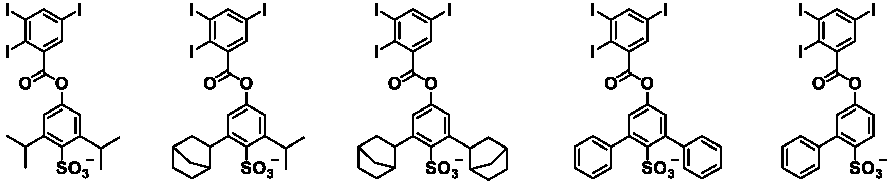

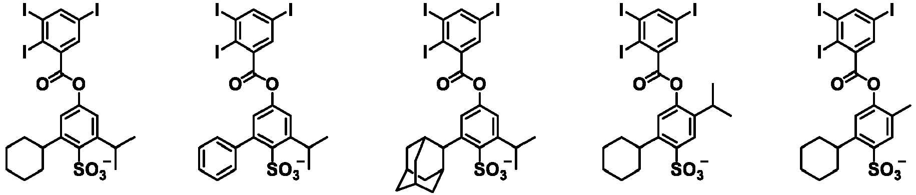

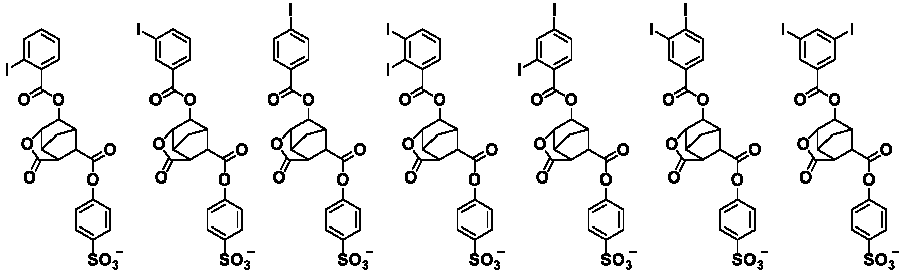

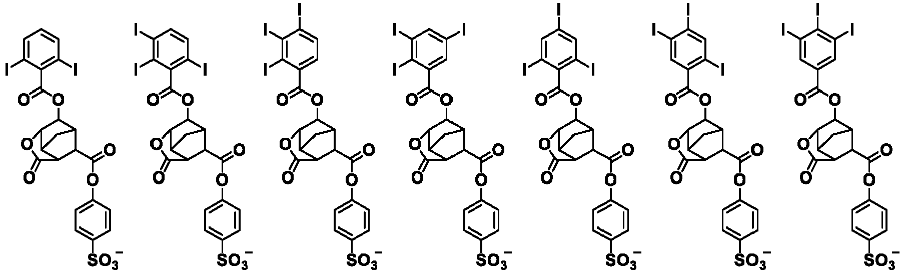

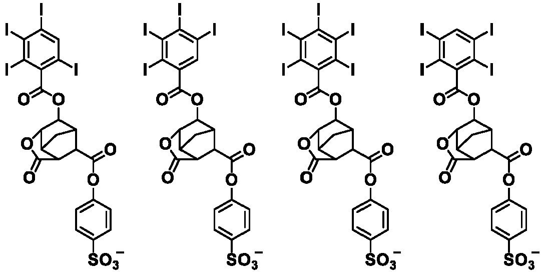

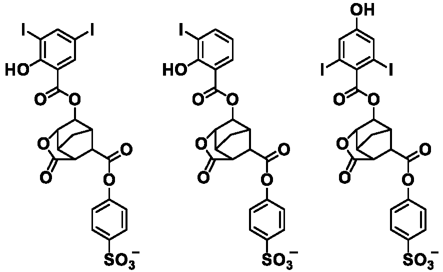

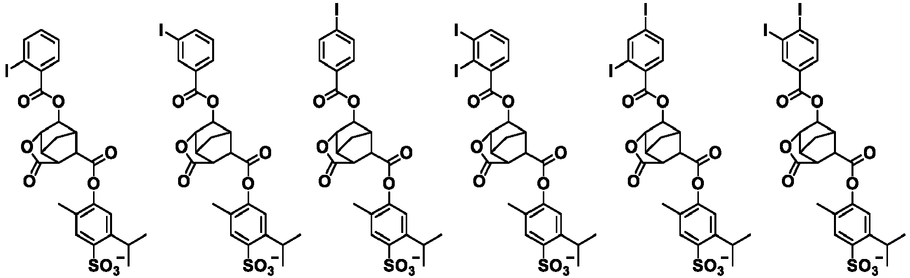

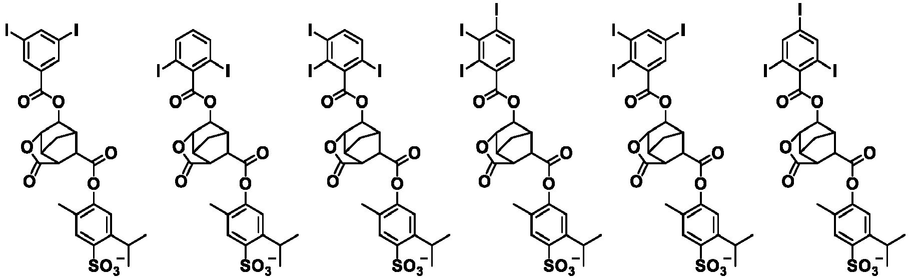

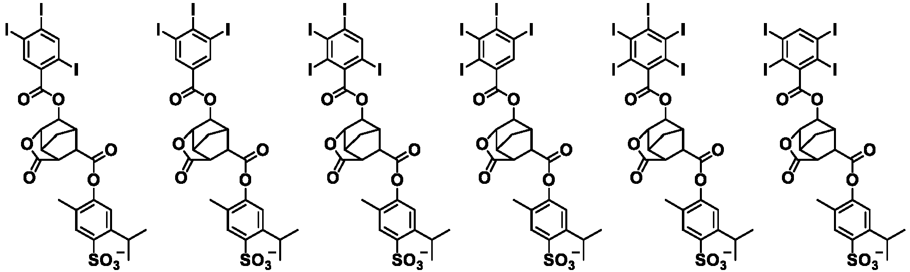

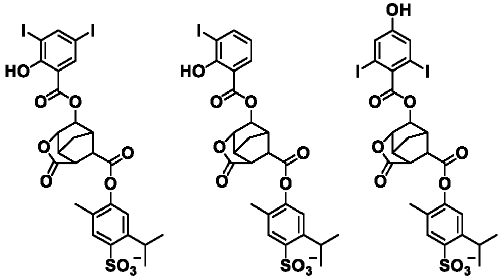

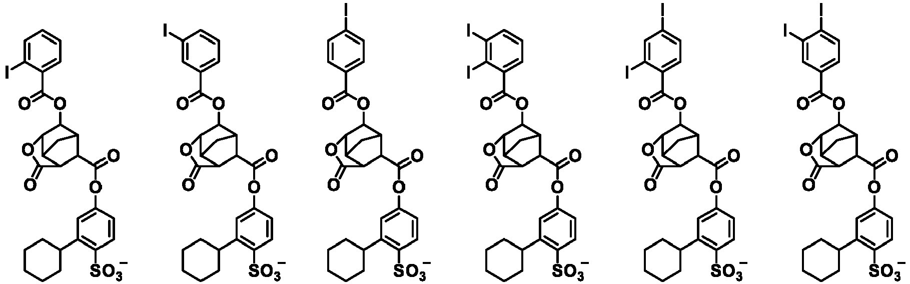

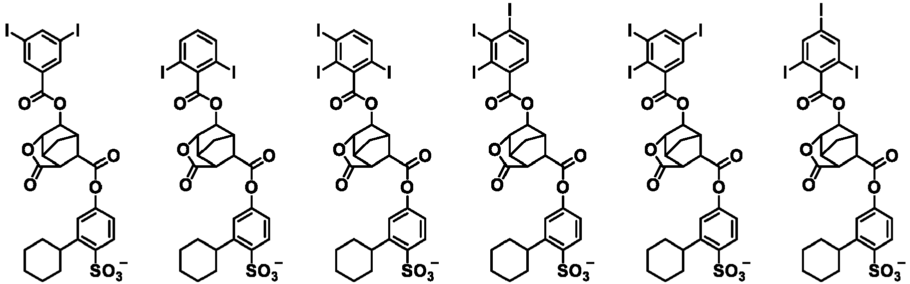

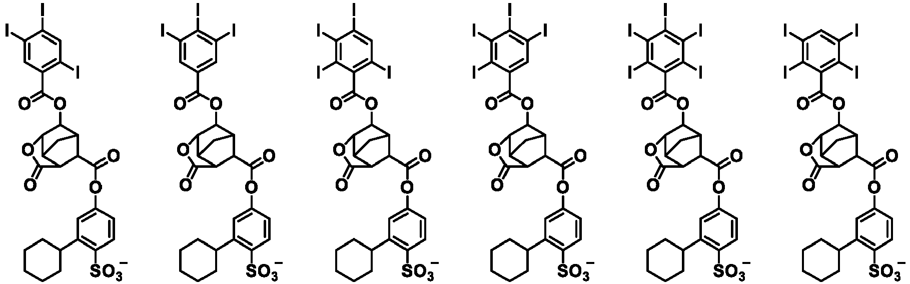

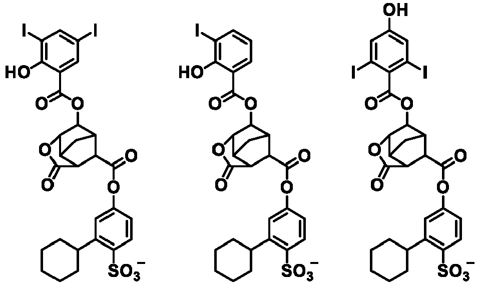

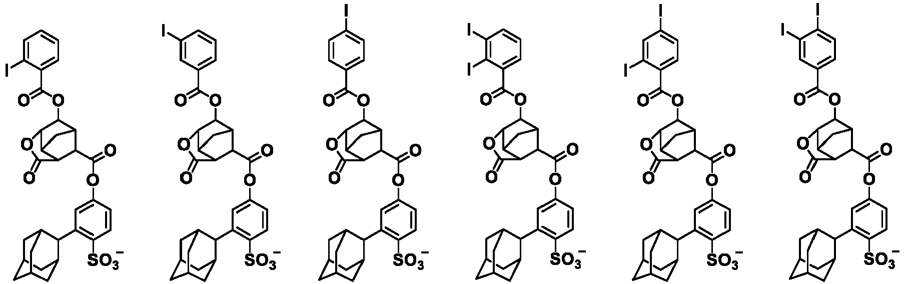

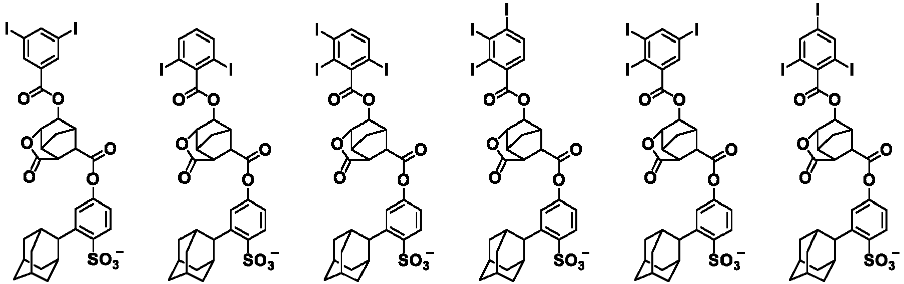

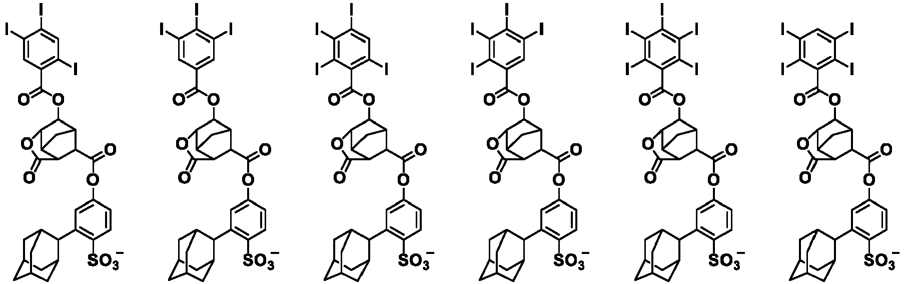

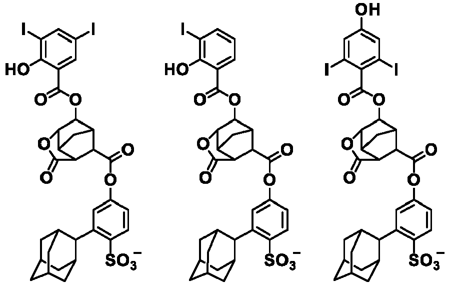

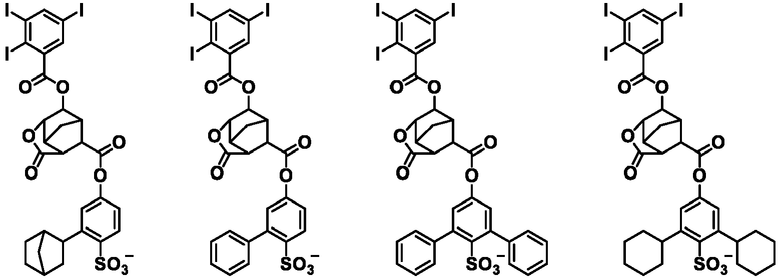

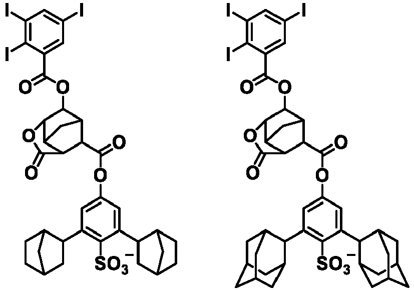

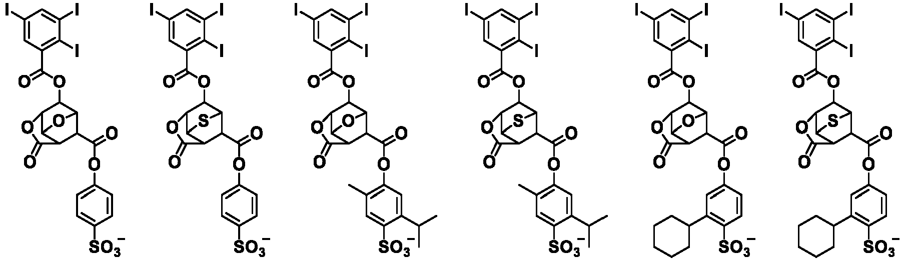

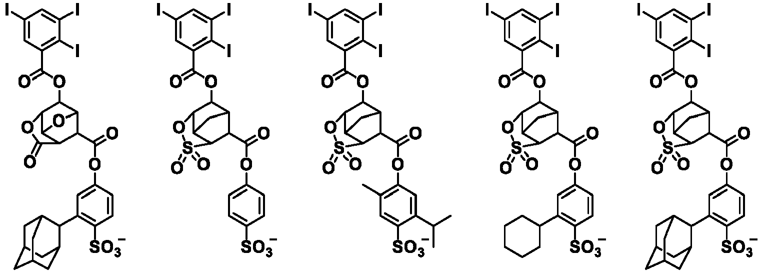

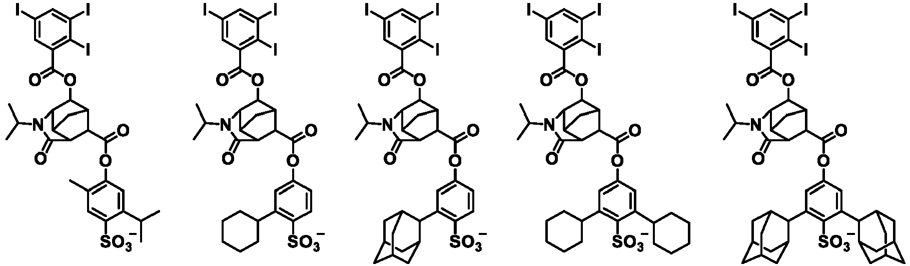

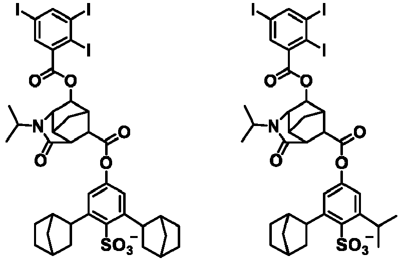

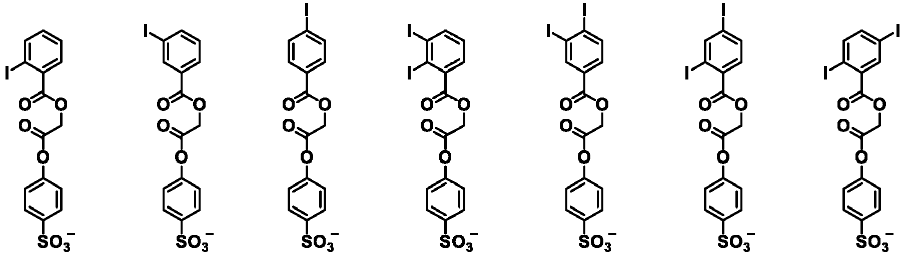

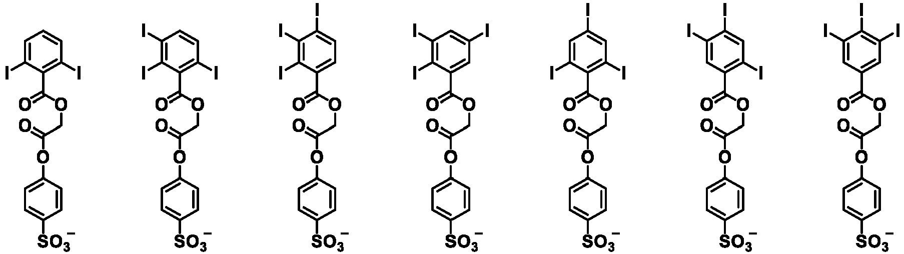

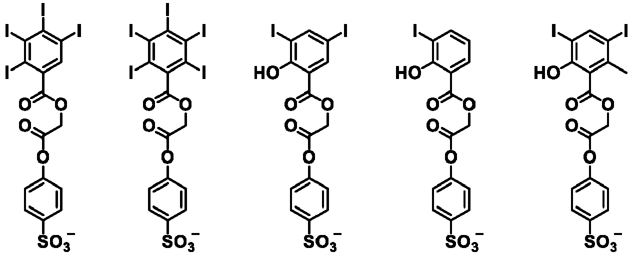

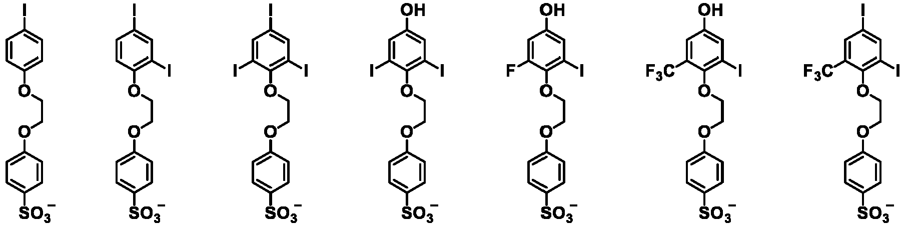

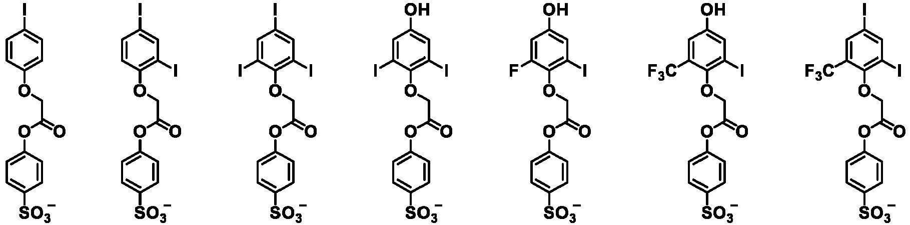

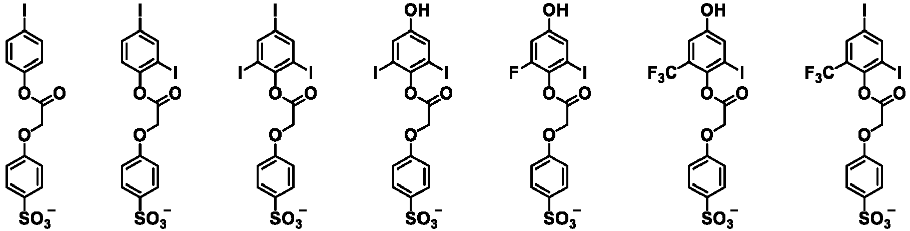

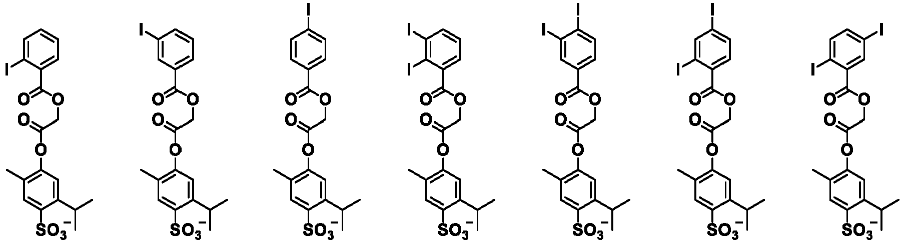

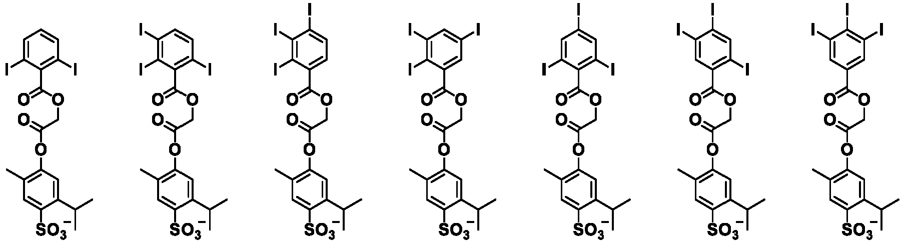

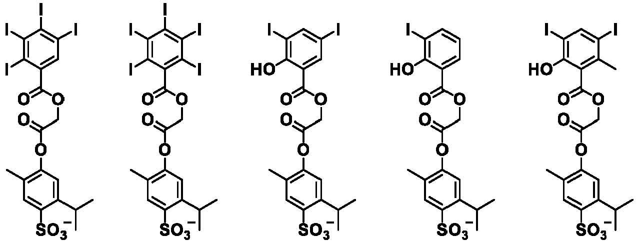

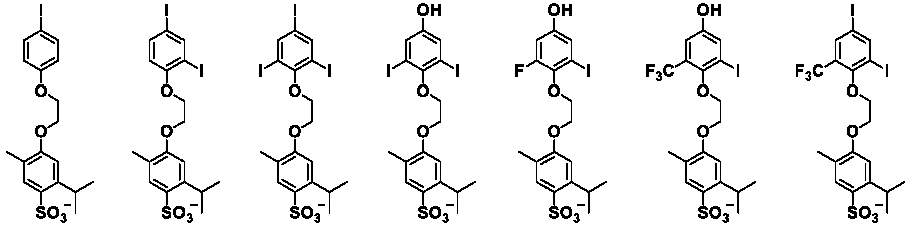

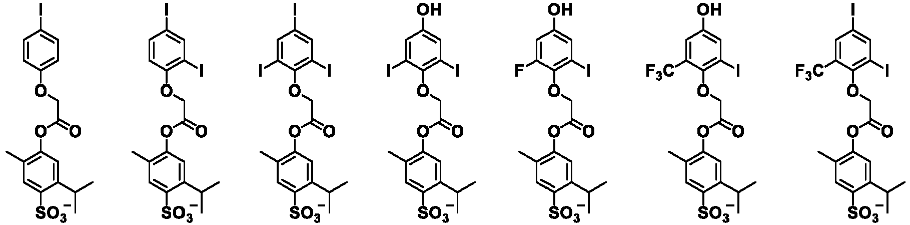

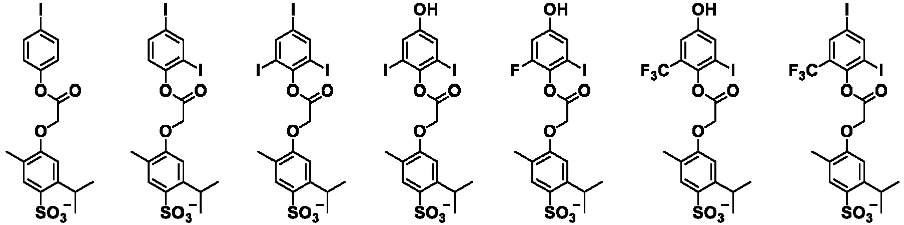

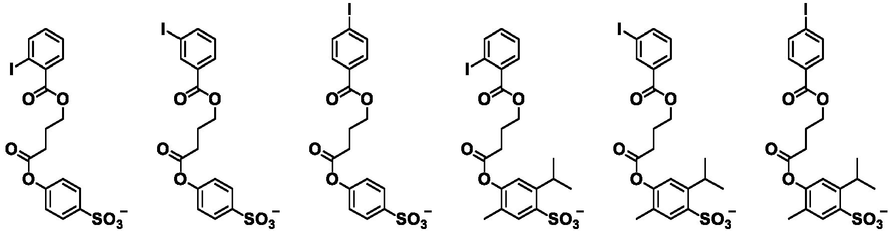

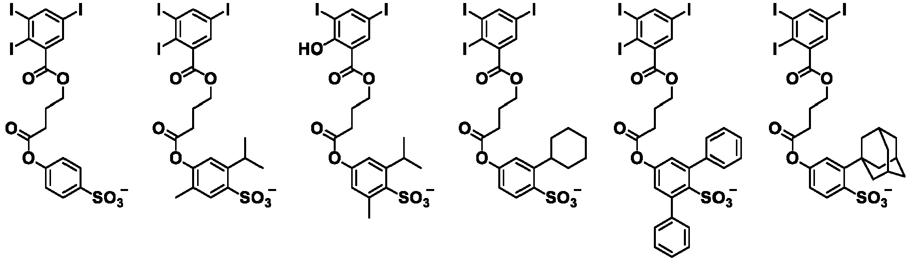

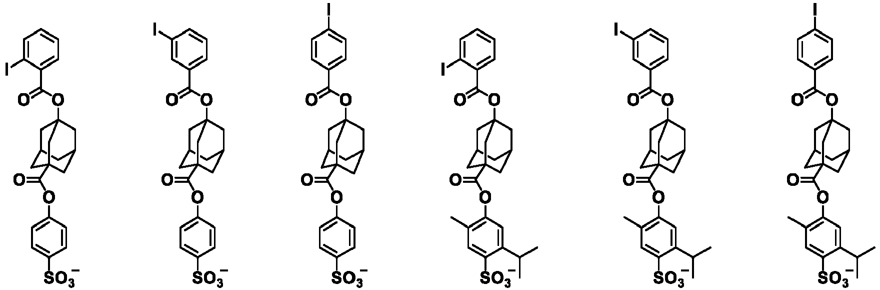

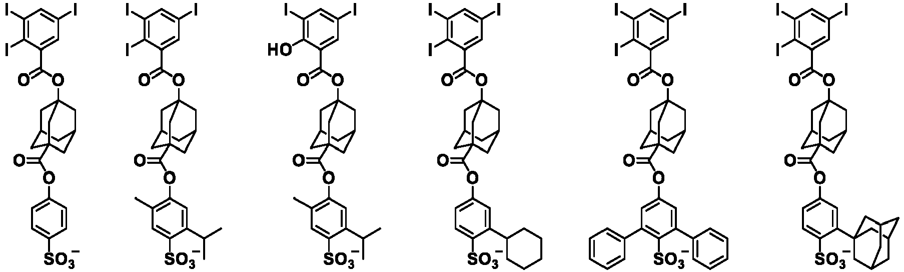

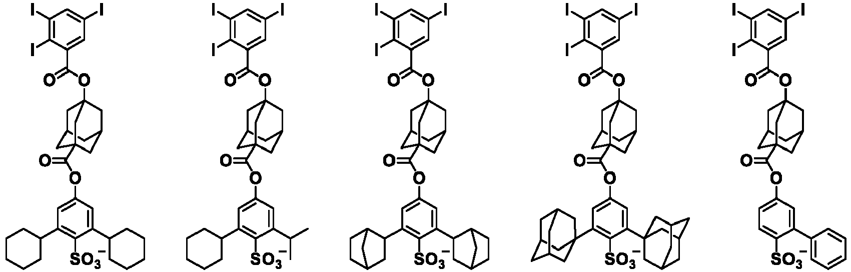

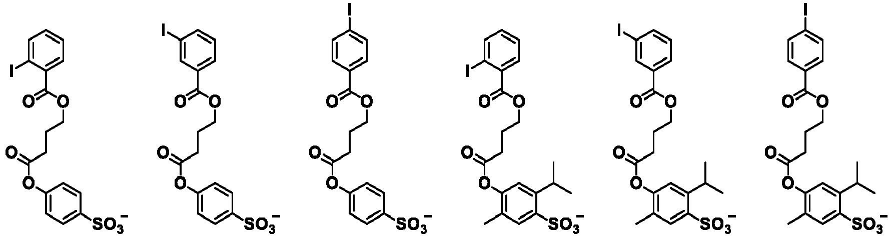

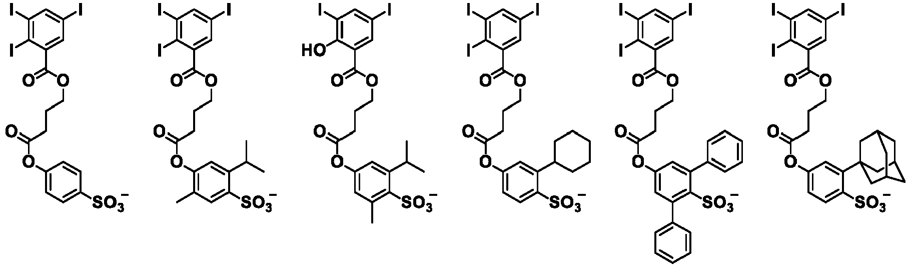

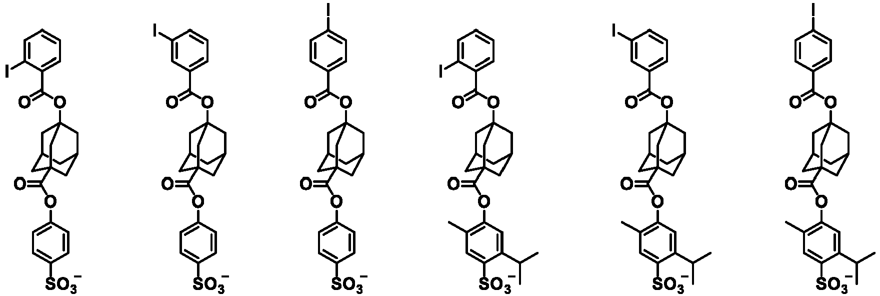

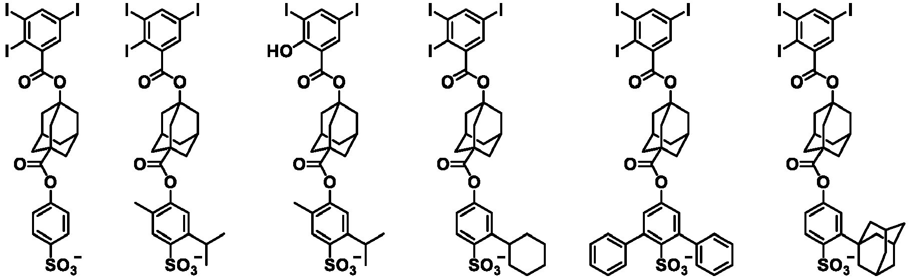

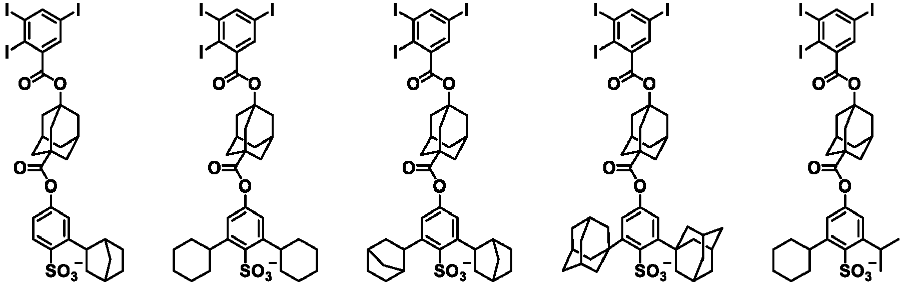

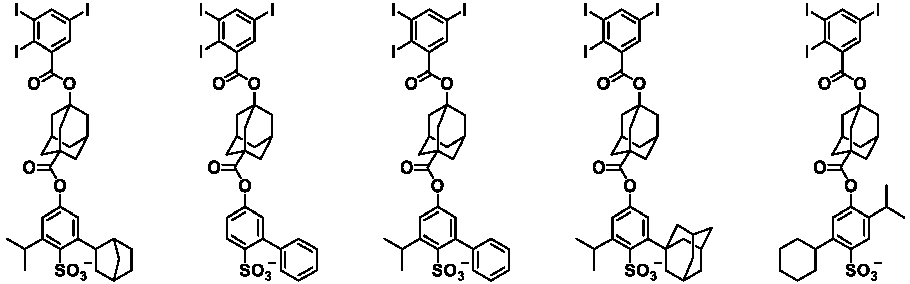

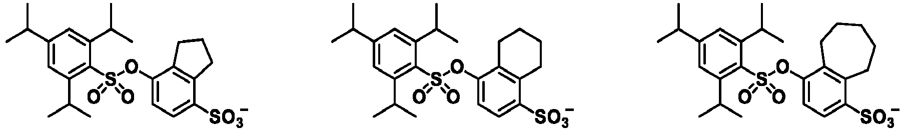

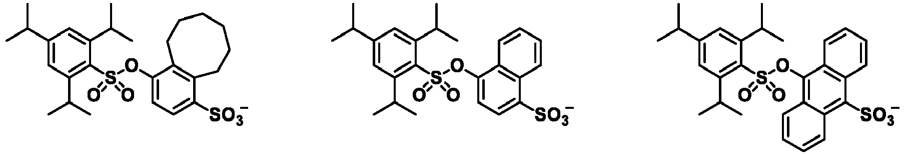

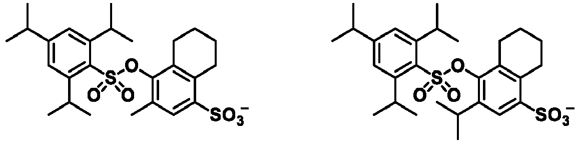

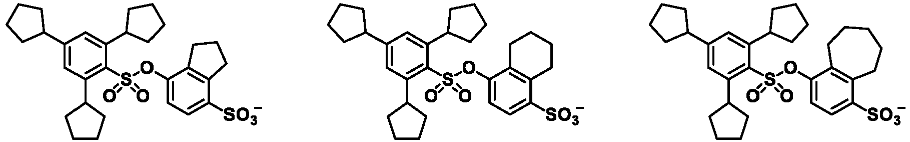

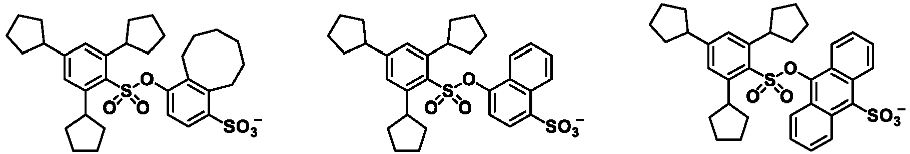

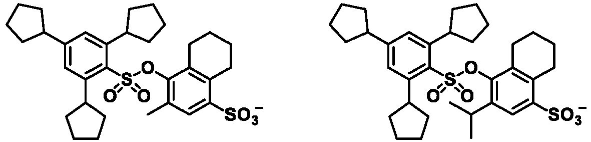

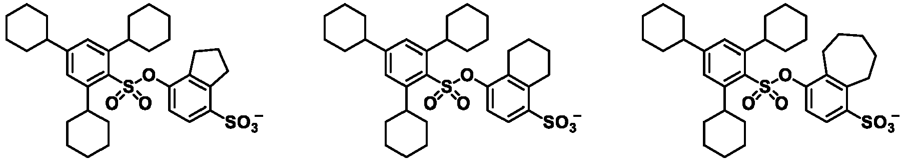

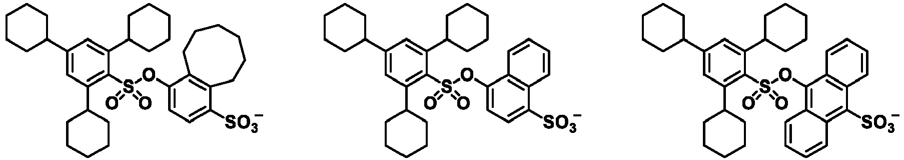

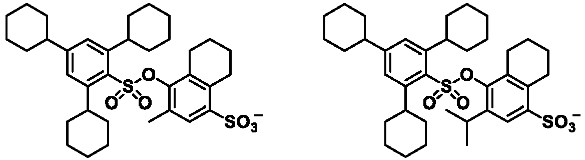

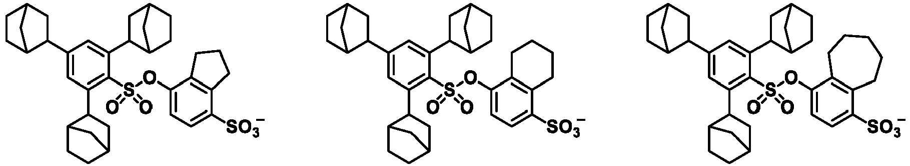

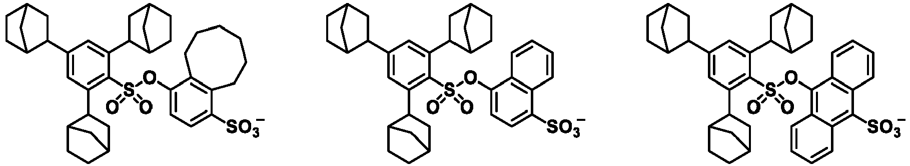

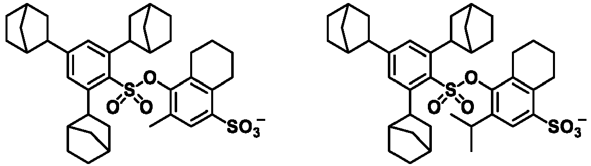

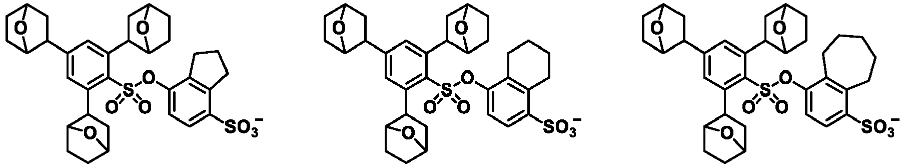

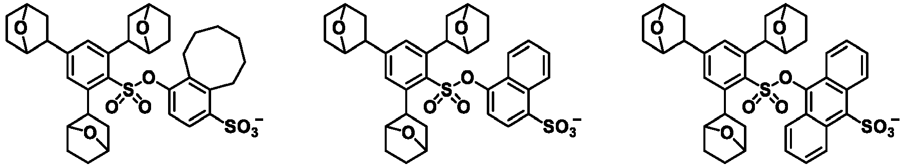

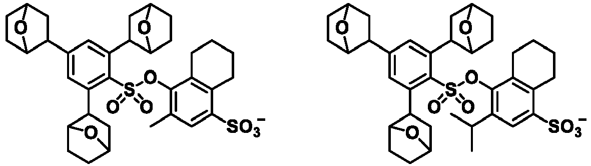

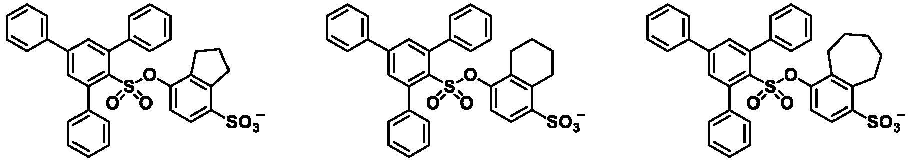

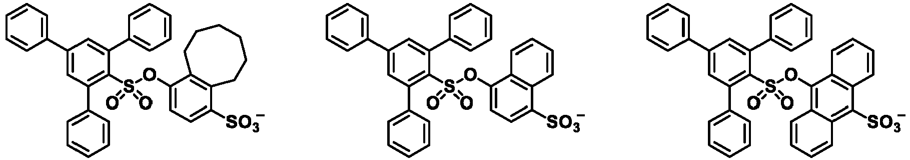

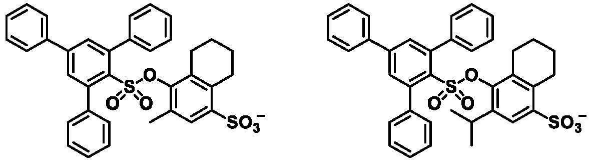

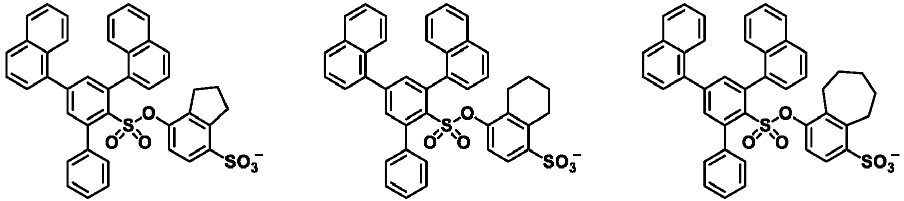

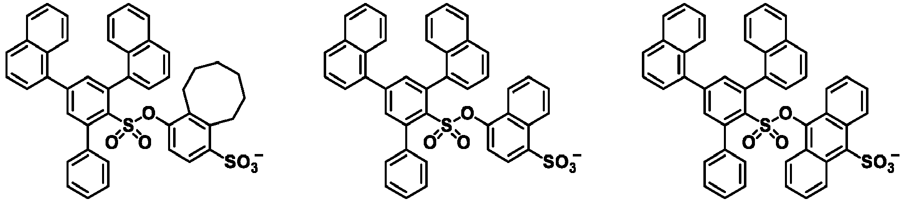

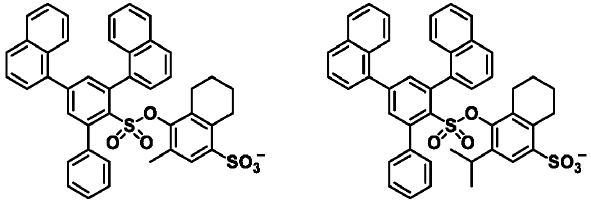

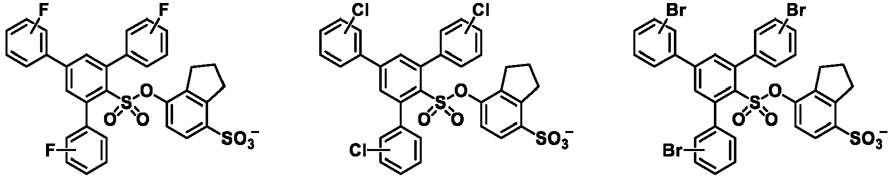

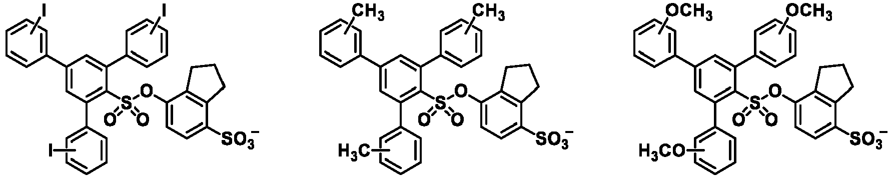

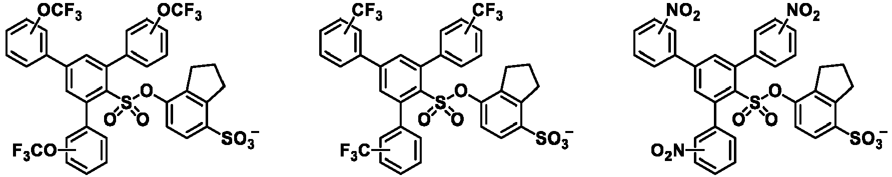

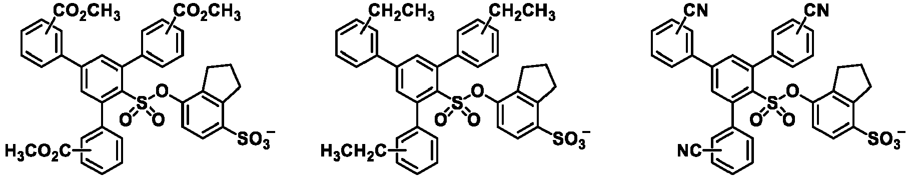

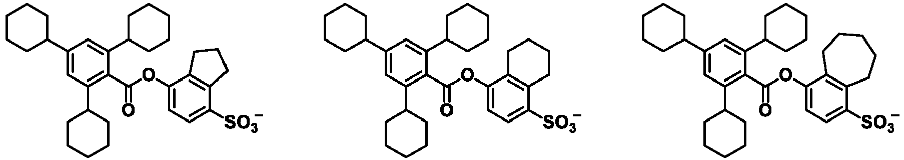

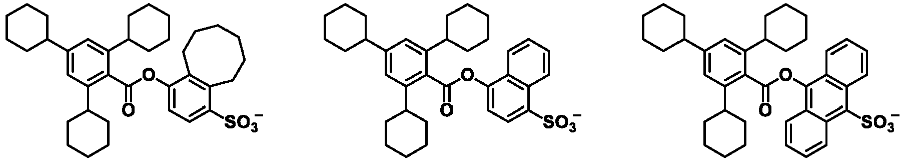

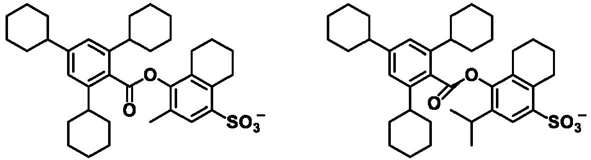

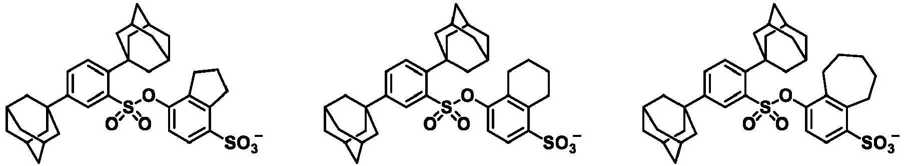

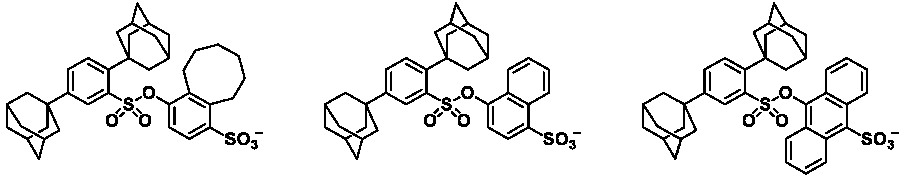

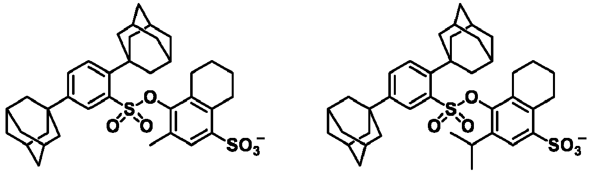

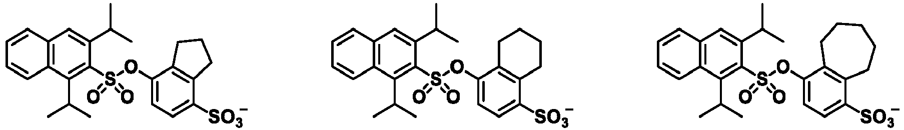

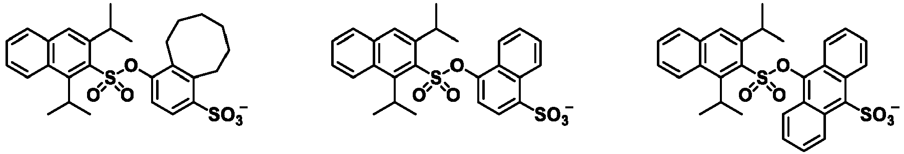

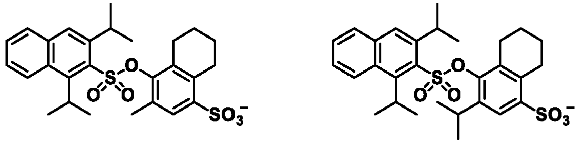

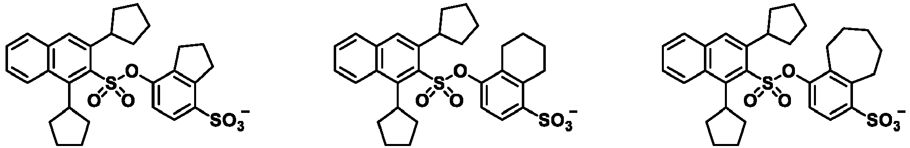

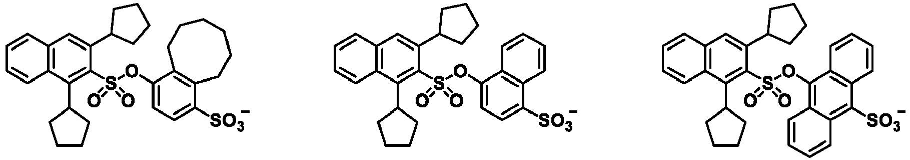

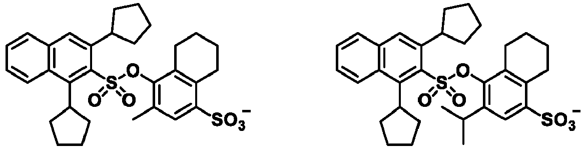

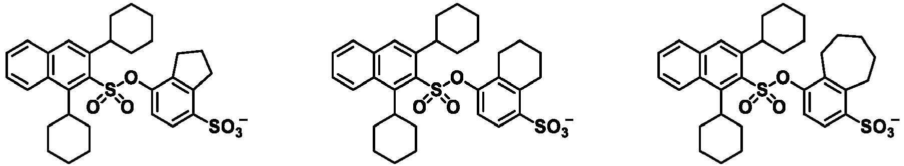

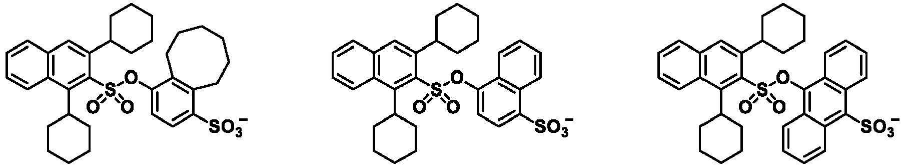

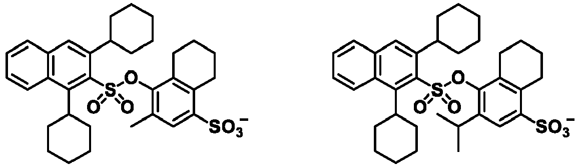

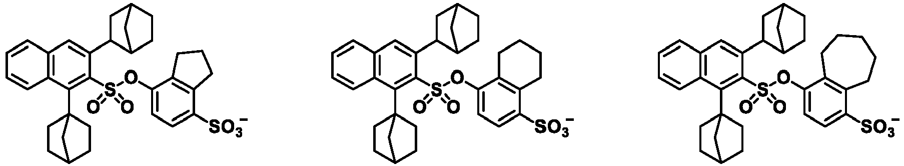

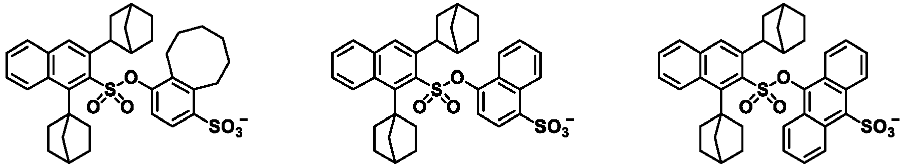

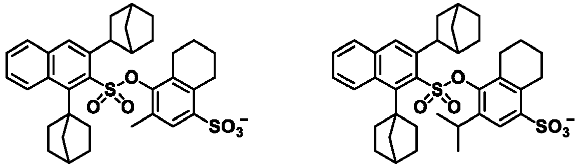

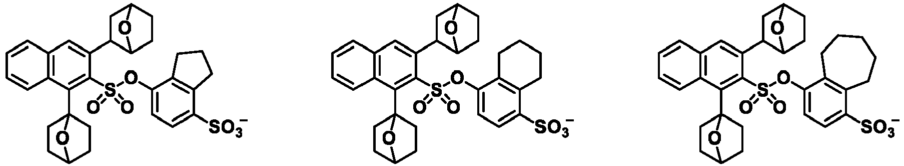

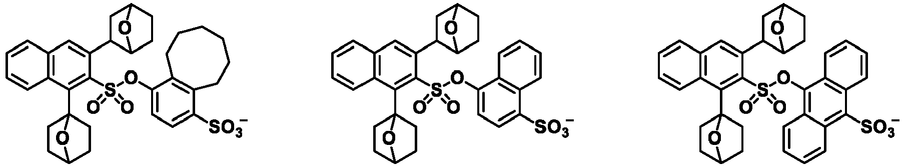

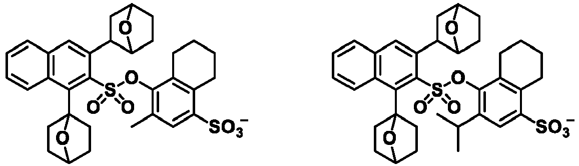

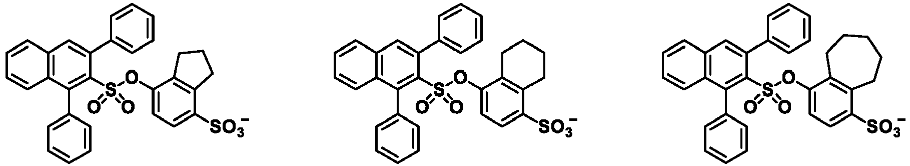

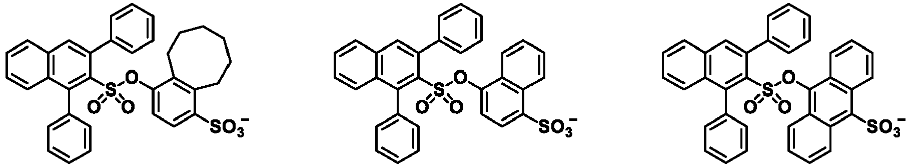

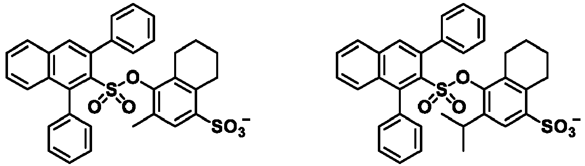

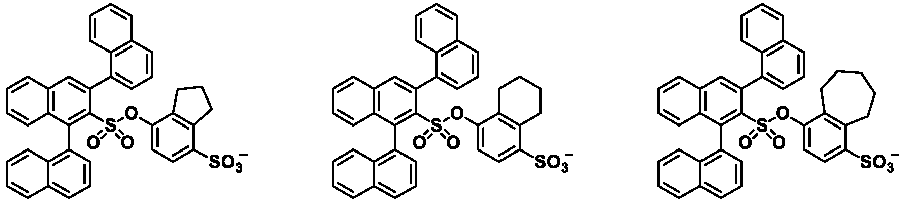

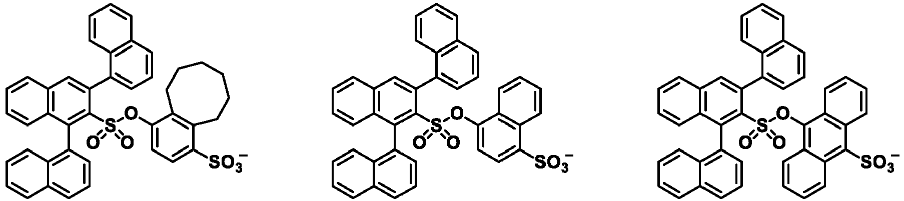

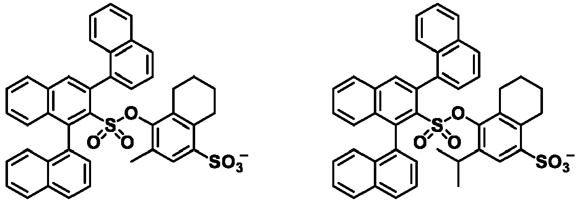

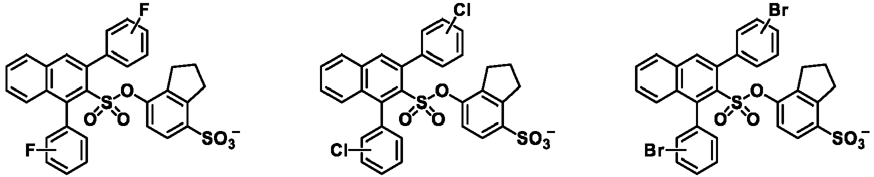

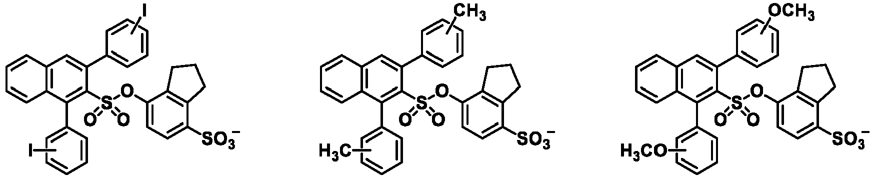

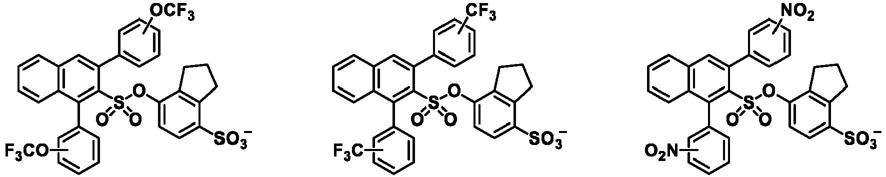

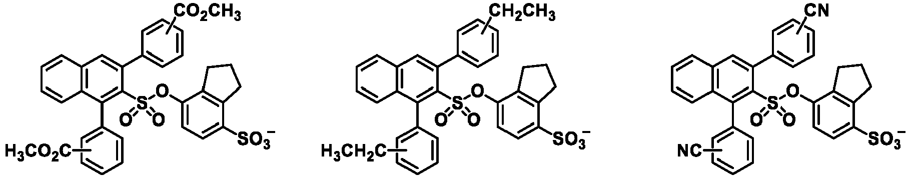

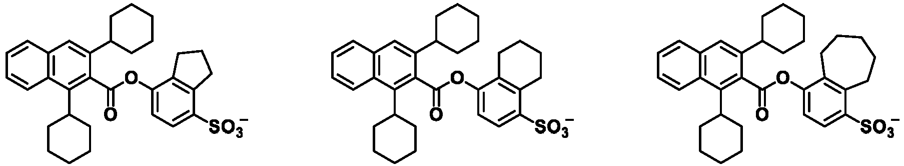

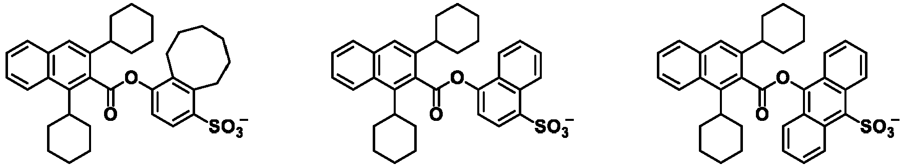

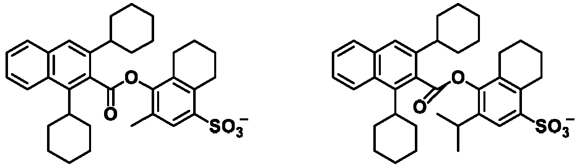

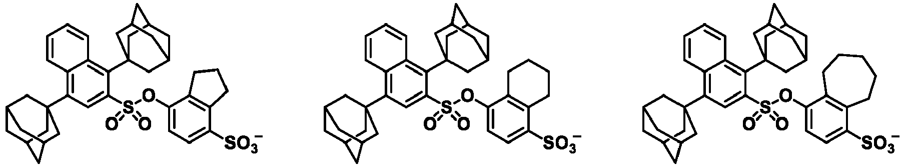

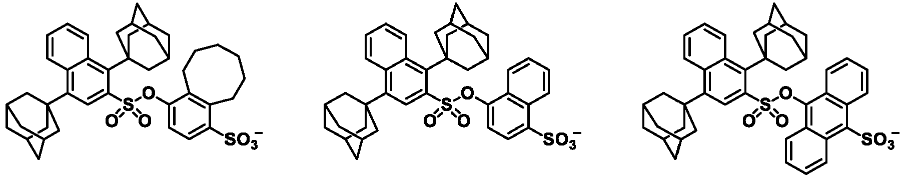

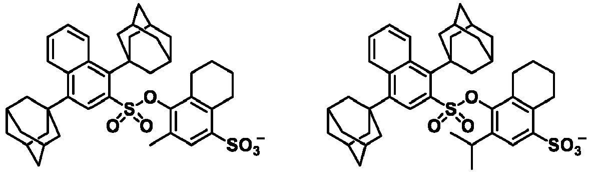

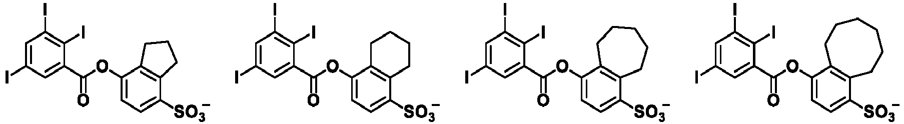

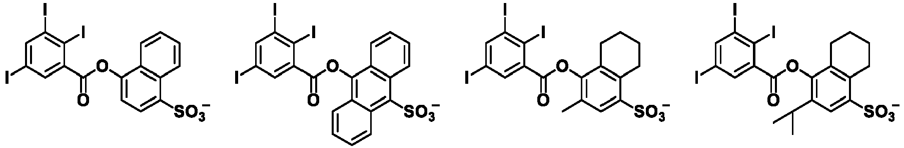

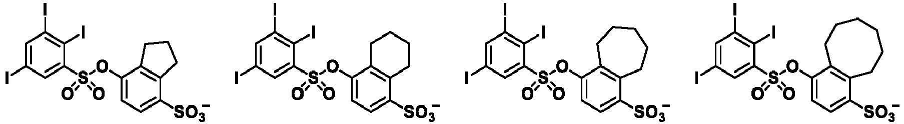

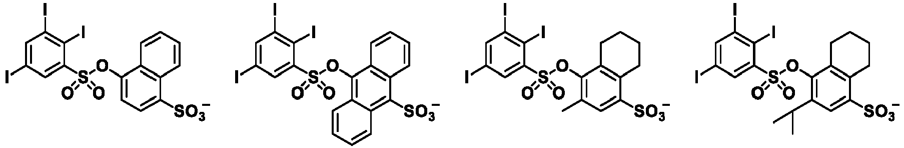

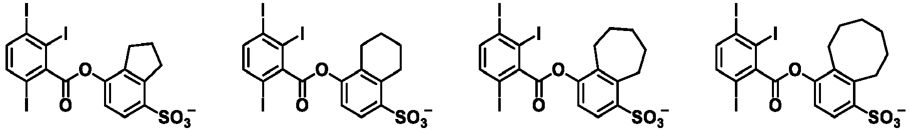

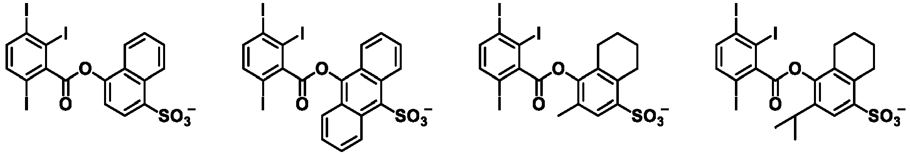

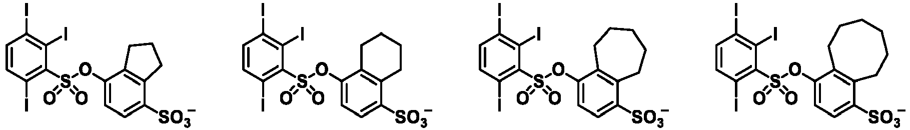

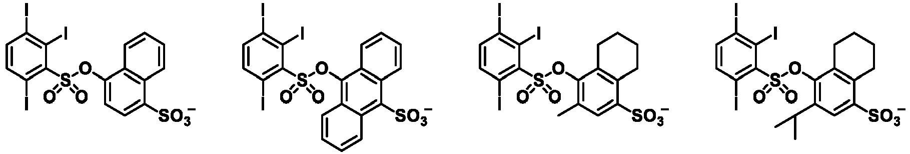

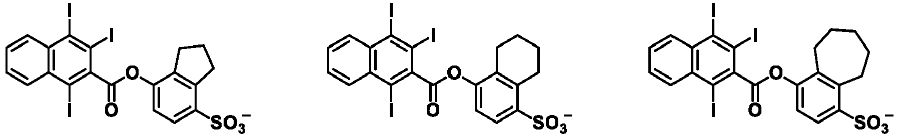

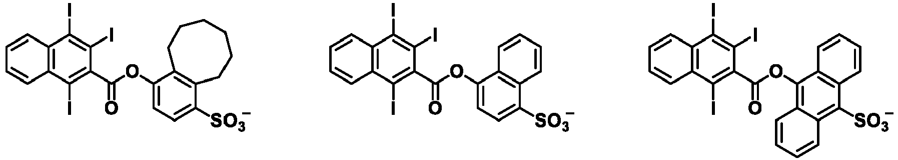

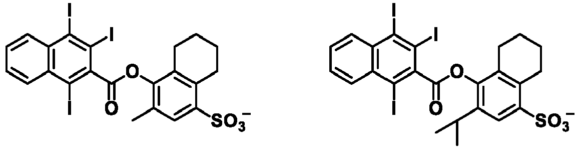

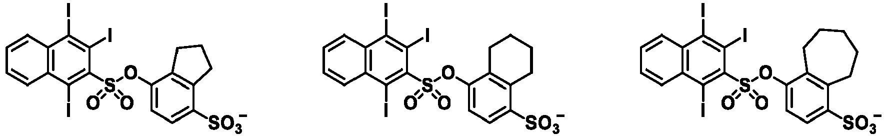

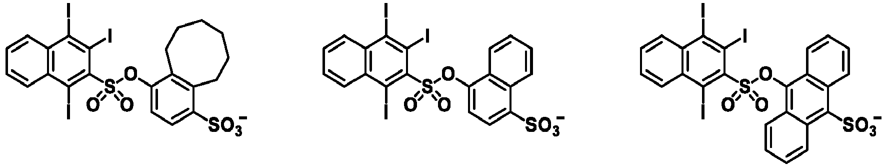

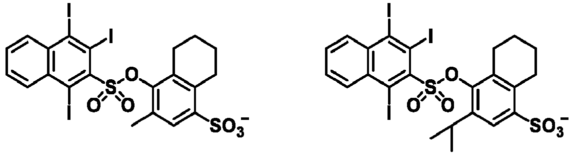

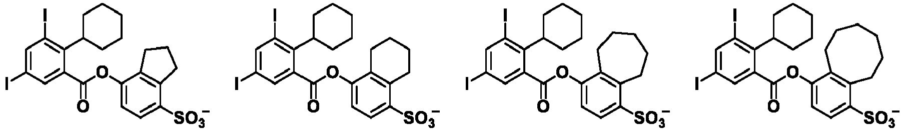

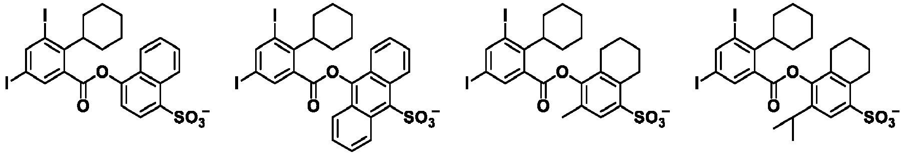

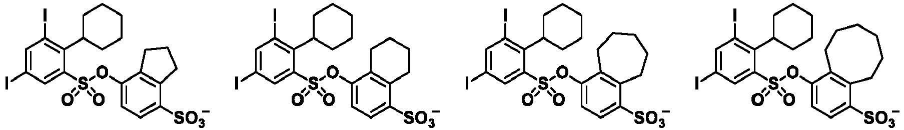

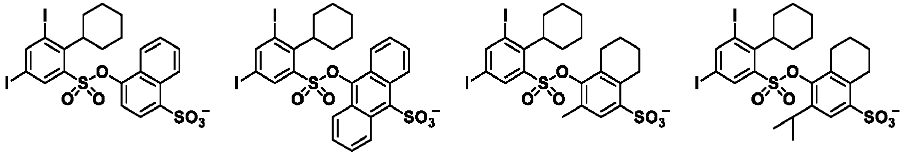

In formulae (B9) and (B 10), L¹ is a single bond, ether bond, ester bond, carbonyl group, sulfonate ester bond, carbonate bond, or carbamate bond. Of these, an ether bond, ester bond, and carbonyl group are preferred, with an ester bond and carbonyl group being more preferred.

In formula (B9), Rf¹ and Rf² are each independently fluorine or a C₁-C₆ fluorinated saturated hydrocarbyl group. It is preferred for enhancing the strength of the generated acid that both Rf¹ and Rf² be fluorine. Rf³ and Rf⁴ are each independently hydrogen, fluorine, or a C₁-C₆ fluorinated saturated hydrocarbyl group. It is preferred for increasing solvent solubility that at least one of Rf³ and Rf⁴ be trifluoromethyl.

In formula (B9), Rf⁵ and Rf⁶ are each independently hydrogen, fluorine, or a C₁-C₆ fluorinated saturated hydrocarbyl group, excluding that all Rf⁵ and Rf⁶ are hydrogen at the same time. It is preferred for increasing solvent solubility that at least one of Rf⁵ and Rf⁶ be trifluoromethyl.

In formulae (B9) and (B 10), h is an integer of 0 to 3, preferably 1.

Examples of the anion in repeat units B9 are shown below, but not limited thereto. Herein R^{A} is as defined above.

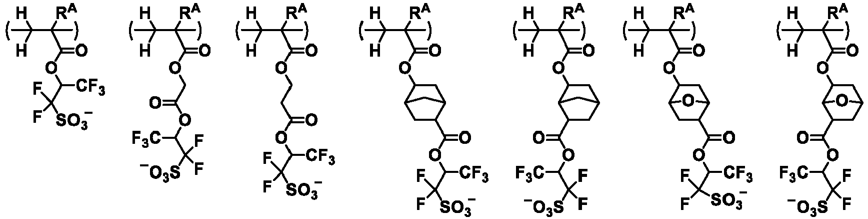

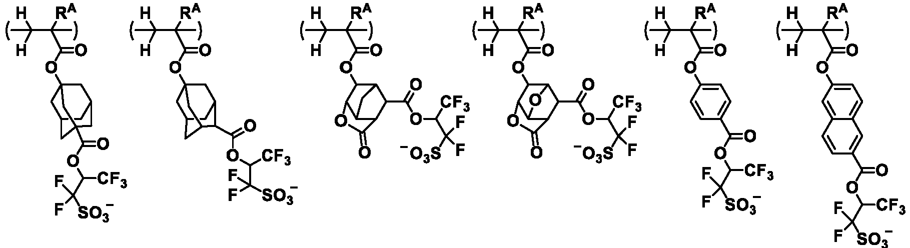

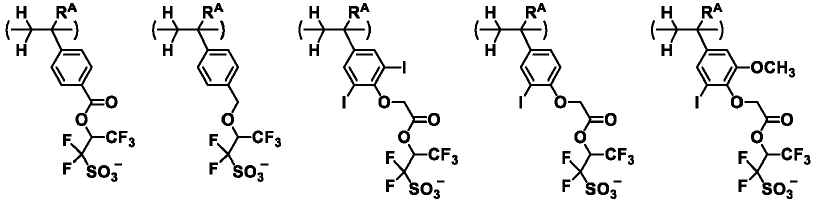

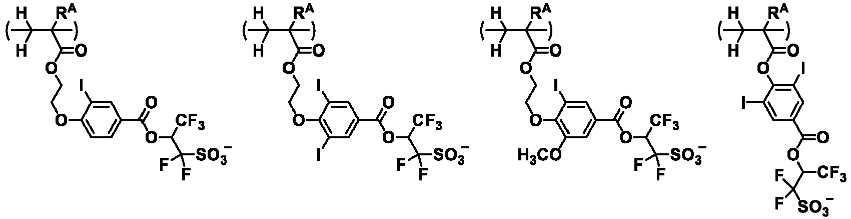

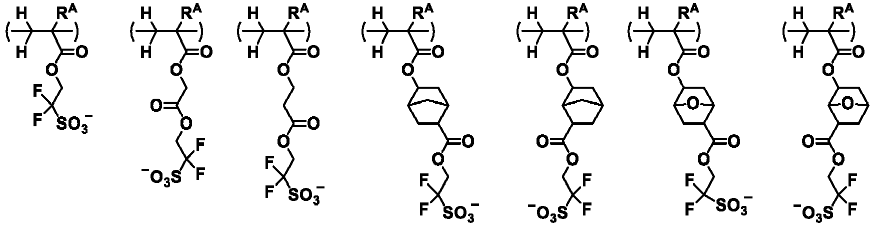

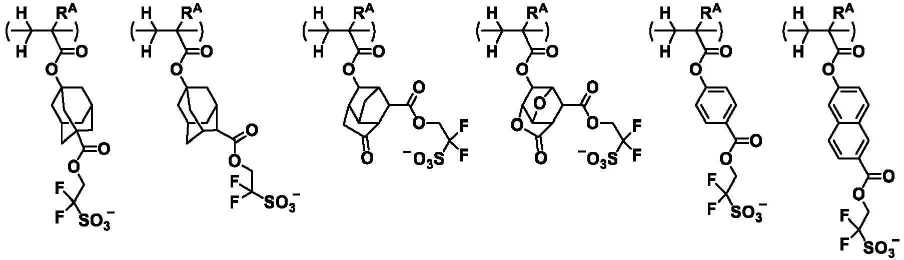

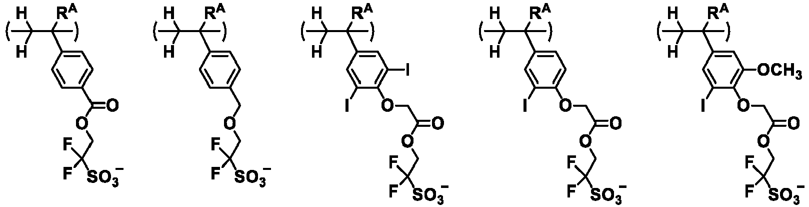

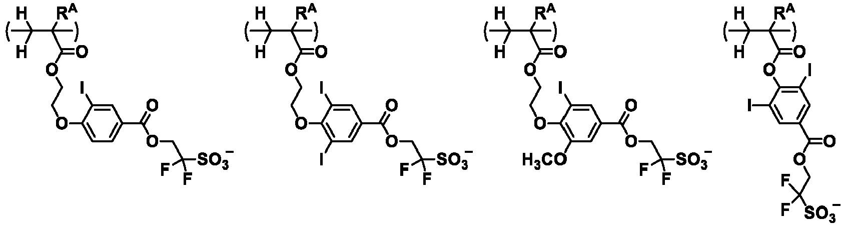

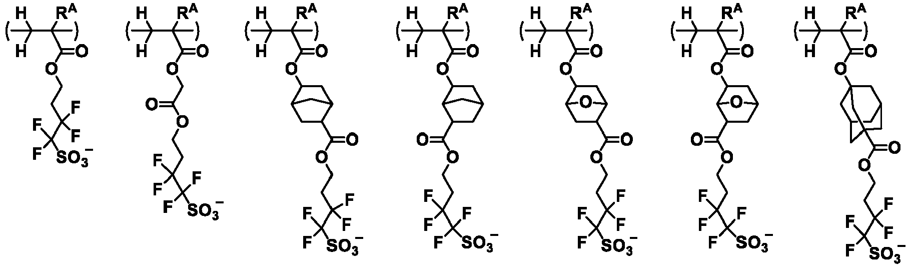

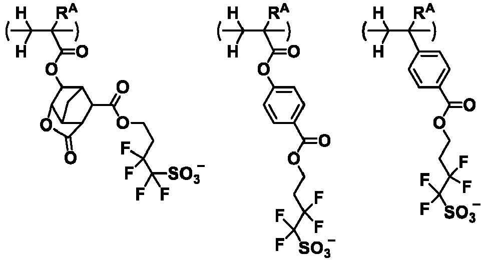

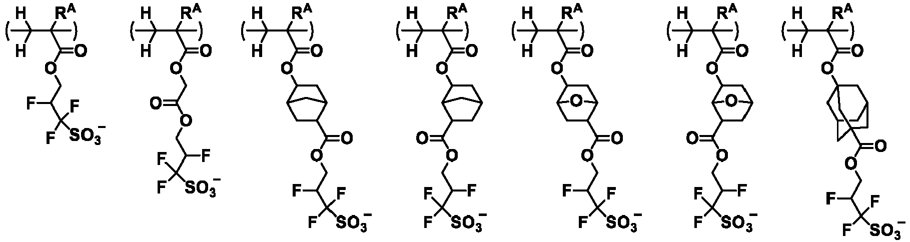

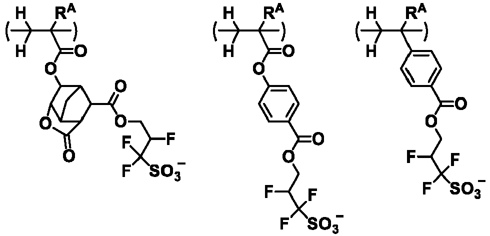

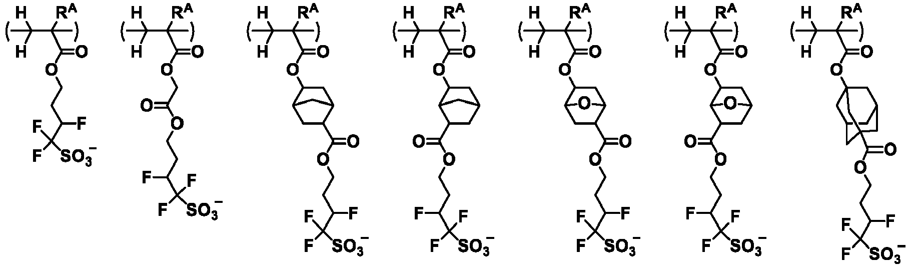

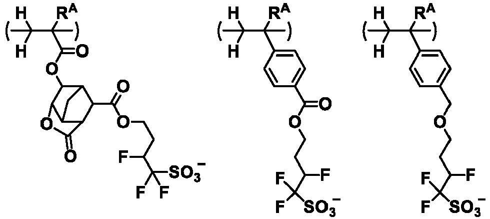

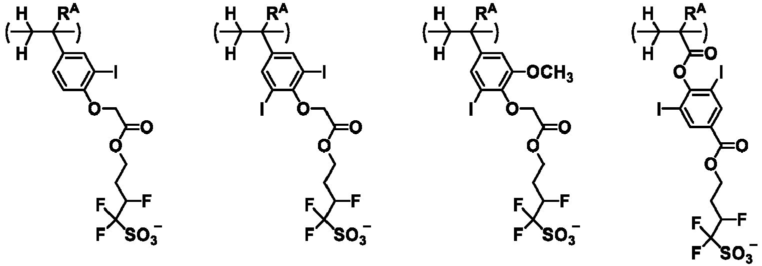

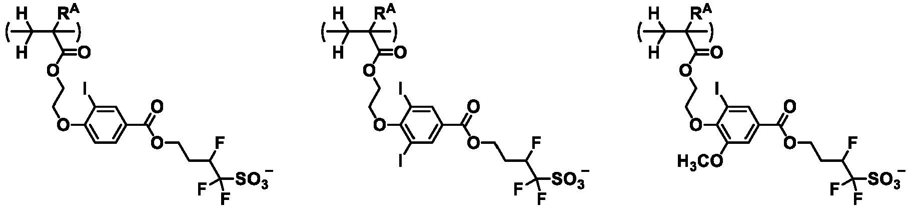

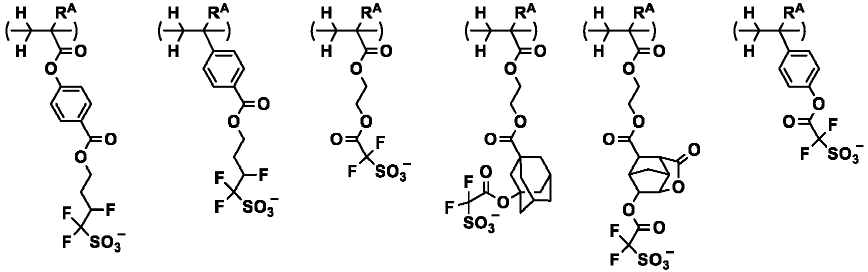

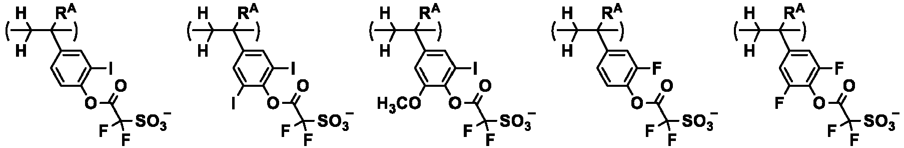

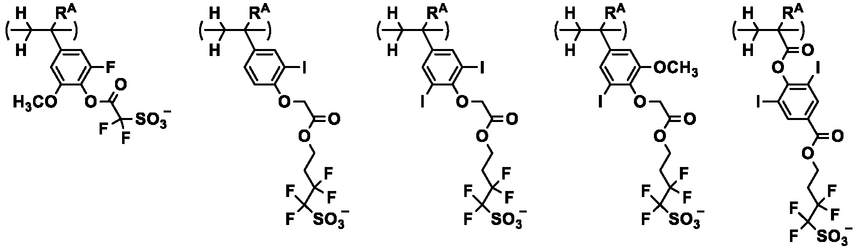

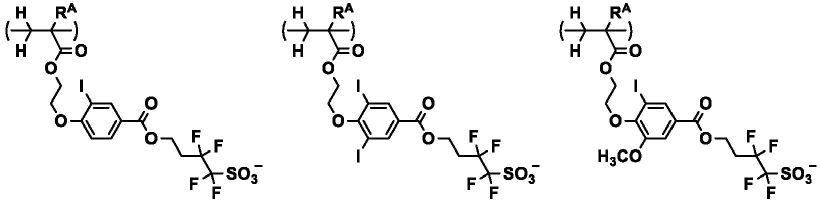

Examples of the anion in repeat units B 10 are shown below, but not limited thereto. Herein R^{A} is as defined above.

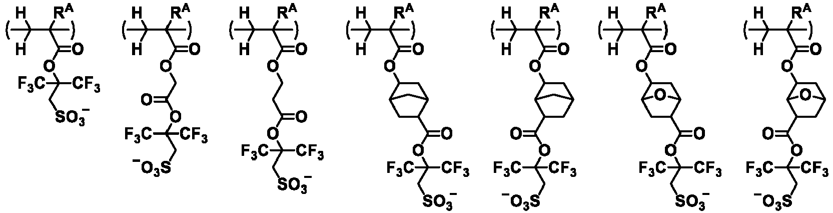

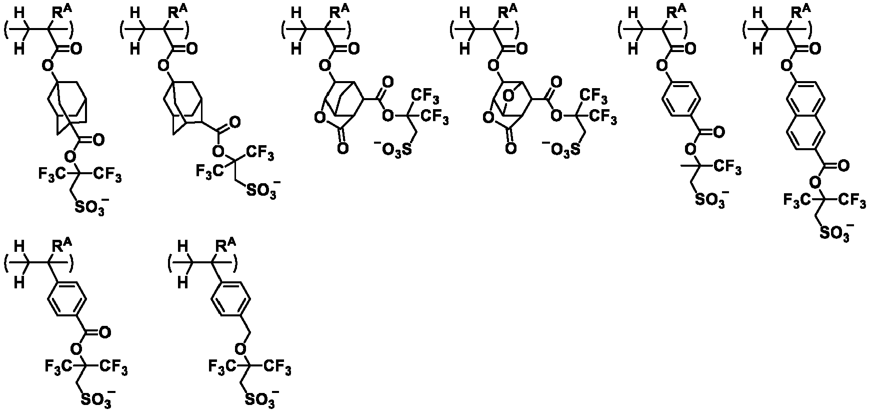

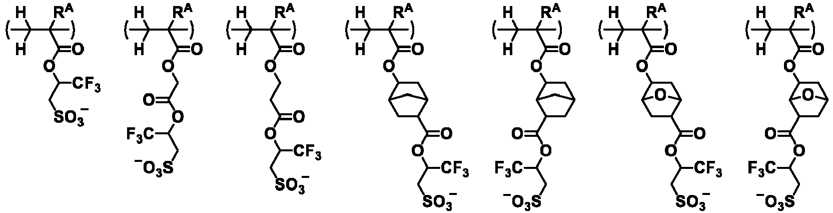

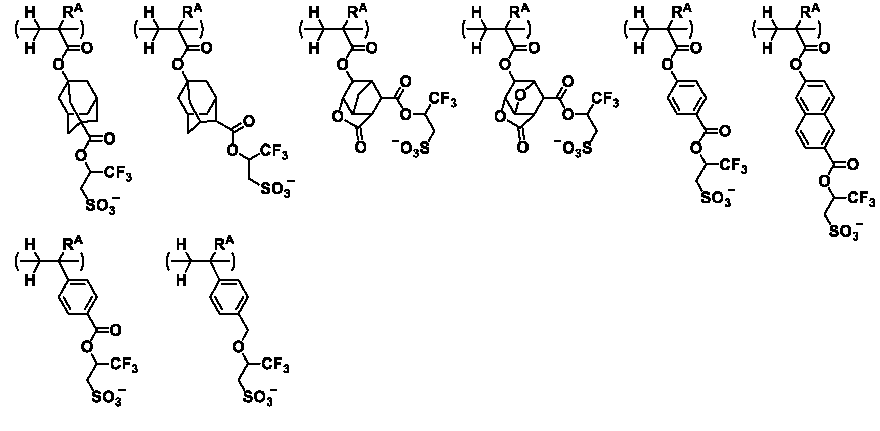

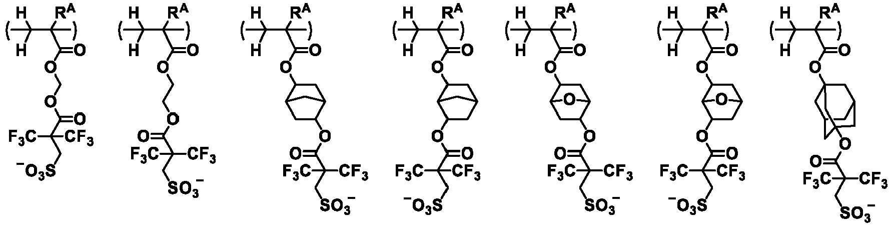

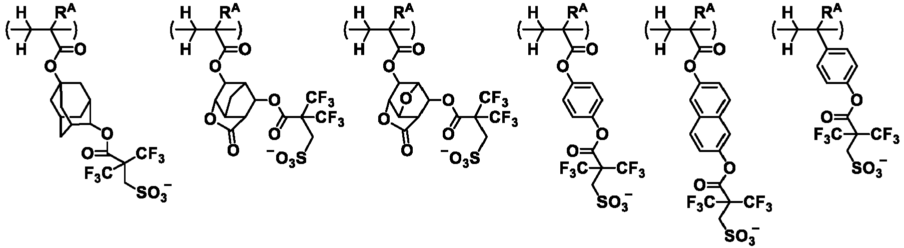

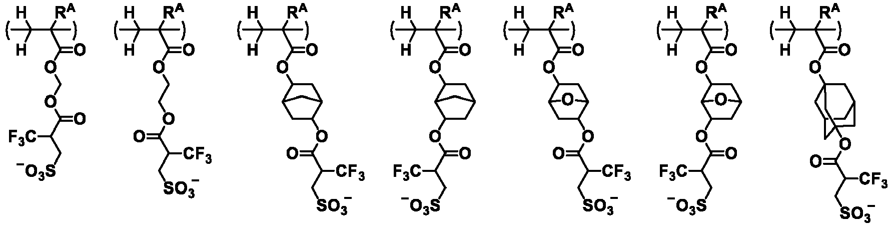

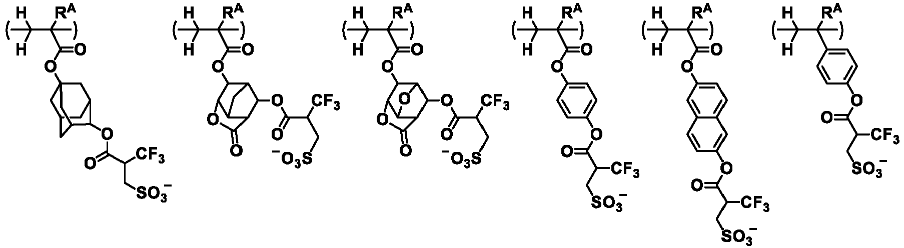

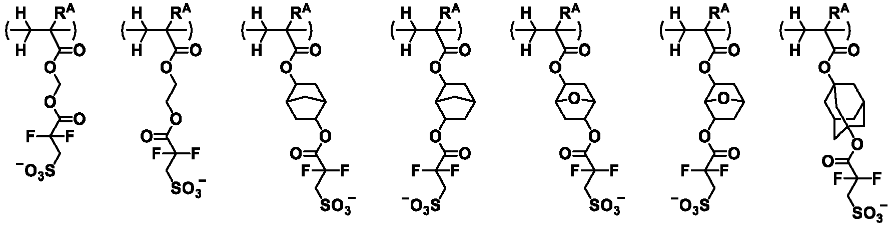

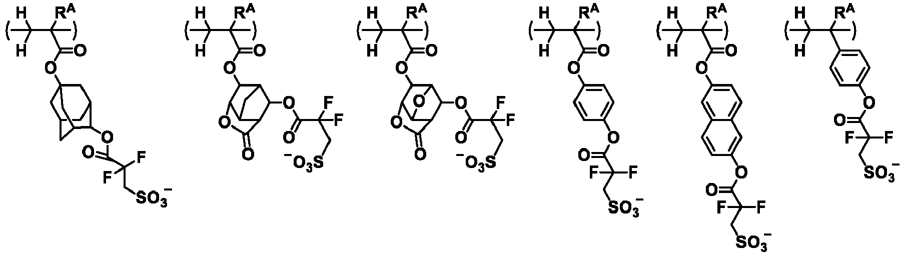

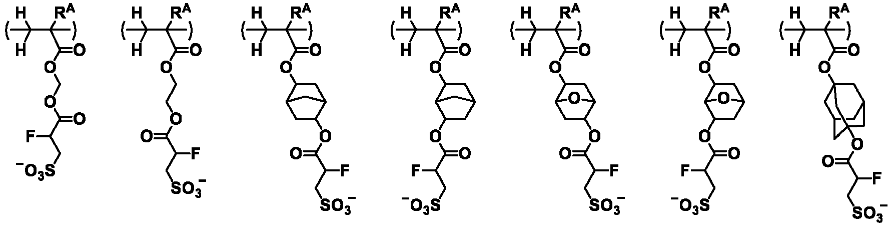

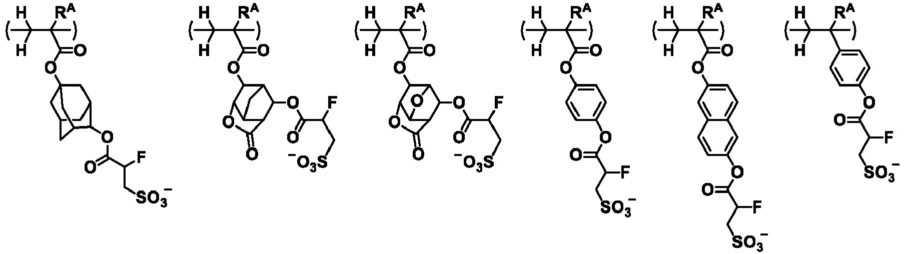

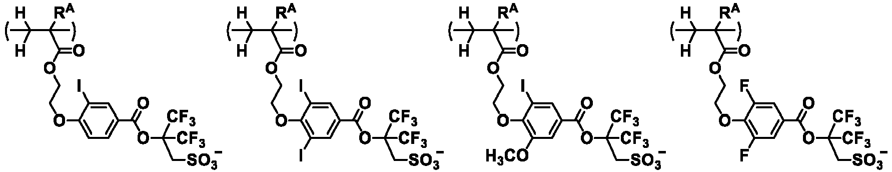

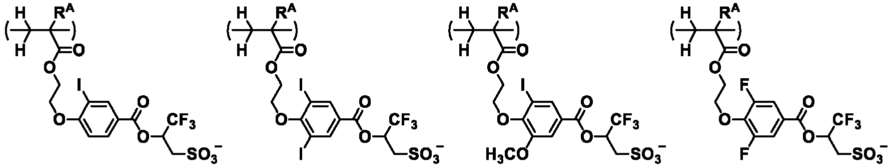

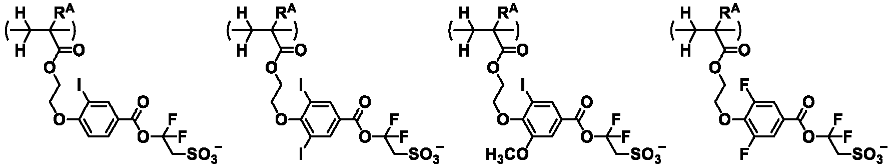

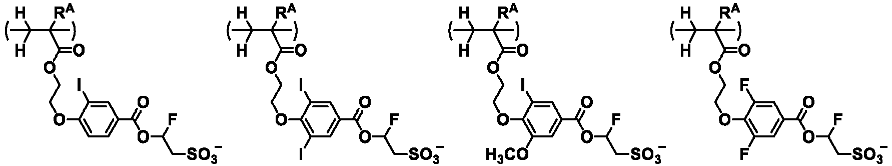

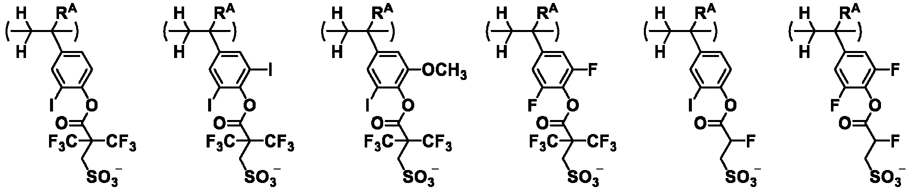

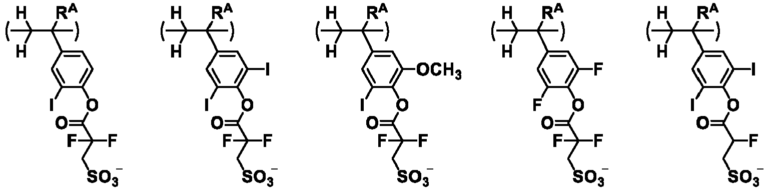

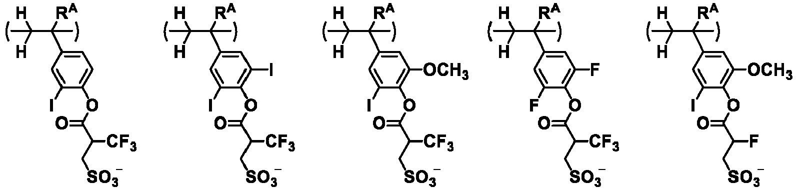

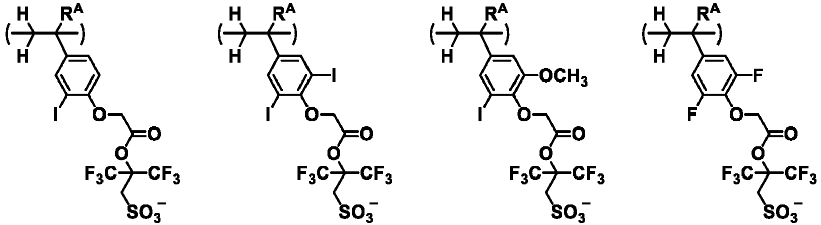

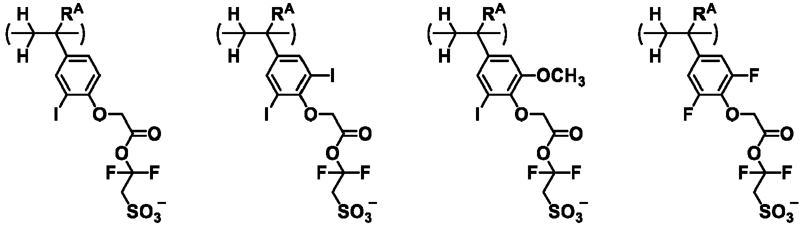

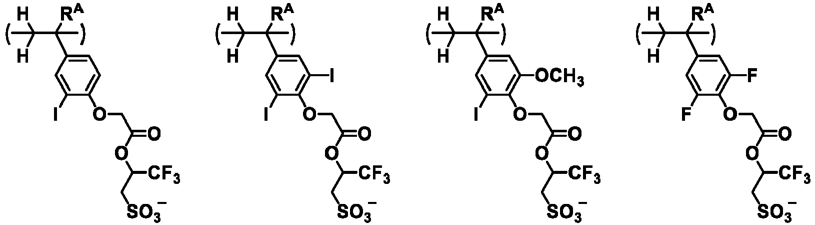

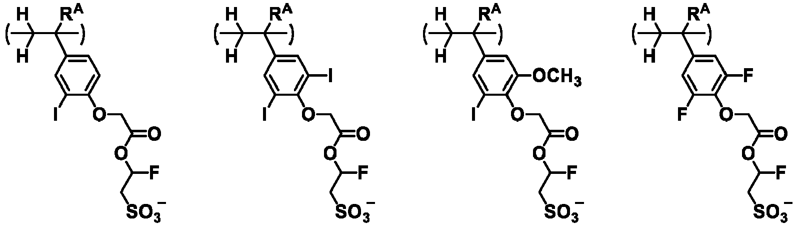

Examples of the anion in repeat units B 11 are shown below, but not limited thereto. Herein R^{A} is as defined above.

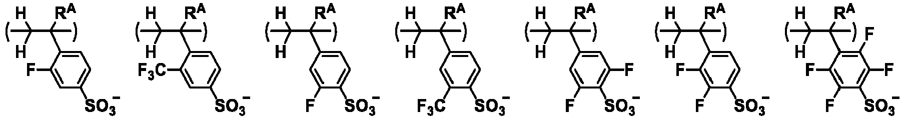

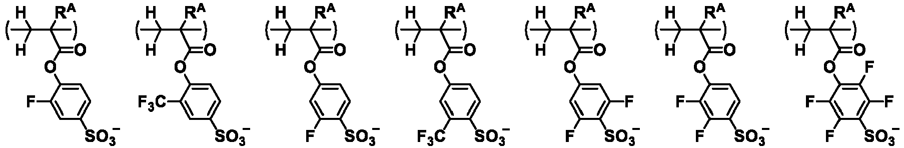

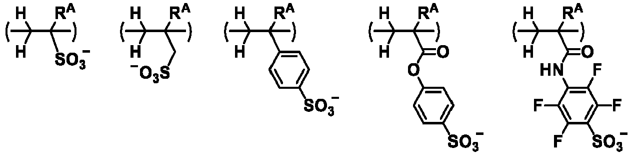

In formulae (B9) to (B11), A⁺ is an onium cation. Examples of the onium cation are as exemplified above for the cation Z⁺ in formula (A), but not limited thereto.

Of the repeat units B8 to B 1 1, repeat units B9 or B 10 are preferred for the processing of photomask blanks because the acid strength of the generated acid is optimum for the design of an acid labile group on the polymer.

The repeat units B8 to B 1 1 are capable of generating an acid upon exposure to high-energy radiation. It is believed that binding of the relevant units to a polymer enables to appropriately control acid diffusion and to form a pattern with reduced LER. Since the acid-generating unit is bound to a polymer, the phenomenon that acid volatilizes from the exposed region and re-deposits on the unexposed region during bake in vacuum is suppressed. This is effective for reducing LER and for suppressing profile degradation due to unwanted film thickness loss in the unexposed region.

When repeat units B8 to B 11 are included, their content is preferably 0.1 to 30 mol%, more preferably 0.5 to 20 mol% based on the overall repeat units of the polymer. Each of repeat units B8 to B 11 may be of one type or a combination of plural types.

The content of repeat units having an aromatic ring structure is preferably at least 65 mol%, more preferably at least 75 mol%, even more preferably at least 85 mol% based on the overall repeat units of the polymer in the base polymer. When the polymer does not contain repeat units B8 to B 1 1, it is preferred that all units have an aromatic ring structure.

The content of repeat units B 1, repeat units B2, repeat units B3, repeat units B4, and repeat units of at least one type selected from repeat units B5 to B7 is preferably at least 70 mol%, more preferably at least 80 mol%, even more preferably at least 90 mol% based on the overall repeat units of the polymer in the base polymer.

The polymer may further comprise (meth)acrylate units protected with an acid labile group or (meth)acrylate units having an adhesive group such as lactone structure or hydroxy group other than phenolic hydroxy as commonly used in the art. These repeat units are effective for fine adjustment of properties of a resist film, but not essential.

Examples of the (meth)acrylate unit having an adhesive group include repeat units having the following formulae (B 12) to (B14), which are also referred to as repeat units B12 to B14. While these units do not exhibit acidity, they may be used as auxiliary units for providing adhesion to substrates or adjusting solubility.

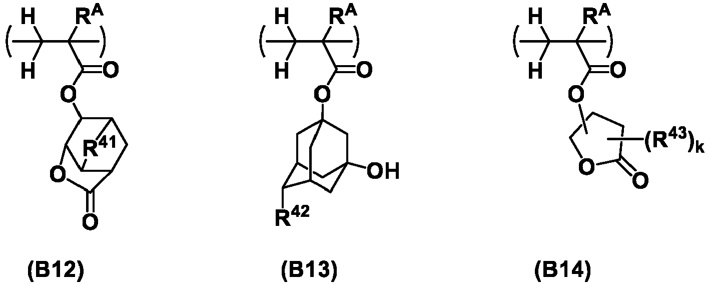

In formulae (B12) to (B14), R^{A} is each independently hydrogen, fluorine, methyl or trifluoromethyl. R⁴¹ is -O-, -S- or methylene. R⁴² is hydrogen or hydroxy. R⁴³ is a C₁-C₄ saturated hydrocarbyl group, and k is an integer of 0 to 3.

When repeat units B12 to B14 are included, their content is preferably 0 to 20 mol%, more preferably 0 to 10 mol% based on the overall repeat units of the polymer. Each of repeat units B12 to B14 may be of one type or a combination of plural types.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER is degraded when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.9, even more preferably 1.0 to 1.8. A polymer with such a narrow dispersity eliminates the risk that foreign particles are left on the pattern after development and the pattern profile is aggravated.

The base polymer is designed such that the dissolution rate in alkaline developer is preferably up to 10 nm/min, more preferably up to 7 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 10 nm/min, pattern collapse occurs, i.e., a small size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

Besides the polymer containing repeat units B1, the base polymer (B) may comprise another polymer having a well-known acid labile group such as a tertiary alkyl group or tert-butoxycarbonyl group. For obtaining the benefits of the invention, the content of the polymer containing repeat units B 1 is preferably at least 30% of the base polymer in the resist composition.

In addition to the polymer defined above, the base polymer (B) may comprise another polymer. The other polymer may be any of prior art well-known base polymers used in resist compositions. The content of the other polymer is not particularly limited as long as the benefits of the invention are not impaired.

### (C) Organic solvent

The chemically amplified positive resist composition may comprise an organic solvent as component (C). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone, and 2-heptanone; alcohols such as 3-methoxybutanol, 3-methyl-3-methoxybutanol, 1-methoxy-2-propanol, 1-ethoxy-2-propanol, and diacetone alcohol (DAA); ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones such as γ-butyrolactone (GBL), and mixtures thereof. Where an acid labile group of acetal form is used, a high boiling alcohol solvent such as diethylene glycol, propylene glycol, glycerol, 1,4-butanediol or 1,3-butanediol may be added to accelerate deprotection reaction of acetal.

Of these organic solvents, it is recommended to use 1-ethoxy-2-propanol, PGMEA, PGME, cyclohexanone, EL, GBL, and mixtures thereof.

In the resist composition, the organic solvent (C) is preferably used in an amount of 200 to 10,000 parts, more preferably 400 to 5,000 parts by weight per 80 parts by weight of the base polymer (B). The organic solvent may be used alone or in admixture.

### (D) Fluorinated polymer

The chemically amplified positive resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively. Since the fluorinated polymer also has a surfactant function, it can prevent insoluble residues from re-depositing onto the substrate during the development step and is thus effective for preventing development defects.

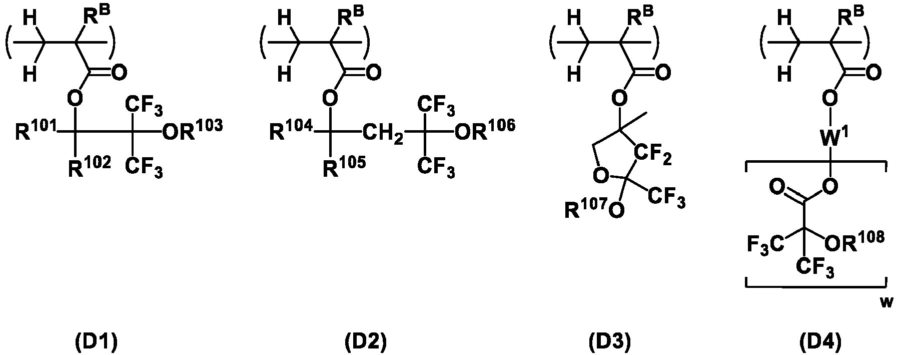

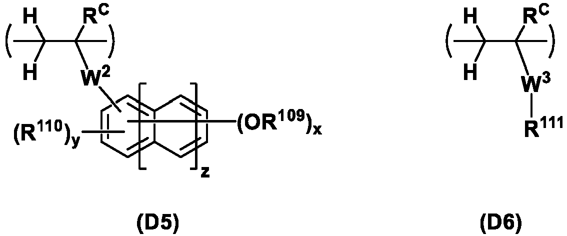

In formulae (D1) to (D6), x is an integer of 1 to 3, y is an integer satisfying: 0 ≤ y ≤ 5+2z-x, z is 0 or 1, and w is an integer of 1 to 3. R^{B} is each independently hydrogen, fluorine, methyl or trifluoromethyl. R^{C} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group. An ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. W¹ is a C₁-C₂₀ (w+1)-valent hydrocarbon group or C₁-C₂₀ (w+1)-valent fluorinated hydrocarbon group. W² is a single bond, *-C(=O)-O- or *-C(=O)-NH-. W³ is a single bond, -O-, *-C(=O)-O-W³¹-W³²- or *-C(=O)-NH-W³¹-W³²-, wherein W³¹ is a single bond or a C₁-C₁₀ saturated hydrocarbylene group, W³² is a single bond, ester bond, ether bond or sulfonamide bond. The asterisk (*) designates a point of attachment to the carbon atom in the backbone.

In formulae (D1) and (D2), the C₁-C₁₀ saturated hydrocarbyl group represented by R¹⁰¹, R¹⁰², R¹⁰⁴ and R¹⁰⁵ may be straight, branched or cyclic, and examples thereof include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), the C₁-C₁₅ hydrocarbyl group represented by R¹⁰³, R¹⁰⁶, R¹⁰⁷ and R¹⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (w+1)-valent hydrocarbon group W¹ include the foregoing C₁-C₂₀ alkyl groups and C₃-C₂₀ cyclic saturated hydrocarbyl groups, with w number of hydrogen atoms being eliminated. Examples of the C₁-C₂₀ (w+1)-valent fluorinated hydrocarbon group W¹ include the foregoing (w+1)-valent hydrocarbon groups in which at least one hydrogen atom is substituted by fluorine.

Examples of the repeat units D1 to D4 are given below, but not limited thereto. Herein R^{B} is as defined above.

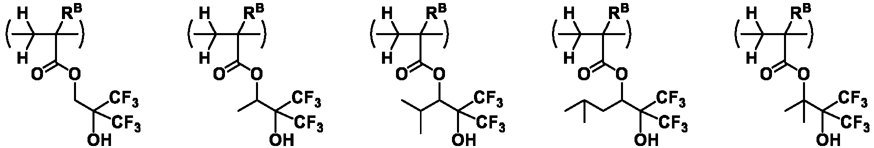

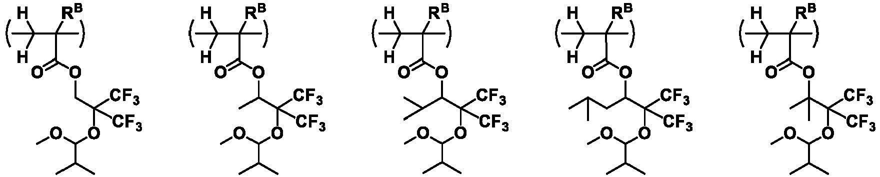

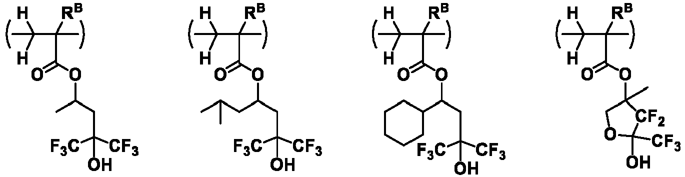

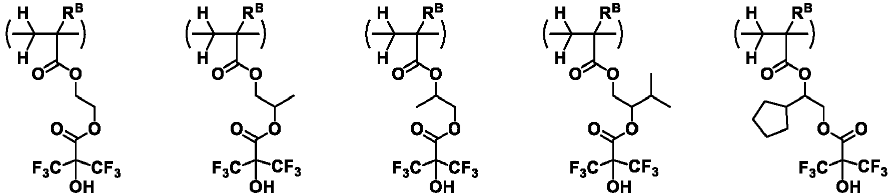

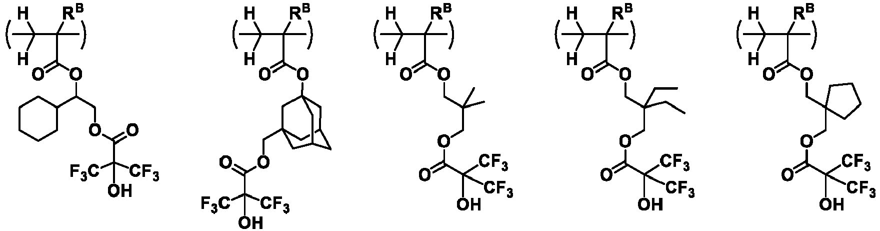

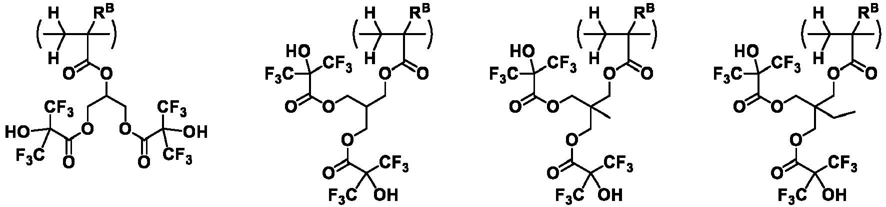

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In the hydrocarbyl group, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), W² is preferably *-C(=O)-O- or *-C(=O)-NH-. Also preferably R^{C} is methyl. The inclusion of carbonyl in W² enhances the ability to trap the acid originating from the anti-charging film. A polymer wherein R^{C} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{C} is as defined above.

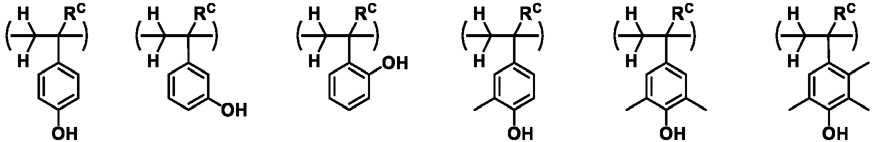

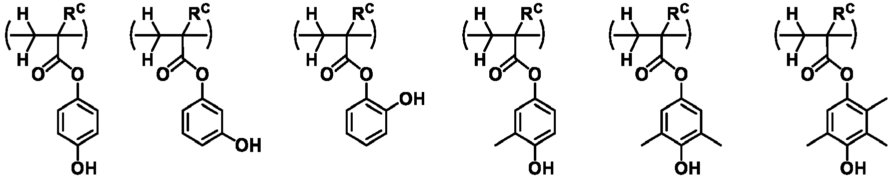

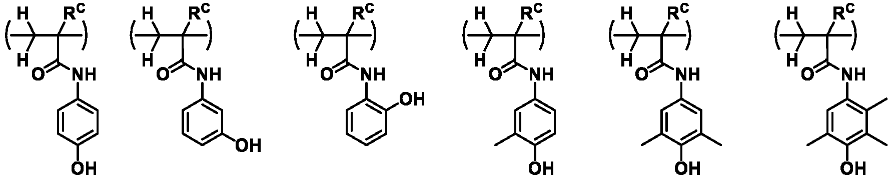

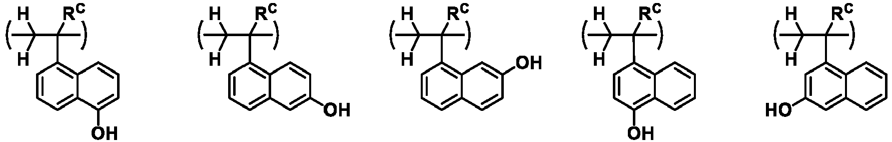

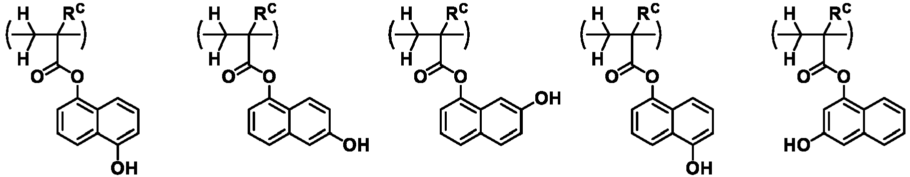

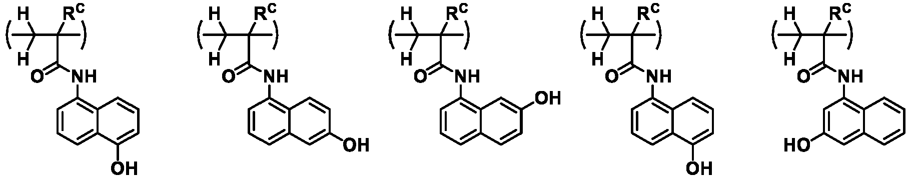

In formula (D6), the C₁-C₁₀ saturated hydrocarbylene group W³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{C} is as defined above.

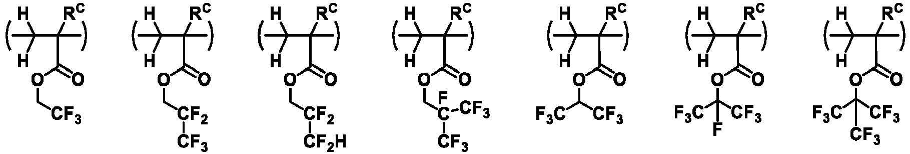

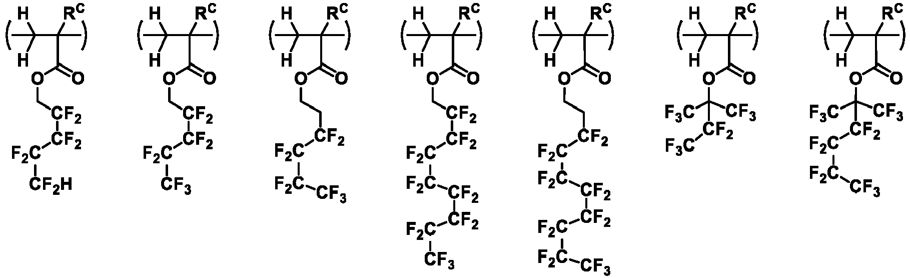

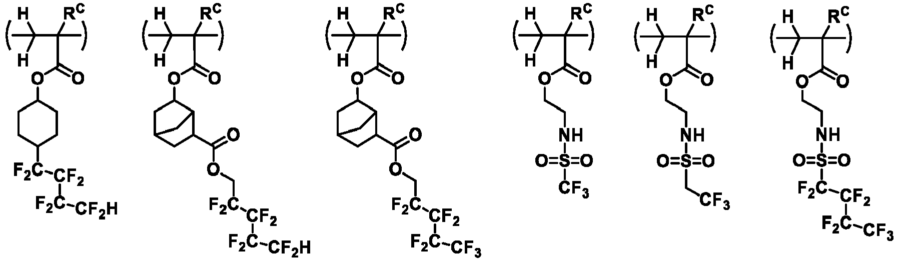

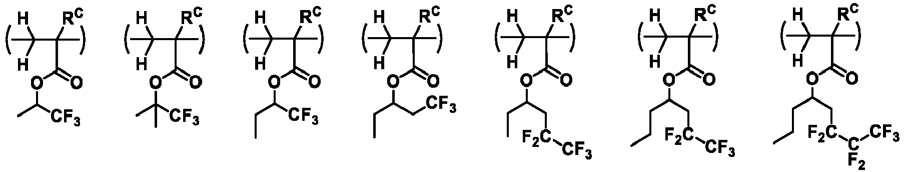

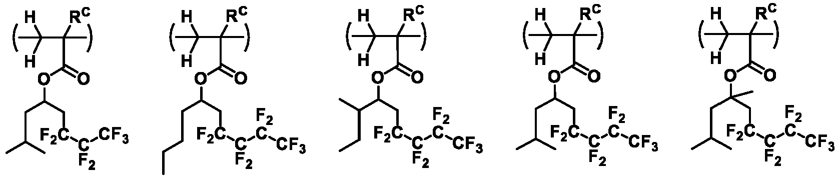

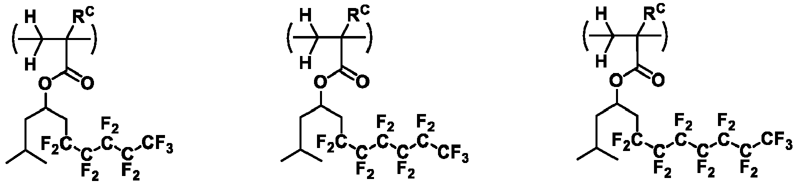

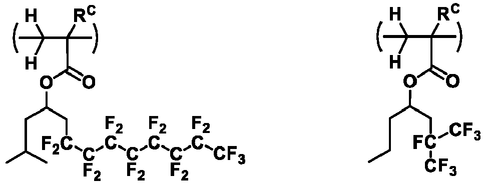

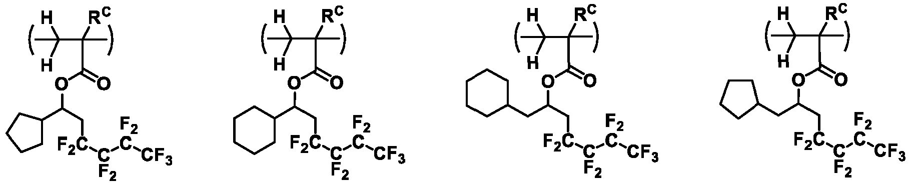

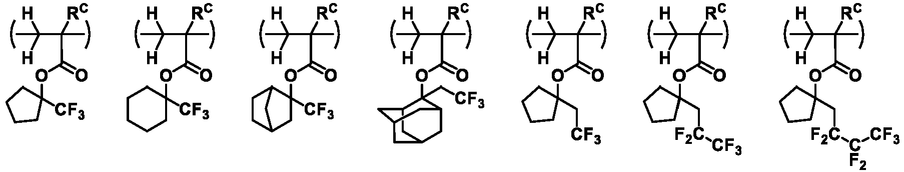

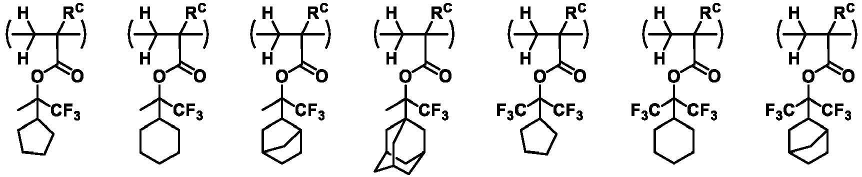

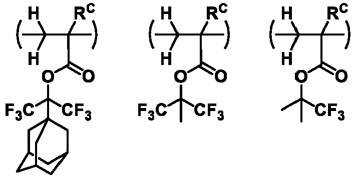

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the resist composition, the fluorinated polymer (D) is preferably used in an amount of 0.01 to 30 parts by weight, more preferably 0.1 to 20 parts by weight per 80 parts by weight of the base polymer (B).

### (E) Quencher

The resist composition may further contain a quencher as component (E). The quencher is a compound having a function of trapping the acid generated by the acid generator. The quencher is effective for holding down the rate of diffusion of the acid (generated by the acid generator) in the resist film. Even when a substrate whose outermost surface is made of a chromium-containing material is used, the quencher is effective for suppressing the influence of the acid (generated in the resist film) on the chromium-containing material.

One preferred example of the quencher is an onium salt of carboxylic acid having the formula (E1).

**R²⁰¹-CO₂⁻Mq⁺** **(E1)**

In formula (E1), R²⁰¹ is a C₁-C₄₀ hydrocarbyl group which may contain a heteroatom. The hydrocarbyl group may be saturated or unsaturated and straight, branched or cyclic. Examples include C₁-C₄₀ alkyl groups, C₃-C₄₀ cyclic saturated hydrocarbyl groups, C₂-C₄₀ alkenyl groups, C₂-C₄₀ alkynyl groups, C₃-C₄₀ cyclic unsaturated aliphatic hydrocarbyl groups, C₆-C₄₀ aryl groups, C₇-C₄₀ aralkyl groups, and combinations thereof. In the hydrocarbyl group, some or all hydrogen may be substituted by a hydroxy, carboxy, halogen, cyano, amide, nitro, mercapto, sultone, sulfone or sulfonium salt-containing moiety, and some constituent -CH₂- may be replaced by an ether bond, ester bond, carbonyl moiety, carbonate moiety or sulfonate ester bond.

In formula (E1), Mq⁺ is an onium cation. Suitable onium cations include sulfonium, iodonium and ammonium cations, with the sulfonium cations being preferred. Preferred sulfonium cations are as exemplified above for the sulfonium cation having formula (cation-1).

When the carboxylic onium salt having formula (E1) is contained as the quencher, its content is preferably 0.1 to 40 parts by weight, more preferably 0.1 to 20 parts by weight per 80 parts by weight of the base polymer (B).

Another preferred example of the quencher is an onium salt of carboxylic acid having the formula (E2) or (E3).

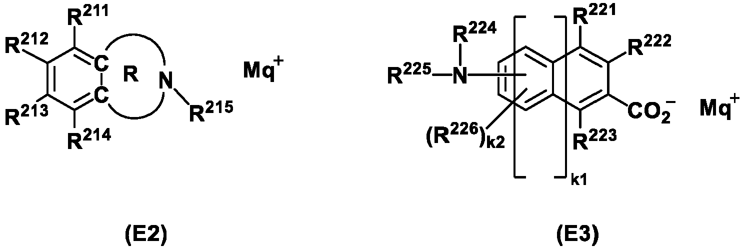

Herein, Mq⁺ is as defined above.

In formula (E2), R²¹¹ to R²¹⁴ are each independently hydrogen, -L¹¹-CO₂⁻, or a C₁-C₂₀ hydrocarbyl group which may contain a heteroatom. A pair of R²¹¹ and R²¹², R²¹² and R²¹³, or R²¹³ and R²¹⁴ may bond together to form a ring with the carbon atoms to which they are attached. L¹¹ is a single bond or a C₁-C₂₀ hydrocarbylene group which may contain a heteroatom. R¹¹⁵ is hydrogen or a C₁-C₂₀ hydrocarbyl group which may contain a heteroatom.

In formula (E2), the ring R is a ring of 2 to 6 carbon atoms including the carbon and nitrogen atoms depicted in the formula, in which some or all of the carbon-bonded hydrogen atoms may be substituted by a C₁-C₂₀ hydrocarbyl moiety or -L¹¹-CO₂⁻, and some constituent -CH₂- may be replaced by a divalent moiety containing sulfur, oxygen or nitrogen. The ring may be alicyclic or aromatic and is preferably 5- or 6-membered. Examples include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (E2) has at least one -L¹¹-CO₂⁻ group. That is, at least one of R²¹¹ to R²¹⁴ is -L¹¹-CO₂⁻ and/or at least one of carbon-bonded hydrogen atoms in the ring R is substituted by -L¹¹-CO₂⁻.

In formula (E3), R²²¹ to R²²⁶ are each independently hydrogen or a C₁-C₂₀ hydrocarbyl group which may contain a heteroatom. A pair of R²²¹ and R²²², or R²²³ and R²²⁶ may bond together to form a ring with the carbon atoms to which they are attached, and a pair of R²²⁴ and R²²⁵ may bond together to form a ring with the nitrogen atom to which they are attached. The subscript k1 is 0 or 1, and k2 is 0 or 1 in case of k1=0, and k2 is an integer of 0 to 3 in case of k1=1.

When the resist composition contains the carboxylic onium salt having formula (E2) or (E3) as the quencher, its content is preferably 0.1 to 50 parts by weight, more preferably 0.5 to 30 parts by weight per 80 parts by weight of the base polymer (B).

A further preferred example of the quencher is a sulfonium compound having the formula (E4).

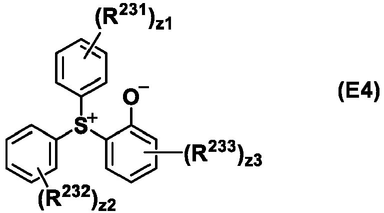

In formula (E4), R²³¹, R²³² and R²³³ are each independently a C₁-C₂₀ hydrocarbyl group which may contain a heteroatom. In the hydrocarbyl group, some hydrogen may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonate ester bond, carbonate bond, carbamate bond, lactone ring, sultone ring, carboxylic anhydride (-C(=O)-O-C(=O)-) or haloalkyl moiety. The constituent -CH₂- in the hydrocarbyl group may be a carbon atom bonded to the benzene ring.

In formula (E4), z1 and z2 are each independently an integer of 0 to 5, and z3 is an integer of 0 to 4. From the standpoints of ease of synthesis and availability of reactants, z1, z2 and z3 each are preferably 0, 1 or 2.

When z1 is 2 to 5, two adjoining R²³¹ may bond together to form a ring with the carbon atoms to which they are attached. When z2 is 2 to 5, two adjoining R²³² may bond together to form a ring with the carbon atoms to which they are attached. When z3 is 2 to 4, two adjoining R²³³ may bond together to form a ring with the carbon atoms to which they are attached.

When the resist composition contains the sulfonium compound having formula (E4) as the quencher, its content is preferably 0.1 to 40 parts by weight, more preferably 1 to 20 parts by weight per 80 parts by weight of the base polymer (B).

In combination with the above-mentioned onium salt compound, a photo-decomposable onium salt having a nitrogen-containing substituent group may be used as the quencher, if desired. This compound functions as a quencher in the unexposed region, but as a so-called photo-degradable base in the exposed region because it loses the quencher function in the exposed region due to neutralization thereof with the acid generated by itself. Using a photo-degradable base, the contrast between exposed and unexposed regions can be further enhanced. With respect to the photo-degradable base, reference may be made to JP-A 2009-109595, 2012-046501 and JP-A 2013-209360, for example. When the resist composition contains the photo-degradable base as the quencher, its content is preferably 0.1 to 40 parts by weight, more preferably 0.1 to 20 parts by weight per 80 parts by weight of the base polymer (B).

An amine compound may also be used as the quencher. Suitable amine compounds include primary, secondary and tertiary amine compounds as described in JP-A 2008-111103, paragraphs [0146]-[0164] (USP 7,537,880), especially amine compounds having a hydroxy group, ether bond, ester bond, lactone ring, cyano group or sulfonate ester bond. Also useful are compounds having primary or secondary amine protected with a carbamate group, as described in JP 3790649. When the resist composition contains the amine compound as the quencher, its content is preferably 0.001 to 12 parts by weight, more preferably 0.01 to 8 parts by weight per 80 parts by weight of the base polymer (B).

The quencher may be used alone or in admixture.

### (F) Other photoacid generator

In addition to the PAG having formula (A), the chemically amplified positive resist composition may further comprise another photoacid generator (PAG). The other PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable other PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081].

The preferred PAGs are salt compounds having a sulfonium anion of the structure shown below.

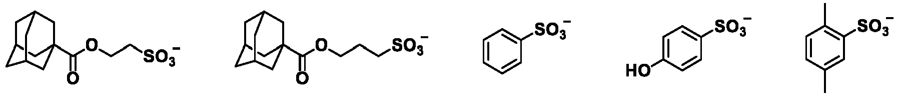

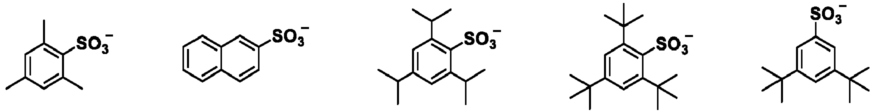

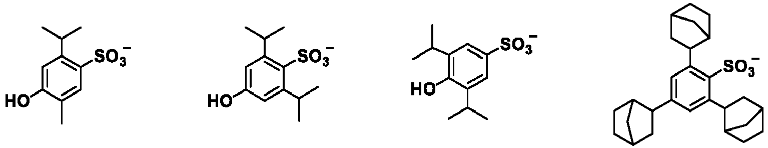

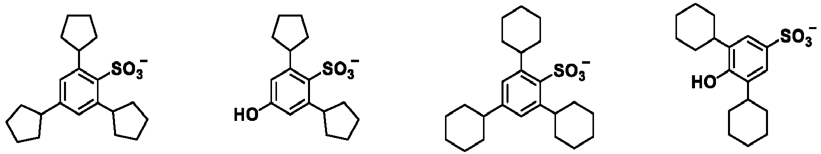

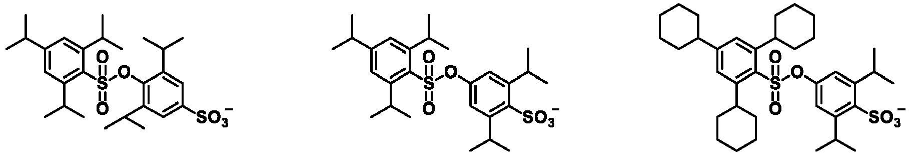

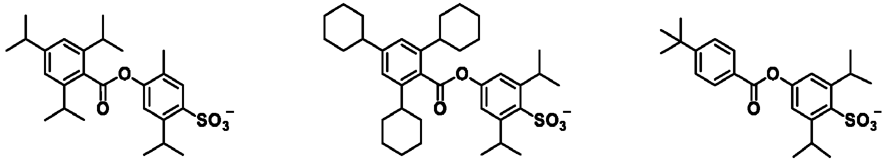

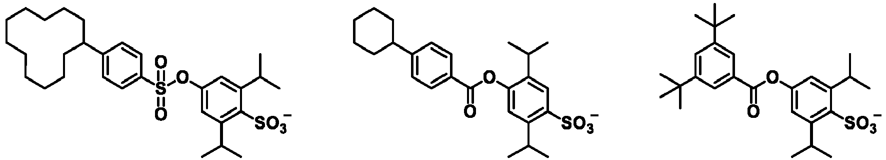

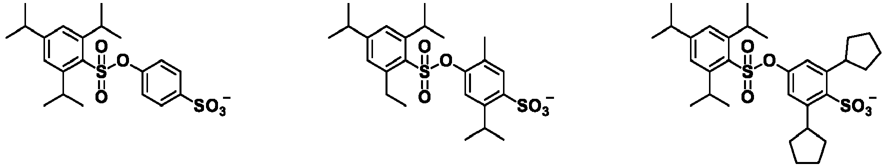

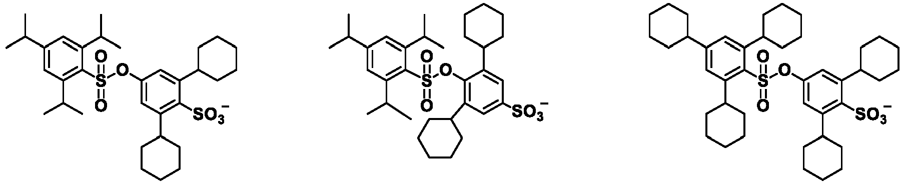

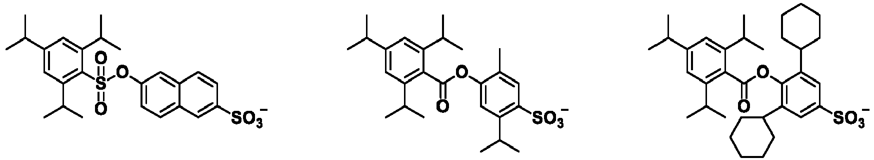

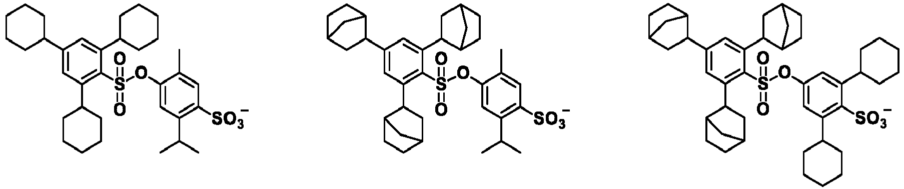

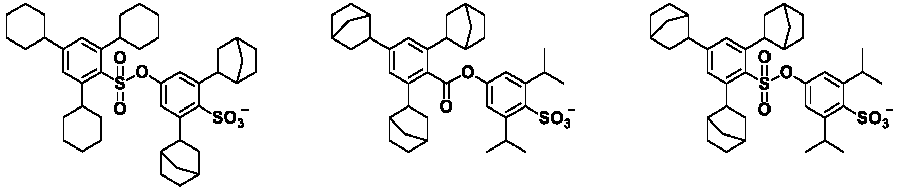

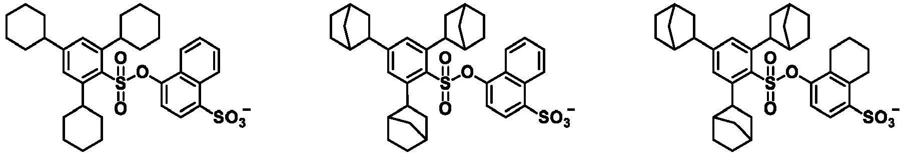

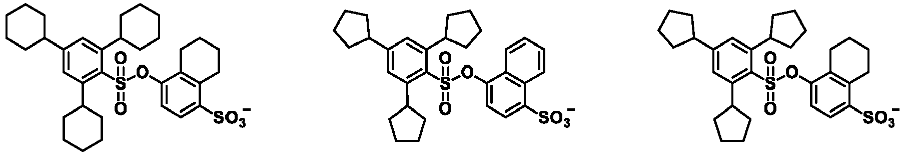

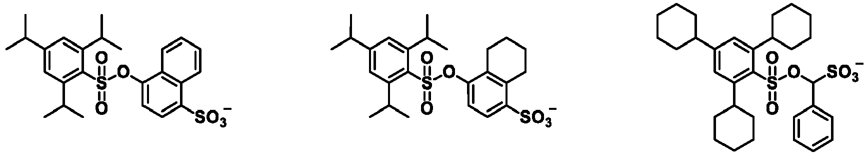

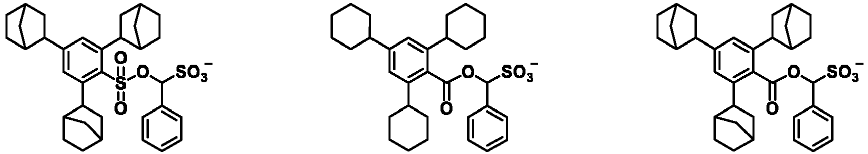

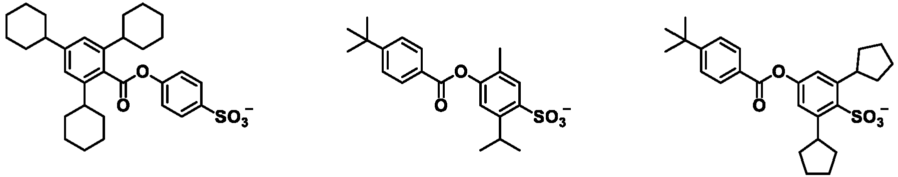

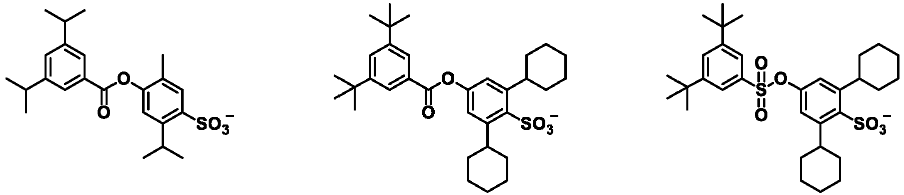

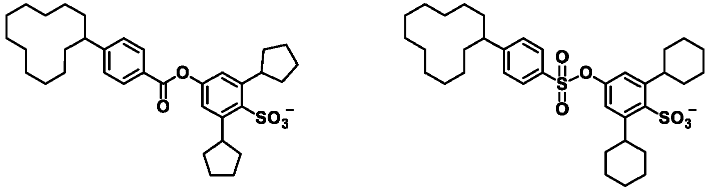

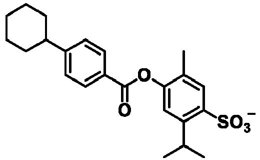

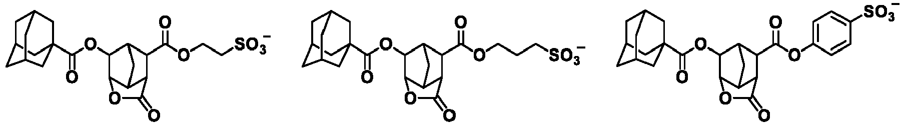

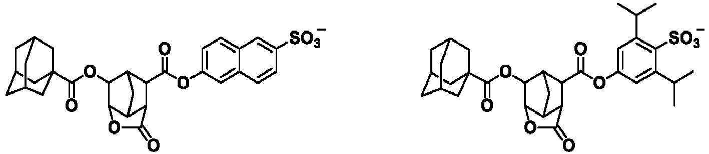

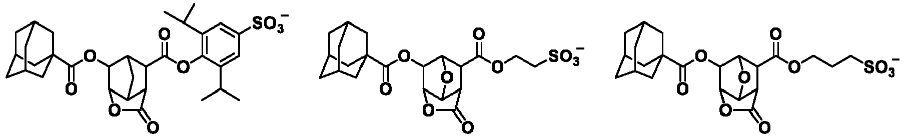

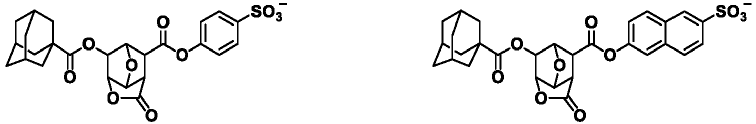

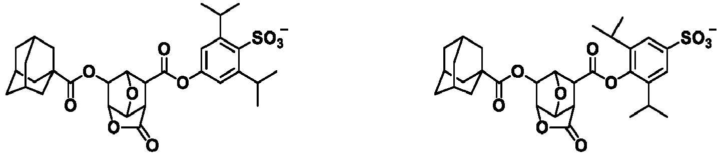

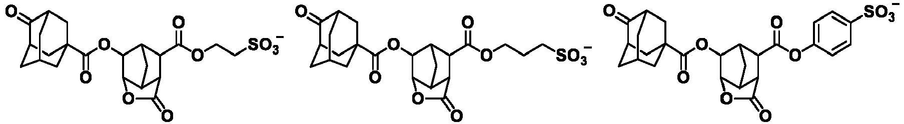

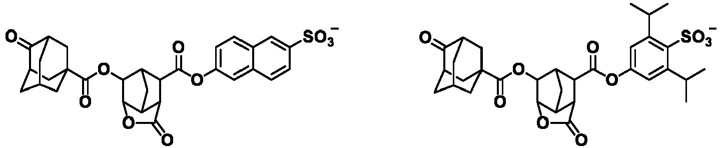

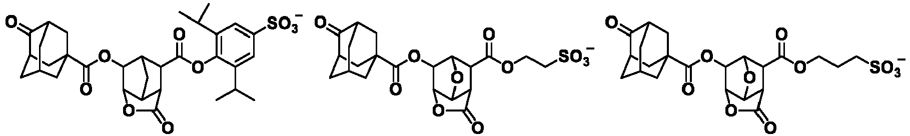

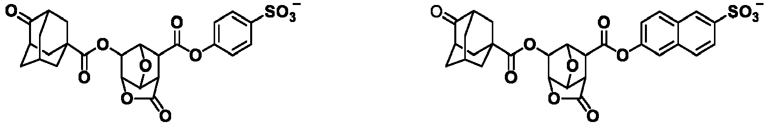

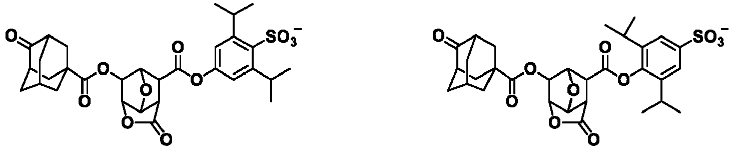

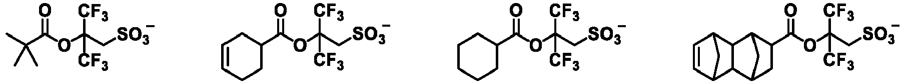

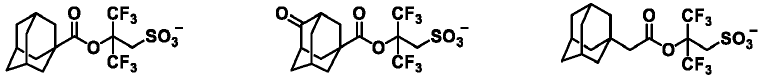

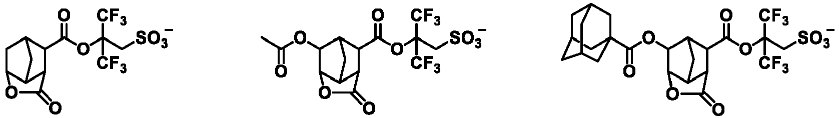

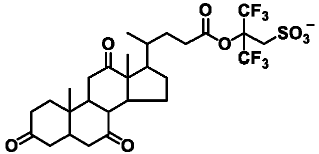

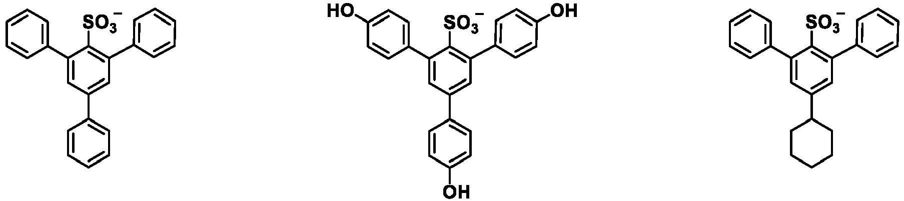

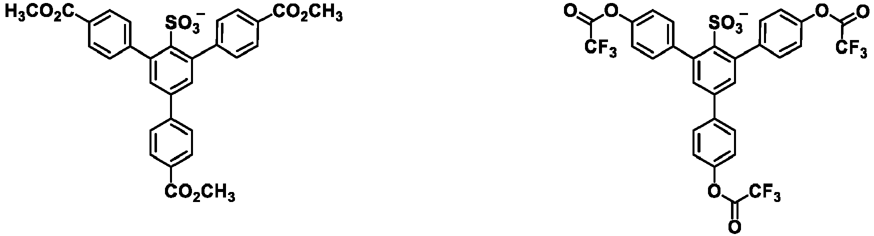

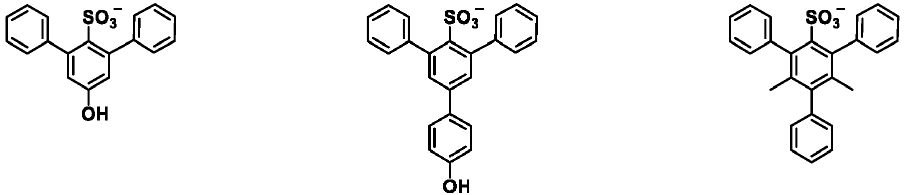

Also preferred as the PAG is a salt compound containing an anion having the formula (F1).

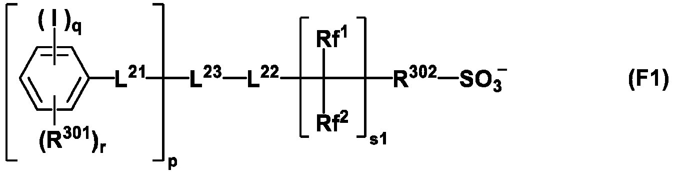

In formula (F1), p is an integer of 1 to 3, q is an integer of 1 to 5, r is an integer of 0 to 3, and s1 is 0 or 1.

In formula (F1), L²¹ is a single bond, ether bond, ester bond, sulfonate ester bond, carbonate bond or carbamate bond.

In formula (F1), L²² is an ether bond, ester bond, sulfonate ester bond, carbonate bond or carbamate bond.

In formula (F1), when p is 1, L²³ is a single bond or a C₁-C₂₀ hydrocarbylene group. When p is 2 or 3, L²³ is a C₁-C₂₀ (p+1)-valent hydrocarbon group. The hydrocarbylene group and (p+1)-valent hydrocarbon group may contain at least one moiety selected from ether bond, carbonyl moiety, ester bond, amide bond, sultone ring, lactam ring, carbonate bond, halogen, hydroxy moiety and carboxy moiety.

The C₁-C₂₀ hydrocarbylene group L²³ may be saturated or unsaturated and straight, branched or cyclic. Examples thereof include C₁-C₂₀ alkanediyl groups such as methylene, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, dodecane-1,12-diyl; C₃-C₂₀ cyclic saturated hydrocarbylene groups such as cyclopentanediyl, cyclohexanediyl, norbornanediyl and adamantanediyl; C₂-C₂₀ unsaturated aliphatic hydrocarbylene groups such as vinylene and propene-1,3-diyl; C₆-C₂₀ arylene groups such as phenylene and naphthylene; and combinations thereof. The C₁-C₂₀ (p+1)-valent hydrocarbon group L²³ may be saturated or unsaturated and straight, branched or cyclic. Examples thereof include those exemplified above for the C₁-C₂₀ hydrocarbylene group, with one or two hydrogen atoms being eliminated.

In formula (F1), Rf¹ and Rf² are each independently hydrogen, fluorine or trifluoromethyl, at least one being fluorine or trifluoromethyl.

In formula (F1), R³⁰¹ is hydroxy, carboxy, a C₁-C₆ saturated hydrocarbyl group, C₁-C₆ saturated hydrocarbyloxy group, C₂-C₆ saturated hydrocarbylcarbonyloxy group, fluorine, chlorine, bromine, amino, -N(R^{301A})-C(=O)-R^{301B} or -N(R^{301A})-C(=O)-O-R^{301B}. R^{301A} is hydrogen or a C₁-C₆ saturated hydrocarbyl group. R^{301B} is a C₁-C₆ saturated hydrocarbyl group or C₂-C₈ unsaturated aliphatic hydrocarbyl group.

The C₁-C₆ saturated hydrocarbyl group represented by R³⁰¹, R^{101A} and R^{101B} may be straight, branched or cyclic. Examples thereof include C₁-C₆ alkyl groups such as methyl, ethyl, n-propyl, isopropyl, n-butyl, isobutyl, sec-butyl, tert-butyl, n-pentyl, and n-hexyl; and C₃-C₆ cyclic saturated hydrocarbyl groups such as cyclopropyl, cyclobutyl, cyclopentyl, and cyclohexyl. Examples of the saturated hydrocarbyl moiety in the C₁-C₆ saturated hydrocarbyloxy group represented by R³⁰¹ are as exemplified above for the saturated hydrocarbyl group. Examples of the saturated hydrocarbyl moiety in the C₂-C₆ saturated hydrocarbylcarbonyloxy group represented by R³⁰¹ are as exemplified above for the C₁-C₆ saturated hydrocarbyl group, but of 1 to 5 carbon atoms.

The C₂-C₈ unsaturated aliphatic hydrocarbyl group represented by R^{301B} may be straight, branched or cyclic and examples thereof include C₂-C₈ alkenyl groups such as vinyl, propenyl, butenyl, and hexenyl; C₂-C₈ alkynyl groups such as ethynyl, propynyl, and butynyl; and C₃-C₈ cyclic unsaturated aliphatic hydrocarbyl groups such as cyclohexenyl and norbornenyl.

In formula (F1), R³⁰² is a C₁-C₂₀ saturated hydrocarbylene group or C₆-C₁₄ arylene group. Some or all of the hydrogen atoms in the saturated hydrocarbylene group may be substituted by halogen other than fluorine. Some or all of the hydrogen atoms in the arylene group may be substituted by a substituent selected from C₁-C₂₀ saturated hydrocarbyl groups, C₁-C₂₀ saturated hydrocarbyloxy groups, C₆-C₁₄ aryl groups, halogen, and hydroxy.

The C₁-C₂₀ saturated hydrocarbylene group represented by R³⁰² may be straight, branched or cyclic. Examples thereof include C₁-C₂₀ alkanediyl groups such as methylene, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, dodecane-1,12-diyl; and C₃-C₂₀ cyclic saturated hydrocarbylene groups such as cyclopentanediyl, cyclohexanediyl, norbornanediyl and adamantanediyl.

Examples of the C₆-C₁₄ arylene group represented by R³⁰² include phenylene, naphthylene, phenanthrenediyl, and anthracenediyl. The C₁-C₂₀ saturated hydrocarbyl moiety and hydrocarbyl moiety in the C₁-C₂₀ hydrocarbyloxy moiety, which are substituents on the arylene group, may be straight, branched or cyclic and examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; and C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl. Examples of the C₆-C₁₄ arylene moiety which is a substituent on the arylene group include phenylene, naphthylene, phenanthrenediyl and anthracenediyl.

Of the anions having formula (F1), anions having the formula (F2) are preferred.

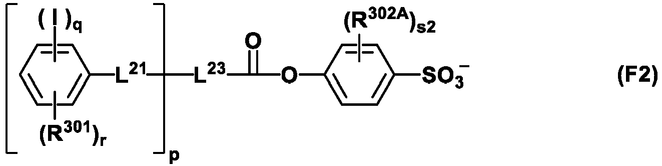

In formula (F2), p, q, r, L²¹, L²³, and R³⁰¹ are as defined above. The subscript s2 is an integer of 1 to 4. R^{302A} is a C₁-C₂₀ saturated hydrocarbyl group, C₁-C₂₀ saturated hydrocarbyloxy group, C₆-C₁₄ aryl group, halogen or hydroxy group. When s2 is 2, 3 or 4, a plurality of R^{302A} may be identical or different.

Examples of the anion having formula (F1) are shown below, but not limited thereto.

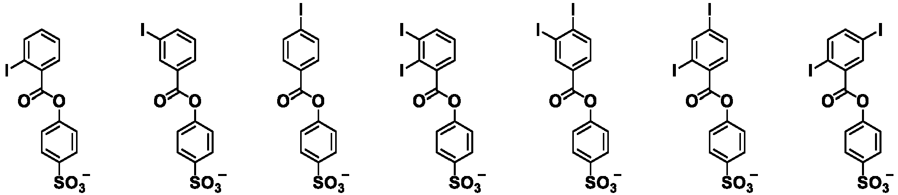

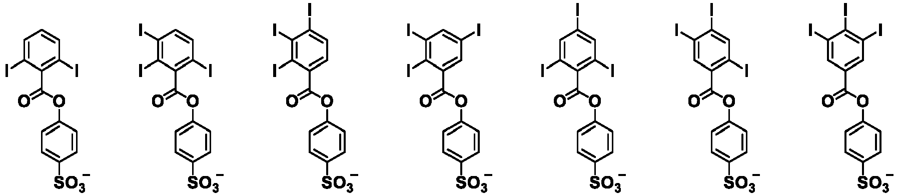

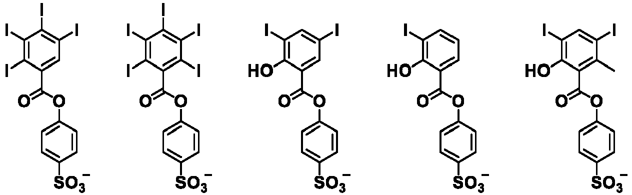

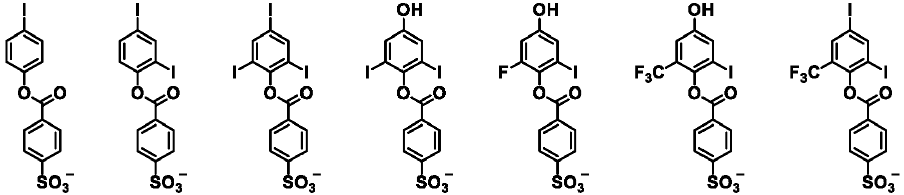

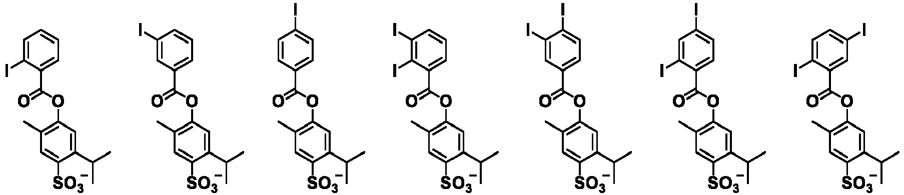

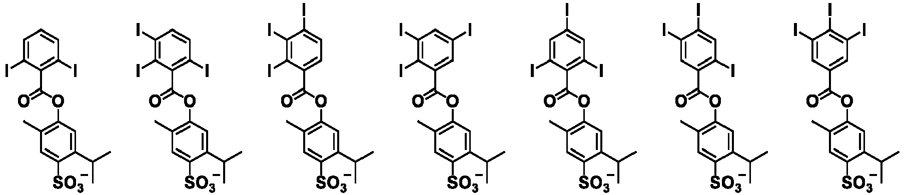

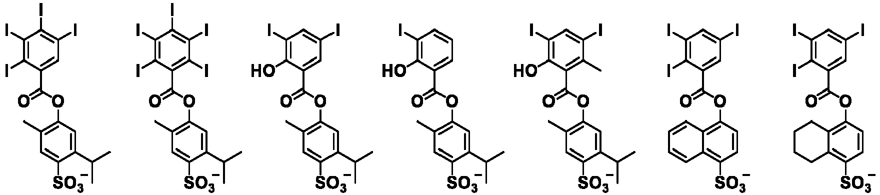

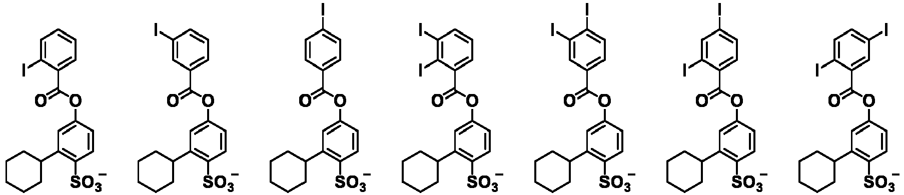

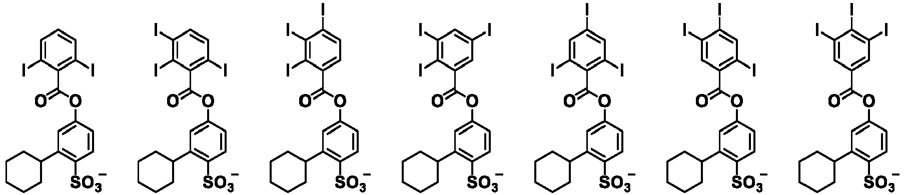

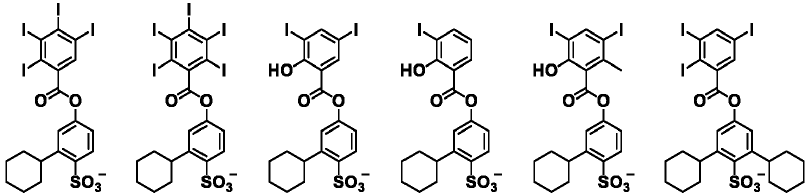

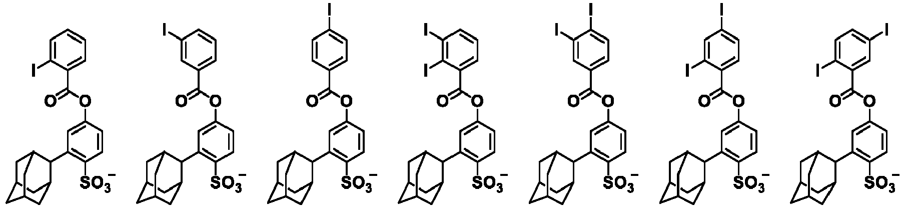

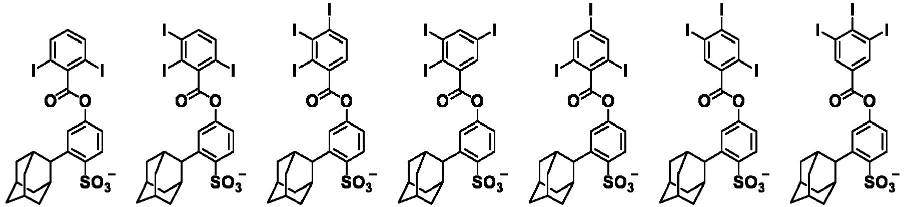

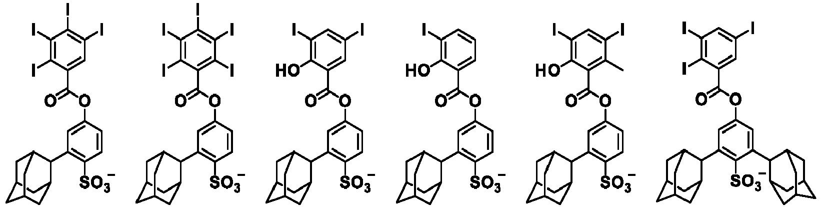

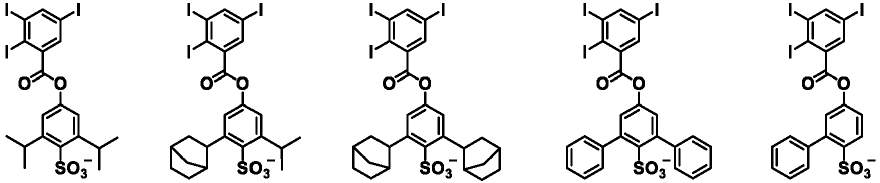

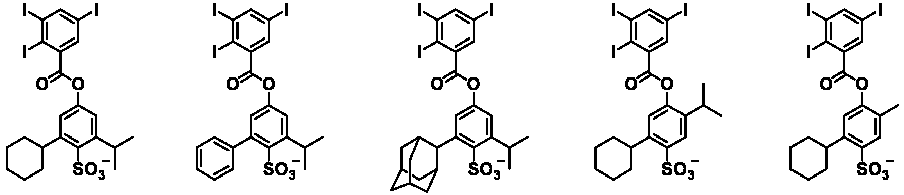

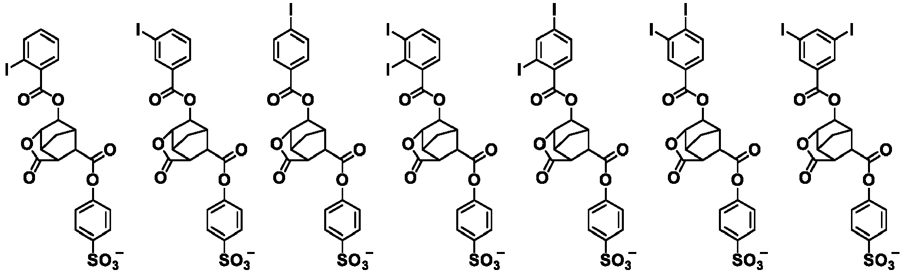

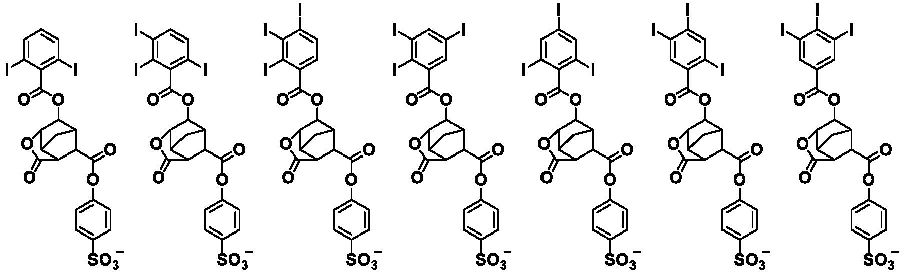

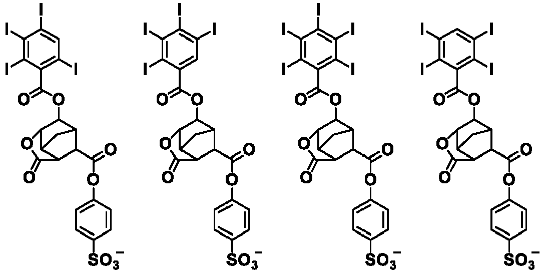

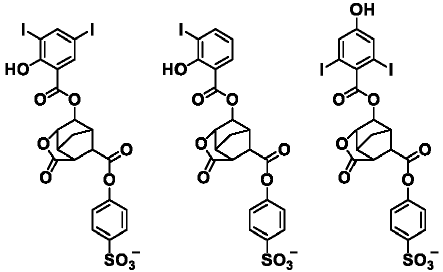

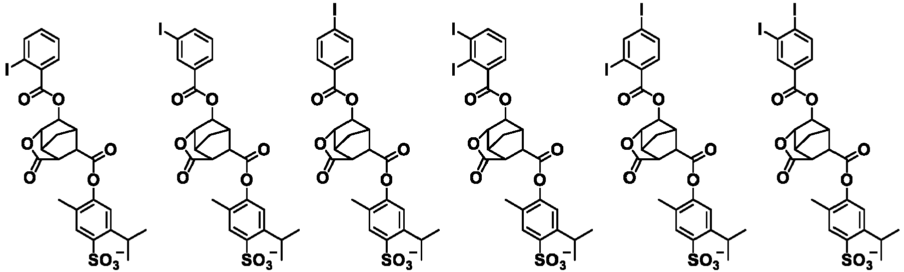

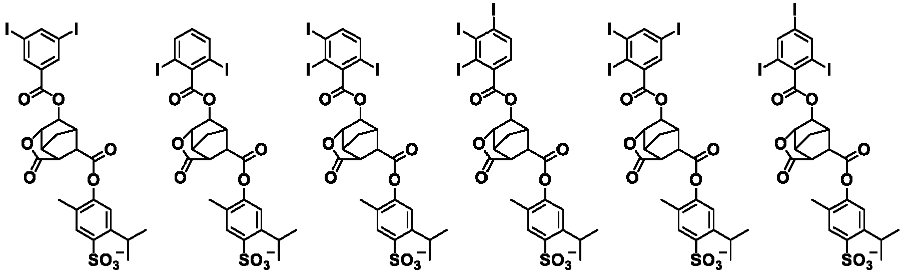

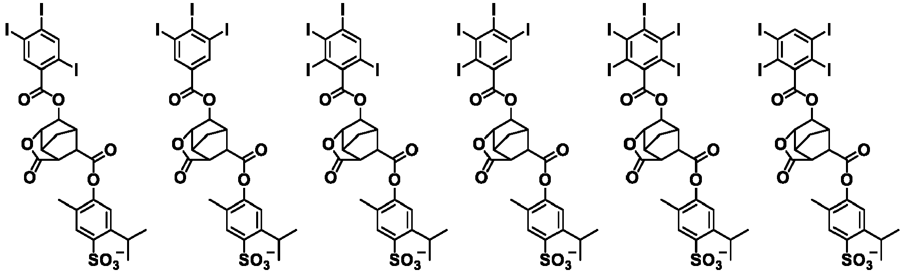

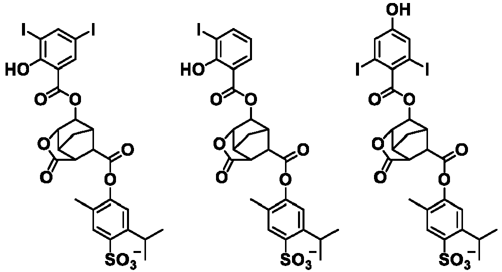

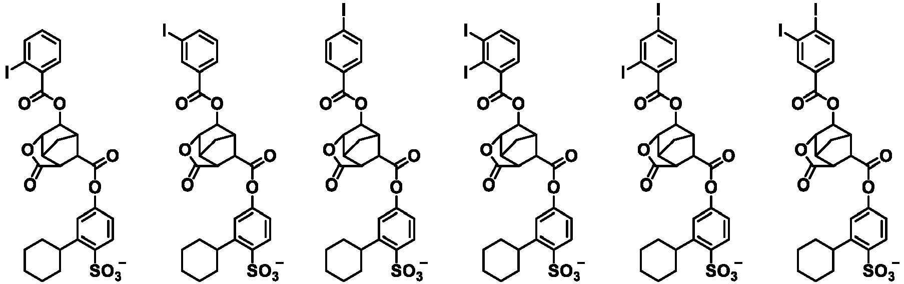

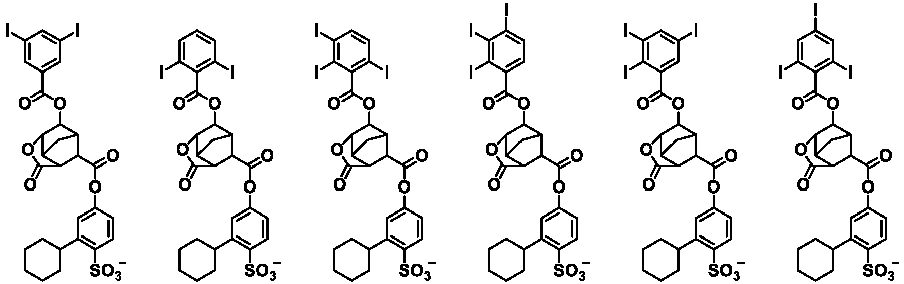

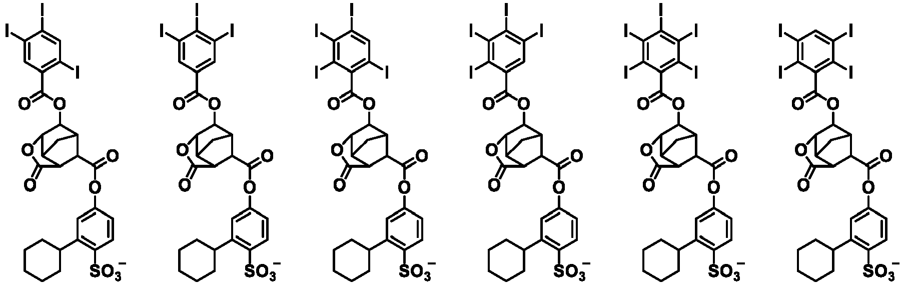

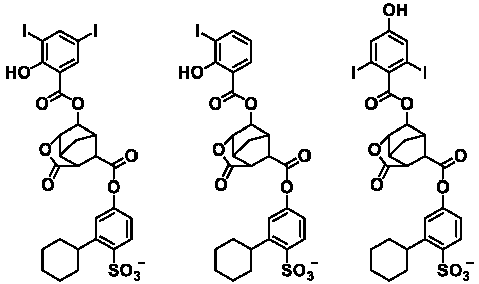

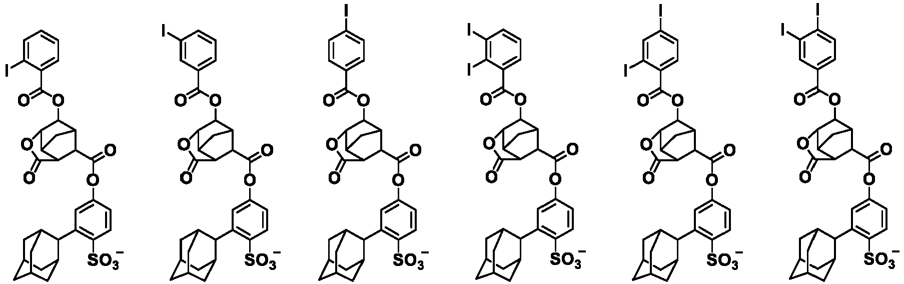

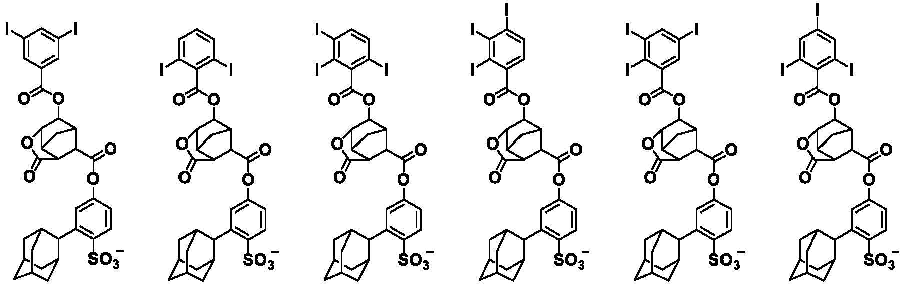

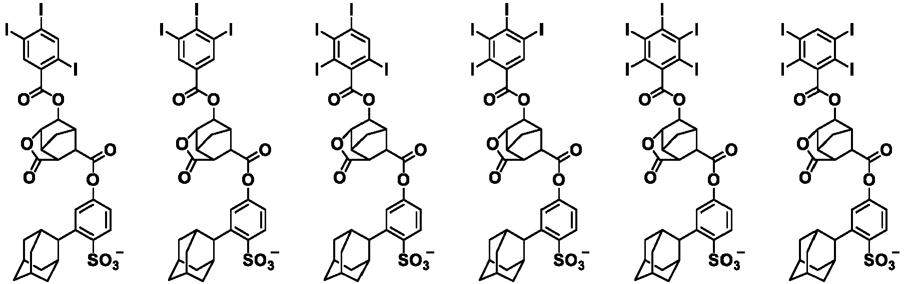

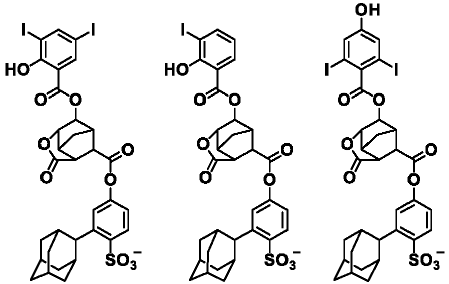

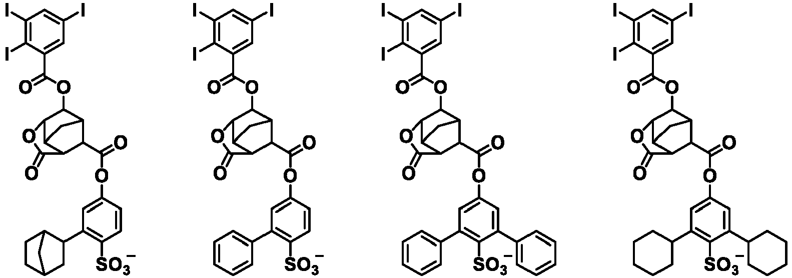

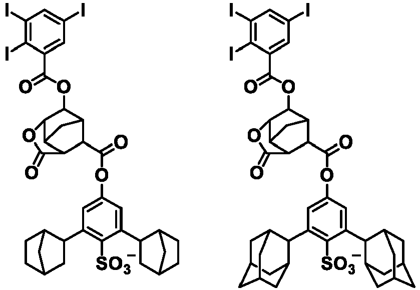

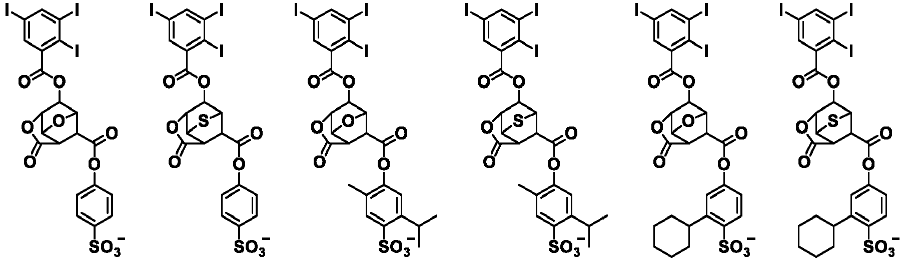

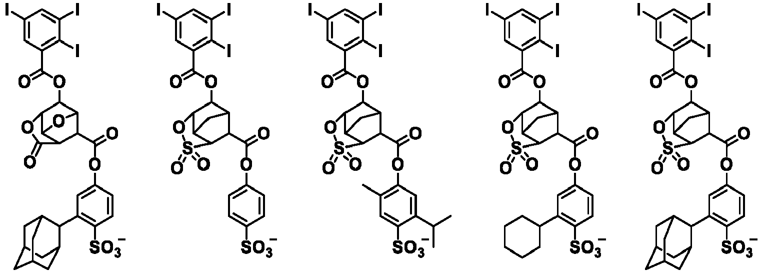

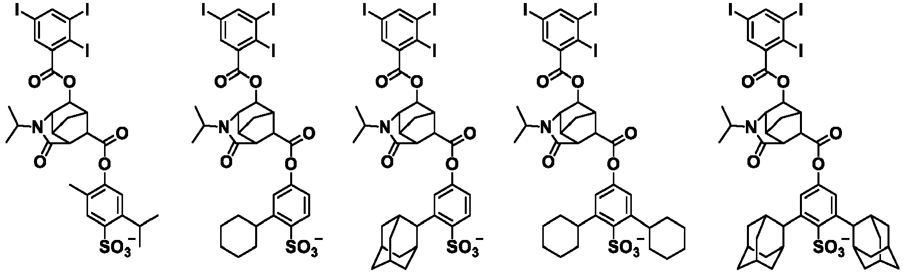

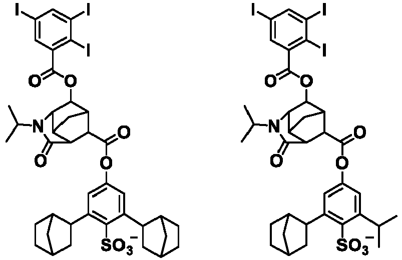

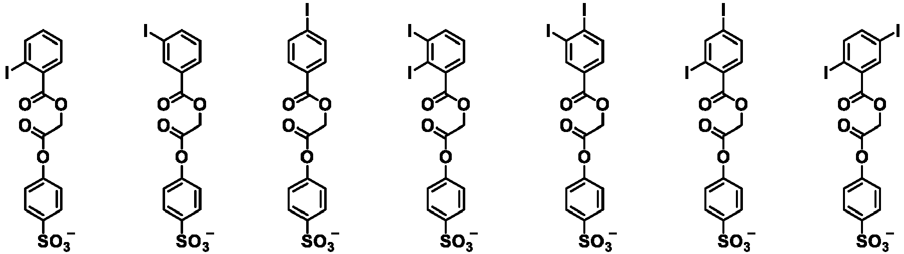

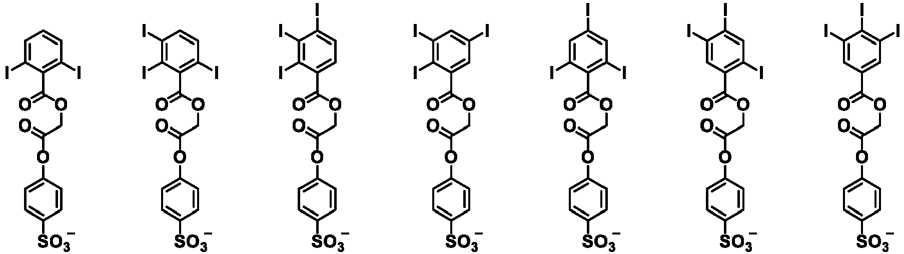

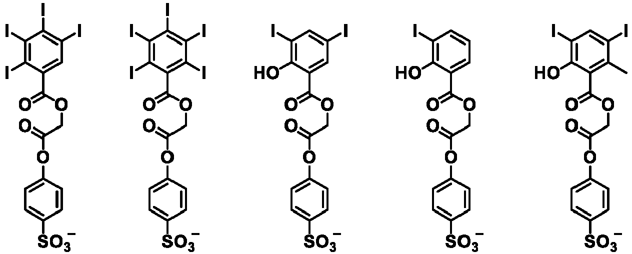

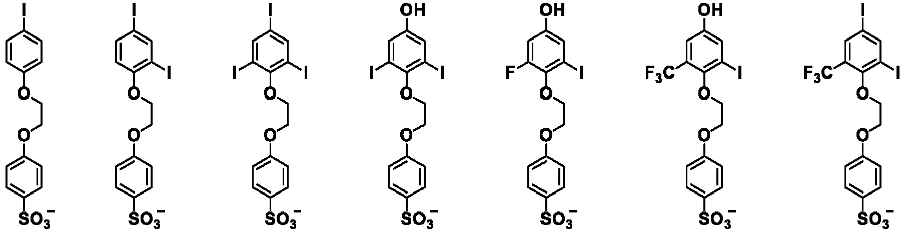

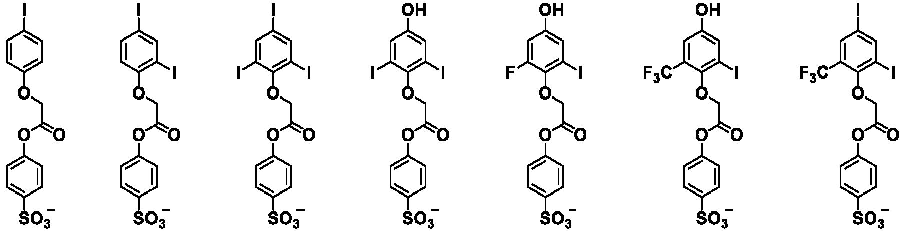

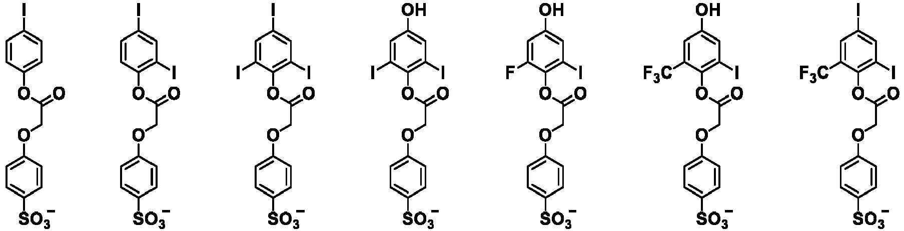

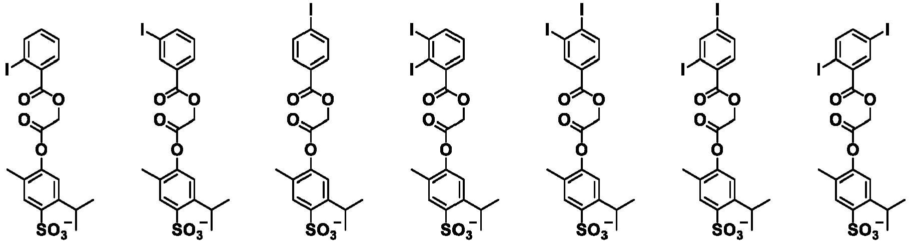

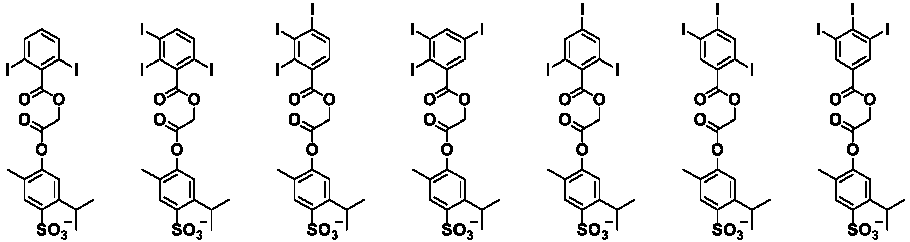

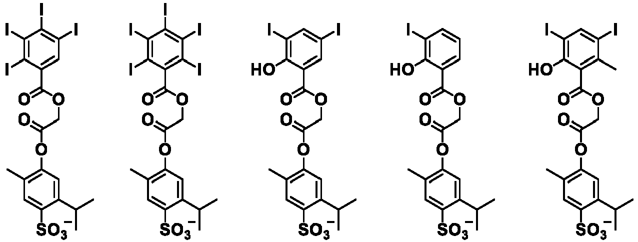

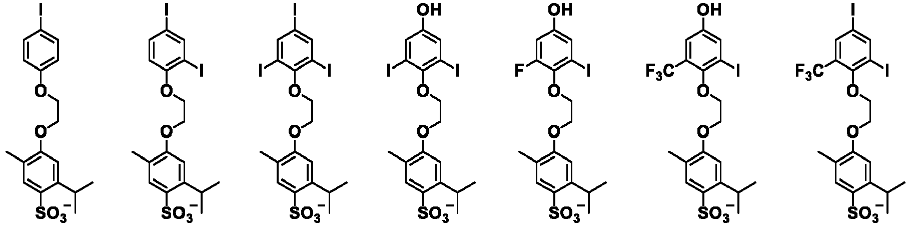

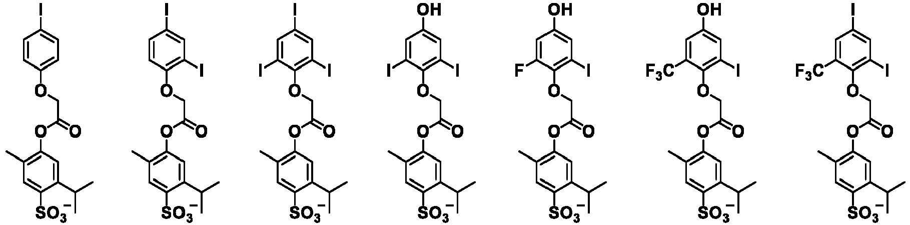

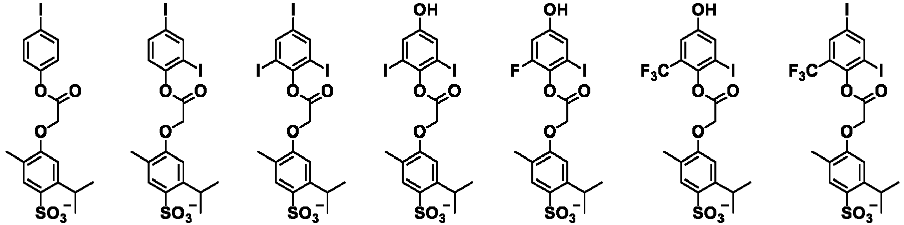

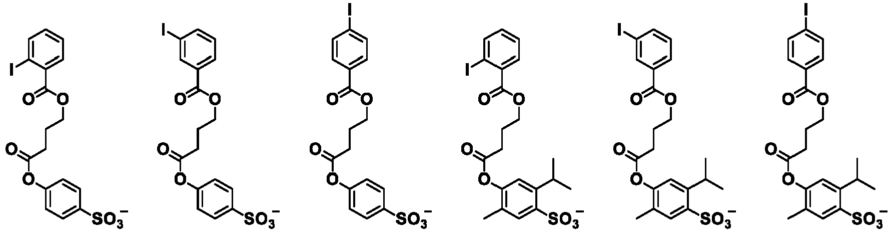

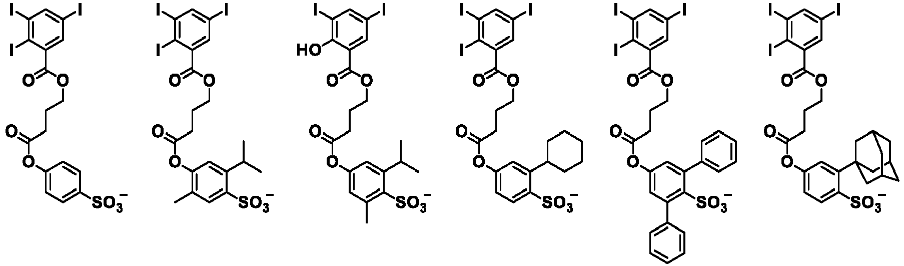

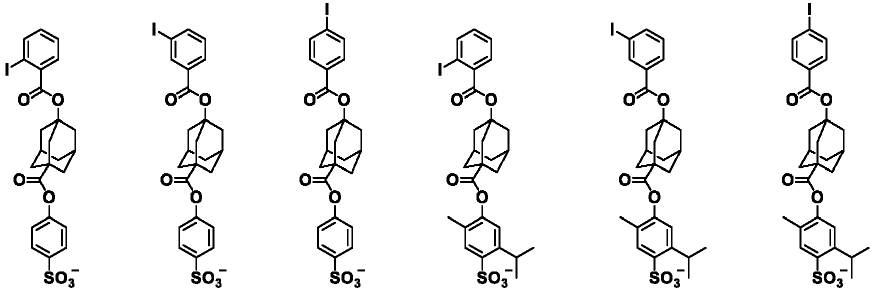

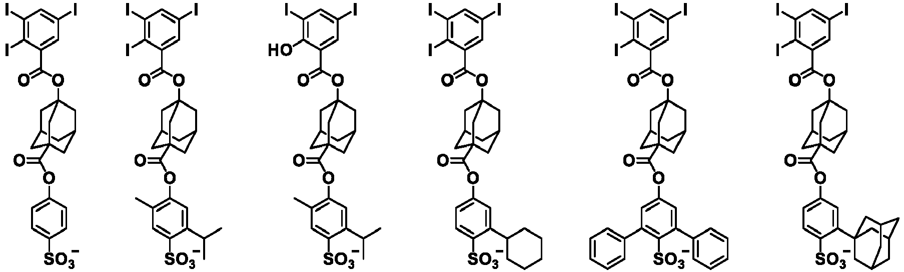

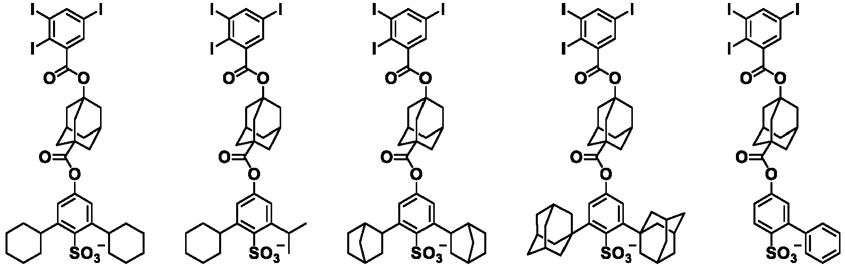

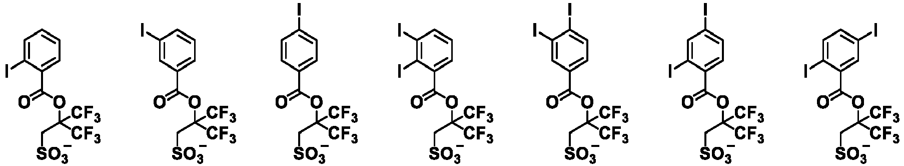

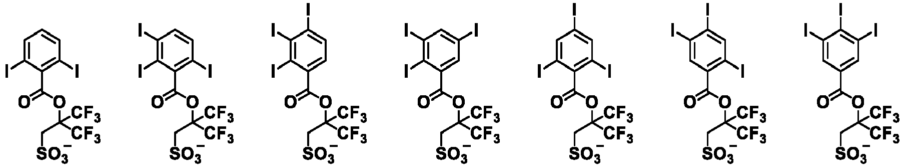

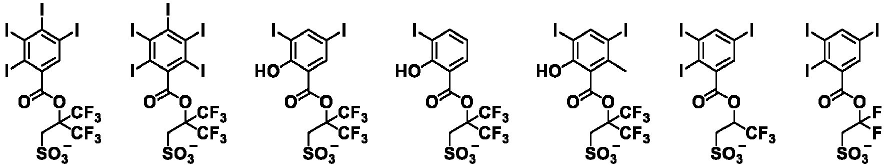

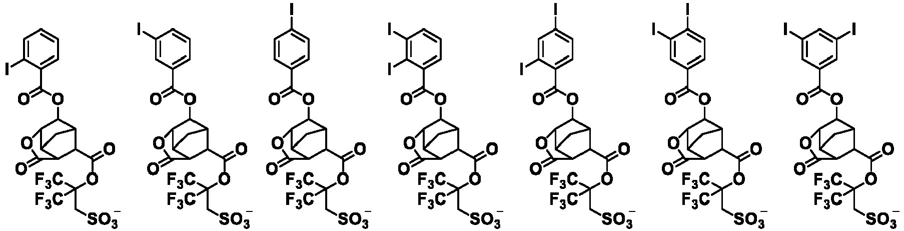

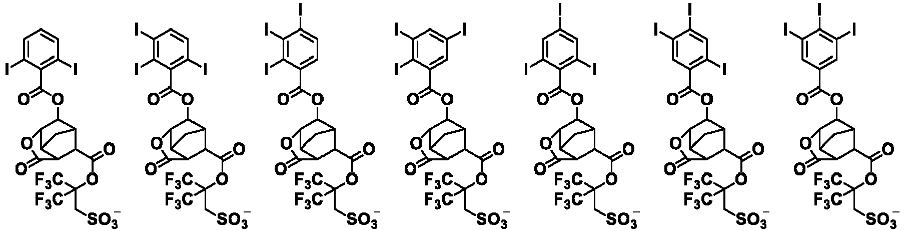

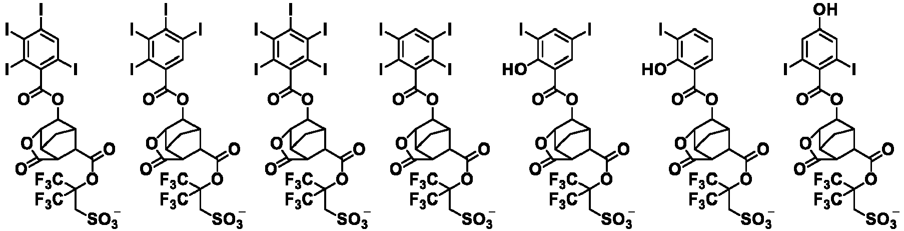

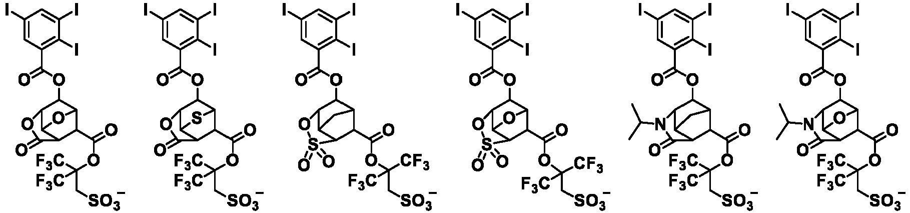

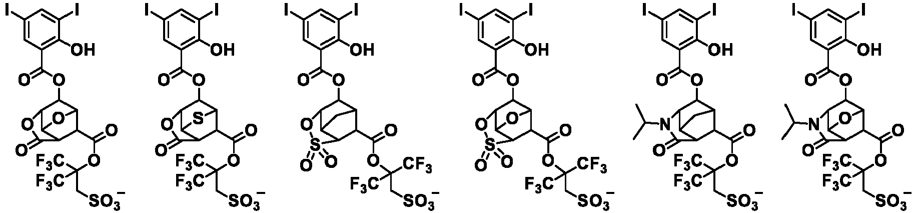

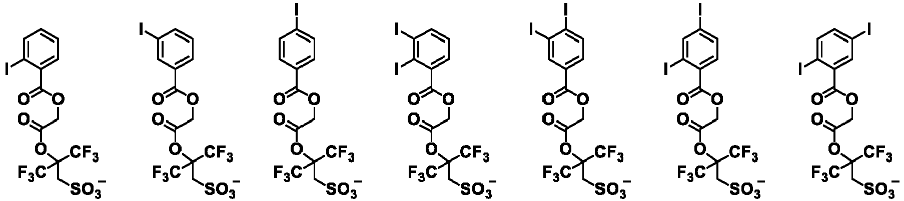

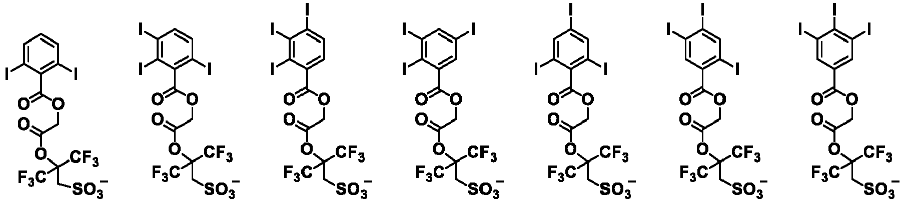

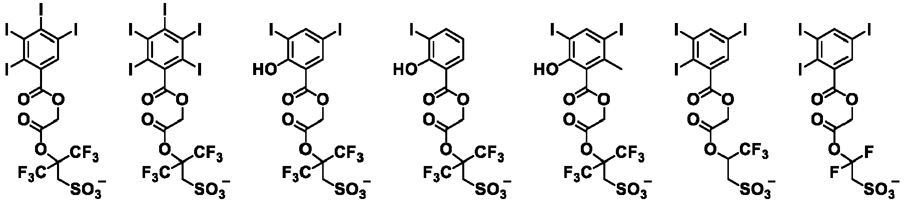

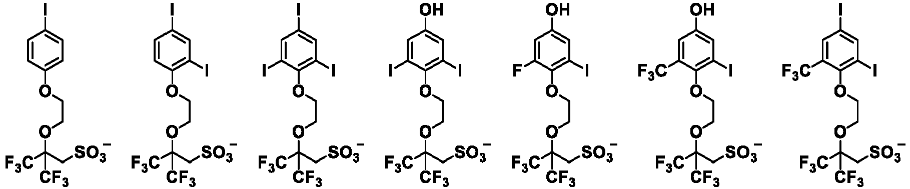

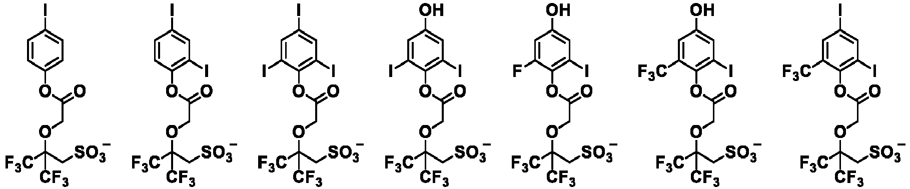

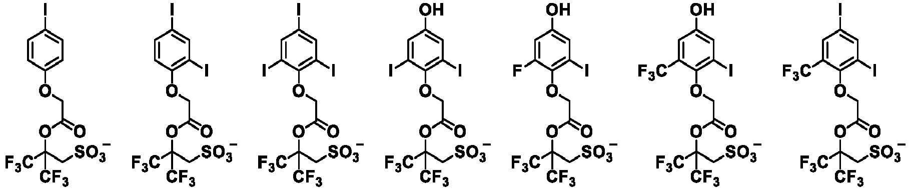

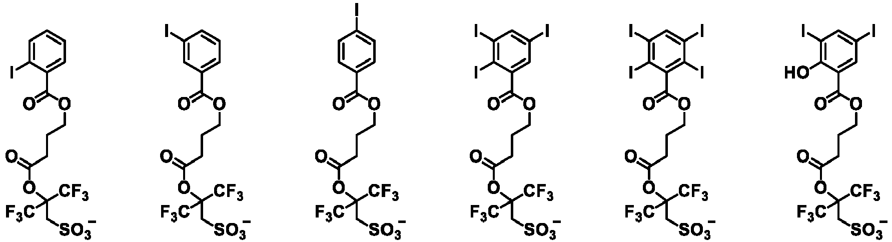

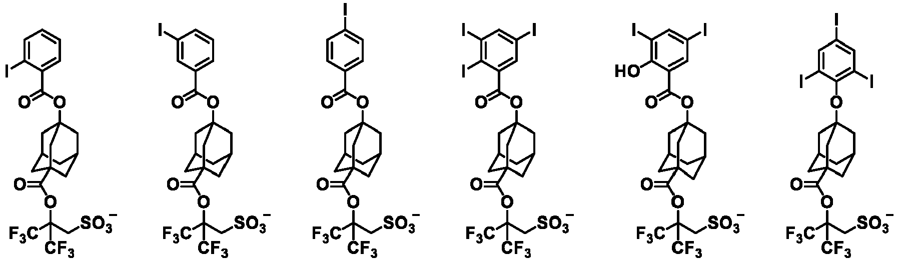

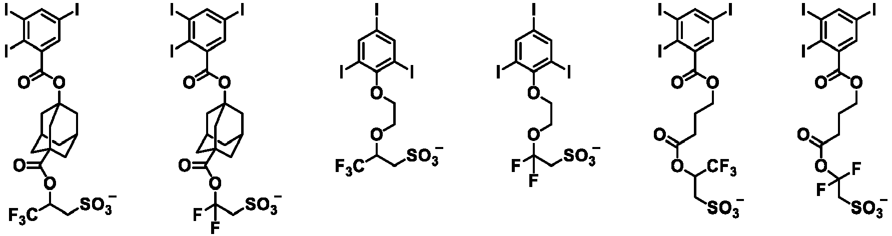

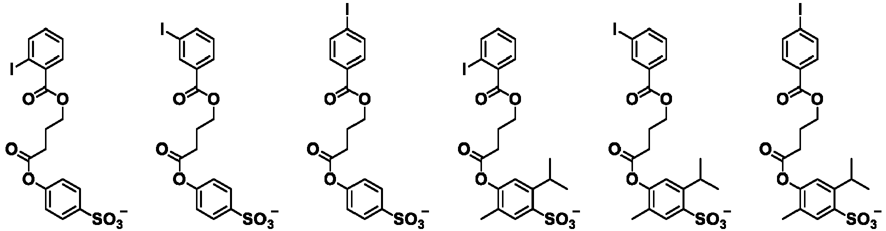

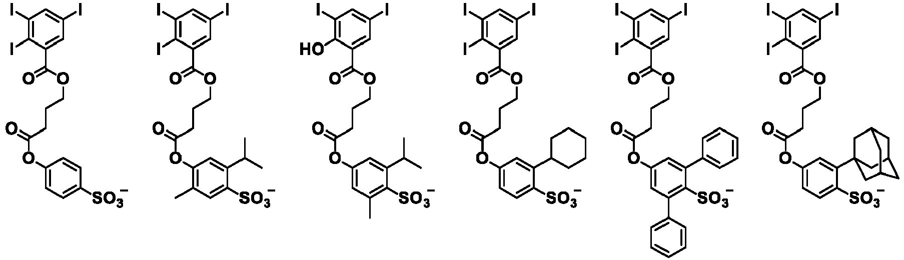

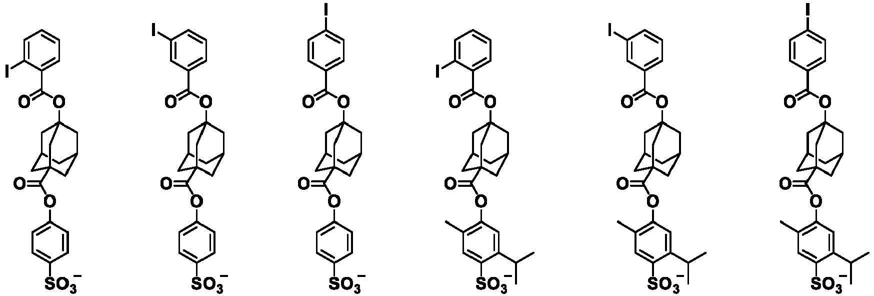

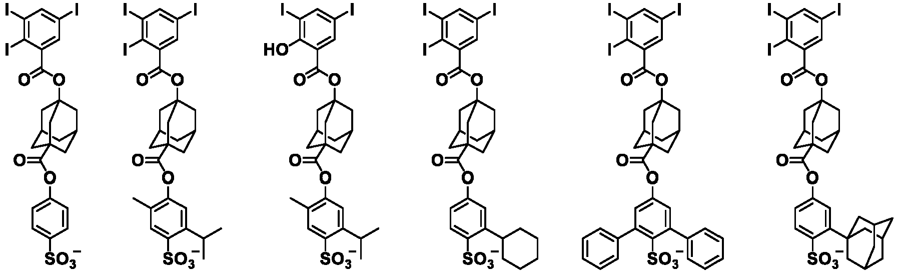

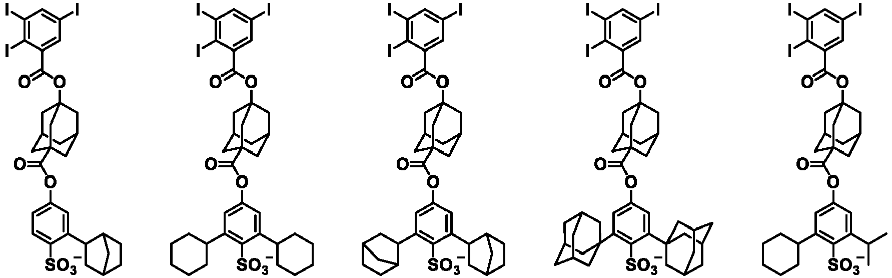

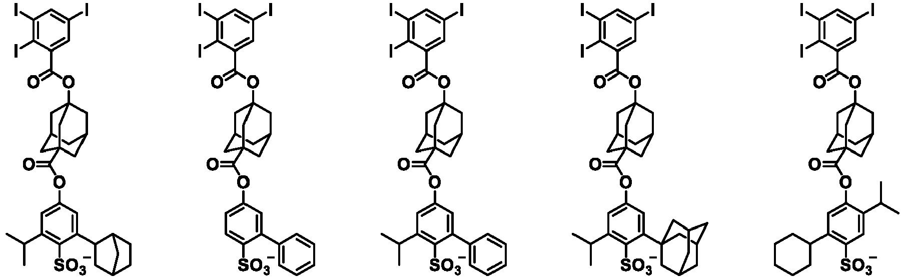

Preferred examples of the cation that pairs with the anion include sulfonium and iodonium cations. Examples of the sulfonium cation are as exemplified above for the sulfonium cation having formula (cation-1), but not limited thereto. Examples of the iodonium cation are as exemplified above for the iodonium cation having formula (cation-2), but not limited thereto.

The other PAG generates an acid having a pKa value of preferably -2.0 or larger, more preferably -1.0 or larger. The upper limit of pKa is preferably 2.0. Notably, the pKa value is computed using pKa DB in software ACD/Chemsketch ver: 9.04 of Advanced Chemistry Development Inc.

When the resist composition contains the other PAG (F), the amount of the PAG (F) used is preferably 1 to 10 parts, more preferably 1 to 5 parts by weight per 80 parts by weight of the base polymer (B). The other PAG may be used alone or in admixture. The inclusion of the other PAG provides for appropriate adjustment of the amount of acid generated in the exposed region and the degree of dissolution inhibition in the unexposed region.

### (G) Surfactant

The resist composition may contain any conventional surfactants for facilitating to coat the composition to the substrate. A number of surfactants are known in the art as described in WO 2006/121096, JP-A 2008-102383, JP-A 2008-304590, JP-A 2004-115630, and JP-A 2005-008766, and any suitable one may be chosen therefrom.

When the resist composition contains the surfactant (G), the amount of the surfactant (G) added is preferably up to 2 parts by weight, more preferably up to 1 part by weight and preferably at least 0.01 part by weight per 80 parts by weight of the base polymer (B).

### Process

A further embodiment of the invention is a resist pattern forming process comprising the steps of applying the chemically amplified positive resist composition defined above onto a substrate to form a resist film thereon, exposing the resist film to a pattern of high-energy radiation, and developing the exposed resist film in an alkaline developer.

The substrate used herein may be selected from, for example, substrates for IC fabrication, e.g., Si, SiO, SiO₂, SiN, SiON, TiN, WSi, BPSG, SOG, and organic antireflective coating, and substrates for mask circuit fabrication, e.g., Cr, CrO, CrON, MoSi₂, Si, SiO, SiO₂, SiON, SiONC, CoTa, NiTa, TaBN, and SnO₂.

The resist composition is first applied onto a substrate by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation. Examples of the high-energy radiation include UV, deep UV, excimer laser radiation (typically, KrF and ArF), EUV, X-ray, γ-ray, synchrotron radiation, and EB.

On use of UV, deep UV, excimer laser radiation, EUV, X-ray, γ-ray, and synchrotron radiation, the resist film is exposed through a mask having the desired pattern, preferably in a dose of 1 to 500 mJ/cm², more preferably 10 to 400 mJ/cm². On use of EB, a pattern may be directly written preferably in a dose of 1 to 500 µC/cm², more preferably 10 to 400 µC/cm².

The exposure may be performed by conventional lithography whereas the immersion lithography of holding a liquid, typically water between the resist film and the mask may be employed if desired. In the case of immersion lithography, a protective film which is insoluble in water may be formed on the resist film.

After the exposure, the resist film may be baked (PEB), for example, on a hotplate preferably at 60 to 150°C for 1 to 20 minutes, and more preferably at 80 to 140°C for 1 to 10 minutes.

Finally, development is carried out using as the developer an aqueous alkaline solution, such as a 0.1 to 5 wt%, preferably 2 to 3 wt%, aqueous solution of tetramethylammonium hydroxide (TMAH), this being done by a conventional method such as dip, puddle, or spray development for a period of 0.1 to 3 minutes, and preferably 0.5 to 2 minutes. In this way, the desired pattern is formed on the substrate.

From the positive resist composition, a pattern with a satisfactory resolution and reduced LER can be formed. The resist composition is effectively applicable to a substrate having a surface layer of material to which a resist film is less adherent and which is likely to invite pattern stripping or pattern collapse, and specifically a substrate having sputter deposited on its outermost surface metallic chromium or a chromium compound containing at least one light element selected from oxygen, nitrogen and carbon or a substrate having an outermost surface layer of SiO, SiOₓ, or a tantalum compound, molybdenum compound, cobalt compound, nickel compound, tungsten compound or tin compound. The substrate to which the positive resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns having a high resolution, suppressed influences of develop loading and residue defects, and a small size difference independent of pattern density (grouped and isolated patterns), even on a substrate (typically mask blank of transmission or reflection type) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards. Analysis is made by IR spectroscopy, NMR spectroscopy, and time-of-flight mass spectrometry (TOF-MS) using analytic instruments as shown below.
IR: NICOLET 6700 by Thermo Fisher Scientific Inc.
¹H-NMR: ECA-500 by JEOL Ltd.
MALDI TOF-MS: S3000 by JEOL Ltd.

### [1] Synthesis of photoacid generators

### Example 1-1

### Synthesis of PAG-1

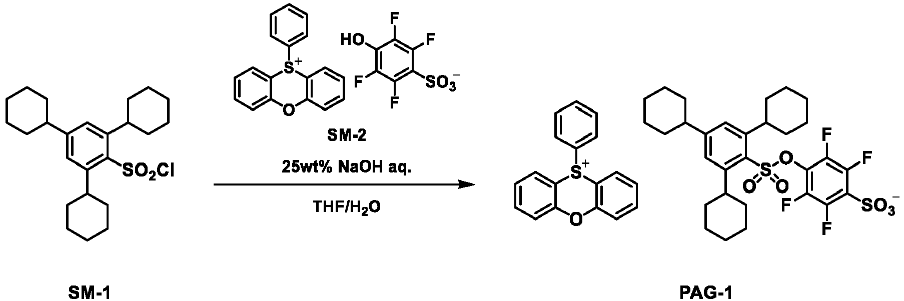

In nitrogen atmosphere, 8.5 g of SM-2 was suspended in a mixture of 40 g of THF and 40 g of water. 3.3 g of 25 wt% aqueous solution of sodium hydroxide was added dropwise to the suspension, which was stirred at room temperature for 2 hours until SM-2 was dissolved. Then, 8.5 g of SM-1 in powder form was added to the solution, which was aged at room temperature for 10 hours. After aging, the reaction solution was cooled down and 80 g of water was added thereto to quench the reaction. The target compound was extracted with 160 g of methylene chloride. This was followed by ordinary aqueous workup, solvent distillation, and recrystallization from diisopropyl ether, obtaining 16.9 g of PAG-1 (yield 86%).

PAG-1 was analyzed by spectroscopy. FIG. 1 shows the NMR spectrum (¹H-NMR/DMSO-d₆) of PAG-1.
IR (D-ATR): v = 3070, 2973, 2927, 2853, 1634, 1598, 1561, 1483, 1468, 1446, 1390, 1378, 1365, 1356, 1327, 1272, 1260, 1237, 1225, 1189, 1166, 1129, 1111, 1073, 1050, 1008, 999, 981, 889, 864, 842, 815, 777, 768, 758, 748, 736, 682, 630, 580, 562, 534, 501, 485 cm⁻¹
MALDI TOF-MS:
   positive M⁺ 277 (corresponding to C₁₈H₁₃OS⁺)
   negative M⁻ 631 (corresponding to C₃₀H₃₅F₄O₆S₂⁻)

### Examples 1-2 to 1-7

### Synthesis of PAG-2 to PAG-7

Photoacid generators PAG-2 to PAG-7, shown below, were synthesized through well-known organic synthesis reaction using the corresponding reactants.

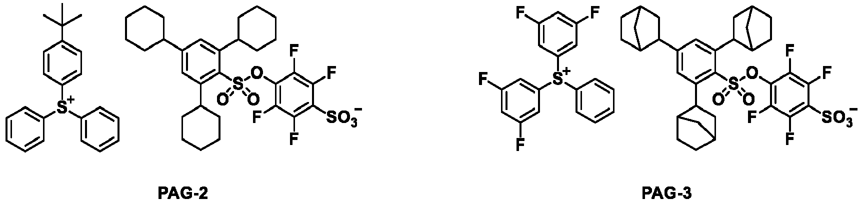

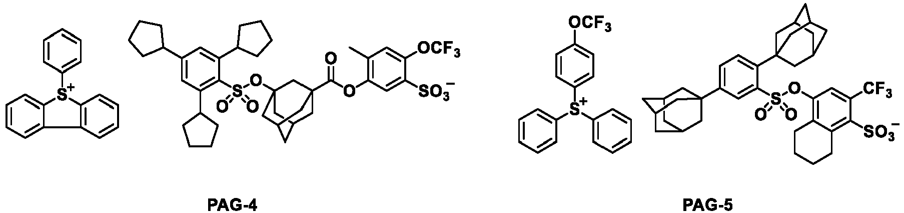

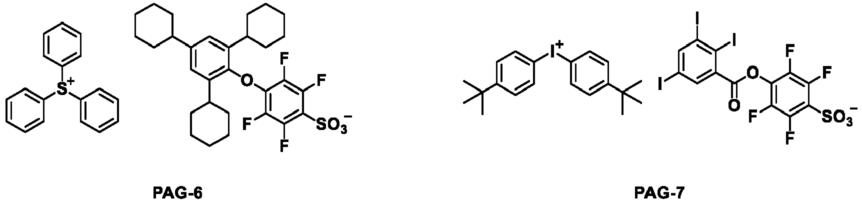

### [2] Synthesis of monomers

### Synthesis Example 2-1

### Synthesis of Monomer a1-1

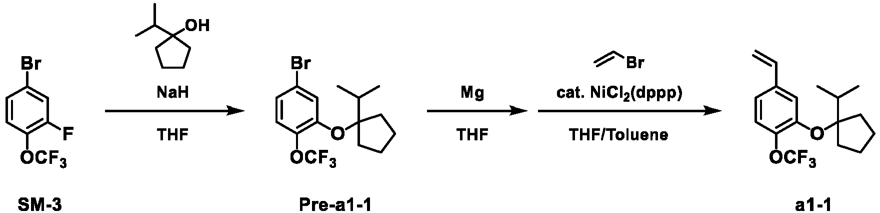

### (1) Synthesis of Intermediate Pre-a1-1

In nitrogen atmosphere, 144.0 g of sodium hydride (purity 55 wt%) was suspended in 800 mL of THF. A solution of 465.4 g of 1-isopropylcyclopentanol in 380 mL of THF was added dropwise to the suspension. The solution was heated under reflux for 4 hours to form a metal alkoxide. Thereafter, 854.7 g of reactant M-1 was added dropwise to the solution, which was heated under reflux and aged for 18 hours. The reaction solution was cooled in an ice bath and poured into 1,200 mL of water to quench the reaction. A mixture of 1,000 mL of toluene and 1,000 mL of hexane was added to the reaction solution for extracting the desired compound. This was followed by standard aqueous workup, solvent distillation, and purification by distillation, obtaining Intermediate Pre-a1-1 as colorless oily matter (amount 816.2 g, yield 67%).

### (2) Synthesis of Monomer a1-1

In nitrogen atmosphere, a Grignard reagent was prepared from 56.7 g of magnesium, 900 g of THF, and 816.2 g of Intermediate Pre-a1-1. The Grignard reagent was diluted with 450 g of toluene. The reaction system was cooled below 10°C. Thereafter, 6.0 g of [1,3-bis(diphenylphosphino)propane]nickel(II) dichloride was added to the reaction system, which was stirred for 30 minutes at a temperature below 10°C. After stirring, a solution of 260.3 g of vinyl bromide in 450 g of THF and 450 g of toluene was added dropwise to the reaction system which was maintained at a temperature below 20°C. At the end of addition, the reaction system was aged for 1 hour at a temperature below 20°C. After aging, the reaction system was cooled. An aqueous solution of 233 g of ammonium chloride in 233 g of 20 wt% hydrochloric acid and 1,165 g of water was added dropwise to the reaction system to quench the reaction. The target compound was extracted with 2,000 g of hexane. This was followed by standard aqueous workup, solvent distillation, and purification by distillation, obtaining Monomer a1-1 as colorless oily matter (amount 519.5 g, yield 74%).
Monomer a1-1 was analyzed by IR and ¹H-NMR spectroscopy.
IR (D-ATR): v = 2966, 2877, 1597, 1584, 1504, 1470, 1454, 1417, 1391, 1369, 1352, 1253, 1225, 1201, 1167, 1122, 1033, 984, 911, 868, 831, 800, 752, 699, 627 cm⁻¹
¹H-NMR (600 MHz in DMSO-d₆):
   δ = 7.27 (1H, d), 7.18 (1H, d), 7.13 (1H, d), 6.74 (1H, dd), 5.80 (1H, d), 5.29 (1H, d), 2.47 (2H, m), 1.87 (4H, m), 1.54 (4H, m), 0.90 (6H, d) ppm

### Synthesis Examples 2-2 to 2-7

### Synthesis of Monomers a 1-2 to a1-7

Monomers a1-2 to a1-7 shown below were synthesized by various organic synthesis reactions using the corresponding reactants.

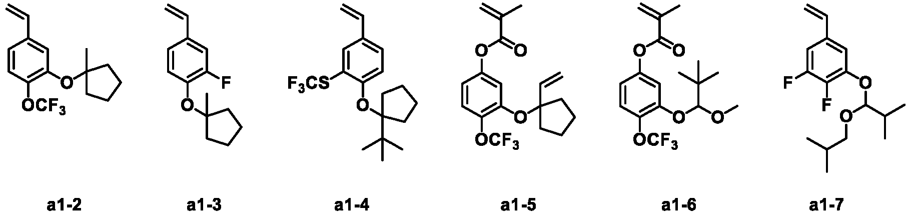

### [3] Synthesis of base polymers

The structure of repeat units incorporated in polymers is shown below.

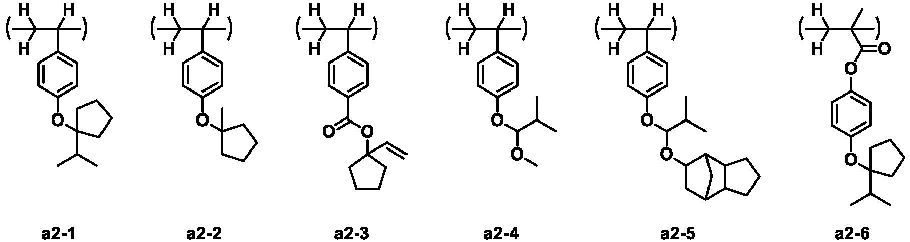

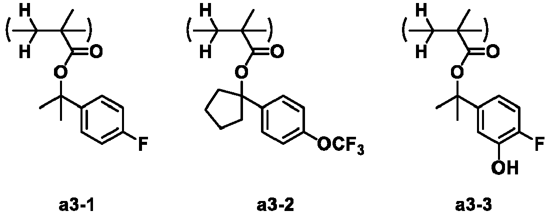

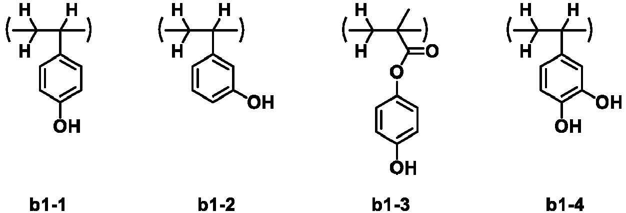

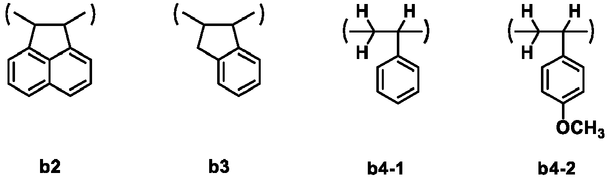

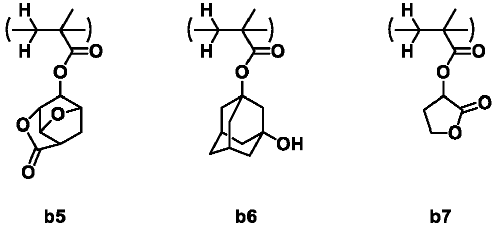

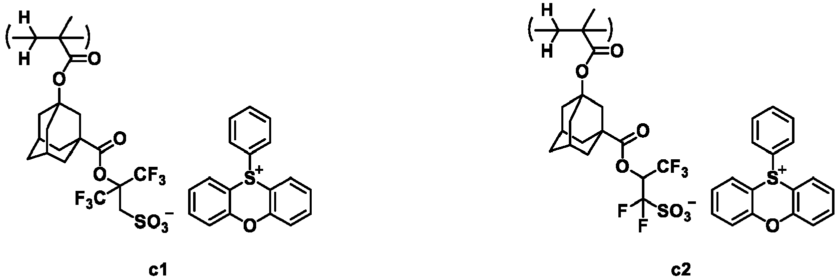

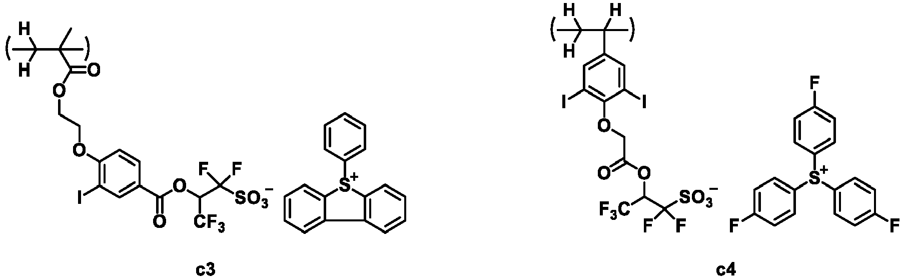

### Synthesis Example 3-1

### Synthesis of Polymer P-1

A 300-mL dropping cylinder under nitrogen blanket was charged with 52.9 g of 4-acetoxystyrene, 39.4 g of Monomer a1-1, 7.6 g of acenaphthylene, 7.4 g of dimethyl 2,2'-azobis(2-methylpropionate) (trade name V601, FUJIFILM Wako Pure Chemical Corp.), and 139 g of methyl ethyl ketone (MEK) solvent to form a solution. A 500-mL flask under nitrogen blanket was charged with 62 g of MEK, which was heated at 80°C. While the temperature was maintained, the solution was added dropwise to the flask over 4 hours. At the end of dropwise addition, the solution was continuously stirred for 18 hours while the temperature of 80°C was maintained during polymerization. The polymerization solution was cooled to room temperature and added dropwise to 1,000 g of hexane, whereupon a copolymer precipitated. The copolymer precipitate was filtered and washed twice with 500 g of hexane. In a 1-L flask under nitrogen atmosphere, the copolymer was dissolved in a mixture of 150 g of THF and 50 g of methanol. 22.3 g of ethanolamine was added to the solution, which was stirred at 60°C for 3 hours. The reaction solution was concentrated under reduced pressure. The concentrate was dissolved in a mixture of 240 g of ethyl acetate and 60 g of water. The solution was transferred to a separatory funnel, to which 11.1 g of acetic acid was added, followed by separatory operation. After the lower layer was removed, 60 g of water and 14.8 g of pyridine were added to the organic layer, followed by separatory operation again. After the lower layer was removed, 60 g of water was added to the organic layer, followed by water washing and separatory operation. The water washing and separatory operation was repeated 5 times in total. The organic layer after separation was concentrated and dissolved in 130 g of acetone. The acetone solution was added dropwise to 1,200 g of water whereupon crystals precipitated. The precipitate was filtered, washed with water, and suction dried for 2 hours. The filter cake was dissolved in 130 g of acetone. The acetone solution was added dropwise to 1,200 g of water. The precipitate was filtered, washed with water, and dried, obtaining 56.3 g of the target polymer P-1 as white solid.

Polymer P-1 was analyzed by ¹³C-NMR and ¹H-NMR spectroscopy to determine a compositional ratio of repeat units and by GPC to determine Mw and Mw/Mn, with the results shown below.

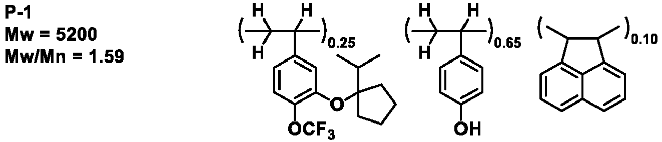

### Synthesis Examples 3-2 to 3-30 and Comparative Synthesis Examples 1-1 to 1-15

### Synthesis of Polymers P-2 to P-30 and Comparative Polymers CP-1 to CP-15

Polymers P-2 to P-30 and Comparative Polymers CP-1 to CP-15 shown in Tables 1 to 3 were synthesized with reference to Synthesis Example 3-1 or a well-known method while the type and amount of monomers were changed.

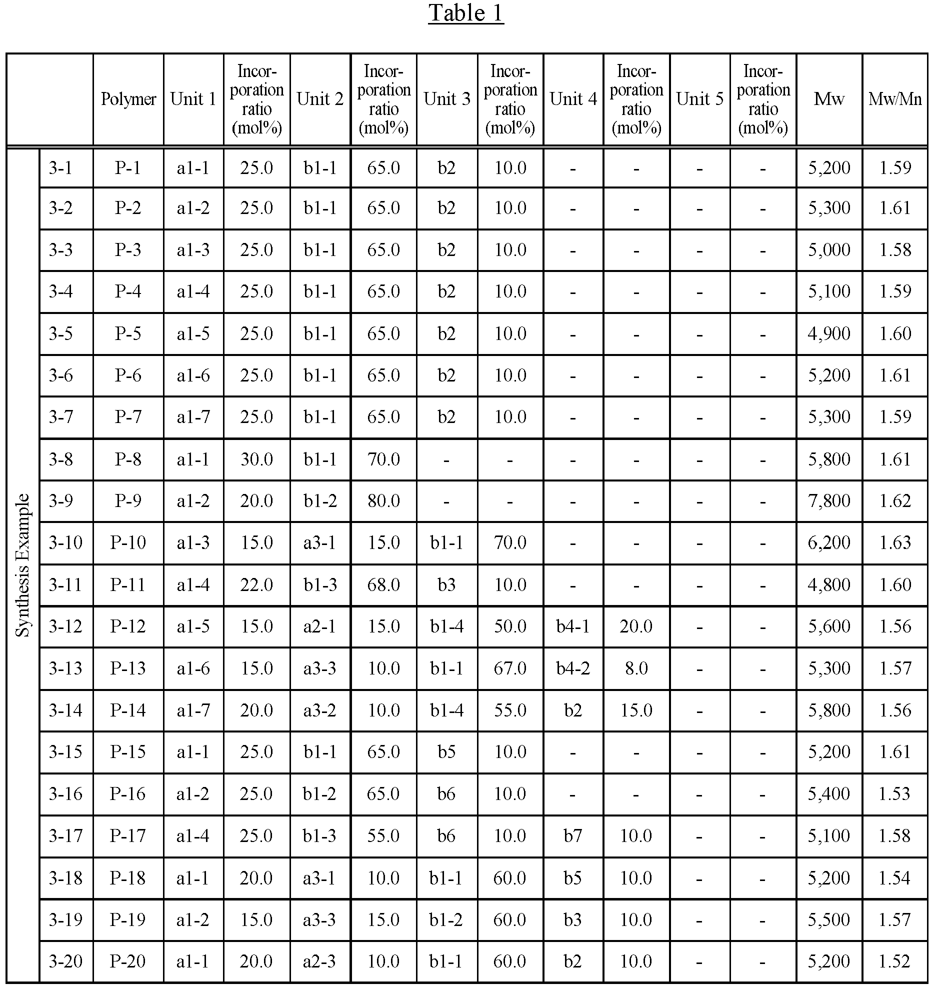

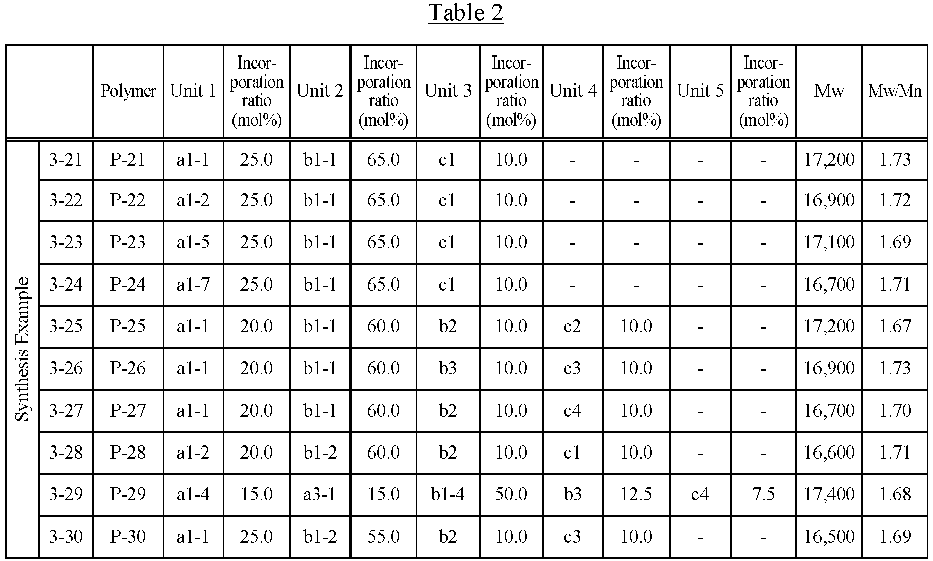

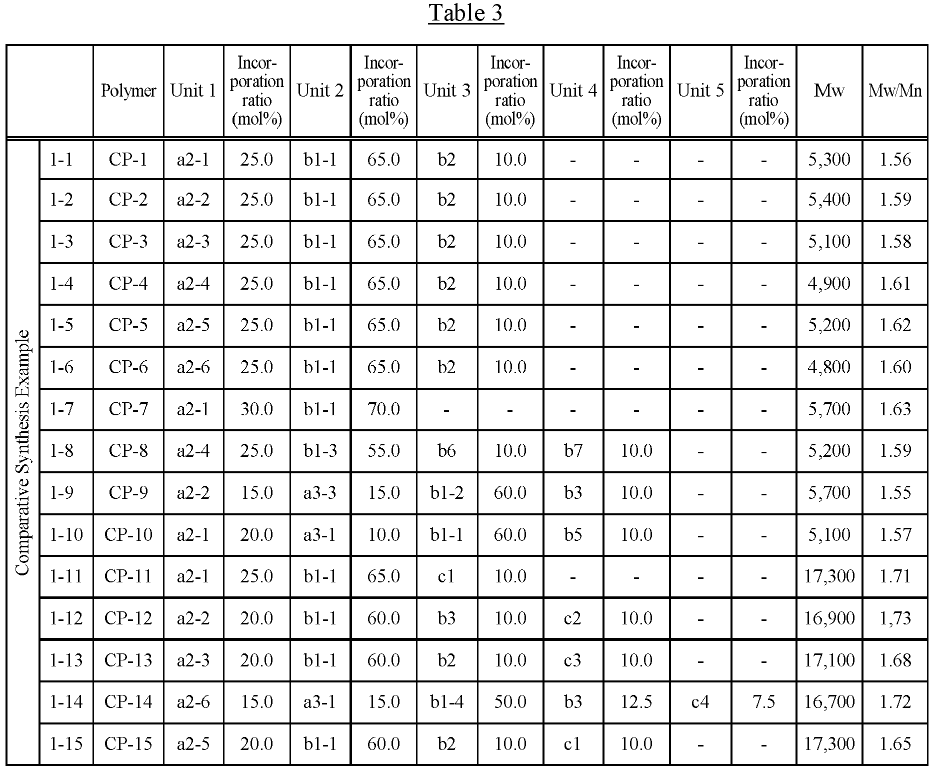

### [4] Preparation of chemically amplified positive resist compositions

### Examples 1-1 to 1-50 and Comparative Examples 1-1 to 1-32

A chemically amplified positive resist composition (R-1 to R-50, CR-1 to CR-32) in solution form was prepared by dissolving selected components in an organic solvent in accordance with the recipe shown in Tables 4 to 7, and filtering the solution through a nylon filter with a pore size of 5 nm or UPE filter with a pore size of 1 nm. The organic solvent was a mixture of 940 pbw of PGMEA, 1,870 pbw of EL, and 1,870 pbw of PGME.

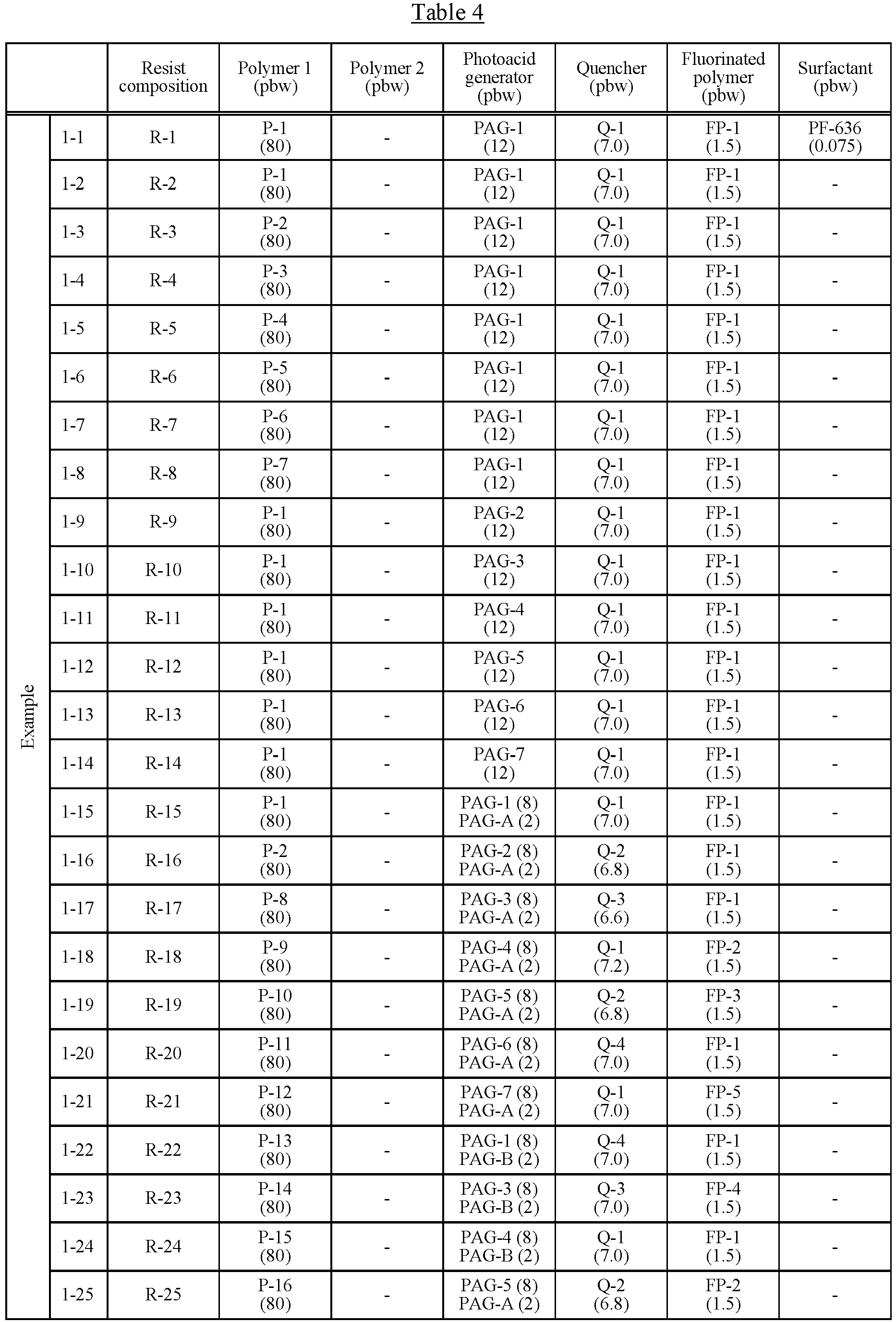

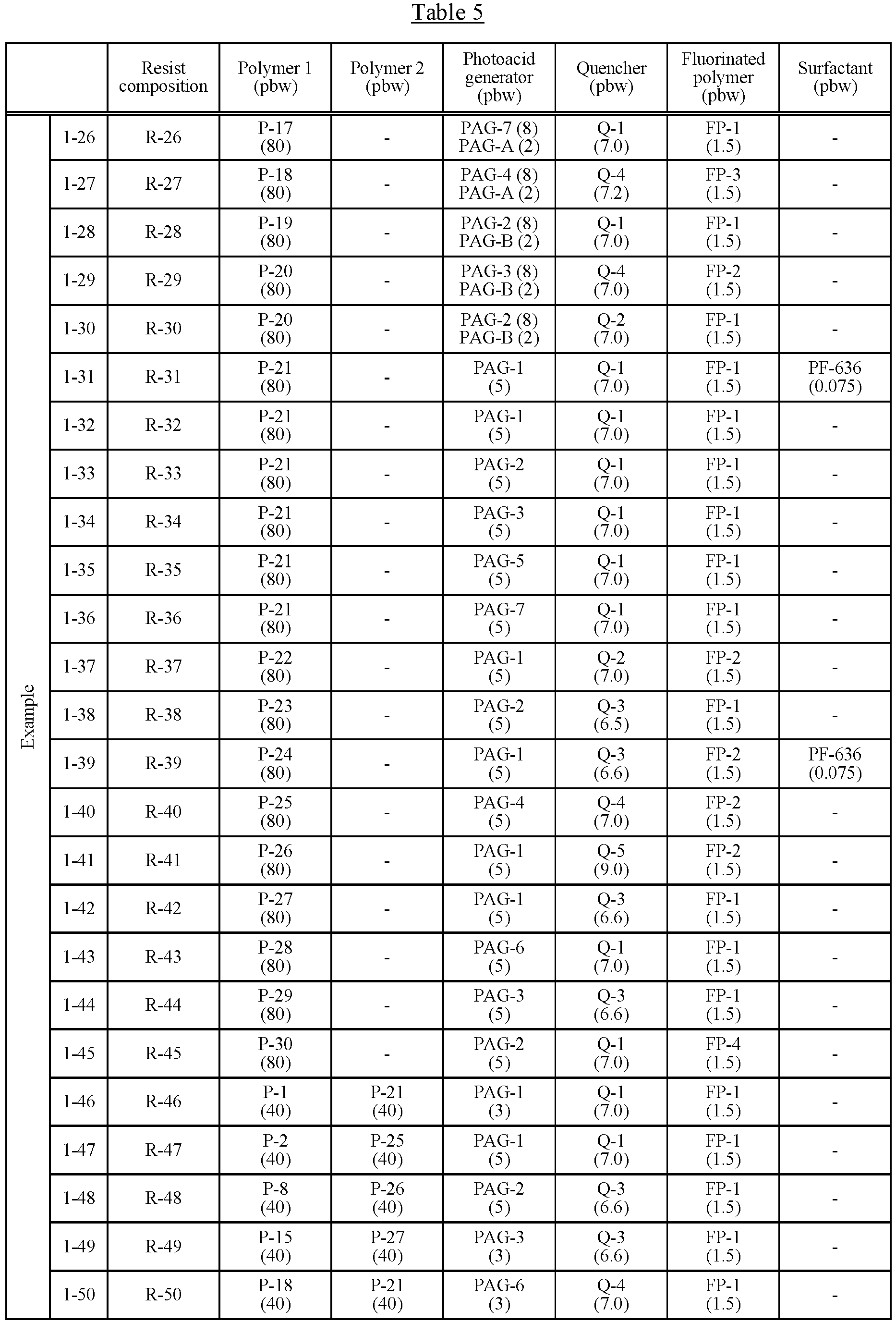

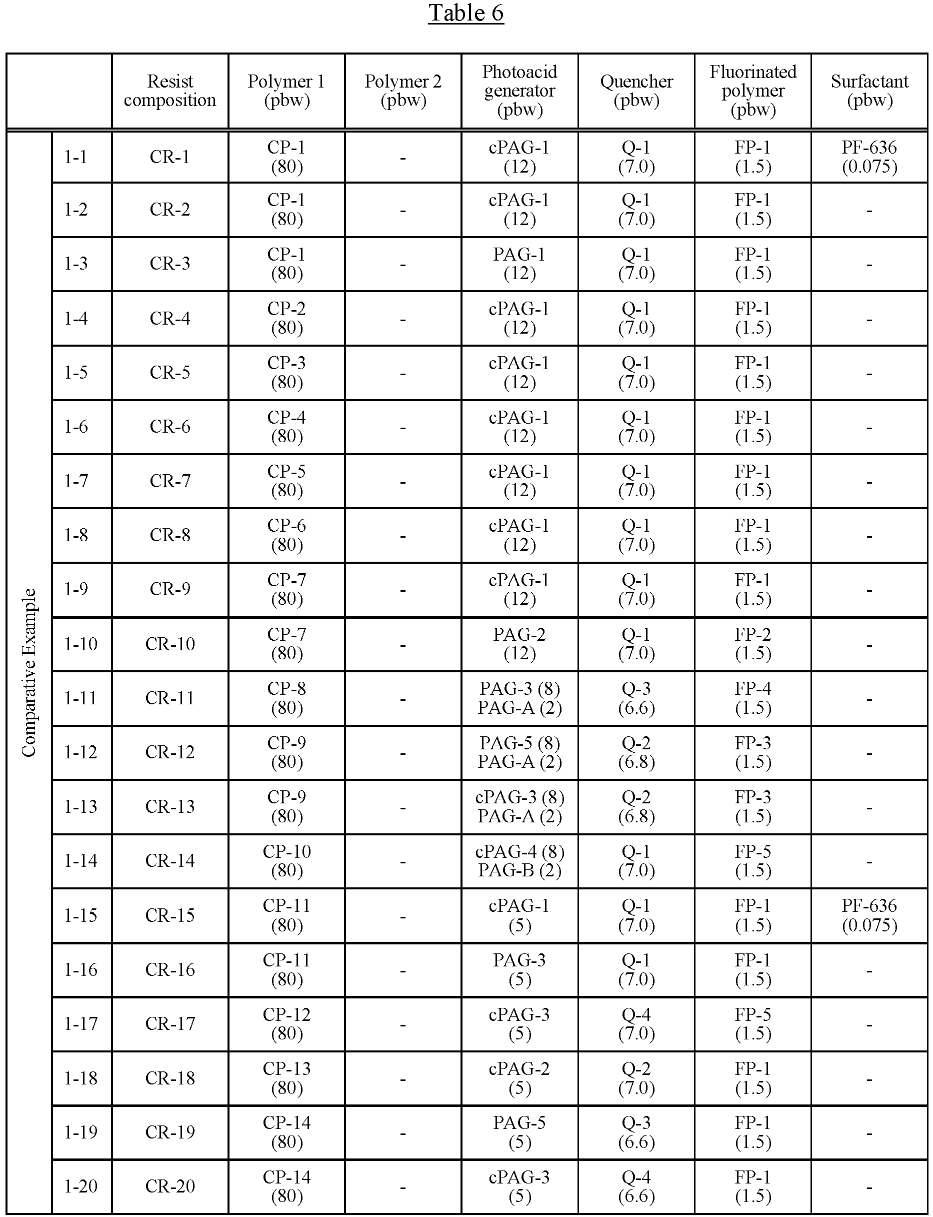

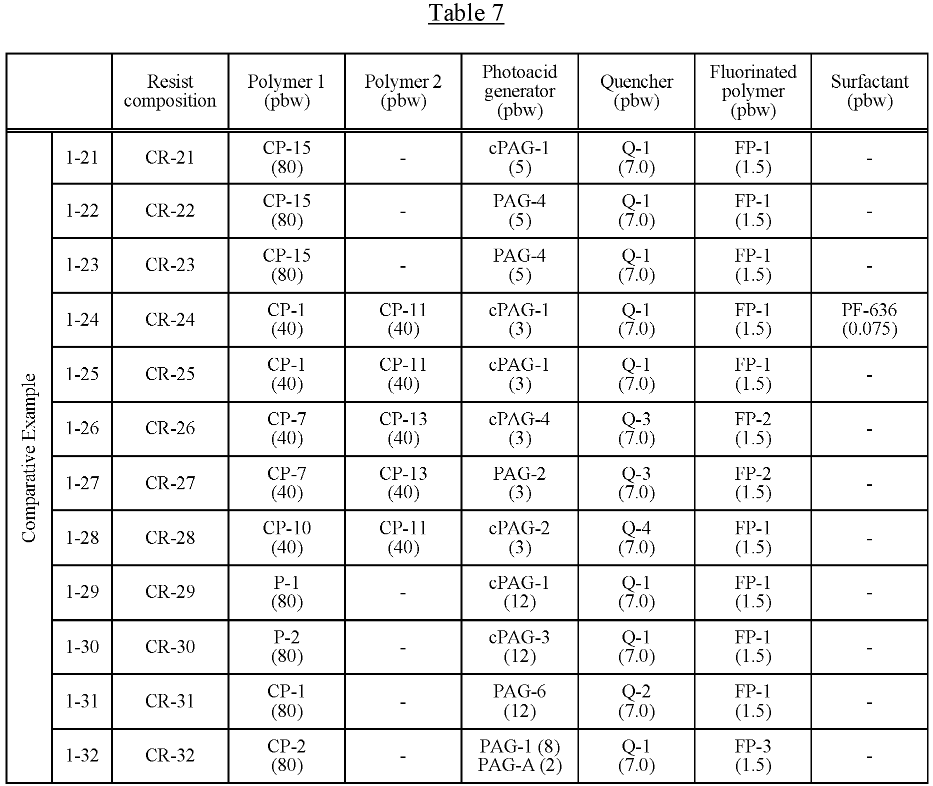

The comparative photoacid generators cPAG-1 to cPAG-4, photoacid generators PAG-A and PAG-B, quenchers Q-1 to Q-4, and fluorinated polymers FP-1 to FP-5 in the resist compositions are identified below.

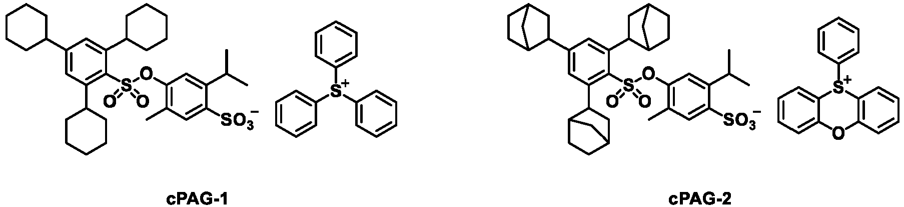

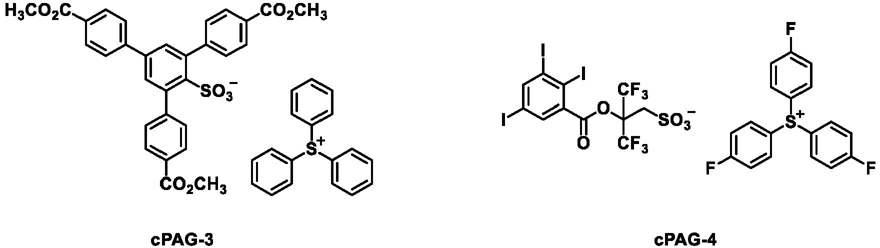

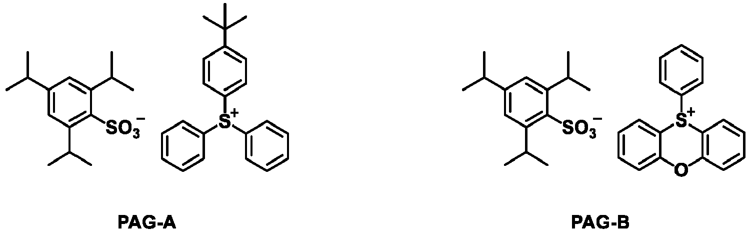

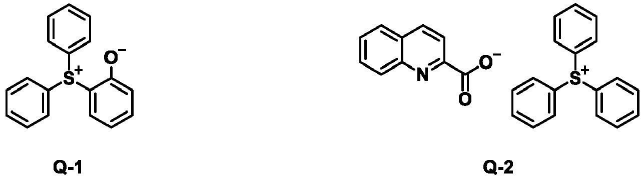

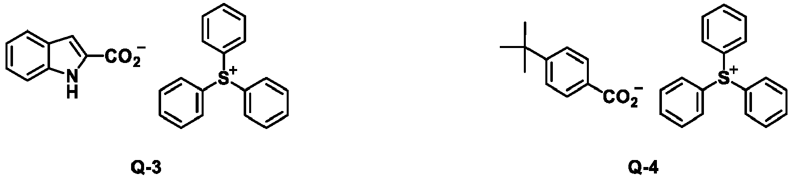

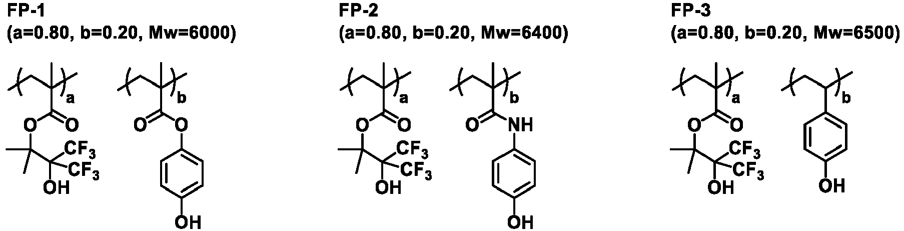

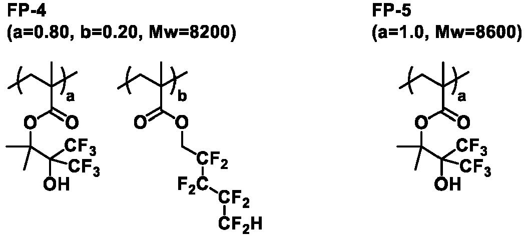

### [5] EB lithography test

### Examples 2-1 to 2-50 and Comparative Examples 2-1 to 2-32

A photomask blank of reflection type for an EUV lithography mask was furnished by starting with a low-coefficient-of-thermal-expansion glass substrate of 6 inches squares and depositing thereon a multilayer reflective film of 40 Mo/Si layers with a thickness of 284 nm, a Ru film of 3.5 nm thick as protective film, a TaN film of 70 nm thick as absorbing layer, and a CrN film of 6 nm thick as hard mask. Using a coater/developer system ACT-M (Tokyo Electron Ltd.), each of the resist compositions (R-1 to R-50, CR-1 to CR-32) was spin coated onto the photomask blank, and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The resolution (or maximum IS resolution) was defined as the minimum size at the dose which provided a 9:1 resolution for an isolated space (IS) of 200 nm. The edge roughness (LER) of a 200-nm LS pattern was measured under SEM. The develop loading was evaluated by forming a 200-nm LS pattern at the dose (µC/cm²) capable of resolving a 1:1 LS pattern of 200 nm design at a ratio 1: 1 and a 200-nm LS pattern including dummy patterns having a density of 15%, 25%, 33%, 45%, 50%, 55%, 66%, 75%, 85%, and 95% arranged around the center pattern, measuring the size of spaces under SEM, and comparing the size difference among grouped and isolated patterns. Also, the pattern was visually observed to judge whether or not the profile was rectangular.

The dissolution rate of an exposed region is computed by spin coating the resist solution onto a 8-inch silicon wafer, baking at 110°C for 60 seconds to form a resist film of 90 nm thick, exposing the resist film to KrF excimer laser radiation in a dose (mJ/cm²) capable of resolving a 200-nm 1:1 LS pattern at a ratio 1: 1, baking at 110°C for 60 seconds, developing the film in a 2.38 wt% TMAH aqueous solution at 23°C, and measuring a loss of film thickness by means of a resist development rate analyzer (RDA-800 by Litho Tech Japan Corp.). The results are shown in Tables 8 to 10.

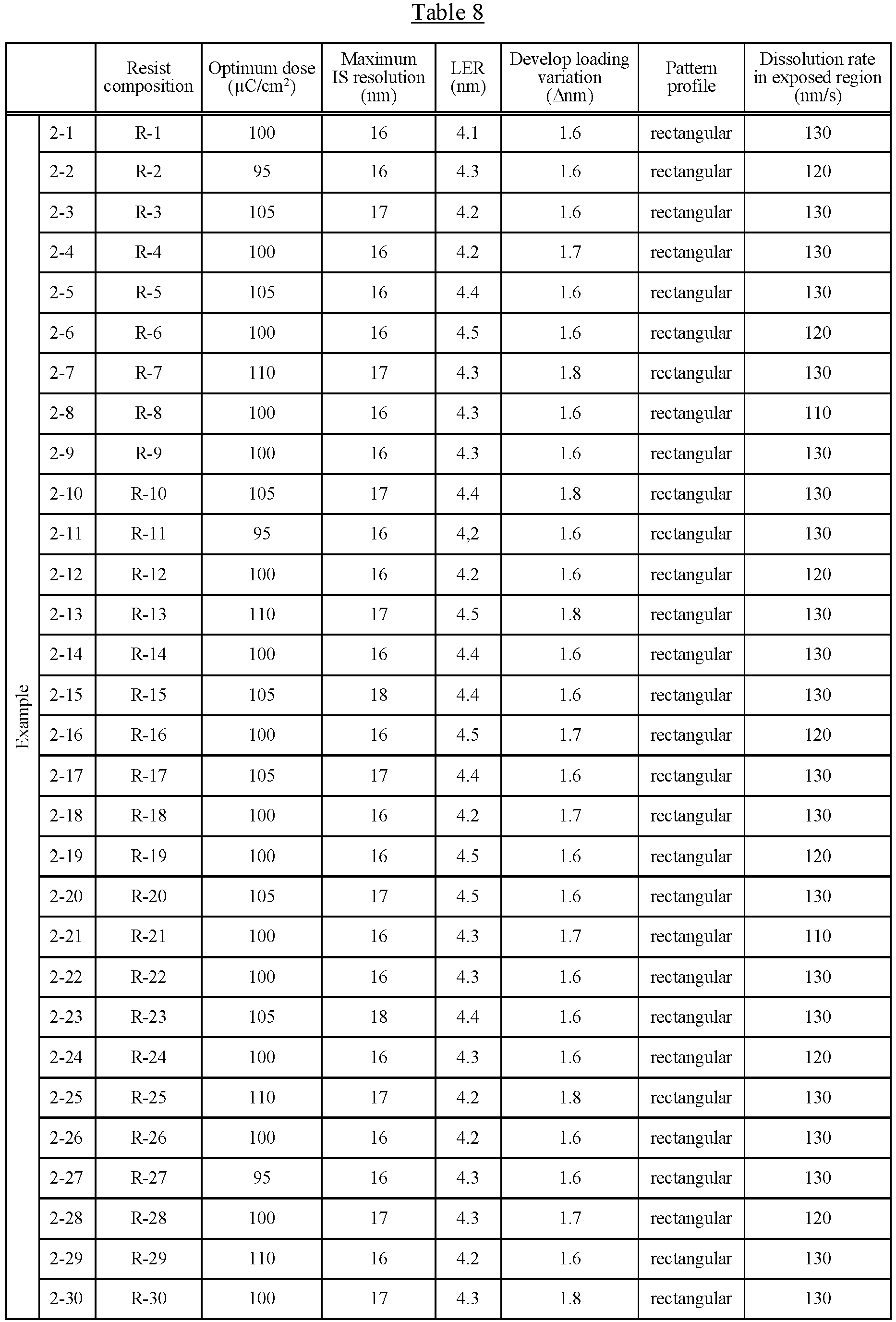

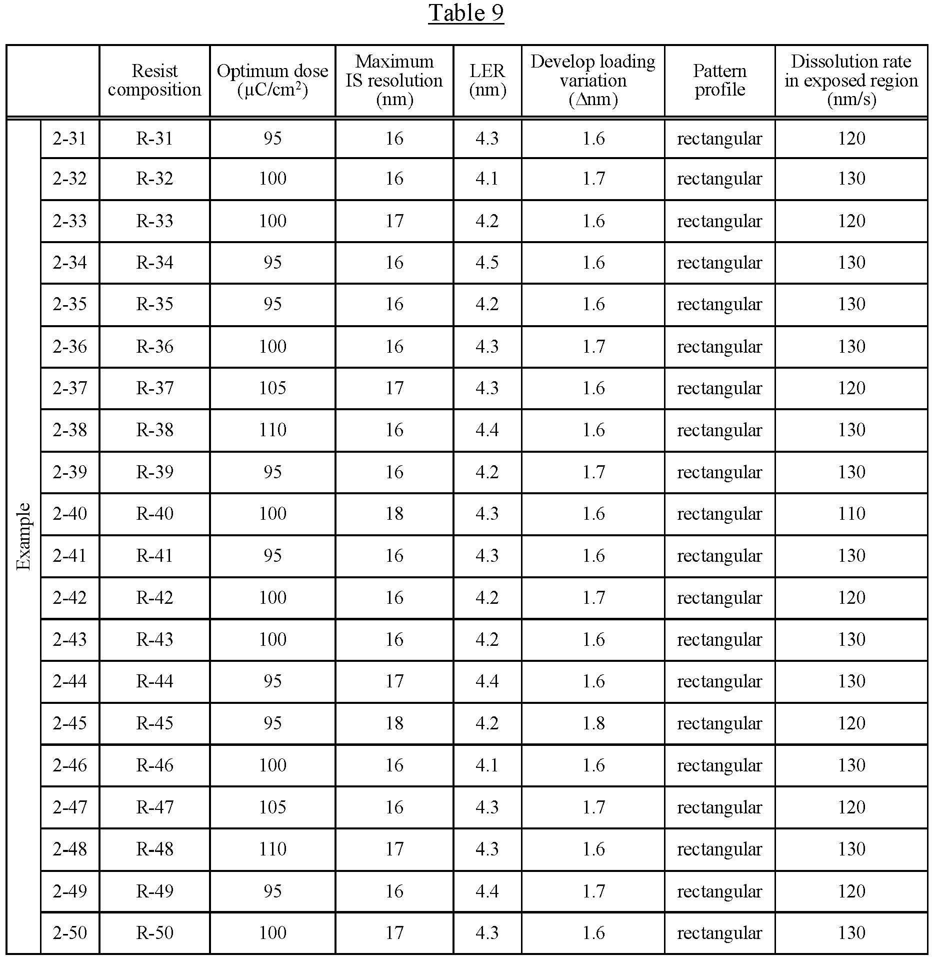

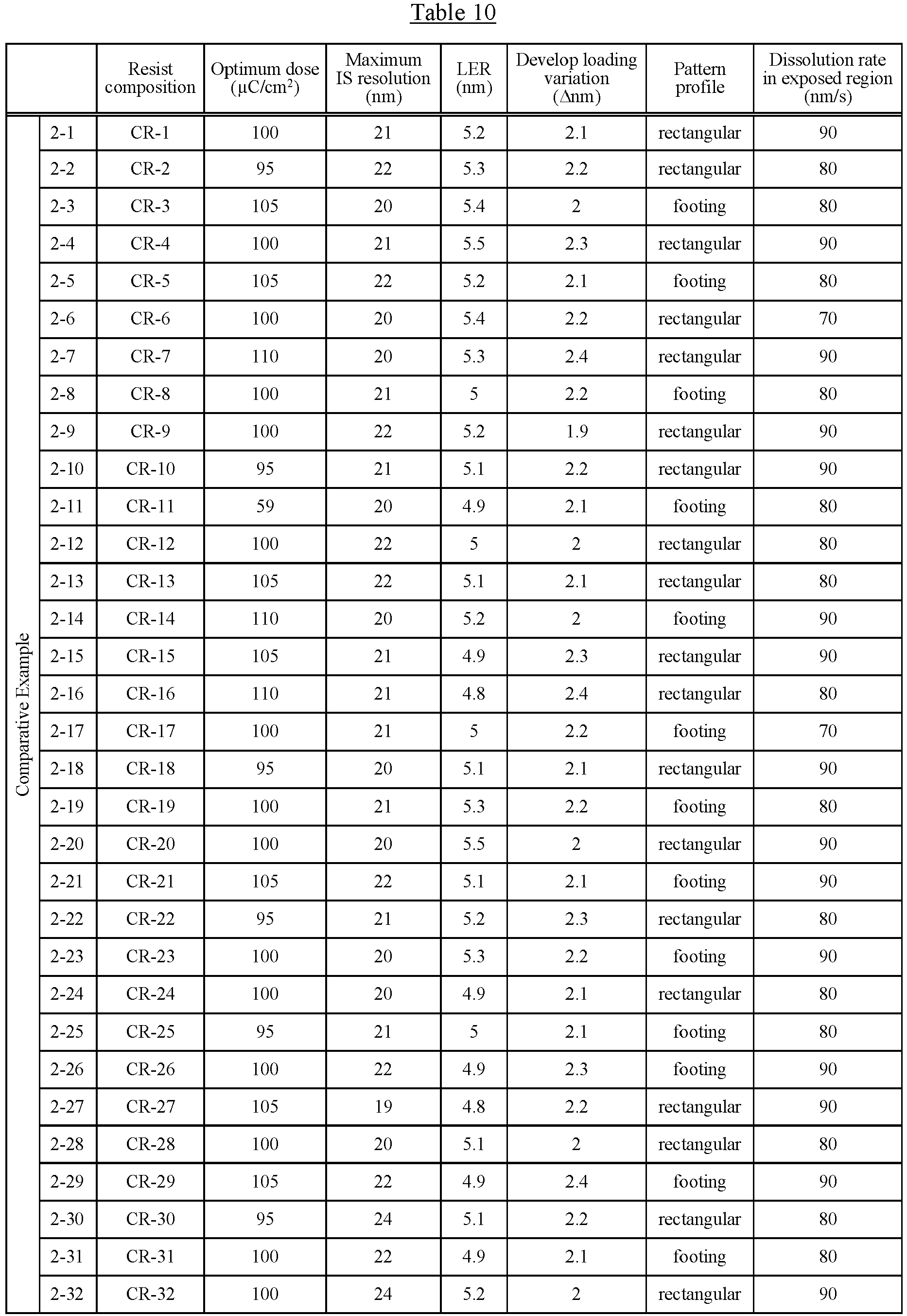

As is evident from Tables 8 to 10, the chemically amplified positive resist composition and the resist pattern forming process within the scope of the invention are effective in photolithography for the fabrication of semiconductor devices and the processing of photomask blanks of transmission and reflection types.

## Claims

1. A chemically amplified positive resist composition comprising
(A) a photoacid generator capable of generating an acid upon receipt of high-energy radiation, having the formula (A), and
(B) a base polymer containing a polymer adapted to increase its solubility in an alkaline aqueous solution under the action of acid, the polymer comprising repeat units having the formula (B1), 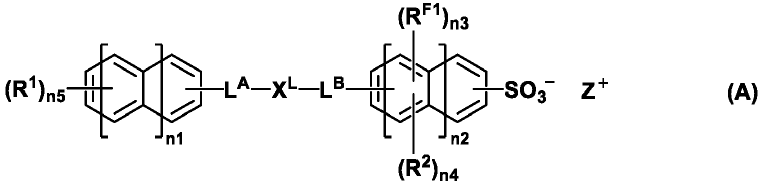 wherein n1 and n2 are each independently an integer of 0 to 2, n3 is an integer of 1 to 4 in case of n2=0, an integer of 1 to 6 in case of n2=1, and an integer of 1 to 8 in case of n2=2, n4 is an integer of 0 to 3 in case of n2=0, an integer of 0 to 5 in case of n2=1, and an integer of 0 to 7 in case of n2=2, n3+n4 is an integer of 1 to 4 in case of n2=0, an integer of 1 to 6 in case of n2=1, and an integer of 1 to 8 in case of n2=2, n5 is an integer of 1 to 5 in case of n1=0, an integer of 1 to 7 in case of n1=1, and an integer of 1 to 9 in case of n1=2,
R¹ is iodine or a C₃-C₂₀ branched or cyclic hydrocarbyl group which may contain a heteroatom, at least one R¹ is attached to the carbon atom adjoining the carbon atom to which L^{A} is attached, a plurality of R¹ may bond together to form a ring with the carbon atoms to which they are attached when n5 is 2 or more,
R² is a C₁-C₂₀ hydrocarbyl group which may contain a heteroatom, a plurality of R² may bond together to form a ring with the carbon atoms to which they are attached when n4 is 2 or more,
R^{F1} is fluorine, a C₁-C₆ fluorinated alkyl group, C₁-C₆ fluorinated alkoxy group, or C₁-C₆ fluorinated thioalkoxy group,
L^{A} and L^{B} are each independently a single bond, ether bond, ester bond, amide bond, sulfonate ester bond, carbonate bond or carbamate bond,
X^{L} is a single bond or a C₁-C₄₀ hydrocarbylene group which may contain a heteroatom, and
Z⁺ is an onium cation, 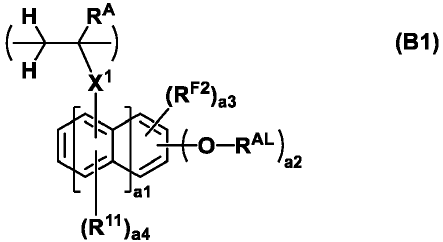 wherein a1 is an integer of 0 to 2, a2 is an integer of 1 or 2, a3 is an integer of 1 or 2, a4 is an integer of 0 to 4,
R^{A} is hydrogen, fluorine, methyl or trifluoromethyl,
X¹ is a single bond or *-C(=O)-O-, * designates a point of attachment to the carbon atom in the backbone,
R^{AL} is an acid labile group,
R^{F2} is fluorine, a C₁-C₆ fluorinated saturated hydrocarbyl group, C₁-C₆ fluorinated saturated hydrocarbyloxy group, or C₁-C₆ fluorinated saturated hydrocarbylthio group,
R¹¹ is halogen exclusive of fluorine or a C₁-C₂₀ hydrocarbyl group which may contain a heteroatom,
in case of a2=1, -O-R^{AL} and -R^{F2} are attached to the adjoining carbon atoms on the aromatic ring, and in case of a2=2, one of two -O-R^{AL} is attached to the carbon atom adjoining the carbon atom on the aromatic ring to which -R^{F2} is attached.

2. The resist composition of claim 1 wherein the photoacid generator has the formula (A1): 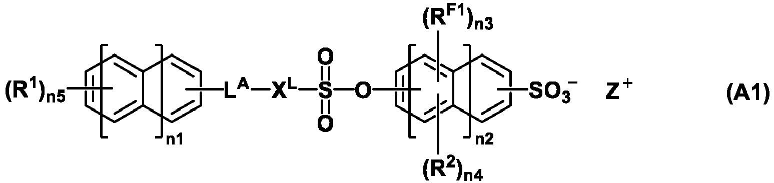 wherein n1 to n5, R¹, R², R^{F1}, L^{A}, X^{L} and Z⁺ are as defined above.

3. The resist composition of claim 1 or 2 wherein Z⁺ is a sulfonium cation having the formula (cation-1) or iodonium cation having the formula (cation-2): 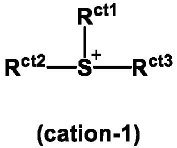
R^{ct4}-I⁺-R^{ct5} (cation-2)
wherein R^{ct1} to R^{ct5} are each independently halogen or a C₁-C₃₀ hydrocarbyl group which may contain a heteroatom, R^{ct1} and R^{ct2} may bond together to form a ring with the sulfur atom to which they are attached.

4. The resist composition of any one of claims 1 to 3 wherein R^{AL} is a group having the formula (AL-1) or (AL-2): 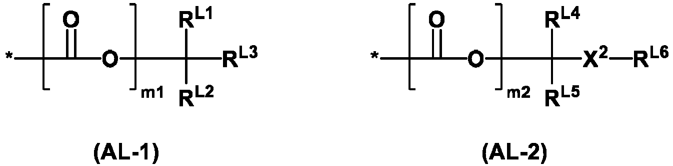 wherein R^{L1}, R^{L2} and R^{L3} are each independently a C₁-C₁₂ hydrocarbyl group in which some -CH₂- may be replaced by -O- or -S-, when the hydrocarbyl group contains an aromatic ring, some or all of the hydrogen atoms in the aromatic ring may be substituted by halogen, cyano moiety, nitro moiety, optionally halogenated C₁-C₄ alkyl moiety or optionally halogenated C₁-C₄ alkoxy moiety, R^{L1} and R^{L2} may bond together to form a ring with the carbon atom to which they are attached,
R^{L4} and R^{L5} are each independently hydrogen or a C₁-C₁₀ hydrocarbyl group, R^{L6} is a C₁-C₂₀ hydrocarbyl group in which some -CH₂- may be replaced by -O- or -S-, R^{L5} and R^{L6} may bond together to form a C₃-C₂₀ heterocyclic group with the carbon atom and X² to which they are attached, some -CH₂- in the heterocyclic group may be replaced by -O- or -S-,
X² is -O- or -S-,
m1 and m2 are each independently 0 or 1,
* designates a point of attachment to the adjoining -O-.

5. The resist composition of any one of claims 1 to 4 wherein the polymer further comprises repeat units of at least one type selected from repeat units having the formula (B2) and repeat units having the formula (B3): 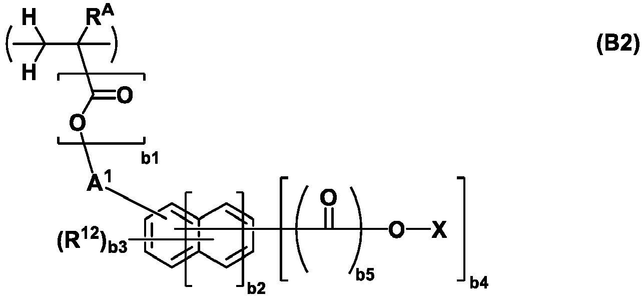 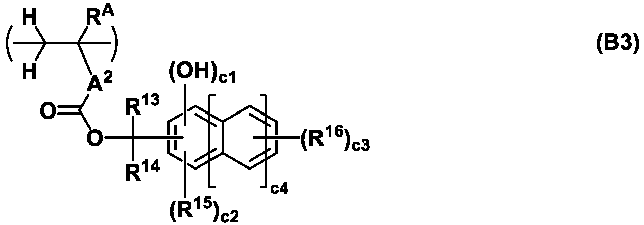 wherein b1 is 0 or 1, b2 is an integer of 0 to 2, b3 is an integer satisfying 0 ≤ b3 ≤ 5+2(b2)-b4, b4 is an integer of 1 to 3, b5 is 0 or 1,
c1 is an integer of 0 to 2, c2 is an integer of 0 to 2, c3 is an integer of 0 to 5, c4 is an integer of 0 to 2,
R^{A} is each independently hydrogen, fluorine, methyl or trifluoromethyl,
A¹ is a single bond or a C₁-C₁₀ saturated hydrocarbylene group in which some -CH₂-may be replaced by -O-,
A² is a single bond, phenylene group, naphthylene group or *-C(=O)-O-A²¹-, A²¹ is a C₁-C₂₀ aliphatic hydrocarbylene group which may contain hydroxy, ether bond, ester bond or lactone ring, or phenylene group or naphthylene group, * designates a point of attachment to the carbon atom in the backbone,
R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R¹³ and R¹⁴ are each independently a C₁-C₁₀ hydrocarbyl group which may contain a heteroatom, R¹³ and R¹⁴ may bond together to form a ring with the carbon atom to which they are attached,
R¹⁵ is each independently fluorine, C₁-C₅ fluorinated alkyl group, or C₁-C₅ fluorinated alkoxy group, and
R¹⁶ is each independently a C₁-C₁₀ hydrocarbyl group which may contain a heteroatom,
X is an acid labile group in case of b4=1, X is hydrogen or an acid labile group, at least one being an acid labile group, in case of b4=2 or 3.

6. The resist composition of any one of claims 1 to 5 wherein the polymer further comprises repeat units having the formula (B4): 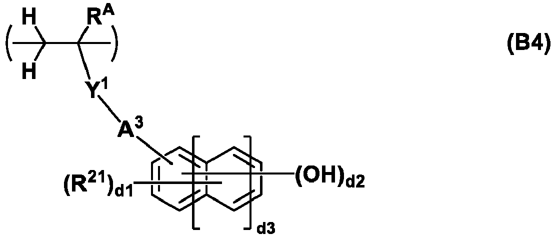 wherein d1 is an integer satisfying 0 ≤ d1 ≤ 5+2(d3)-d2, d2 is an integer of 1 to 3, d3 is an integer of 0 to 2,
R^{A} is hydrogen, fluorine, methyl or trifluoromethyl,
Y¹ is a single bond, *-C(=O)-O- or *-C(=O)-NH-, * designates a point of attachment to the carbon atom in the backbone,
A³ is a single bond or a C₁-C₁₀ saturated hydrocarbylene group in which some -CH₂-may be replaced by -O-, and
R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group.

7. The resist composition of any one of claims 1 to 6 wherein the polymer further comprises repeat units of at least one type selected from repeat units having the formula (B5), repeat units having the formula (B6), and repeat units having the formula (B7): 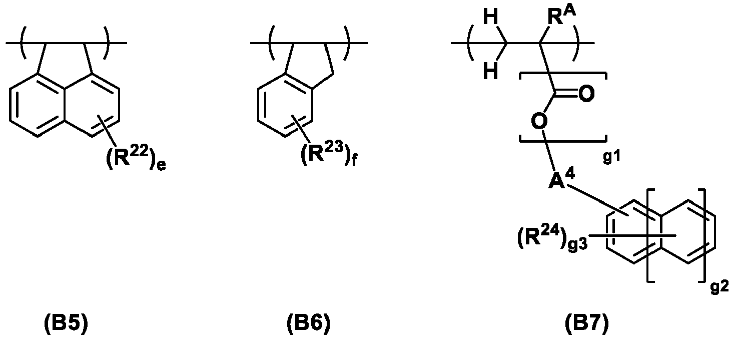 wherein e is an integer of 0 to 6, f is an integer of 0 to 4, g1 is 0 or 1, g2 is an integer of 0 to 2, g3 is an integer of 0 to 5,
R^{A} is hydrogen, fluorine, methyl or trifluoromethyl,
R²² and R²³ are each independently hydroxy, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group,
R²⁴ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group or cyano group, R²⁴ may also be hydroxy in case of g2=1 or 2,
A⁴ is a single bond or a C₁-C₁₀ saturated hydrocarbylene group in which some -CH₂-may be replaced by -O-.

8. The resist composition of any one of claims 1 to 7 wherein the polymer further comprises repeat units of at least one type selected from repeat units having the formula (B8), repeat units having the formula (B9), repeat units having the formula (B10), and repeat units having the formula (B11): 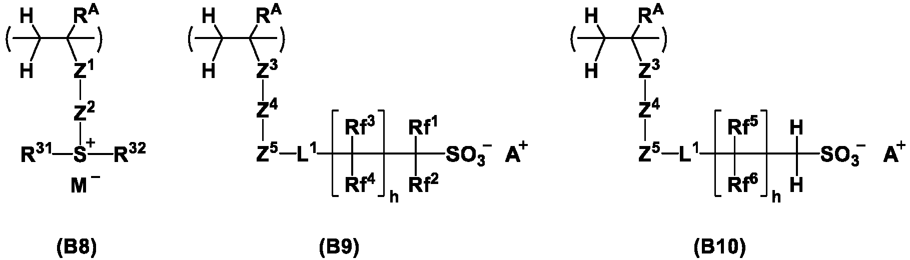 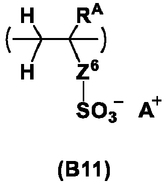 wherein R^{A} is each independently hydrogen, fluorine, methyl or trifluoromethyl,
Z¹ is a single bond or phenylene group,
Z² is *¹-C(=O)-O-Z²¹-, *¹-C(=O)-NH-Z²¹- or *¹-O-Z²¹-, Z²¹ is a C₁-C₆ aliphatic hydrocarbylene group, phenylene group, or divalent group obtained by combining the foregoing, which may contain a carbonyl moiety, ester bond, ether bond or hydroxy moiety, *¹ designates a point of attachment to Z¹,
Z³ is each independently a single bond, phenylene group, naphthylene group, or *²-C(=O)-O-Z³¹-, Z³¹ is a C₁-C₁₀ aliphatic hydrocarbylene group, phenylene group, or naphthylene group, the aliphatic hydrocarbylene group may contain a hydroxy moiety, ether bond, ester bond or lactone ring, *² designates a point of attachment to the carbon atom in the backbone,
Z⁴ is each independently a single bond, *³-Z⁴¹-C(=O)-O-, *³-C(=O)-NH-Z⁴¹- or *³-O-Z⁴¹-, Z⁴¹ is a C₁-C₂₀ hydrocarbylene group which may contain a heteroatom, *³ designates a point of attachment to Z³,
Z⁵ is each independently a single bond, *⁴-Z⁵¹-C(=O)-O-, *⁴-C(=O)-NH-Z⁵¹- or *⁴-O-Z⁵¹-, Z⁵¹ is a C₁-C₂₀ hydrocarbylene group which may contain a heteroatom, *⁴ designates a point of attachment to Z⁴,
Z⁶ is a single bond, methylene, ethylene, phenylene, fluorinated phenylene, trifluoromethyl-substituted phenylene, *²-C(=O)-O-Z⁶¹-, *²-C(=O)-N(H)-Z⁶¹-, or *²-O-Z⁶¹-, Z⁶¹ is a C₁-C₆ aliphatic hydrocarbylene group, phenylene group, fluorinated phenylene group, or trifluoromethyl-substituted phenylene group, which may contain a carbonyl moiety, ester bond, ether bond or hydroxy moiety, *² designates a point of attachment to the carbon atom in the backbone,
R³¹ and R³² are each independently a C₁-C₂₀ hydrocarbyl group which may contain a heteroatom, R³¹ and R³² may bond together to form a ring with the sulfur atom to which they are attached,
L¹ is a single bond, ether bond, ester bond, carbonyl group, sulfonate ester bond, carbonate bond or carbamate bond,
Rf¹ and Rf² are each independently fluorine or a C₁-C₆ fluorinated saturated hydrocarbyl group,
Rf³ and Rf⁴ are each independently hydrogen, fluorine, or a C₁-C₆ fluorinated saturated hydrocarbyl group,
Rf⁵ and Rf⁶ are each independently hydrogen, fluorine, or a C₁-C₆ fluorinated saturated hydrocarbyl group, excluding that all Rf⁵ and Rf⁶ are hydrogen at the same time,
M⁻ is a non-nucleophilic counter ion,
A⁺ is an onium cation, and
h is an integer of 0 to 3.

9. The resist composition of any one of claims 1 to 8, further comprising an organic solvent.

10. The resist composition of any one of claims 1 to 9, further comprising a fluorinated polymer comprising repeat units of at least one type selected from repeat units having the formula (D1), repeat units having the formula (D2), repeat units having the formula (D3), and repeat units having the formula (D4) and optionally repeat units of at least one type selected from repeat units having the formula (D5) and repeat units having the formula (D6): 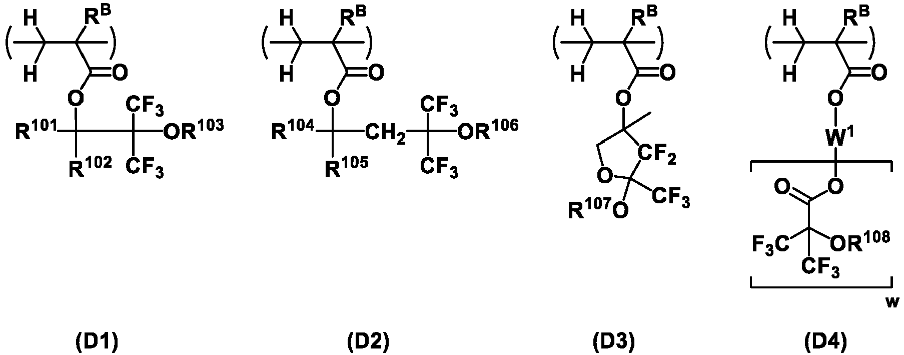 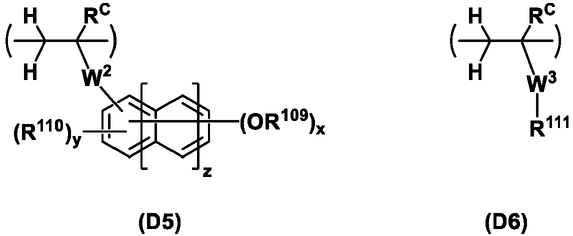 wherein x is an integer of 1 to 3, y is an integer satisfying 0 ≤ y ≤ 5+2z-x, z is 0 or 1, w is an integer of 1 to 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen atom is substituted by fluorine and in which some -CH₂- may be replaced by an ester bond or ether bond,
W¹ is a C₁-C₂₀ (w+1)-valent hydrocarbon group or C₁-C₂₀ (w+1)-valent fluorinated hydrocarbon group,
W² is a single bond, *-C(=O)-O- or *-C(=O)-NH-,
W³ is a single bond, -O-, *-C(=O)-O-W³¹-W³²- or *-C(=O)-NH-W³¹-W³²-, W³¹ is a single bond or a C₁-C₁₀ saturated hydrocarbylene group, W³² is a single bond, ester bond, ether bond or sulfonamide bond,
* designates a point of attachment to the carbon atom in the backbone.

11. The resist composition of any one of claims 1 to 10, further comprising a quencher.

12. The resist composition of any one of claims 1 to 11, further comprising a photoacid generator other than the photoacid generator having formula (A).

13. A resist pattern forming process comprising the steps of:
applying the chemically amplified positive resist composition of any one of claims 1 to 12 onto a substrate to form a resist film thereon,
exposing the resist film to high-energy radiation, and
developing the exposed resist film in an alkaline developer.

14. The process of claim 13 wherein the substrate is a mask blank of transmission or reflection type.

15. A mask blank of transmission or reflection type which is coated with the chemically amplified positive resist composition of any one of claims 1 to 12.
